# EUROPEAN PATENT APPLICATION

(11) **EP 4 796 549 A1**
(43) Date of publication of application: **26.08.2026**
(21) Application number: 26159668.8
(22) Date of filing: 19.02.2026
(51) Int. Cl.: C07F 5/02, C09K 11/06, H10K 85/30

(54) **LIGHT EMITTING ELEMENT, FUSED POLYCYCLIC COMPOUND FOR THE LIGHT EMITTING ELEMENT, AND ELECTRONIC APPARATUS INCLUDING THE LIGHT EMITTING ELEMENT**

(30) Priority: 21.02.2025 JP 2025027220
(71) Applicant: Samsung Display Co., Ltd., Yongin-si, Gyeonggi-do (KR)
(72) Inventor: ASHIKARI, Yasuhiko, 220-0011 Yokohama-shi (JP); KAWANO, Yuta, 220-0011 Yokohama-shi (JP)
(74) Representative: Marks & Clerk LLP

(57) **Abstract**

Provided is a light-emitting element including a first electrode, a second electrode disposed on the first electrode, an emission layer disposed between the first electrode and the second electrode, and the emission layer includes a first compound represented by Formula 1.

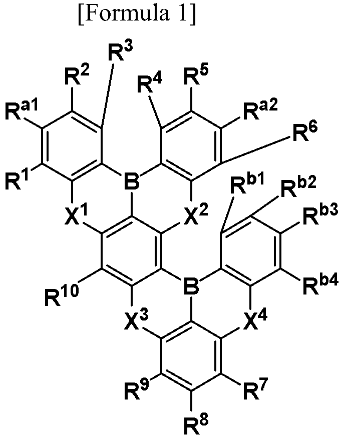

## Description

### BACKGROUND

The present disclosure herein relates to a light-emitting element, a fused polycyclic compound used in the light-emitting element, and an electronic apparatus including the light-emitting element.

Recently, developments in organic electroluminescence display devices (and the like) as image display devices have been actively conducted. Organic electroluminescence display devices (or the like) may include a so-called self-luminous light-emitting element which generate a display (or image) by recombining, in an emission layer, holes and electrons respectively injected from a first electrode and a second electrode to cause a light-emitting material in the emission layer to emit light.

For application of a light-emitting element to a display device, improvements in lifespan and the like are being explored, and development of materials for a light-emitting element, which may stably meet or exceed the industry demands, are increasingly being demanded.

### SUMMARY

The present disclosure provides a light-emitting element having improved emission efficiency and lifespan and an electronic apparatus including the same.

The present disclosure also provides a fused polycyclic compound, which is a material for a light-emitting element, improving emission efficiency and lifespan.

At least one example embodiment of the inventive concepts provides a light-emitting element including a first electrode, a second electrode on the first electrode, and an emission layer between the first electrode and the second electrode, the emission layer including a first compound represented by Formula 1 below.

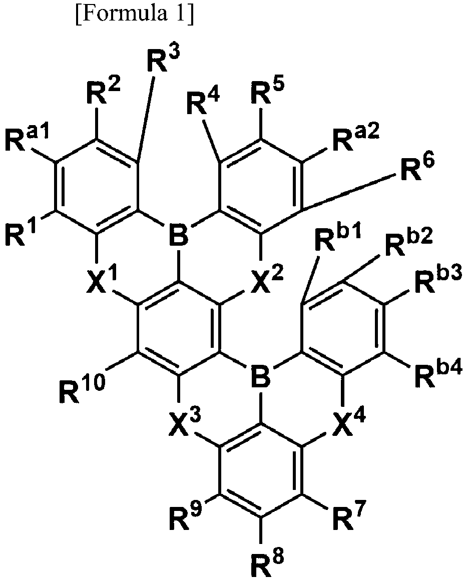

In Formula 1 above, X¹ to X⁴ are each independently O, S, or NR^{y1}, R^{y1} is a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, a substituted or unsubstituted heteroaryl group having 2 to 30 ring-forming carbon atoms, or represented by Formula 2 below, R¹ to R⁶ and R^{b1} to R^{b4} are each independently a hydrogen atom, a deuterium atom, a halogen atom, a substituted or unsubstituted amine group, a substituted or unsubstituted oxy group, a substituted or unsubstituted thio group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms, wherein R¹ to R⁶ and R^{b1} to R^{b4} are optionally bonded to an adjacent group to form a ring, R⁷ to R¹⁰, R^{a1}, and R^{a2} are each independently a hydrogen atom, a deuterium atom, a cyano group, a halogen atom, a substituted or unsubstituted amine group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms, at least one among R^{a1} and R^{a2} is the substituted or unsubstituted aryl group having 6 to 60 ring-forming carbon atoms, at least one among R^{b1} to R^{b4} is the substituted or unsubstituted alkyl group having 1 to 20 carbon atoms, or an electron-donating group, and the electron-donating group is a substituted or unsubstituted alkoxy group, a substituted or unsubstituted alkylthio group, a substituted or unsubstituted alkylamine group, a substituted or unsubstituted aryloxy group, a substituted or unsubstituted arylthio group, a substituted or unsubstituted arylamine group, or a substituted or unsubstituted carbazole group.

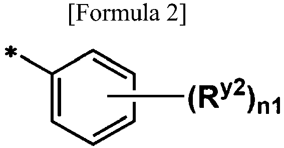

In Formula 2 above, n1 is an integer of 0 to 5, R^{y2} is a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms, when R^{b2} and R^{b3} are bonded to each other R^{b2} and R^{b3} form a moiety represented by Formula RB and the at least one among R^{a1} and R^{a2} is the unsubstituted aryl group having 6 to 60 ring-forming carbon atoms.

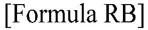

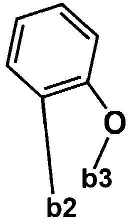

In Formula RB above, b2 is a position corresponding to R^{b2}, and b3 is a position corresponding to R^{b3}, and the first compound includes a chemical structure in which a hydrogen atom is optionally substituted with a deuterium atom.

In at least one example embodiment, the emission layer may further include at least one of a second compound represented by Formula HT-1 below, a third compound represented by Formula ET-1 below, and a fourth compound represented by Formula D-1 below.

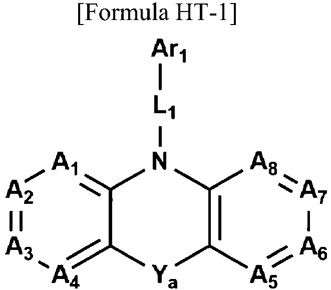

In Formula HT-1 above, A₁ to A₈ may be each independently N or CR₅₁, L₁ may be a direct linkage, a substituted or unsubstituted arylene group having 6 to 30 ring-forming carbon atoms, or a substituted or unsubstituted heteroarylene group having 2 to 30 ring-forming carbon atoms, Yₐ may be a direct linkage, CR₅₂R₅₃, or SiR₅₄R₅₅, Ar₁ may be a substituted or unsubstituted aryl group having 6 to 30 ring-forming carbon atoms, or a substituted or unsubstituted heteroaryl group having 2 to 30 ring-forming carbon atoms, R₅₁ to R₅₅ may be each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, wherein R₅₁ to R₅₅ are optionally bonded to an adjacent group to form a ring.

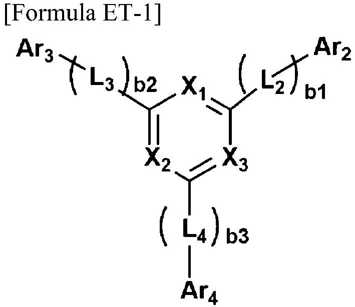

In Formula ET-1 above, at least one among X₁ to X₃ may be N, and a remainder of the X₁ to X₃ may be CR₅₆, R₅₆ may be a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, b1 to b3 may be each independently an integer of 0 to 10, Ar₂ to Ar₄ may be each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, L₂ to L₄ may be each independently a direct linkage, a substituted or unsubstituted arylene group having 6 to 30 ring-forming carbon atoms, or a substituted or unsubstituted heteroarylene group having 2 to 30 ring-forming carbon atoms.

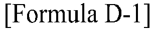

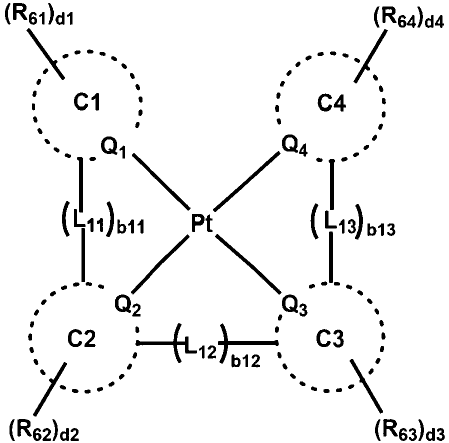

In Formula D-1 above, Q₁ to Q₄ may be each independently C or N, C1 to C4 may be each independently a substituted or unsubstituted hydrocarbon ring having 5 to 30 ring-forming carbon atoms, a substituted or unsubstituted aryl group having 6 to 30 ring-forming carbon atoms, or a substituted or unsubstituted heterocycle having 2 to 30 ring-forming carbon atoms, L₁₁ to L₁₃ may be each independently a direct linkage, 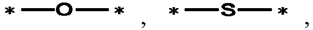 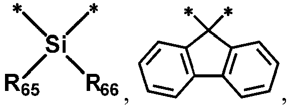 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms, b11 to b13 may be each independently 0 or 1, R₆₁ to R₆₆ may be each independently hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, and d1 to d4 may be each independently an integer of 0 to 4.

In at least one example embodiment, Formula 1 above may be represented by at least one of Formula 1-A1 to Formula 1-A6.

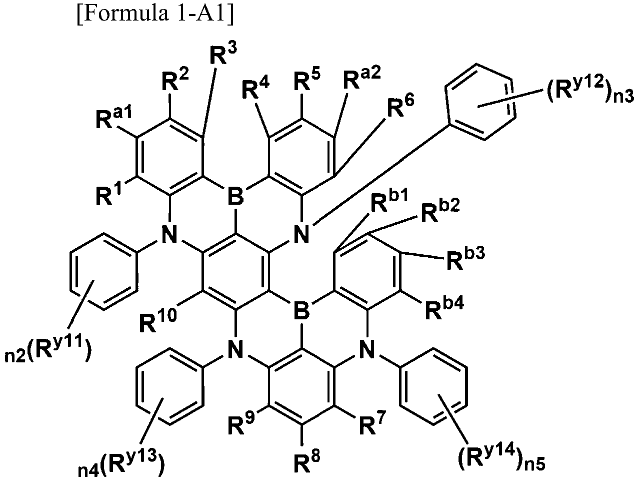

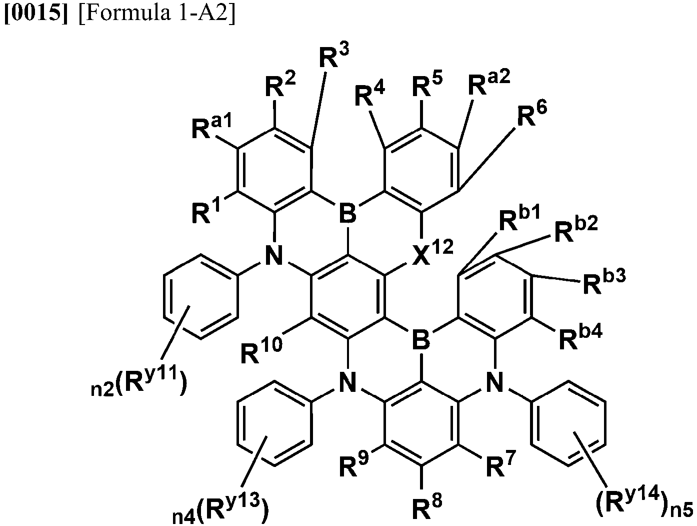

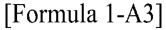

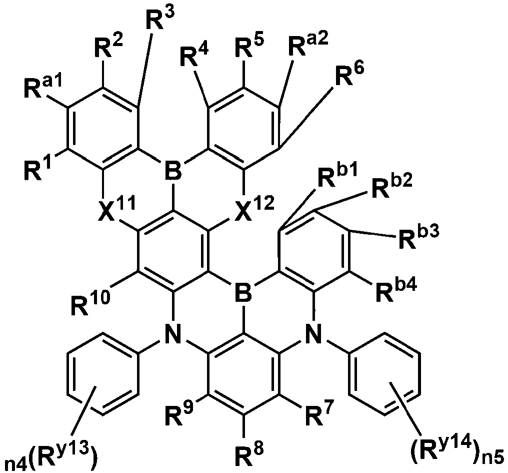

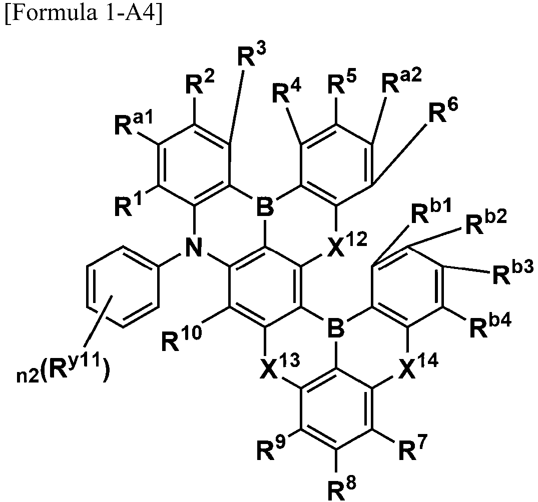

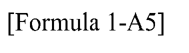

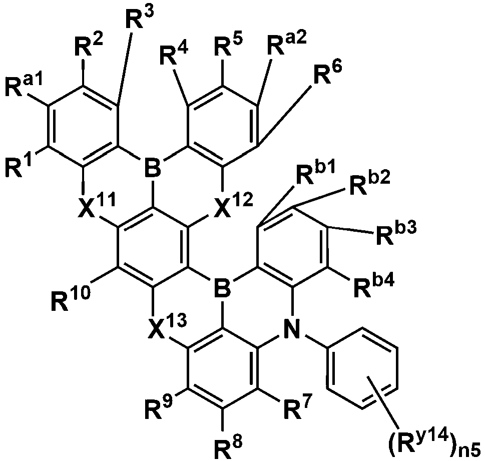

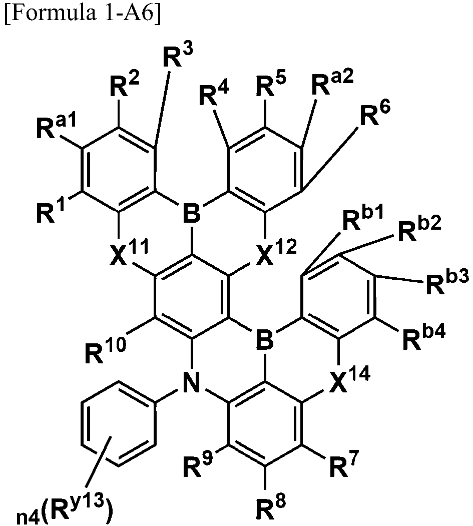

In Formula 1-A1 to Formula 1-A6 above, X¹¹ to X¹⁴ may be each independently O or S, n2 to n5 may be each independently an integer of 0 to 5, R^{y11} to R^{y14} may be each independently a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms. R¹ to R⁶, R^{b1} to R^{b4}, R⁷ to R¹⁰, R^{a1}, and R^{a2} are the same as defined in Formula 1 above.

In at least one example embodiment, in Formula 1 above, at least one among R^{b1} to R^{b4} may be a substituted or unsubstituted methyl group, a substituted or unsubstituted ethyl group, a substituted or unsubstituted isopropyl group, a substituted or unsubstituted n-butyl group, a substituted or unsubstituted t-butyl group, a substituted or unsubstituted cyclopentyl group, a substituted or unsubstituted cyclohexyl group, a substituted or unsubstituted methoxy group, a substituted or unsubstituted propyloxy group, a substituted or unsubstituted isopropyloxy, a substituted or unsubstituted t-butyloxy group, a substituted or unsubstituted cyclohexyloxy group, a substituted or unsubstituted phenyloxy group, a substituted or unsubstituted dimethylamine group, a substituted or unsubstituted ethylamine group, a substituted or unsubstituted N-methylphenylamine group, a substituted or unsubstituted N-propylphenylamine group, a substituted or unsubstituted diphenylamine group, a substituted or unsubstituted methylthio group, a substituted or unsubstituted isopropylthio group, a substituted or unsubstituted propylthio group, a substituted or unsubstituted t-butylthio group, a substituted or unsubstituted phenylthio group, or a substituted or unsubstituted carbazole group.

In at least one example embodiment, in Formula 1 above, the at least one among R^{b1} to R^{b4} may be represented by at least one of Rb-1 to Rb-45 below.

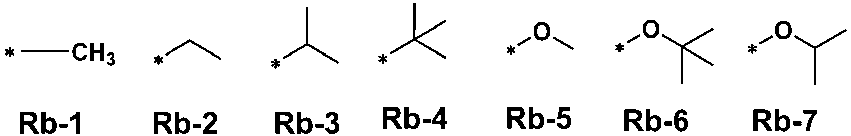

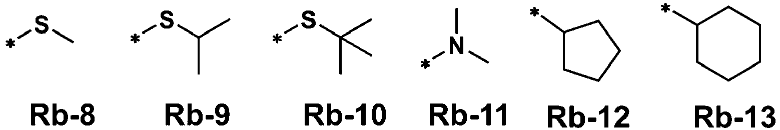

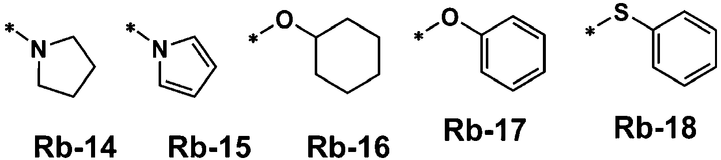

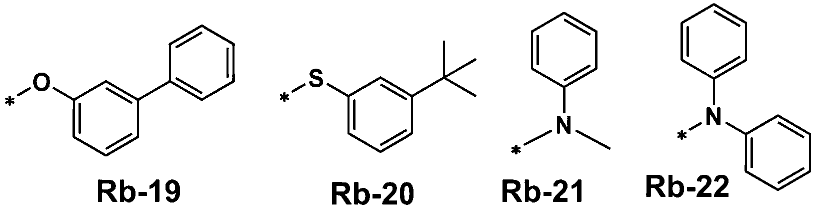

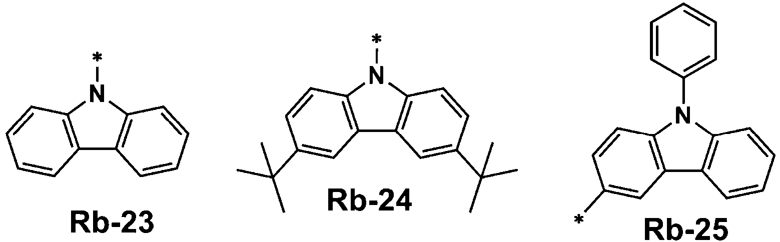

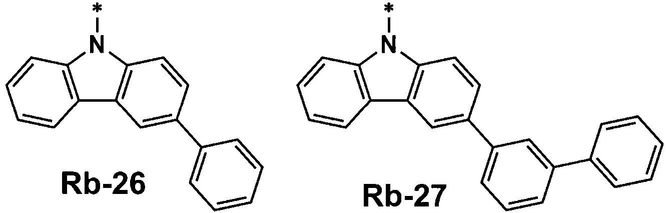

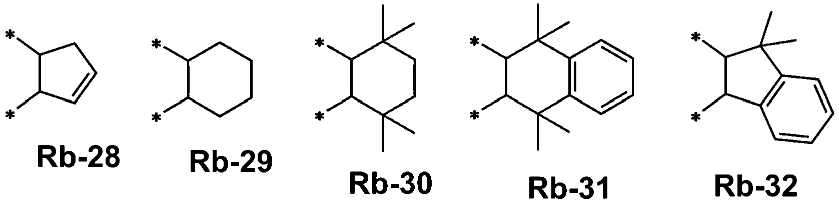

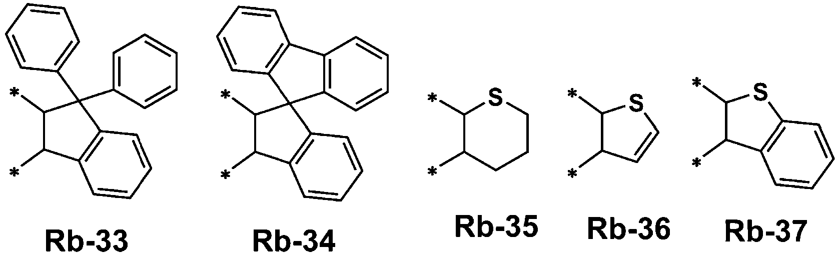

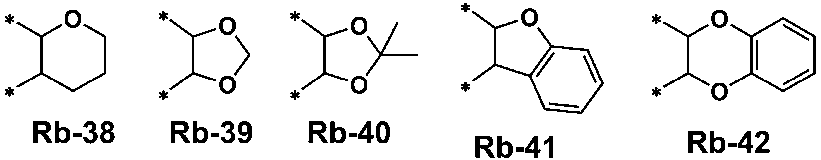

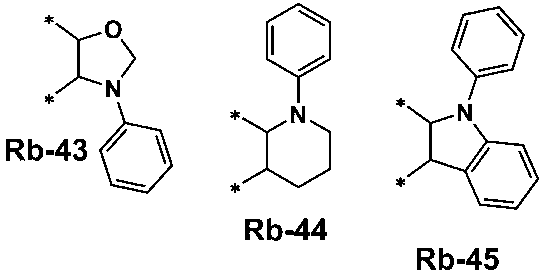

In Rb-28 to Rb-45 above, two * are positions corresponding to two groups adjacent to each other among R^{b1} to R^{b4}.

In at least one example embodiment, in Formula 1 above, the at least one among R^{a1} and R^{a2} above may be represented by at least one of Ra-1 to Ra-5 below:

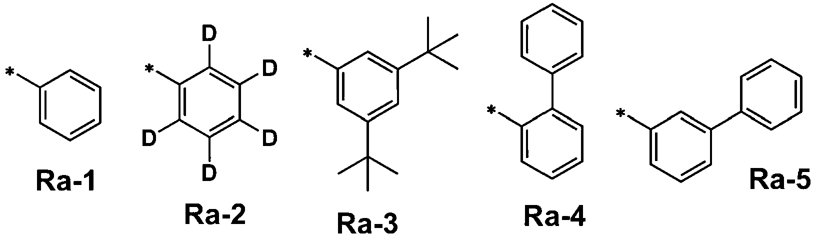

In Ra-2 above, D is a deuterium atom.

In at least one example embodiment, in Formula 1 above, a remainder of R^{a1} and R^{a2} may be a hydrogen atom, a deuterium atom, a cyano group, a substituted or unsubstituted diphenylamine group, or a substituted or unsubstituted carbazole group.

In at least one example embodiment, R^{y1} in Formula 1 above may be represented by at least one of Y1-1 to Y1-18 below:

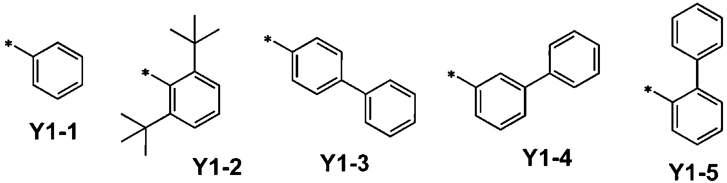

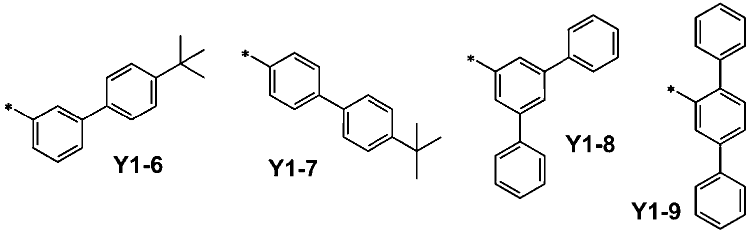

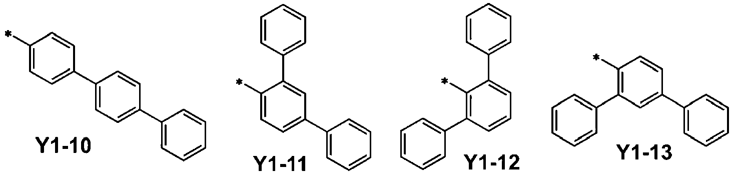

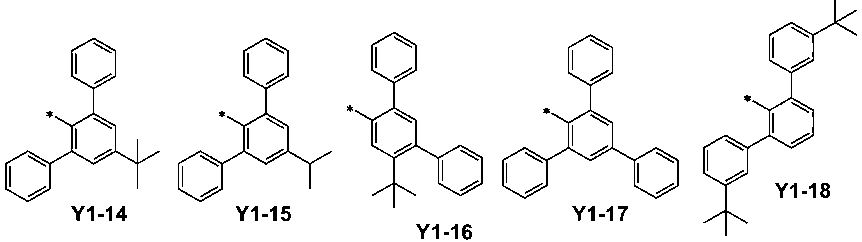

In at least one example embodiment of the inventive concepts, a fused polycyclic compound represented by Formula 1 below is provided.

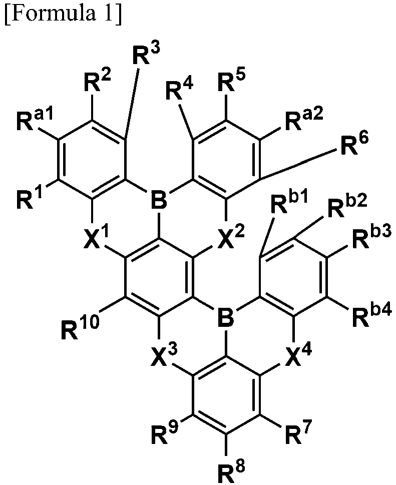

In Formula 1 above, X¹ to X⁴ are each independently O, S, or NR^{y1}, R^{y1} is a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, a substituted or unsubstituted heteroaryl group having 2 to 30 ring-forming carbon atoms, or represented by Formula 2 below, R¹ to R⁶ and R^{b1} to R^{b4} are each independently a hydrogen atom, a deuterium atom, a halogen atom, a substituted or unsubstituted amine group, a substituted or unsubstituted oxy group, a substituted or unsubstituted thio group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms, wherein R¹ to R⁶ and R^{b1} to R^{b4} are optionally bonded to an adjacent group to form a ring, R⁷ to R¹⁰, R^{a1}, and R^{a2} are each independently a hydrogen atom, a deuterium atom, a cyano group, a halogen atom, a substituted or unsubstituted amine group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms, at least one among R^{a1} and R^{a2} is the substituted or unsubstituted aryl group having 6 to 60 ring-forming carbon atoms, at least one among R^{b1} to R^{b4} is the substituted or unsubstituted alkyl group having 1 to 20 carbon atoms, or an electron-donating group, and the electron-donating group is a substituted or unsubstituted alkoxy group, a substituted or unsubstituted alkylthio group, a substituted or unsubstituted alkylamine group, a substituted or unsubstituted aryloxy group, a substituted or unsubstituted arylthio group, a substituted or unsubstituted arylamine group, or a substituted or unsubstituted carbazole group.

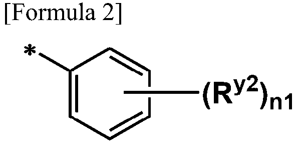

In Formula 2 above, n1 may be an integer of 0 to 5, R^{y2} may be a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms, and when R^{b2} and R^{b3} are bonded to each other to form a moiety represented by Formula RB below, one among R^{a1} and R^{a2} may be an unsubstituted aryl group having 6 to 60 ring-forming carbon atoms.

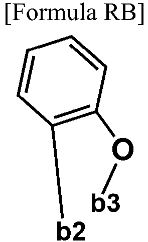

In Formula RB above, b2 is a position corresponding to R^{b2}, and b3 is a position corresponding to R^{b3}, and the fused polycyclic compound may include a chemical structure in which a hydrogen atom is optionally substituted with a deuterium atom.

In at least one example embodiment of the inventive concepts, an electronic apparatus including a display device that provides an image is provided, the display device includes a base layer, a circuit layer disposed on the base layer, and a display element layer disposed on the circuit layer and including a light-emitting element, and the light-emitting element includes a first electrode, a second electrode disposed on the first electrode, and an emission layer disposed between the first electrode and the second electrode and including a fused polycyclic compound represented by Formula 1 above.

In at least one example embodiment, the electronic apparatus may further include at least one among a light control layer and a color filter layer, the light control layer may include a quantum dot, and the color filter layer may include at least one of a pigment or dye.

In at least one example embodiment, the electronic apparatus may further include at least one among a processor, a memory, and power module.

At least some of the above and other features of the invention are set out in the claims.

### BRIEF DESCRIPTION OF THE FIGURES

The accompanying drawings are included to provide a further understanding of the inventive concepts, and/or are incorporated in and constitute a part of this specification. The drawings illustrate embodiments of the inventive concepts and, together with the description, serve to explain principles of the inventive concepts. In the drawings:
FIG. 1 is a plan view illustrating a display device according to at least one example embodiment;
FIG. 2 is a cross-sectional view illustrating a portion taken along line I-I' in FIG. 1;
FIG. 3 is a cross-sectional view schematically illustrating a light-emitting element according to at least one example embodiment;
FIG. 4 is a cross-sectional view schematically illustrating a light-emitting element according to at least one example embodiment;
FIG. 5 is a cross-sectional view schematically illustrating a light-emitting element according to at least one example embodiment;
FIG. 6 is a cross-sectional view schematically illustrating a light-emitting element according to at least one example embodiment;
FIG. 7A is an image showing a highest occupied molecular orbital (HOMO) distribution of a fused polycyclic compound according to at least one example embodiment;
FIG. 7B is an image showing a lowest unoccupied molecular orbital (LUMO) distribution of a fused polycyclic compound according to at least one example embodiment;
FIG. 8 is a cross-sectional view illustrating a display device according to at least one example embodiment;
FIG. 9 is a cross-sectional view illustrating a display device according to at least one example embodiment;
FIG. 10 is a cross-sectional view illustrating a display device according to at least one example embodiment;
FIG. 11 is a cross-sectional view illustrating a display device according to at least one example embodiment;
FIG. 12 is a view illustrating an inside of a vehicle in which a display device, according to at least one example embodiment, is disposed;
FIG. 13 is a perspective view illustrating an electronic apparatus according to at least one example embodiment;
FIG. 14 is an exploded perspective view illustrating an electronic apparatus according to at least one example embodiment;
FIG. 15 is a block diagram of an electronic apparatus according to at least one example embodiment; and
FIG. 16 illustrates schematic views of electronic apparatuses according to various embodiments.

### DETAILED DESCRIPTION

The present disclosure may be modified in many alternate forms, and/or thus specific example embodiments will be illustrated in the drawings and described in detail. It should be understood, however, that it is not intended to limit the present disclosure to the particular forms disclosed, but is intended to cover all modifications, equivalents, and/or alternatives falling within the scope of the present disclosure.

In this specification, it will be understood that when an element (or a region, a layer, a portion, and the like) is referred to as being "on", "connected to" or "coupled to" another element, it may be directly disposed on, connected to, and/or coupled to the other element, and/or other elements may be disposed therebetween, unless expressly indicated otherwise.

Like reference numerals or symbols refer to like elements throughout. In the drawings, the thickness, ratio, and/or size of the elements are exaggerated for effectively describing the technical contents. The term "and/or" includes any and all combinations of one or more of the associated listed elements.

It will be understood that, although the terms "first", "second", etc. may be used herein to describe various elements, the elements are not to be limited by these terms. These terms are only used to distinguish one element from another element. For instance, a first element could be termed a second element without departing from the scope of the inventive concepts. Similarly, a second element could be termed a first element. The singular expressions "a", "an" and "the" are intended to include the plural forms as well, unless the context clearly indicates otherwise.

In addition, the terms "below", "under", "on the lower side", "above", "over", "on the upper side", and the like may be used to describe the relationships between the elements illustrated in the drawings. These terms are relative concepts and are described on the basis of the directions indicated in the drawings. For example, it will be understood that such spatially relative terms are intended to encompass different orientations of the device in use or operation in addition to the orientation depicted in the figures, and/or thus the device may be otherwise oriented (rotated 90 degrees or at other orientations) and the spatially relative terms used herein interpreted accordingly.

Additionally, when terms such as "about", "approximately", "substantially", and the like are used in relation to numerical values, the relevant numerical value may be construed as including a manufacturing or operation deviation (e.g., +10 %) of the stated numerical value. Moreover, regardless of whether a numerical value of a shape is limited by using "about", "approximately" or "substantially", such numerical value or shape should be understood as including a manufacturing or operation deviation (e.g., ±10%) of the stated numerical value.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Also, terms, such as "unit" and "module", as used in the specification, which represent functional units that process at least one function or operation, and/or may be implemented as processing circuitry, such as hardware, software, and/or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components (such as at least one of transistors, resistors, capacitors, etc.), and/or electronic circuits including said components.

Herein, the term "substituted or unsubstituted" may indicate that one is substituted or unsubstituted with at least one substituent selected from the group consisting of a deuterium atom, a halogen atom, a cyano group, a nitro group, an amine group, an amino group, a silyl group, an oxy group, a thio group, a sulfinyl group, a sulfonyl group, a carbonyl group, a boron group, a hydroxyl group, a phosphine oxide group, a phosphine sulfide group, an alkyl group, an alkenyl group, an alkynyl group, a hydrocarbon ring group, an aryl group, and a heterocyclic group. In addition, each of the substituents presented as an example above may be substituted or unsubstituted. For example, a biphenyl group may be interpreted as an aryl group or as a phenyl group substituted with a phenyl group.

Herein, the term "bonded to an adjacent group to form a ring" may indicate that one is bonded to an adjacent group to form a substituted or unsubstituted hydrocarbon ring, or a substituted or unsubstituted heterocycle. The hydrocarbon ring includes an aliphatic hydrocarbon ring and an aromatic hydrocarbon ring. The heterocycle includes an aliphatic heterocycle and an aromatic heterocycle. The hydrocarbon ring and the heterocycle may be monocyclic or polycyclic. In addition, the rings formed by being bonded to each other may be linked to another ring to form a spiro structure.

Herein, the term "adjacent group" may indicate a substituent substituted for an atom which is directly linked to an atom substituted with a corresponding substituent, another substituent substituted for an atom which is substituted with a corresponding substituent, or a substituent sterically closest to a corresponding substituent. For example, two methyl groups in 1,2-dimethylbenzene may be interpreted as mutually "adjacent groups" and two ethyl groups in 1,1-diethylcyclopentane may be interpreted as mutually "adjacent groups". In addition, two methyl groups in 4,5-dimethylphenanthrene may be interpreted as mutually "adjacent groups".

Herein, examples of a halogen atom may include a fluorine atom, a chlorine atom, a bromine atom, or an iodine atom.

Herein, an alkyl group may be a linear, branched, or cyclic group. The alkyl group may include a cycloalkyl group. The number of carbon atoms in the alkyl group is 1 to 60, 1 to 50, 1 to 30, 1 to 20, 1 to 10, or 1 to 6. Examples of the alkyl group may include a methyl group, an ethyl group, an n-propyl group, an isopropyl group, an n-butyl group, a s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-icosyl group, a 2-ethylicosyl group, a 2-butylicosyl group, a 2-hexylicosyl group, a 2-octylicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, and the like, but are not limited thereto.

Herein, a cycloalkyl group may indicate a cyclic alkyl group. The number of carbon atoms in the cycloalkyl group is 3 to 60, 3 to 50, 3 to 30, 3 to 20, or 3 to 10. Examples of the cycloalkyl group include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, and the like, but are not limited thereto.

Herein, an alkenyl group indicates a hydrocarbon group including at least one carbon double bond in the middle or end of an alkyl group having 2 or more carbon atoms. The alkenyl group may be linear or branched. The number of carbon atoms is not particularly limited, but is 2 to 60, 2 to 30, 2 to 20, or 2 to 10. Examples of the alkenyl group include a vinyl group, a 1-butenyl group, a 1-pentenyl group, a 1,3-butadienyl aryl group, a styrenyl group, a styryl vinyl group, and the like, but are not limited thereto.

Herein, an alkynyl group indicates a hydrocarbon group including at least one carbon triple bond in the middle or end of an alkyl group having 2 or more carbon atoms. The alkynyl group may be linear or branched. The number of carbon atoms is not particularly limited, but is 2 to 30, 2 to 20, or 2 to 10. Specific examples of the alkynyl group may include an ethynyl group, a propynyl group, and the like, but are not limited thereto.

Herein, a hydrocarbon ring group indicates any functional group or substituent derived from an aliphatic hydrocarbon ring. The hydrocarbon ring group may be a saturated hydrocarbon ring group having 5 to 60, 5 to 30, or 5 to 20 ring-forming carbon atoms.

Herein, an aryl group indicates any functional group or substituent derived from an aromatic hydrocarbon ring. The aryl group may be a monocyclic aryl group or a polycyclic aryl group. The number of ring-forming carbon atoms in the aryl group may be 5 to 60, 6 to 60, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, and the like, but are not limited thereto.

Herein, a fluorenyl group may be substituted, and two substituents may be bonded to each other to form a spiro structure. An example of some of the substituted fluorenyl groups is as follows. However, the example embodiments are not limited thereto.

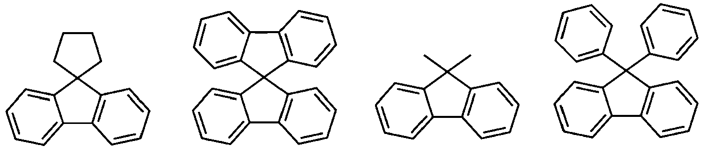

Herein, a heterocyclic group indicates any functional group or substituent derived from a ring containing at least one of B, O, N, P, Si, or S as a hetero atom. The heterocyclic group includes an aliphatic heterocyclic group and an aromatic heterocyclic group. The aromatic heterocyclic group may be a heteroaryl group. The aliphatic heterocyclic group and the aromatic heterocyclic group may be monocyclic or polycyclic.

Herein, the heterocyclic group may contain at least one of B, O, N, P, Si, or S as a hetero atom. When the heterocyclic group contains two or more hetero atoms, the two or more hetero atoms may be the same as or different from each other. The heterocyclic group may be a monocyclic heterocyclic group or a polycyclic heterocyclic group, and include a heteroaryl group. The number of ring-forming carbon atoms in the heterocyclic group may be 2 to 60, 2 to 30, 2 to 20, or 2 to 10.

Herein, the aliphatic heterocyclic group may contain at least one of B, O, N, P, Si, or S as a hetero atom. The number of ring-forming carbon atoms in the aliphatic heterocyclic group may be 2 to 60, 2 to 30, 2 to 20, or 2 to 10. Examples of the aliphatic heterocyclic group include an oxirane group, a thiirane group, a pyrrolidine group, a piperidine group, a tetrahydrofuran group, a tetrahydrothiophene group, a thiane group, a tetrahydropyran group, a 1,4-dioxane group, and the like, but are not limited to thereto.

Herein, a heteroaryl group may contain at least one of B, O, N, P, Si, or S as a hetero atom. When the heteroaryl group contains two or more hetero atoms, the two or more hetero atoms may be the same as or different from each other. The heteroaryl group may be a monocyclic heteroaryl group or a polycyclic heteroaryl group. The number of ring-forming carbon atoms in the heteroaryl group may be 2 to 60, 2 to 30, 2 to 20, or 2 to 10. Examples of the heteroaryl group include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzoimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, or the like, but are not limited thereto.

Herein, the above description of the aryl group may also apply to an arylene group, except that the arylene group is a divalent group. The above description of the heteroaryl group may also apply to a heteroarylene group, except that the heteroarylene group is a divalent group.

Herein, a silyl group includes an alkyl silyl group and an aryl silyl group. Examples of the silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and the like, but are not limited thereto.

Herein, the number of carbon atoms in a carbonyl group is not particularly limited, but may be 1 to 40, 1 to 30, or 1 to 20. For example, the carbonyl group may have the following structure, but is not limited thereto.

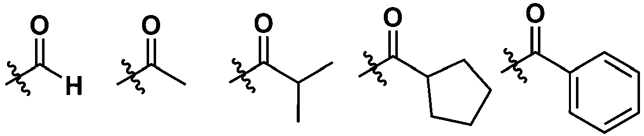

Herein, the number of carbon atoms in a sulfinyl group and a sulfonyl group is not particularly limited, but may be 1 to 30. The sulfinyl group may include an alkyl sulfinyl group and an aryl sulfinyl group. The sulfonyl group may include an alkyl sulfonyl group and an aryl sulfonyl group.

Herein, a thio group may include an alkyl thio group and an aryl thio group. The thio group may indicate the one that a sulfur atom is bonded to the alkyl group or the aryl group as defined above. Examples of the thio group include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, and the like, but are not limited to thereto.

Herein, an oxy group may indicate the one that an oxygen atom is bonded to the alkyl group or the aryl group as defined above. The oxy group may include an alkoxy group and an aryl oxy group. The alkoxy group may be linear, branched, or cyclic. The number of carbon atoms in the alkoxy group is not particularly limited, but may be, for example, 1 to 20, or 1 to 10. Examples of the oxy group include methoxy, ethoxy, n-propoxy, isopropoxy, butoxy, pentyloxy, hexyloxy, octyloxy, nonyloxy, decyloxy, benzyloxy, and the like, but are not limited thereto.

Herein, a boron group may indicate the one that a boron atom is bonded to the alkyl group or the aryl group as defined above. The boron group includes an alkyl boron group and an aryl boron group. Examples of the boron group include a dimethylboron group, a diethylboron group, a t-butylmethylboron group, a diphenylboron group, a phenylboron group, and the like, but are not limited thereto.

Herein, the number of carbon atoms in an amine group is not particularly limited, but may be 1 to 50, 1 to 30, or 1 to 20. The amine group may include an alkyl amine group and an aryl amine group. Examples of the amine group include a methylamine group, a dimethylamine group, a phenylamine group, a diphenylamine group, a naphthylamine group, a 9-methyl-anthracenylamine group, and the like, but are not limited thereto.

Herein, the above-described examples of the alkyl group also apply to an alkyl group from an alkylthio group, an alkyl sulfoxy group, an alkylaryl group, an alkylamino group, an alkyl boron group, an alkyl silyl group, and an alkyl amine group.

Herein, the above-described examples of the aryl group also apply to an aryl group from an aryloxy group, an arylthio group, an aryl sulfoxy group, an arylamino group, an aryl boron group, an aryl silyl group, and an aryl amine group.

Herein, the phosphine oxide group may be substituted with, for example, at least one of the alkyl groups or aryl groups described above.

Herein, the phosphine sulfide group may be substituted with, for example, at least one of the alkyl groups or aryl groups described above.

Herein, a direct linkage may indicate a single bond. Herein, 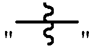 and "-*" indicate positions to be connected.

Hereinafter, some example embodiments of the inventive concepts will be described with reference to the accompanying drawings.

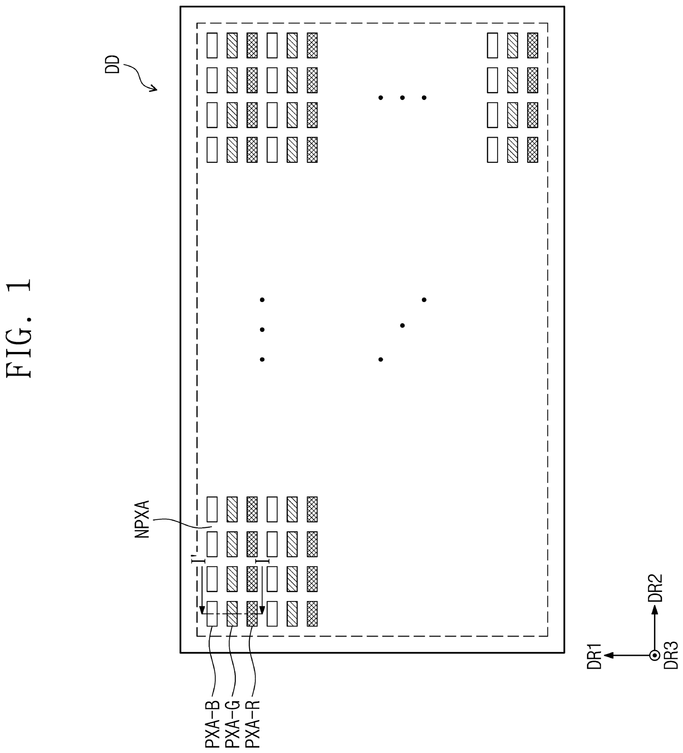

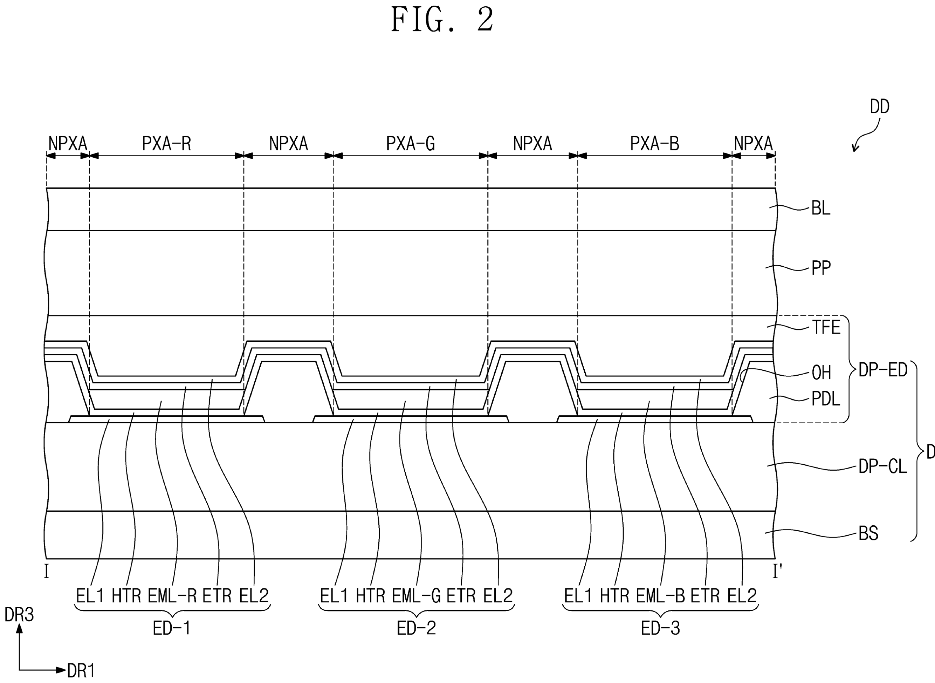

FIG. 1 is a plan view showing at least one example embodiment of a display device DD. FIG. 2 is a cross-sectional view showing a display device DD of at least one example embodiment. FIG. 2 is a cross-sectional view showing a portion corresponding to line I-I' of FIG. 1.

The display device DD may include a display panel DP and an optical layer PP disposed on the display panel DP. The display panel DP includes light-emitting elements ED-1, ED-2, and ED-3. The display device DD may include a plurality of light-emitting elements ED-1, ED-2, and ED-3. The optical layer PP may be disposed on the display panel DP to control reflected light in the display panel DP due to external light. The optical layer PP may include, for example, a polarizing layer or a color filter layer. Unlike what is shown in the drawings, the optical layer PP may not be provided in the display device DD of at least one example embodiment.

A base substrate BL may be disposed on the optical layer PP. The base substrate BL may be a member providing a base surface on which the optical layer PP is disposed. The base substrate BL may be a glass substrate, a metal substrate, a plastic substrate, and the like. However, example embodiments are not limited thereto, and the base substrate BL may be an inorganic layer, an organic layer, or a composite material layer. In addition, unlike what is shown, the base substrate BL may not be provided in at least one example embodiment.

The display device DD according to at least one example embodiment may further include a filling layer (not shown). The filling layer (not shown) may be disposed between a display element layer DP-ED and the base substrate BL. The filling layer (not shown) may be an organic material layer. The filling layer (not shown) may include at least one of an acrylic resin, a silicone-based resin, or an epoxy-based resin.

The display panel DP may include a base layer BS, a circuit layer DP-CL provided on the base layer BS, and a display element layer DP-ED. The display element layer DP-ED may include pixel defining films PDL, a plurality of light-emitting elements ED-1, ED-2, and ED-3 disposed between the pixel defining films PDL, and an encapsulation layer TFE disposed on the plurality of light-emitting elements ED-1, ED-2, and ED-3.

The base layer BS may be a member providing a base surface on which the display element layer DP-ED is disposed. The base layer BS may be a glass substrate, a metal substrate, a plastic substrate, and the like. However, the example embodiments are not limited thereto, and the base layer BS may be an inorganic layer, an organic layer, or a composite material layer.

In at least one example embodiment, the circuit layer DP-CL may be disposed on the base layer BS, and the circuit layer DP-CL may include a plurality of transistors (not shown). The transistors (not shown) may each include a control electrode, an input electrode, and an output electrode. For example, the circuit layer DP-CL may include a switching transistor and a driving transistor for driving the light-emitting elements ED-1, ED-2 and ED-3 of the display element layer DP-ED.

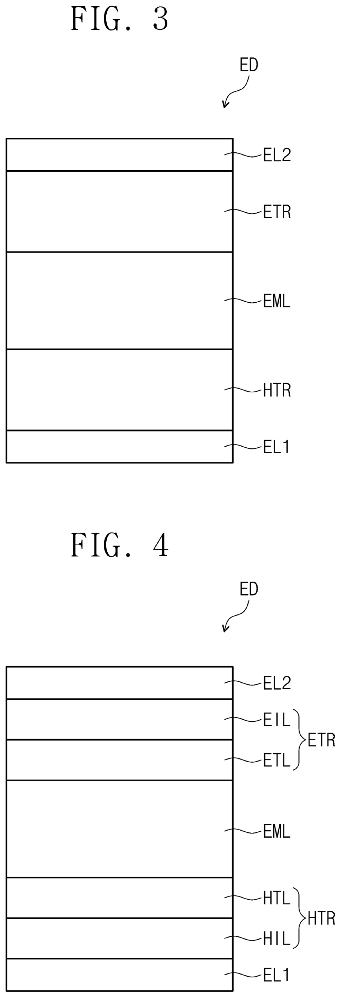

The light-emitting elements ED-1, ED-2, and ED-3 may each have a structure of a light-emitting element ED of at least one example embodiment from FIGS. 3 to 6, which will be described later. The light-emitting elements ED-1, ED-2, and ED-3 may each include a first electrode EL1, a hole transport region HTR, emission layers EML-R, EML-G, and EML-B, an electron transport region ETR, and a second electrode EL2.

FIG. 2 shows at least one example embodiment in which the emission layers EML-R, EML-G, and EML-B of the light-emitting elements ED-1, ED-2, and ED-3 are disposed in openings OH defined in the pixel defining films PDL, and the hole transport region HTR, the electron transport region ETR, and the second electrode EL2 are provided as a common layer throughout the light-emitting elements ED-1, ED-2, and ED-3. However, the example embodiments are not limited thereto, and unlike what is shown in FIG. 2, in at least one example embodiment, the hole transport region HTR and the electron transport region ETR may be provided to be patterned inside the openings OH defined in the pixel defining films PDL. For example, in at least one example embodiment, the hole transport region HTR, the emission layers EML-R, EML-G, and EML-B, and the electron transport region ETR of the light-emitting elements ED-1, ED-2, and ED-3 may be patterned and provided through an inkjet printing method.

The encapsulation layer TFE may cover the light-emitting elements ED-1, ED-2 and ED-3. The encapsulation layer TFE may seal the display element layer DP-ED. The encapsulation layer TFE may be a thin film encapsulation layer. The encapsulation layer TFE may be a single layer or a stack layer of a plurality of layers. The encapsulation layer TFE may include at least one insulating layer. The encapsulation layer TFE according to at least one example embodiment may include at least one inorganic film (hereinafter, an encapsulation inorganic film). In addition, the encapsulation layer TFE according to at least one example embodiment may include at least one organic film (hereinafter, an encapsulation organic film) and at least one encapsulation inorganic film.

The encapsulation inorganic film is configured to protect the display element layer DP-ED from moisture/oxygen, and the encapsulation organic film protects the display element layer DP-ED from foreign substances such as dust particles. The encapsulation inorganic film may include silicon nitride, silicon oxy nitride, silicon oxide, titanium oxide, aluminium oxide, and the like, but is not particularly limited thereto. The encapsulation organic film may include an acrylic compound, an epoxy-based compound, and the like. The encapsulation organic film may include a photopolymerizable organic material, and is not particularly limited.

The encapsulation layer TFE may be disposed on the second electrode EL2, and may be disposed to fill the openings OH.

Referring to FIGS. 1 and 2, the display device DD may include non-light emitting regions NPXA and light emitting regions PXA-R, PXA-G, and PXA-B. The light emitting regions PXA-R, PXA-G, and PXA-B may each be a region emitting light generated from each of the light-emitting elements ED-1, ED-2, and ED-3. The light emitting regions PXA-R, PXA-G, and PXA-B may be spaced apart from each other when viewed on a plane.

The light emitting regions PXA-R, PXA-G, and PXA-B may each be a region separated by the pixel defining films PDL. The non-light emitting regions NPXA may be regions between neighboring light emitting regions PXA-R, PXA-G, and PXA-B, and may correspond to the pixel defining films PDL. Herein, the light emitting regions PXA-R, PXA-G, and PXA-B may each correspond to a pixel. The pixel defining films PDL may separate the light-emitting elements ED-1, ED-2 and ED-3. The emission layers EML-R, EML-G, and EML-B of the light-emitting elements ED-1, ED-2 and ED-3 may be disposed in the openings OH defined by the pixel defining films PDL and thus be separated.

The light emitting regions PXA-R, PXA-G, and PXA-B may be divided into a plurality of groups according to the color of light generated from the light-emitting elements ED-1, ED-2, and ED-3. In the display device DD of at least one example embodiment shown in FIGS. 1 and 2, three light emitting regions PXA-R, PXA-G, and PXA-B which emit red light, green light, and blue light, are shown as an example. For example, the display device DD of at least one example embodiment may include a red light emitting region PXA-R, a green light emitting region PXA-G, and a blue light emitting region PXA-B, which are distinct from one another.

In the display device DD according to at least one example embodiment, the plurality of light-emitting elements ED-1, ED-2, and ED-3 may emit light having different wavelength ranges. For example, in at least one example embodiment, the display device DD may include a first light-emitting element ED-1 emitting red light, a second light-emitting element ED-2 emitting green light, and a third light-emitting element ED-3 emitting blue light. That is, the red light emitting region PXA-R, the green light emitting region PXA-G, and the blue light emitting region PXA-B of the display device DD may correspond to the first light-emitting element ED-1, the second light-emitting element ED-2, and the third light-emitting element ED-3, respectively.

However, the example embodiments are not limited thereto, and the first to third light-emitting elements ED-1, ED-2 and ED-3 may emit light in the same wavelength range or emit light in at least one different wavelength range. For example, the first to third light-emitting elements ED-1, ED-2, and ED-3 may all emit blue light.

The light emitting regions PXA-R, PXA-G, and PXA-B in the display device DD according to at least one example embodiment may be arranged in the form of a stripe. Referring to FIG. 1, a plurality of red light emitting regions PXA-R, a plurality of green light emitting regions PXA-G, and a plurality of blue light emitting regions PXA-B may each be arranged along a second directional axis DR2. Alternatively, the red light emitting region PXA-R, the green light emitting region PXA-G, and the blue light emitting region PXA-B may be alternately arranged in that order along a first directional axis DR1.

FIGS. 1 and 2 show that the light emitting regions PXA-R, PXA-G, and PXA-B are all similar in size, but the example embodiments are not limited thereto, and the light emitting regions PXA-R, PXA-G, and PXA-B may be different in size from each other according to wavelength range of emitted light. The areas of the light emitting regions PXA-R, PXA-G, and PXA-B may indicate areas when viewed on a plane defined by the first directional axis DR1 and the second directional axis DR2.

The arrangement of the light emitting regions PXA-R, PXA-G, and PXA-B is not limited to what is shown in FIG. 1, and the order in which the red light emitting region PXA-R, the green light emitting region PXA-G, and the blue light emitting region PXA-B are arranged comes with varied combination according to display quality characteristics required for the display device DD. For example, the light emitting regions PXA-R, PXA-G, and PXA-B may be arranged in the form of a pentile (PENTILE^{™}) or a diamond (Diamond Pixel^{™}).

In addition, areas of each of the light emitting regions PXA-R, PXA-G, and PXA-B may be different in size from one another. For example, in at least one example embodiment, the green light emitting region PXA-G may be smaller than the blue light emitting region PXA-B in size, but the example embodiments are not limited thereto.

Hereinafter, FIGS. 3 to 6 are cross-sectional views schematically showing a light-emitting element according to at least one example embodiment. FIG. 3 shows a light-emitting element ED according to at least one example embodiment, including a first electrode EL1, a hole transport region HTR, an emission layer EML, an electron transport region ETR, and a second electrode EL2, which are sequentially stacked.

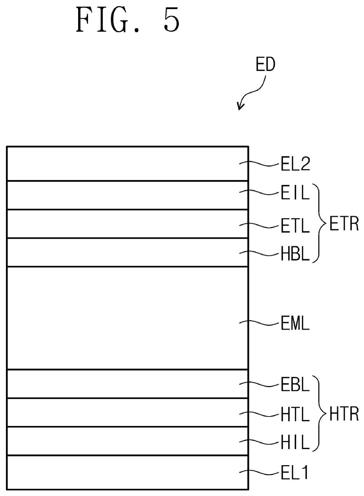

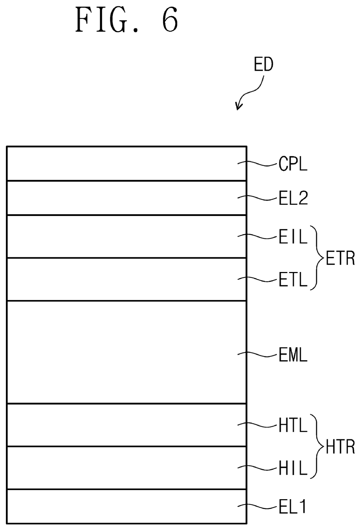

FIG. 4 shows, compared with FIG. 3, a cross-sectional view of a light-emitting element ED of at least one example embodiment in which the hole transport region HTR includes a hole injection layer HIL and a hole transport layer HTL, and the electron transport region ETR includes an electron injection layer EIL and an electron transport layer ETL. In addition, FIG. 5 shows, compared with FIGS. 3 and 4, a cross-sectional view of a light-emitting element ED of at least one example embodiment, in which the hole transport region HTR includes a hole injection layer HIL, a hole transport layer HTL, and an electron blocking layer EBL, and the electron transport region ETR includes an electron injection layer EIL, an electron transport layer ETL, and a hole blocking layer HBL. FIG. 6 shows, compared with FIG. 4, a cross-sectional view of a light-emitting element ED of at least one example embodiment, in which a capping layer CPL disposed on the second electrode EL2 is provided.

The first electrode EL1 is configured to have conductivity. For example, the electrode EL1 may comprise a material having electrical conductivity (or a conductive material). The first electrode EL1 may be formed of a metal material, a metal alloy, a conductive compound, and the like. The first electrode EL1 may be an anode or a cathode. However, the example embodiments are not limited thereto. In addition, the first electrode EL1 may be a pixel electrode. The first electrode EL1 may be a transmissive electrode, a transflective electrode, a reflective electrode, and the like. The first electrode EL1 may include at least one selected from Ag, Mg, Cu, Al, Pt, Pd, Au, Ni, Nd, Ir, Cr, Li, Ca, LiF, Mo, Ti, W, In, Sn, and Zn, at least two compounds selected therefrom, two or more mixtures selected therefrom, an oxide thereof, and the like.

When the first electrode EL1 is a transmissive electrode, the first electrode EL1 may include a transparent metal oxide such as indium tin oxide (ITO), indium zinc oxide (IZO), zinc oxide (ZnO), and indium tin zinc oxide (ITZO). When the first electrode EL1 is a transflective electrode or a reflective electrode, the first electrode EL1 may include Ag, Mg, Cu, Al, Pt, Pd, Au, Ni, Nd, Ir, Cr, Li, Ca, LiF/Ca (a stack structure of LiF and Ca), LiF/Al (a stack structure of LiF and Al), Mo, Ti, W, a compound thereof, or a mixture thereof (e.g., a mixture of Ag and Mg). Alternatively, the first electrode EL1 may have a multilayer structure including a reflective film or a transflective film formed of the above-described materials, and a transparent conductive film formed of indium tin oxide (ITO), indium zinc oxide (IZO), zinc oxide (ZnO), indium tin zinc oxide (ITZO), and the like. For example, the first electrode EL1 may have a three-layer structure of ITO/Ag/ITO, but the example embodiments are not limited thereto. In addition, the example embodiments are not limited thereto, and the first electrode EL1 may include the above-described metal materials, a combination of two or more metal materials selected from the above-described metal materials, or oxides of the above-described metal materials. The first electrode EL1 may have a thickness of about 700 Å to about 10000 Å. For example, the first electrode EL1 may have a thickness of about 1000 Å to about 3000 Å.

The hole transport region HTR is provided on the first electrode EL1. The hole transport region HTR may include at least one of a hole injection layer HIL, a hole transport layer HTL, a buffer layer or an emission-auxiliary layer (not shown), and an electron blocking layer EBL. The thickness of the hole transport region HTR may be, for example, from about 50 Å to about 15,000 Å.

The hole transport region HTR may have a single layer formed of a single material, a single layer formed of a plurality of different materials, or a multilayer structure including a plurality of layers formed of a plurality of different materials.

For example, the hole transport region HTR may have a single layer structure of the hole injection layer HIL or the hole transport layer HTL, or may have a single layer structure formed of a hole injection material and a hole transport material. In addition, the hole transport region HTR may have a single layer structure formed of a plurality of different materials, or a structure in which a hole injection layer HIL/hole transport layer HTL, a hole injection layer HIL/hole transport layer HTL/buffer layer (not shown), a hole injection layer HIL/buffer layer (not shown), a hole transport layer HTL/buffer layer (not shown), or a hole injection layer HIL/hole transport layer HTL/electron blocking layer EBL are stacked in order from the first electrode EL1, but the embodiment of the inventive concepts is not limited thereto.

The hole transport region HTR may be formed using various methods such as a vacuum deposition method, a spin coating method, a cast method, a Langmuir-Blodgett (LB) method, an inkjet printing method, a laser printing method, and a laser induced thermal imaging (LITI) method.

The hole transport region HTR may include a compound represented by Formula H-1 below:

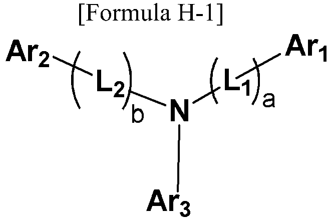

In Formula H-1, L₁ and L₂ may be each independently a direct linkage, a substituted or unsubstituted arylene group having 6 to 30 ring-forming carbon atoms, or a substituted or unsubstituted heteroarylene group having 2 to 30 ring-forming carbon atoms. a and b may be each independently an integer of 0 to 10. When a or b is an integer of 2 or greater, a plurality of L₁'s and L₂'s may be each independently a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ may be each independently a substituted or unsubstituted aryl group having 6 to 30 ring-forming carbon atoms, or a substituted or unsubstituted heteroaryl group having 2 to 30 ring-forming carbon atoms. In addition, in Formula H-1, Ar₃ may be a substituted or unsubstituted aryl group having 6 to 30 ring-forming carbon atoms, or a substituted or unsubstituted heteroaryl group having 2 to 30 ring-forming carbon atoms.

The compound represented by Formula H-1 above may be a monoamine compound. Alternatively, the compound represented by Formula H-1 above may be a diamine compound in which at least one among Ar₁ to Ar₃ includes the amine group as a substituent. In addition, the compound represented by Formula H-1 above may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂.

The compound represented by Formula H-1 may be represented by at least one of the compounds in Compound Group H below. However, the compounds listed in Compound Group H below are examples, and the compounds represented by Formula H-1 are not limited to those represented by Compound Group H below:

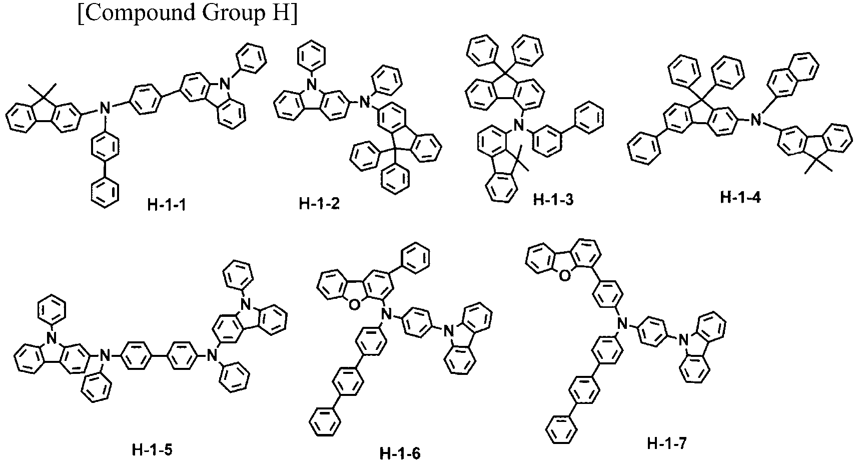

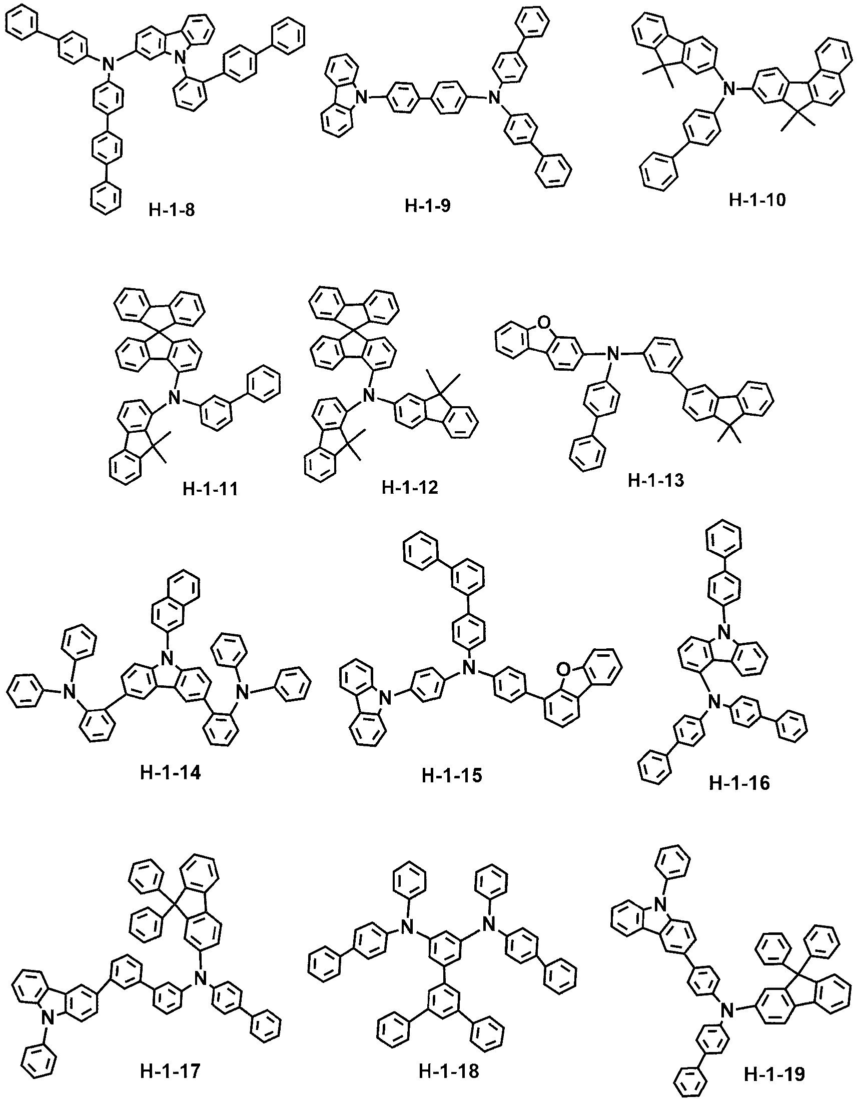

The hole transport region HTR may include a phthalocyanine compound such as copper phthalocyanine; N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalen-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-h]quinoxaline-2,3,6,7,10,11-hexacarbonitrile (HATCN), *etc.*

The hole transport region HTR may include a carbazole-based derivative such as N-phenyl carbazole or polyvinyl carbazole, a fluorene-based derivative, a triphenylamine-based derivative such as N,N'-bis(3-methylphenyl)-N,N'-diphenyl-[1,1-biphenyl]-4,4'-diamine (TPD) or 4,4',4"-tris(N-carbazolyl)triphenylamine (TCTA), N,N'-di(naphthalen-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), 1,3-bis(N-carbazolyl)benzene (mCP), *etc.*

In addition, the hole transport region HTR may include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), *etc.*

The hole transport region HTR may include the above-described compounds of the hole transport region in at least one of a hole injection layer HIL, a hole transport layer HTL, and an electron blocking layer EBL.

The thickness of the hole transport region HTR may be from about 100 Å to about 10,000 Å, for example, from about 100 Å to about 5,000 Å. When the hole transport region HTR includes the hole injection layer HIL, the hole injection layer HIL may have, for example, a thickness of about 30 Å to about 1,000 Å. When the hole transport region HTR includes the hole transport layer HTL, the hole transport layer HTL may have a thickness of about 30 Å to about 1,000 Å. For example, when the hole transport region HTR includes the electron blocking layer EBL, the electron blocking layer EBL may have a thickness of about 10 Å to about 1,000 Å. If the thicknesses of the hole transport region HTR, the hole injection layer HIL, the hole transport layer HTL and the electron blocking layer EBL satisfy the above-described ranges, satisfactory hole transport properties may be achieved without a substantial increase in driving voltage.

The hole transport region HTR may further include a charge generating material to increase conductivity in addition to the above-described materials. The charge generating material may be dispersed uniformly or non-uniformly in the hole transport region HTR. The charge generating material may be, for example, a p-dopant. The p-dopant may include at least one of a halogenated metal compound, a quinone derivative, a metal oxide, or a cyano group-containing compound, but the example embodiments are not limited thereto. For example, the p-dopant may include a metal halide compound such as CuI or RbI, a quinone derivative such as tetracyanoquinodimethane (TCNQ) or 2,3,5,6-tetrafluoro-7,7',8,8'-tetracyanoquinodimethane (F4-TCNQ), a metal oxide such as tungsten oxide or molybdenum oxide, a cyano group-containing compound such as dipyrazino[2,3-f: 2',3'-h] quinoxaline-2,3,6,7,10,11-hexacarbonitrile (HATCN) or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), *etc.,* but the example embodiments are not limited thereto.

As described above, the hole transport region HTR may further include at least one of the buffer layer (not shown) or the electron blocking layer EBL in addition to the hole injection layer HIL and the hole transport layer HTL. The buffer layer (not shown) may compensate for a resonance distance according to the wavelength of light emitted from the emission layer EML and may thus increase emission efficiency. A material that may be included in the hole transport region HTR may be used as a material to be included in the buffer layer (not shown). The electron blocking layer EBL is a layer that serves to protect against (e.g., prevent or reduce the potential for) an electron injection from the electron transport region ETR to the hole transport region HTR.

In at least one example embodiment, the emission layer EML includes a first compound according to at least one example embodiment. The emission layer EML according to at least one example embodiment may further include at least one among second to fourth compounds. The second compound may include a three-ring fused ring system containing a nitrogen atom as a ring-forming atom. The third compound may include a six-membered cyclic group containing at least one nitrogen atom as a ring-forming atom. The fourth compound may include an organometallic complex. The second to fourth compound will be described in more detail later.

In this specification, the first compound may be referred to as a fused polycyclic compound according to at least one example embodiment. The fused polycyclic compound according to at least one example embodiment may include a core structure, a first substituent bonded to the core structure, and a second substituent bonded to the core structure. The fused polycyclic compound according to at least one example embodiment may include a nine-ring fused ring system including four hetero atoms and two boron atoms as ring-forming atoms. The four hetero atoms may each be N, O, or S. The first substituent is a substituted or unsubstituted aryl group having 6 to 60 ring-forming carbon atoms and may be bonded at a para position with respect to the boron atom of the core structure. The second substituent is substituted or unsubstituted alkyl group having 1 to 20 carbon atoms, or an electron-donating group, which may be bonded to another cyclic group different from the cyclic group to which the first substituent is bonded. Therefore, the fused polycyclic compound according to at least one example embodiment may have a sterically bulk and high charge transfer (CT) characteristics, and thus reverse inter system crossing (RISC) may be further accelerated. The fused polycyclic compound according to at least one example embodiment may contribute to improvements in emission efficiency and lifespan of the light-emitting element ED.

The light-emitting element ED according to at least one example embodiment includes a fused polycyclic compound according to at least one example embodiment. The fused polycyclic compound according to at least one example embodiment is represented by Formula 1 below.

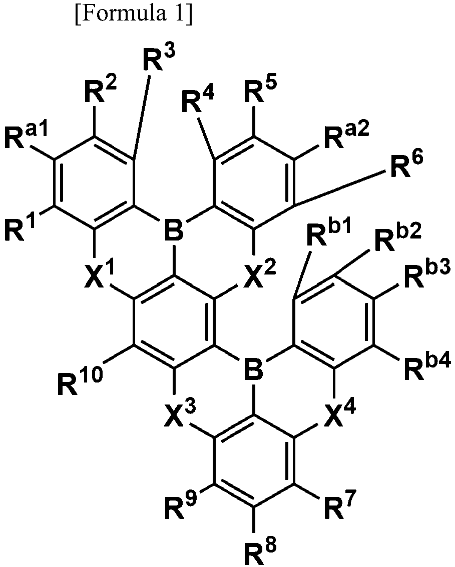

In Formula 1, B represents boron.

In Formula 1, X¹ to X⁴ may correspond to at least one of the above-described four hetero atoms. R^{a1} and R^{a2} may correspond to at least one of the above-described first substituent. At least one among R^{b1} to R^{b4} may correspond to at least one of the above-described second substituent.

For example, in Formula 1, X¹ to X⁴ are each independently O, S, or NR^{y1}. For example, at least one among X¹ to X⁴ may be NR^{y1}.

R^{y1} is a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms or represented by Formula 2 below. For example, R^{y1} may be a substituted or unsubstituted aryl group having 6 to 60 ring-forming carbon atoms or represented by Formula 2 below.

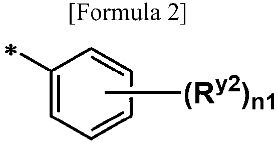

In Formula 2, n1 is an integer of 0 to 5. R^{y2} is a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms.

If n1 is an integer of 2 or greater, a plurality of R^{y2} may all be the same, or at least one among the plurality of R^{y2} may be different from the others. A case where n1 is 0 may be the same as a case where n1 is 5 and five R^{y2} are hydrogen atoms.

R^{y1} may be represented by at least one of Y1-1 to Y1-18 below. Formula 2 may be represented by at least one of Y1-1 to Y1-18 below.

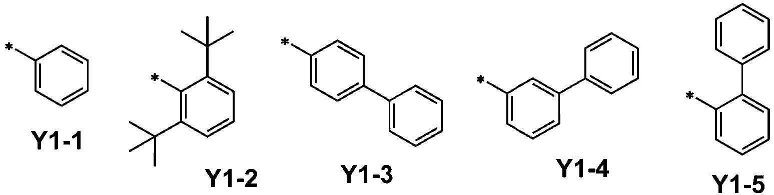

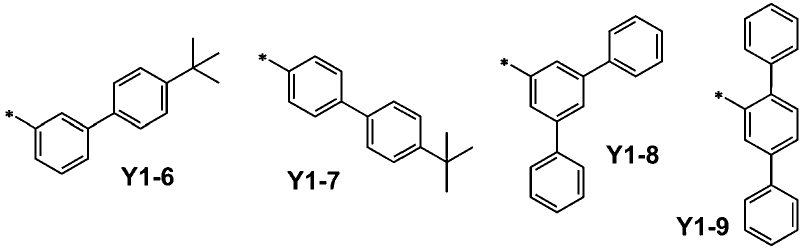

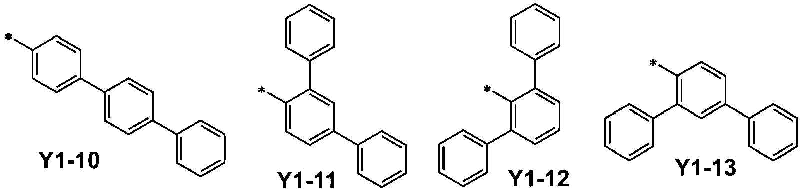

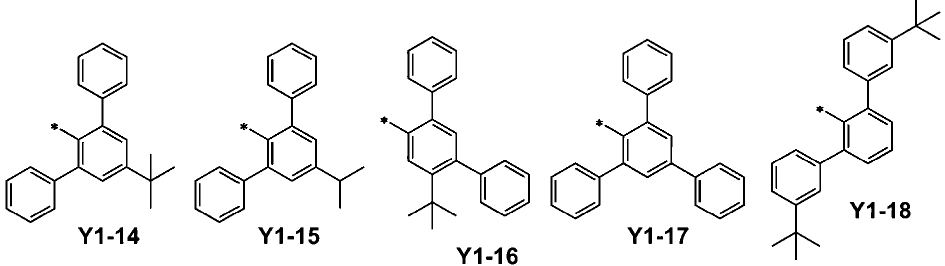

In Formula 1, R¹ to R⁶ and R^{b1} to R^{b4} are each independently a hydrogen atom, a deuterium atom, a halogen atom, a substituted or unsubstituted amine group, a substituted or unsubstituted oxy group, a substituted or unsubstituted thio group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms or bonded to an adjacent group to form a ring, *etc.* For example, R¹ to R⁶ may be each independently a hydrogen atom, a deuterium atom, a substituted or unsubstituted isopropyl group, a substituted or unsubstituted phenyl group, a substituted or unsubstituted biphenyl group, a substituted or unsubstituted naphthyl group, a substituted or unsubstituted dimethylfluorenyl group.

In at least one example embodiment, at least one among R^{b1} to R^{b4} is a substituted or unsubstituted alkyl group having 1 to 20 carbon atoms, or an electron-donating group. The electron-donating group is a substituted or unsubstituted alkoxy group, a substituted or unsubstituted alkylthio group, a substituted or unsubstituted alkylamine group, a substituted or unsubstituted aryloxy group, a substituted or unsubstituted arylthio group, a substituted or unsubstituted arylamine group, or a substituted or unsubstituted carbazole group. Hereinafter, for convenience of explanation, at least one among R^{b1} to R^{b4} is referred to as the 'second substituent'.

For example, the second substituent may be a substituted or unsubstituted methyl group, a substituted or unsubstituted ethyl group, a substituted or unsubstituted isopropyl group, a substituted or unsubstituted n-butyl group, a substituted or unsubstituted t-butyl group, a substituted or unsubstituted cyclopentyl group, a substituted or unsubstituted cyclohexyl group, a substituted or unsubstituted methoxy group, a substituted or unsubstituted propyloxy group, a substituted or unsubstituted isopropyloxy, a substituted or unsubstituted t-butyloxy group, a substituted or unsubstituted cyclohexyloxy group, a substituted or unsubstituted phenyloxy group, a substituted or unsubstituted dimethylamine group, a substituted or unsubstituted ethylamine group, a substituted or unsubstituted N-methylphenylamine group, a substituted or unsubstituted N-propylphenylamine group, a substituted or unsubstituted diphenylamine group, a substituted or unsubstituted methylthio group, a substituted or unsubstituted isopropylthio group, a substituted or unsubstituted propylthio group, a substituted or unsubstituted t-butylthio group, a substituted or unsubstituted phenylthio group, or a substituted or unsubstituted carbazole group. The second substituent may be represented by at least one of Rb-1 to Rb-45 below.

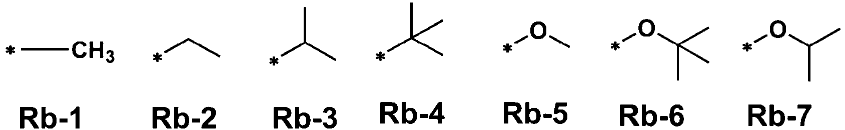

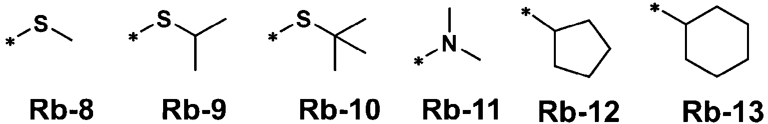

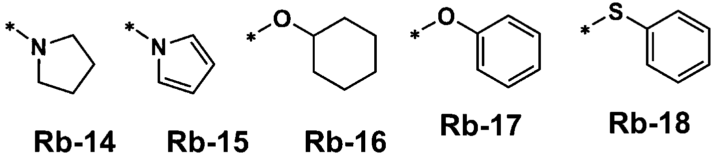

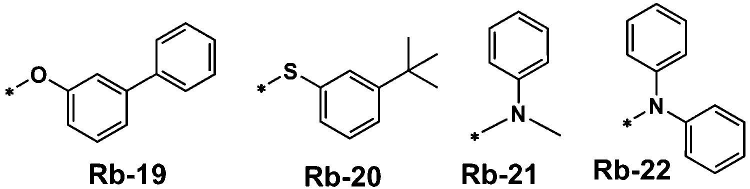

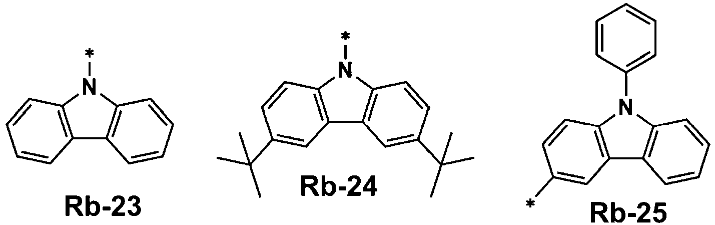

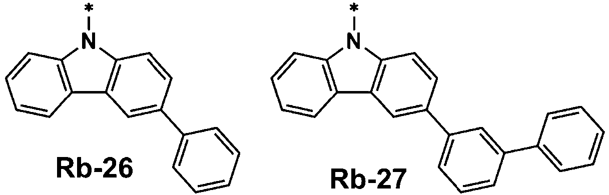

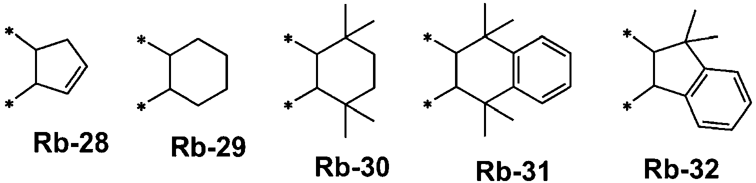

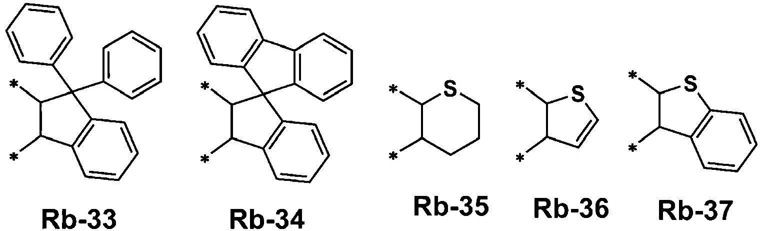

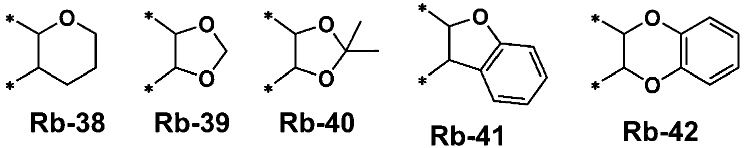

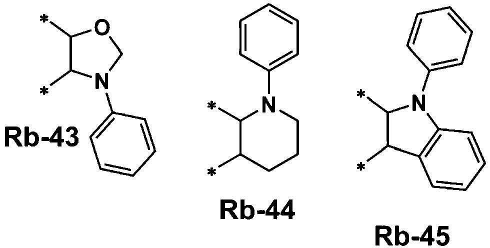

In Rb-28 to Rb-45, two *- may be positions corresponding to two groups adjacent to each other among R^{b1} to R^{b4}. R^{b1} and R^{b2} may be two groups adjacent to each other. R^{b2} and R^{b3} may be two groups adjacent to each other. R^{b3} and R^{b4} may be two groups adjacent to each other. For example, in Rb-30, two *- may be positions corresponding to R^{b3} and R^{b4}, respectively. In Rb-31, two *- may be positions corresponding to R^{b2} and R^{b3}, respectively.

For example, the other which is not the second substituent among R^{b1} to R^{b4}, may be each independently a hydrogen atom, a deuterium atom, a substituted or unsubstituted phenyl group, or a substituted or unsubstituted dibenzofuran group. However, this is an example, and the example embodiments are not limited thereto.

In Formula 1, R⁷ to R¹⁰, R^{a1}, and R^{a2} are each independently a hydrogen atom, a deuterium atom, a cyano group, a halogen atom, a substituted or unsubstituted amine group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms. For example, R⁷ to R¹⁰ may be each independently a hydrogen atom, a deuterium atom, a substituted or unsubstituted t-butyl group, a substituted or unsubstituted phenyl group, or a substituted or unsubstituted terphenyl group.

In at least one example embodiment, one among R^{a1} and R^{a2} is a substituted or unsubstituted aryl group having 6 to 60 ring-forming carbon atoms. Hereinafter, for convenience of explanation, the one among R^{a1} and R^{a2} is referred to as the "first substituent'. The first substituent may be represented by at least one of Ra-1 to Ra-5 below. In Ra-2 below, D is a deuterium atom. The other which is not the first substituent among R^{a1} and R^{a2} may be a hydrogen atom, a deuterium atom, a cyano group, a substituted or unsubstituted diphenylamine group, or a substituted or unsubstituted carbazole group.

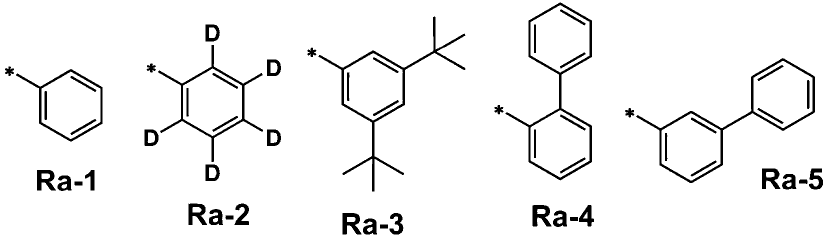

In Formula 1, when R^{b2} and R^{b3} are bonded to each other to form a moiety represented by Formula RB below, the first substituent is an unsubstituted aryl group having 6 to 60 ring-forming carbon atoms. In Formula RB below, b2 is a position corresponding to R^{b2}, and b3 is a position corresponding to R^{b3}.

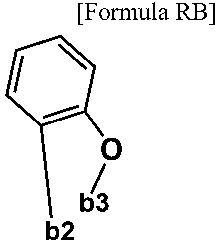

Formula RB may be a moiety included in Rb-41 described previously. For example, in Rb-41, when ***** adjacent to a carbon atom among two * is positioned at R^{b2}, and *- adjacent to an oxygen atom is positioned at R^{b3}, the first substituent may be an unsubstituted aryl group having 6 to 60 ring-forming carbon atoms.

The fused polycyclic compound according to at least one example embodiment may include a chemical structure in which any hydrogen atom in a molecule is substituted with a deuterium atom. For example, at least one of the hydrogen atoms may be optionally substituted with a deuterium atom. In at least one example embodiment, at least one of the hydrogen atoms is substituted with a deuterium atom. The fused polycyclic compound according to at least one example embodiment may include a deuterium atom directly bonded to the core structure or may include a substituent which is directly bonded to the core structure and substituted with a deuterium atom. In Formula 1, at least one among R¹ to R¹⁰, R^{a1}, R^{a2}, R^{b1} to R^{b4}, and R^{y1} may be a deuterium atom, or may include a substituent substituted with a deuterium atom. For example, in Formula 1, at least one among R¹ to R⁶, R^{a1}, and R^{a2} may be a phenyl group substituted with a deuterium atom. However, this is an example, and the example embodiments are not limited thereto.

In at least one example embodiment, Formula 1 may be represented by at least one of Formula 1-A1 to Formula 1-A6 below. Formula 1-A1 to Formula 1-A6 indicate cases where X¹ to X⁴ in Formula 1 are specified. Formula 1-A1 may indicate a case where X¹ to X⁴ are each independently NR^{y1} in Formula 1. Formula 1-A2 may indicate a case where X¹, X³, and X⁴ are each independently NR^{y1}, and X² is O or S in Formula 1. Formula 1-A3 may indicate a case where X³ and X⁴ are each independently NR^{y1}, and X¹ and X² are each independently O or S in Formula 1. Formula 1-A4 may indicate a case where X¹ is NR^{y1}, and X² to X⁴ are each independently O or S in Formula 1. Formula 1-A5 may indicate a case where X⁴ is NR^{y1}, and X¹ to X³ are each independently O or S in Formula 1. Formula 1-A6 may indicate a case where X³ is NR^{y1}, and X¹, X², and X⁴ are each independently O or S in Formula 1.

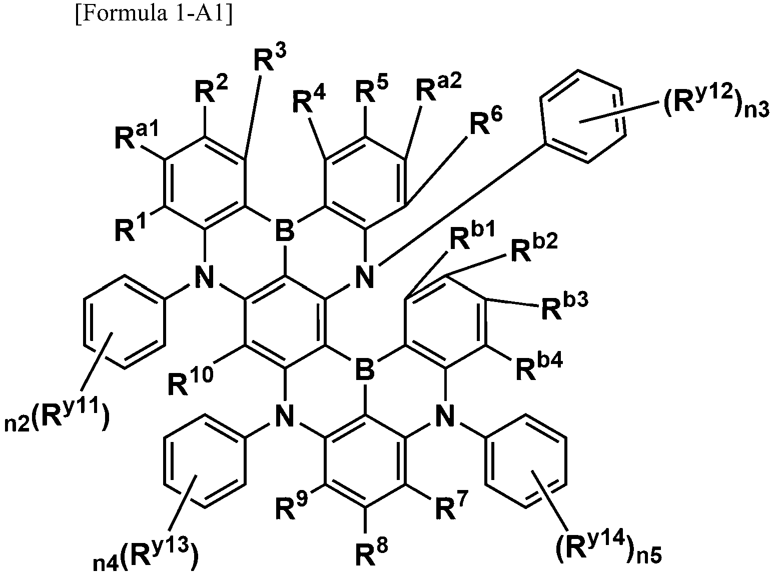

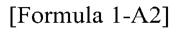

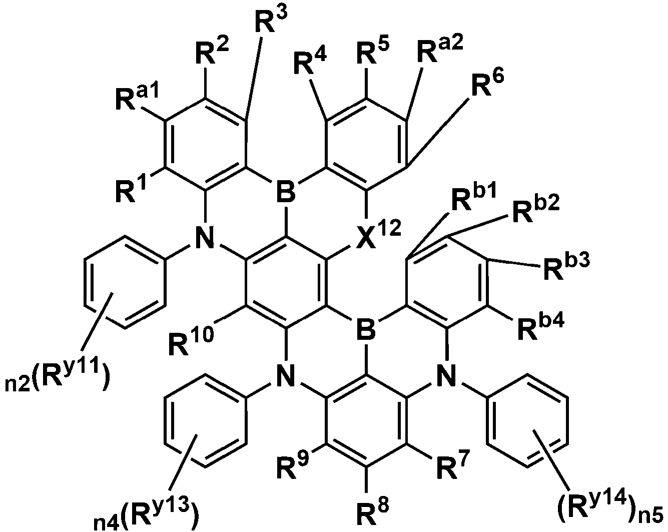

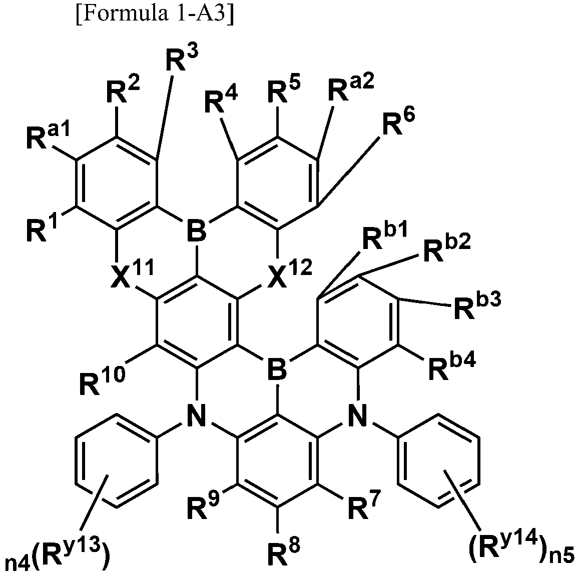

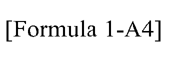

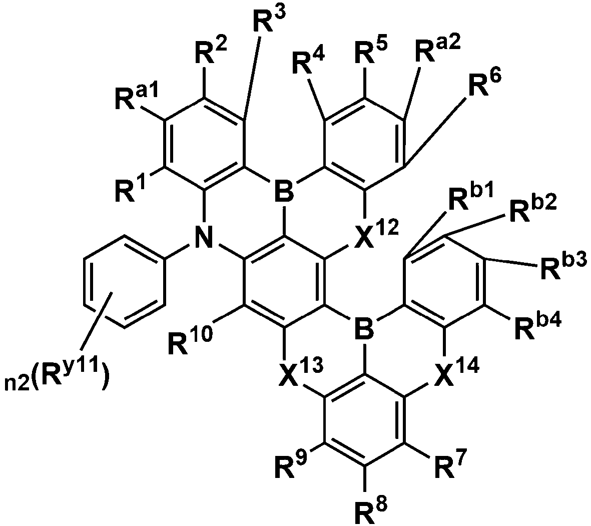

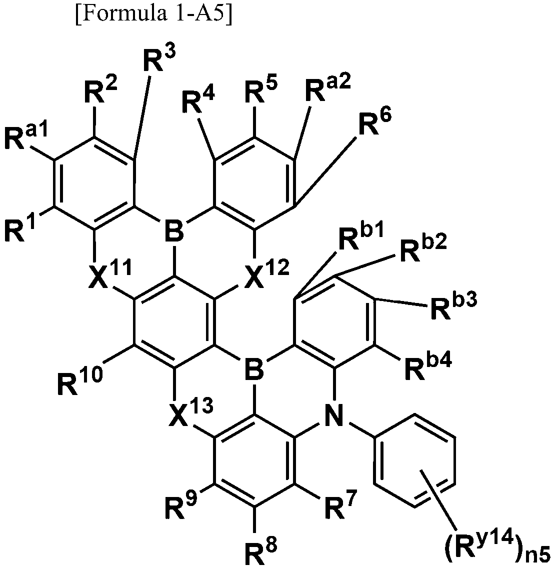

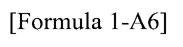

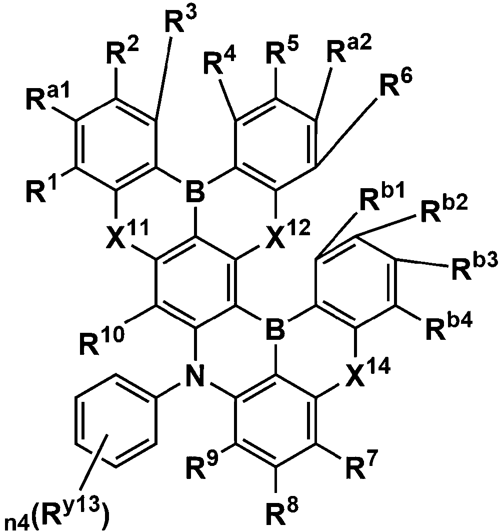

The details described in Formula 1 above may be applied to R¹ to R⁶, R^{b1} to R^{b4}, R⁷ to R¹⁰, R^{a1} , and R^{a2} in Formula 1-A1 to Formula 1-A6. X¹¹ to X¹⁴ may be each independently O or S. For example, in Formula 1-A6, X¹¹, X¹², and X¹⁴ may be O.

In Formula 1-A1 to Formula 1-A6, n2 to n5 may be each independently an integer of 0 to 5. R^{y11} to R^{y14} may be each independently a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms. In Formula 1-A1 to Formula 1-A6, a cyclic group including R^{y11}, a cyclic group including R^{y12} , a cyclic group including R^{y13}, and a cyclic group including R^{y14} may be each independently represented by at least one of Y1-1 to Y1-18 described previously.

If n2 is an integer of 2 or greater, a plurality of R^{y11} may all be the same, or at least one of the plurality of R^{y11} may be different from the others. A case where n2 is 0 may be the same as a case where n2 is 5, and five R^{y11} are hydrogen atoms. If n3 is an integer of 2 or greater, a plurality of R^{y12} may all be the same, or at least one of the plurality of R^{y12} may be different from the others. A case where n3 is 0 may be the same as a case where n3 is 5, and five R^{y12} are hydrogen atoms.

If n4 is an integer of 2 or greater, a plurality of R^{y13} may all be the same, or at least one of the plurality of R^{y13} may be different from the others. A case where n4 is 0 may be the same as a case where n4 is 5, and five R^{y13} are hydrogen atoms. If n5 is an integer of 2 or greater, a plurality of R^{y14} may all be the same, or at least one of the plurality of R^{y14} may be different from the others. A case where n5 is 0 may be the same as a case where n5 is 5, and five R^{y14} are hydrogen atoms.

Formula 1 may be represented by at least one of the compounds in Compound Group 1 below. The fused polycyclic compound according to at least one example embodiment may be represented by at least one of the compounds in Compound Group 1 below. The light-emitting element ED according to at least one example embodiment may include at least one among the compounds in Compound Group 1 below. The emission layer EML may include at least one among the compounds in Compound Group 1 below. In Compound Group 1 below, D is a deuterium atom. In Compound Group 1 below, OMe is a methoxy group, and SMe is a methylthio group.

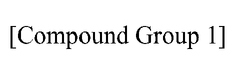

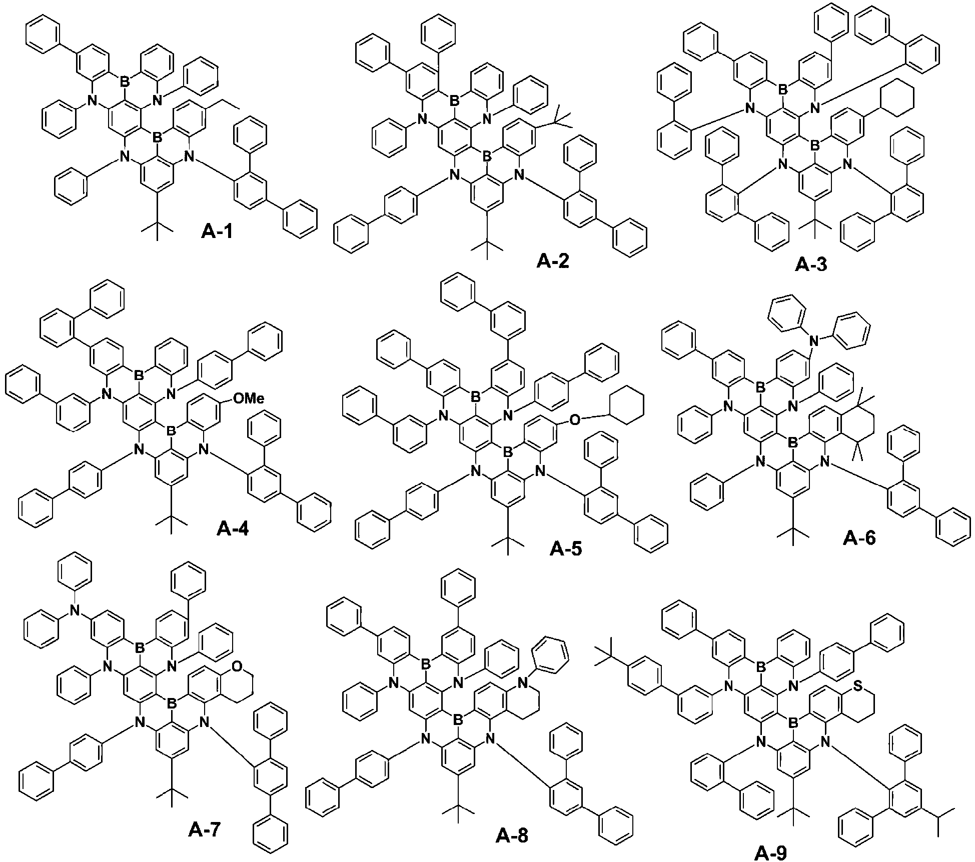

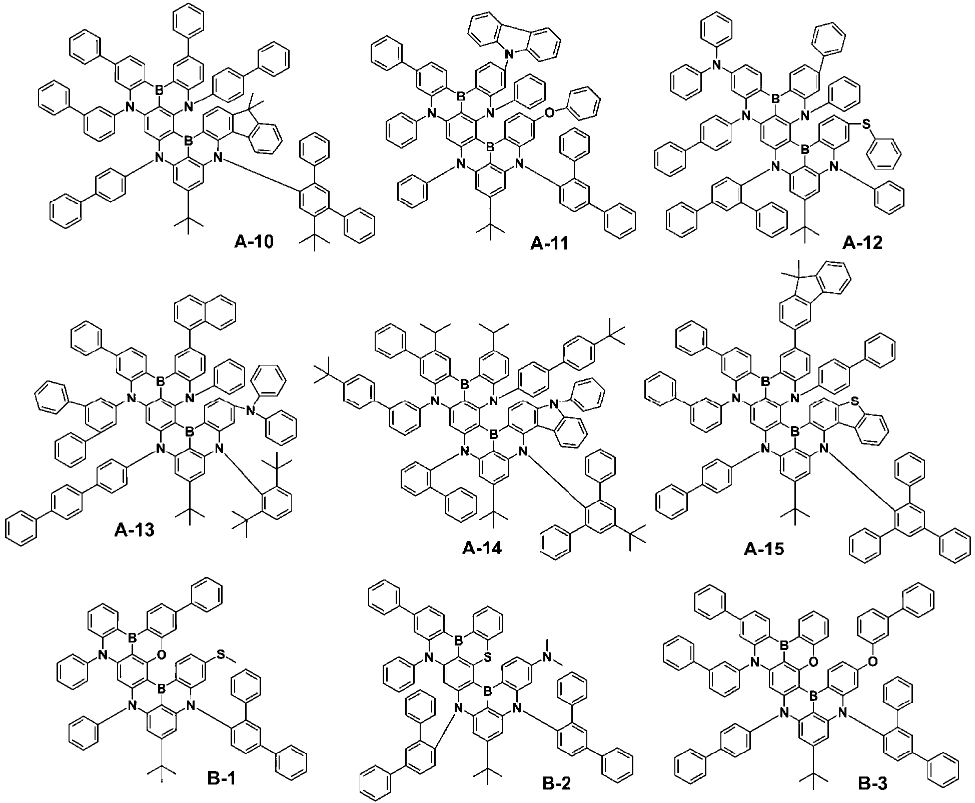

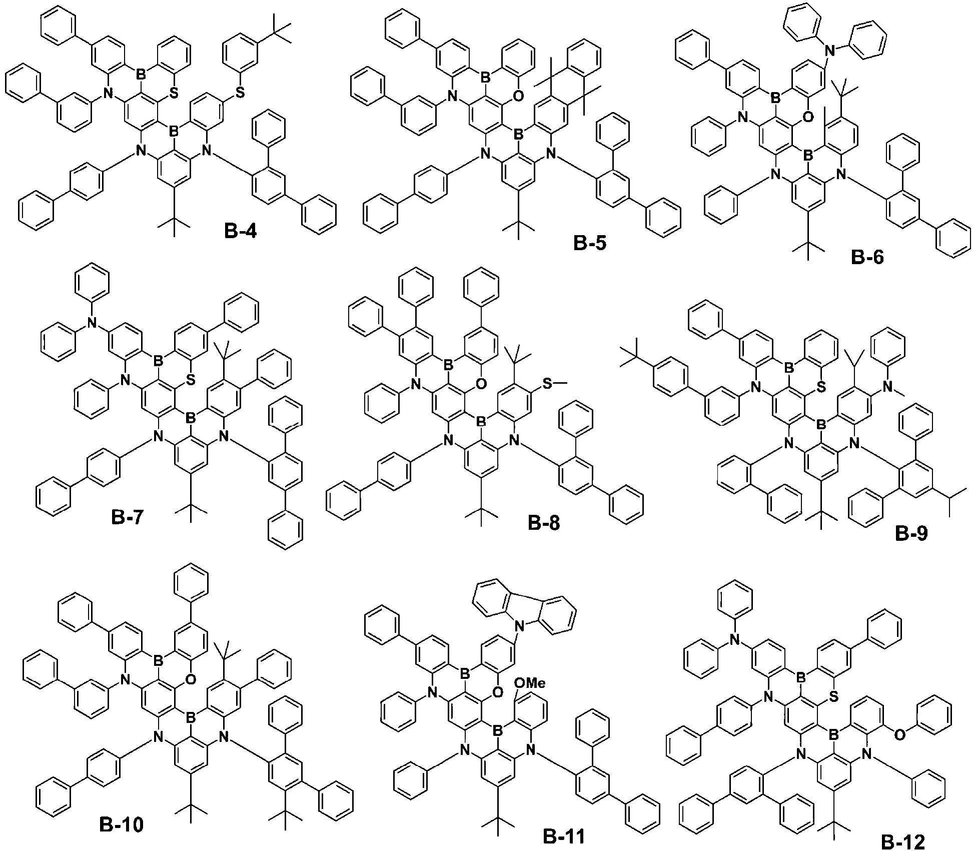

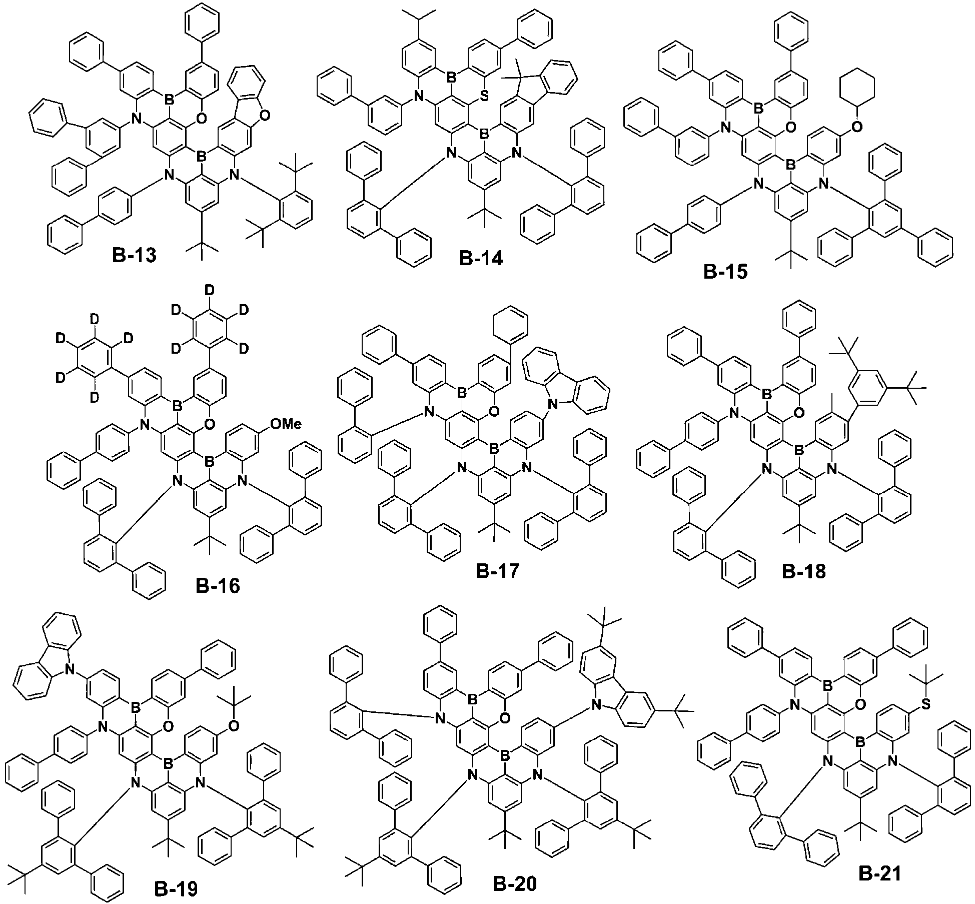

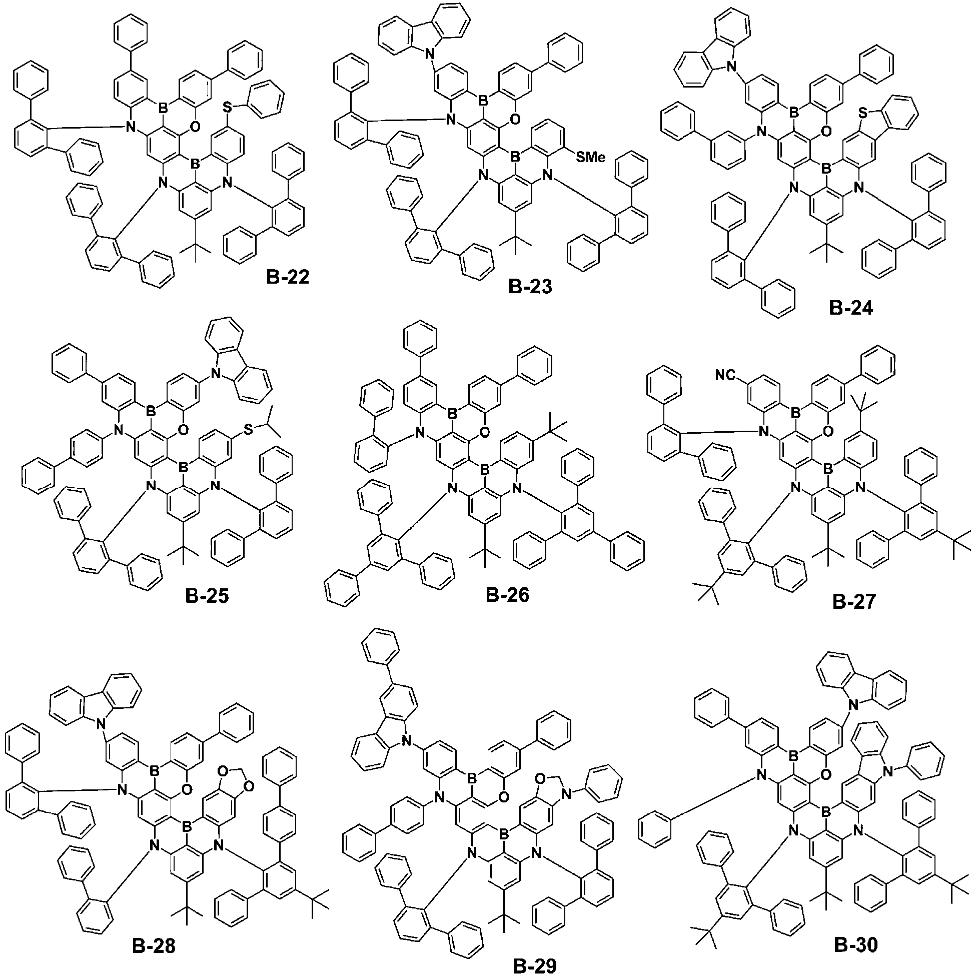

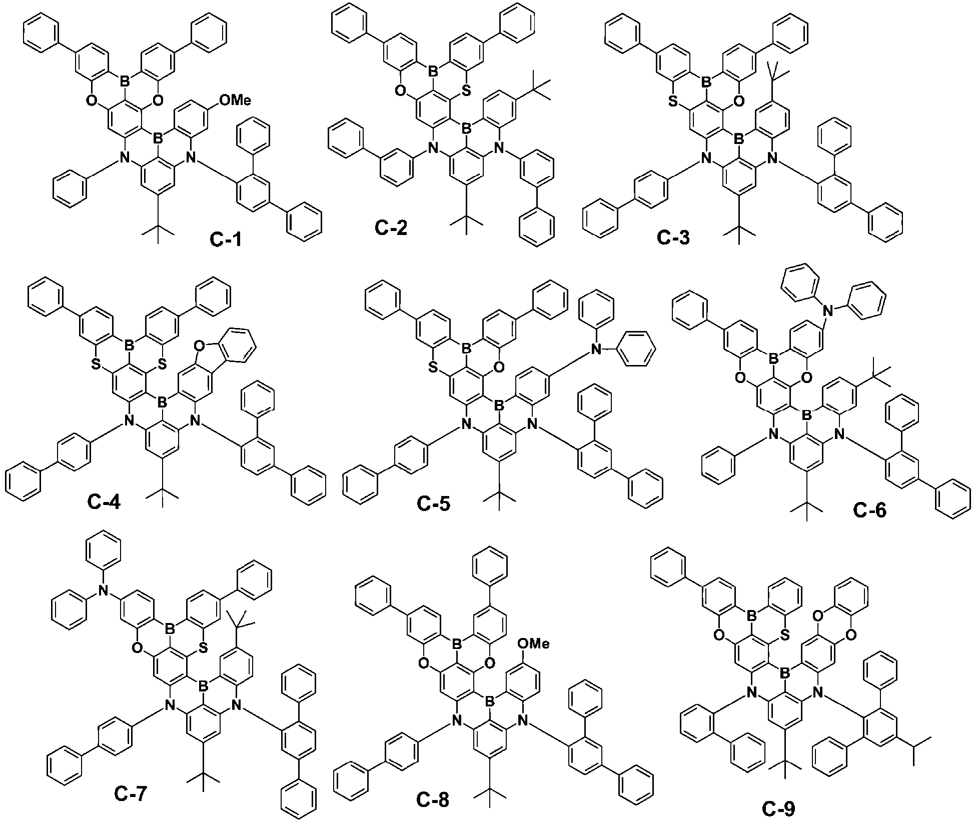

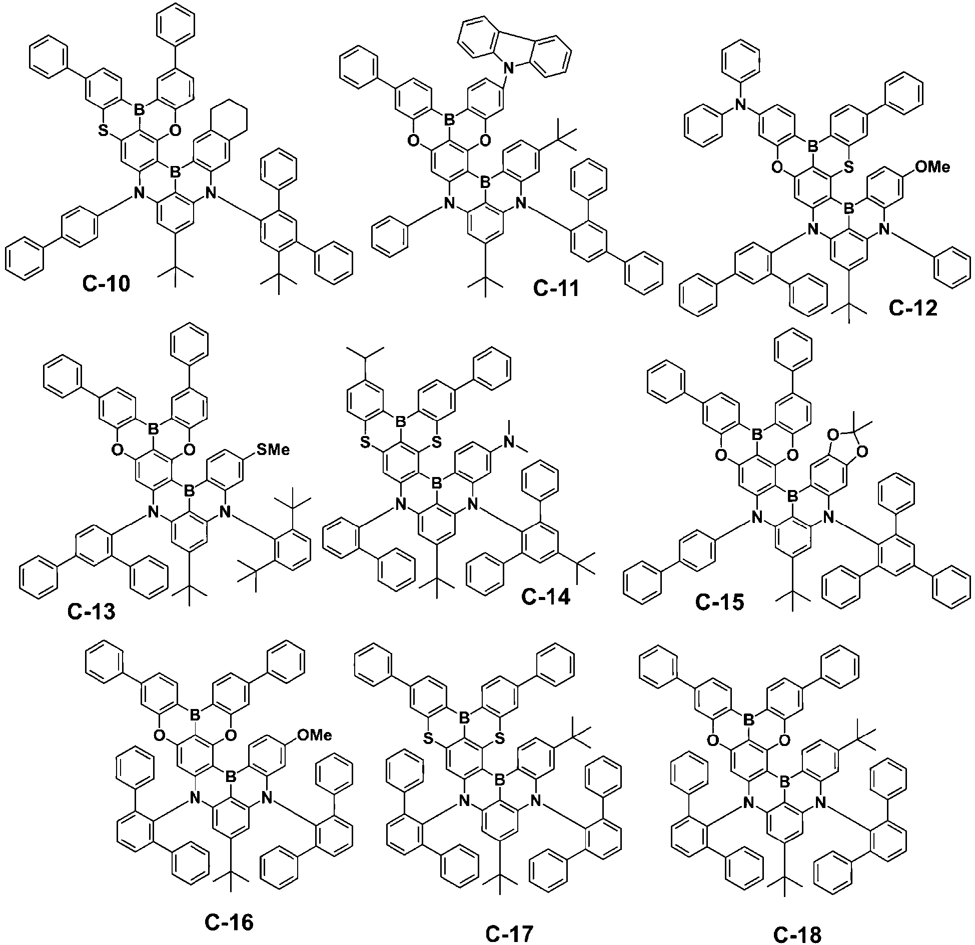

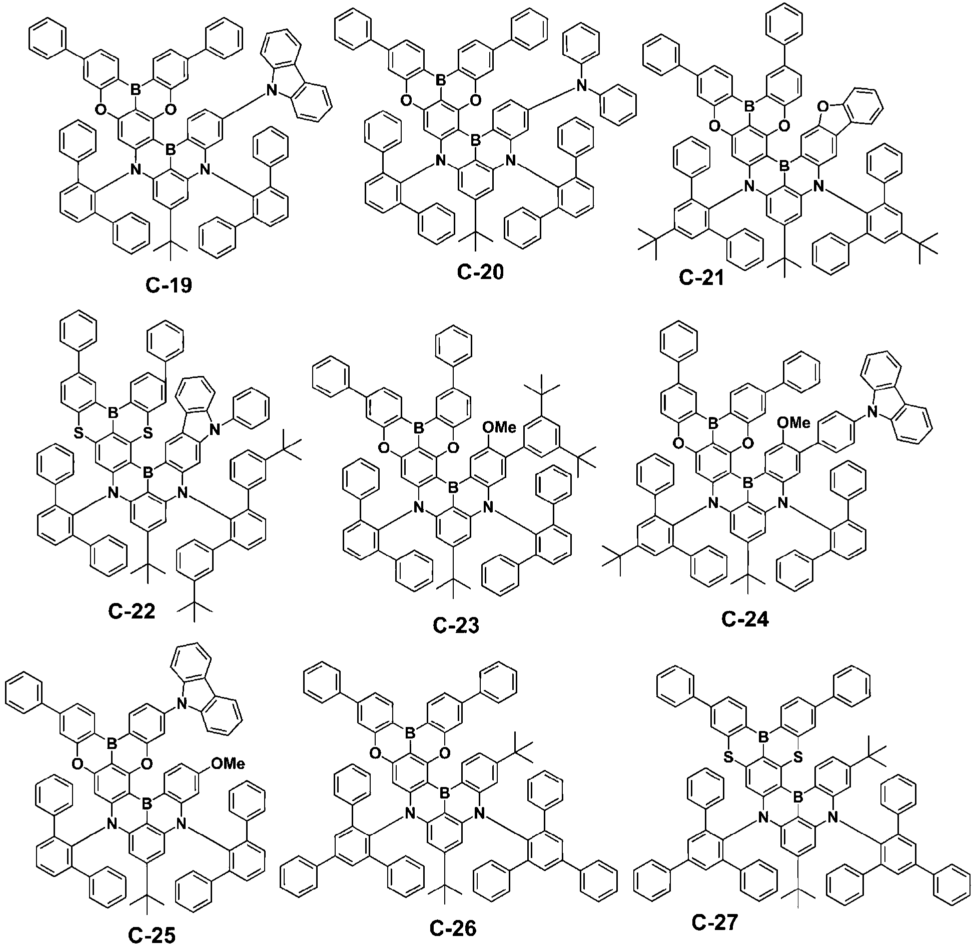

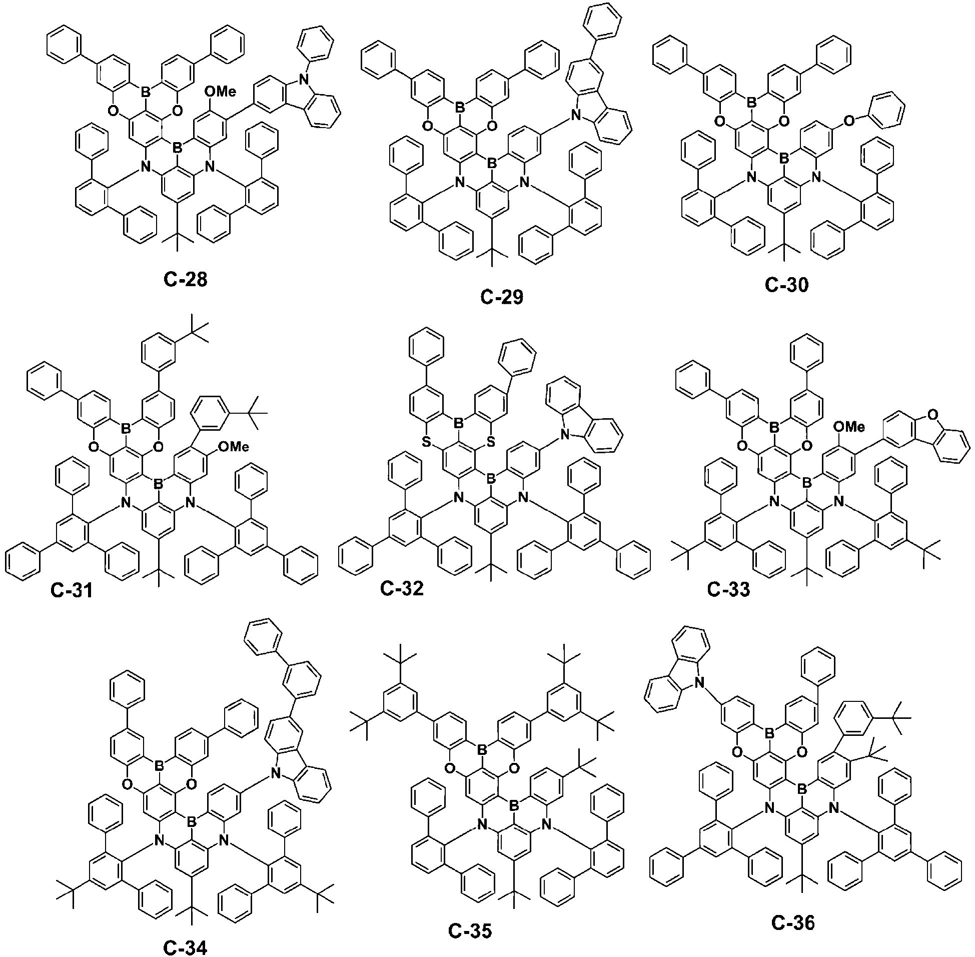

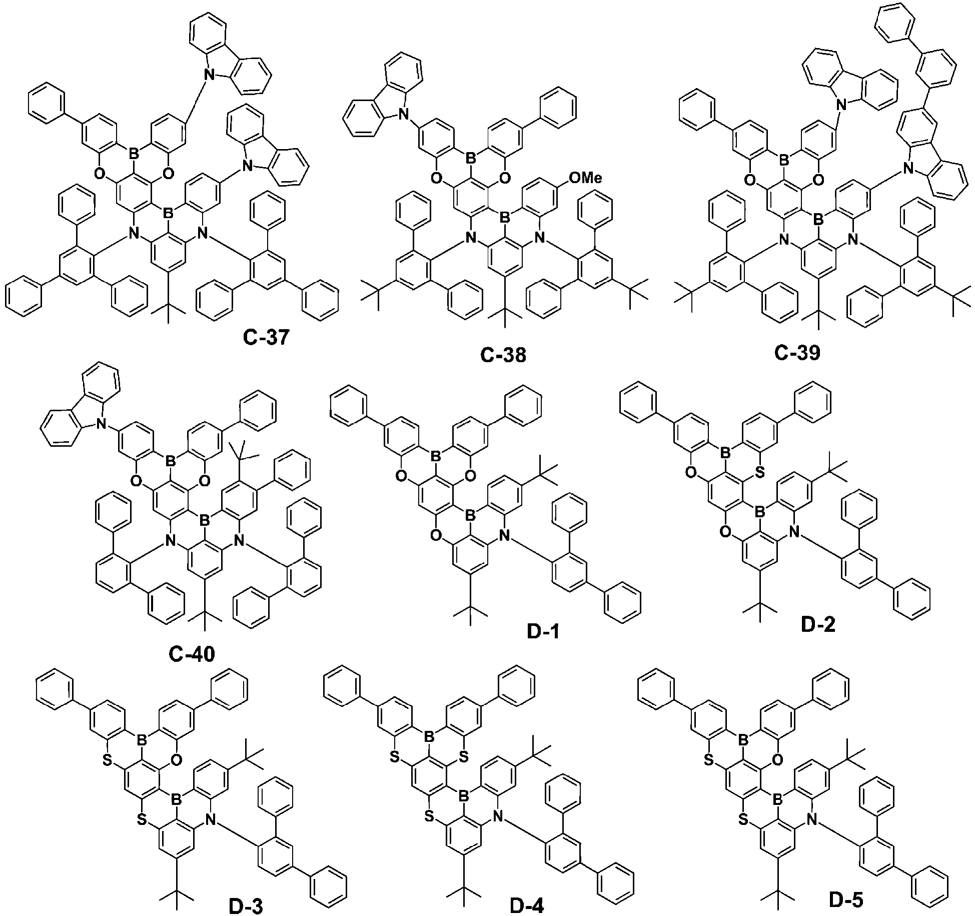

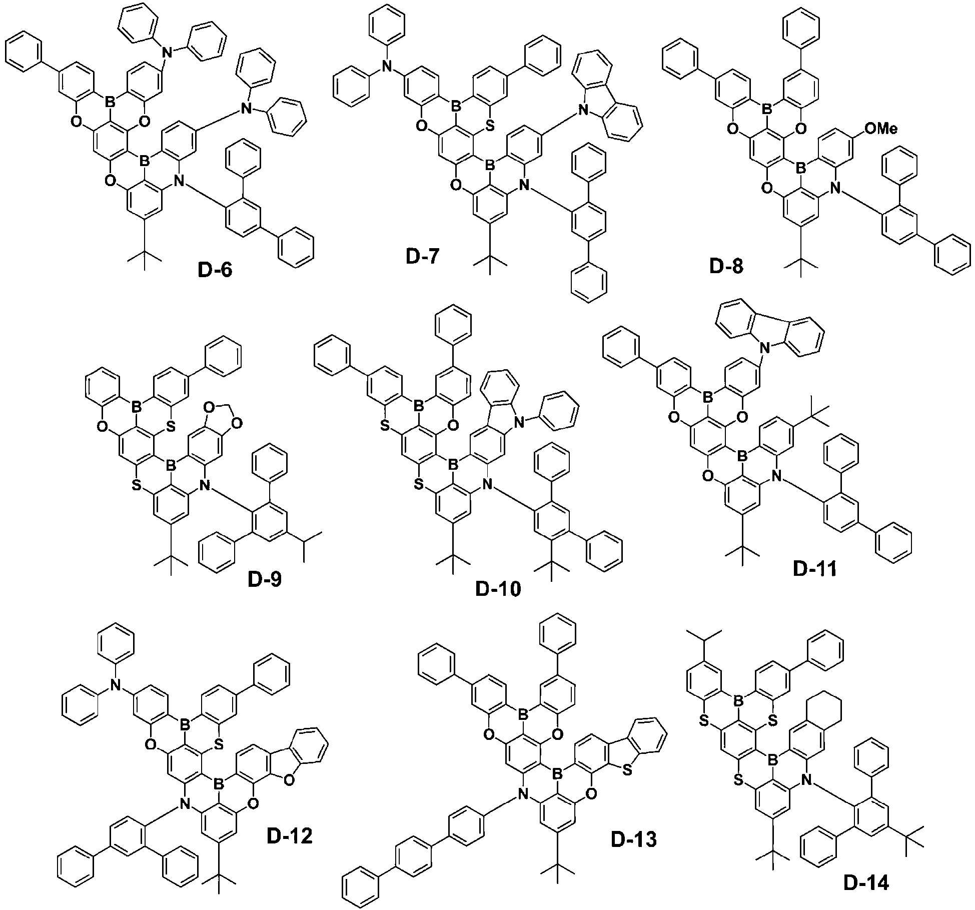

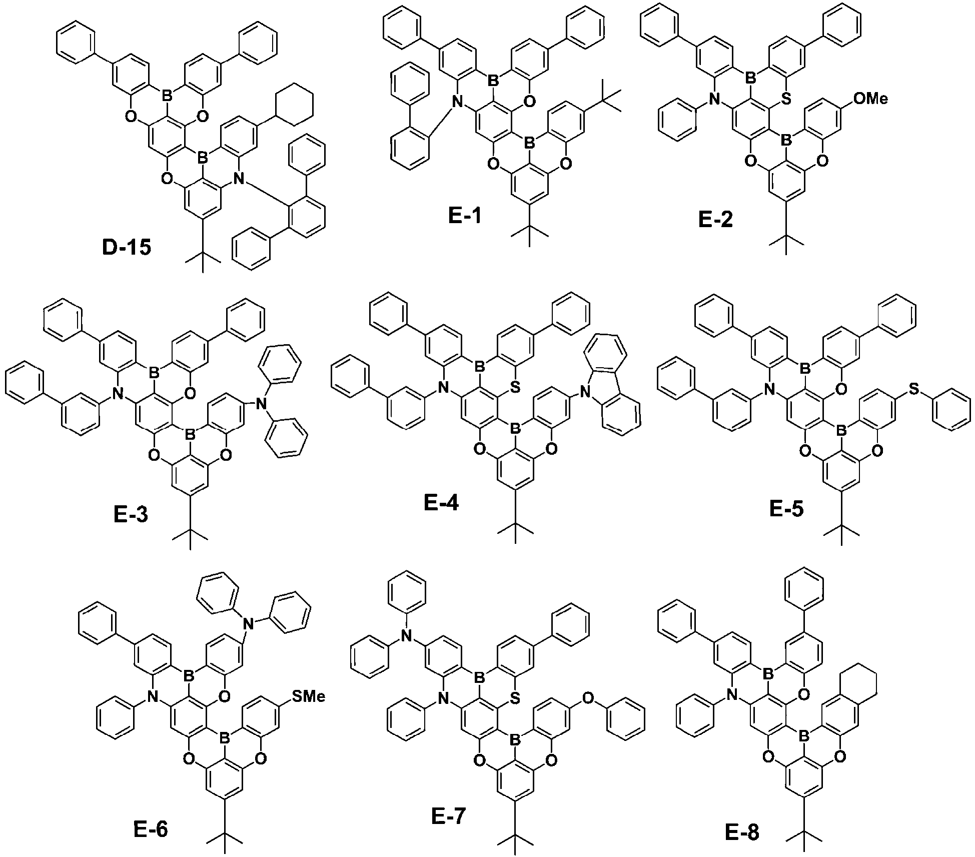

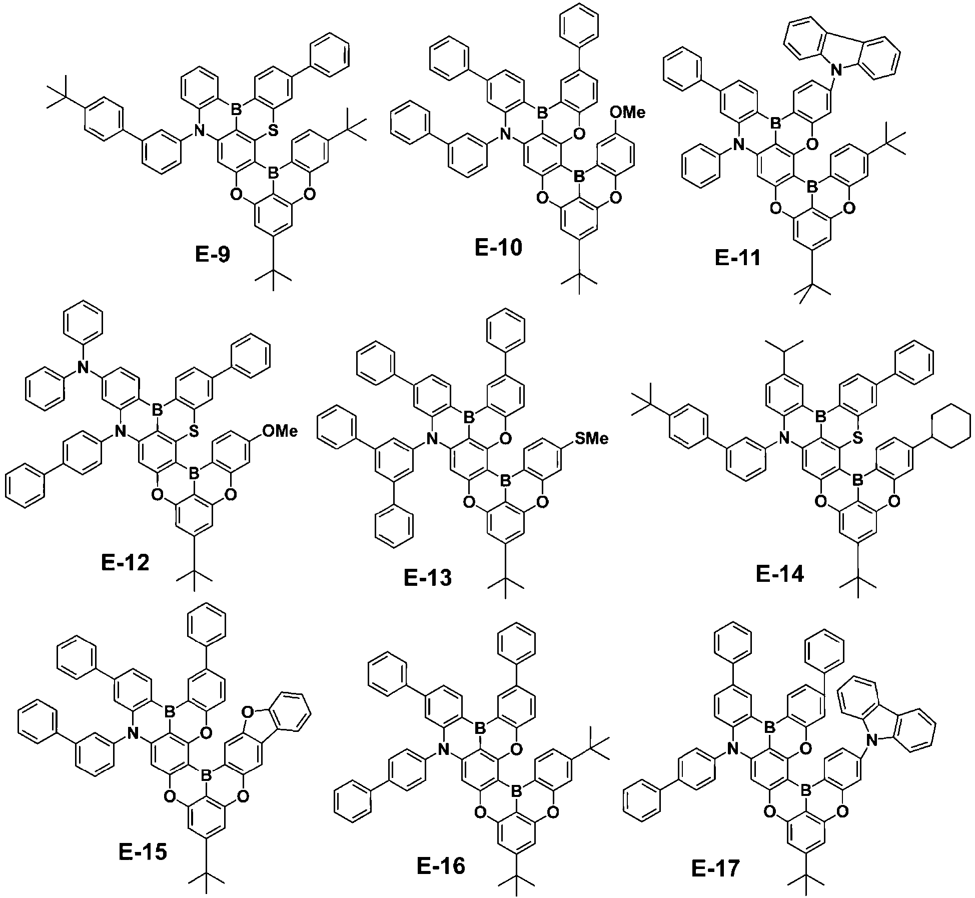

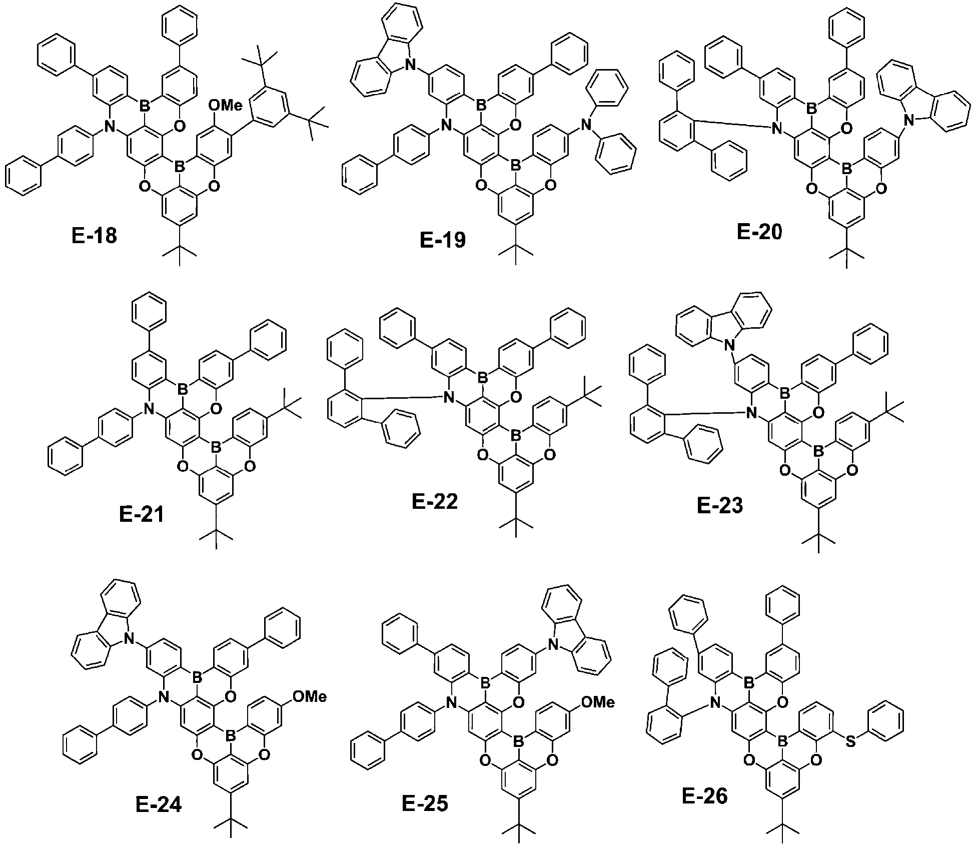

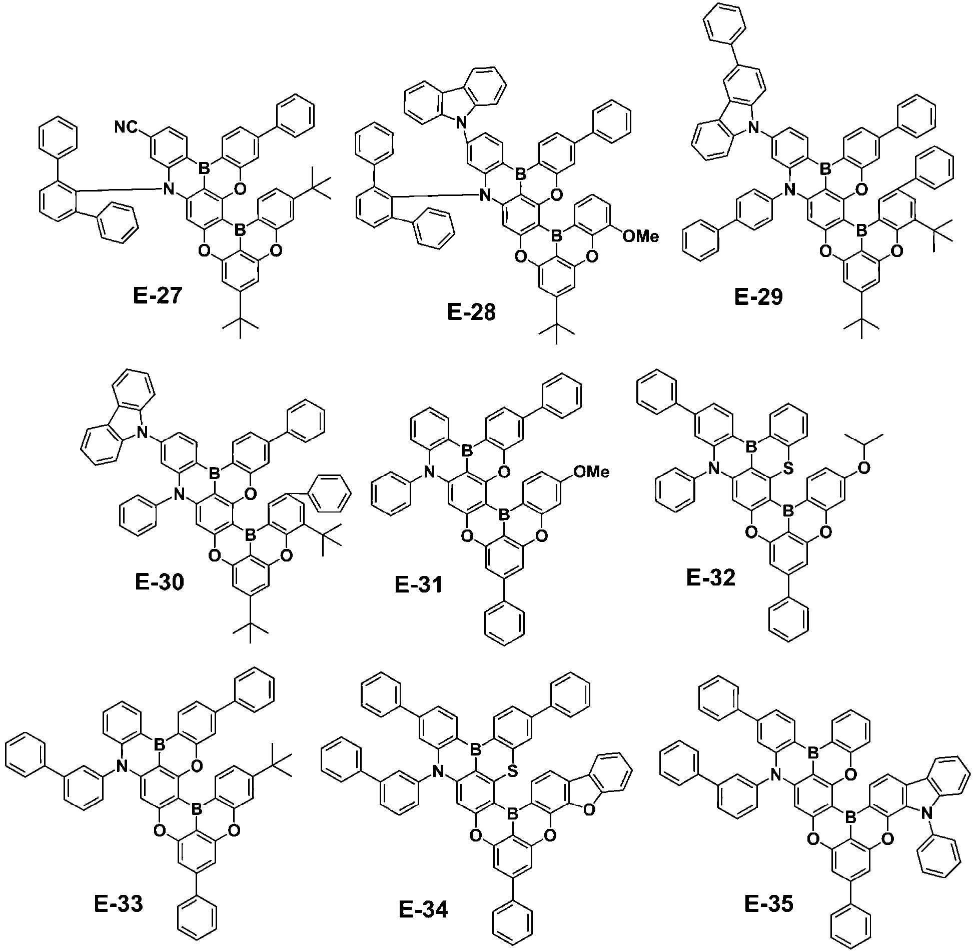

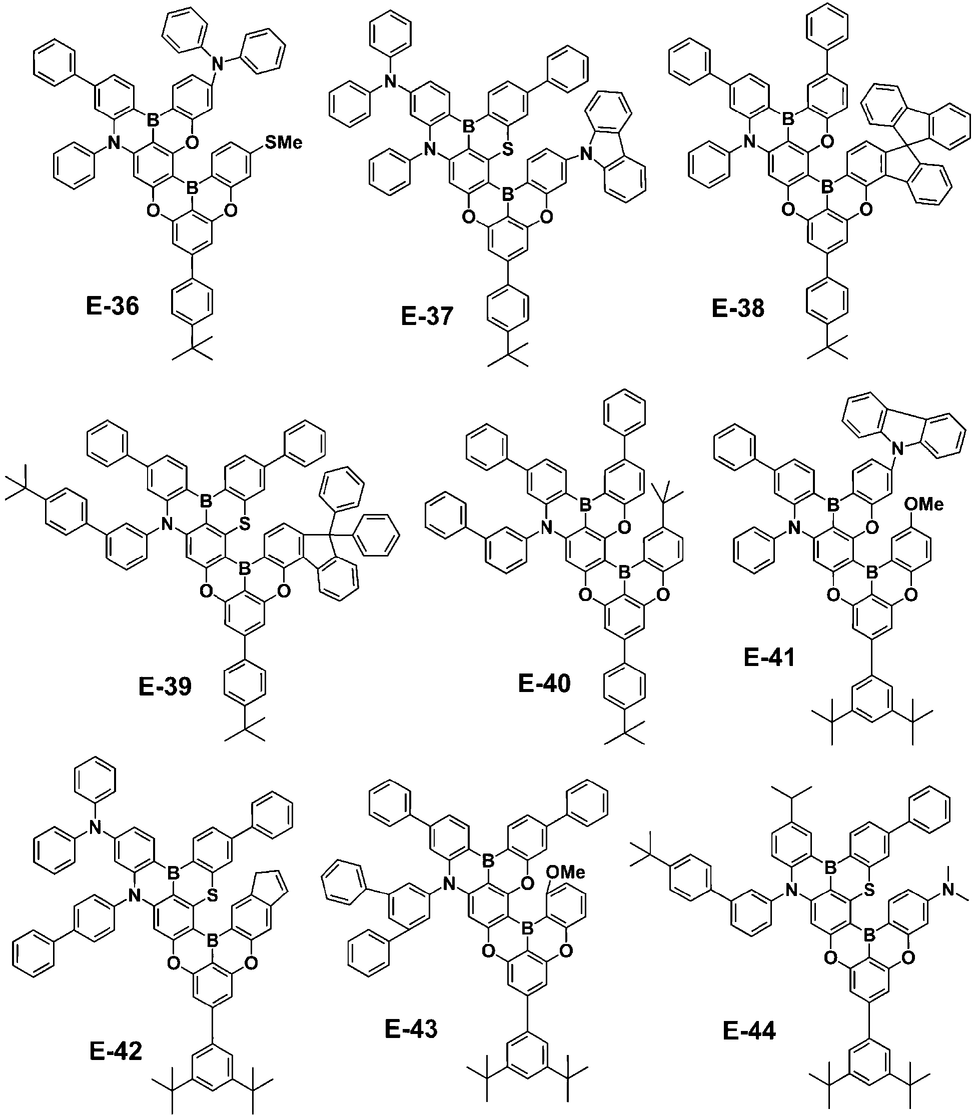

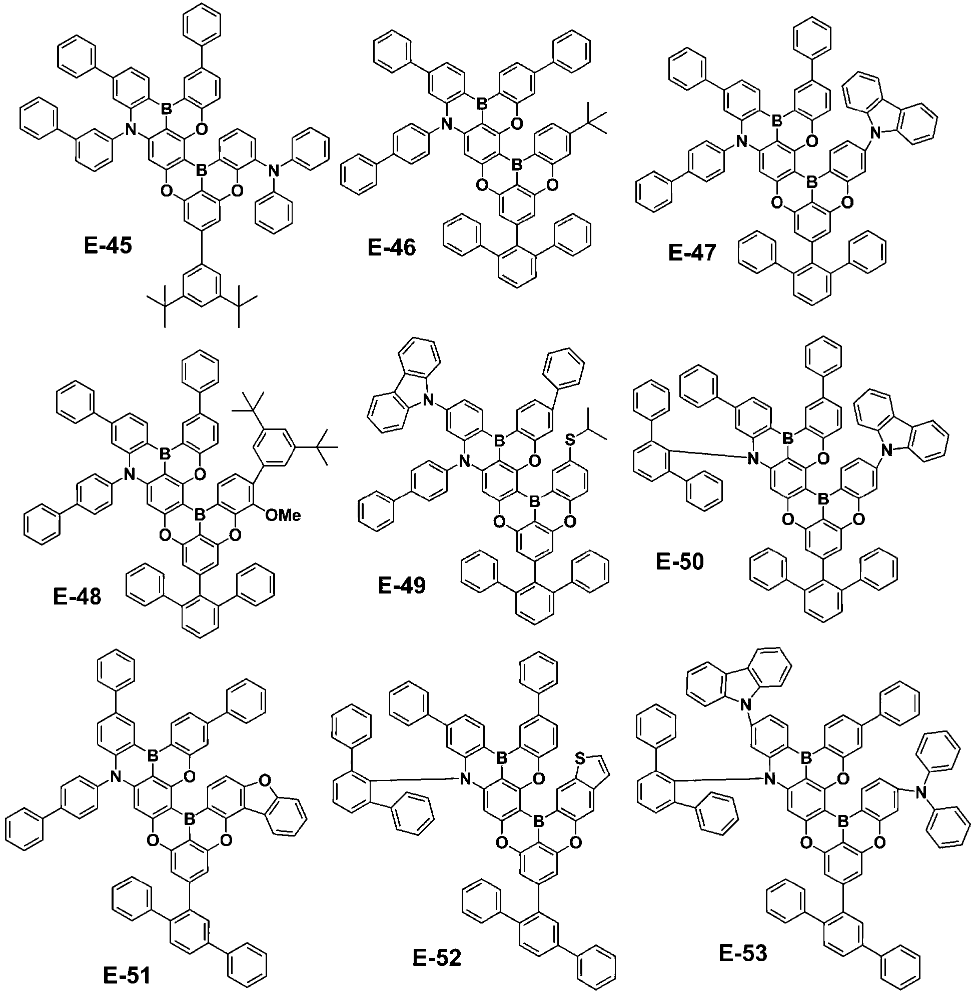

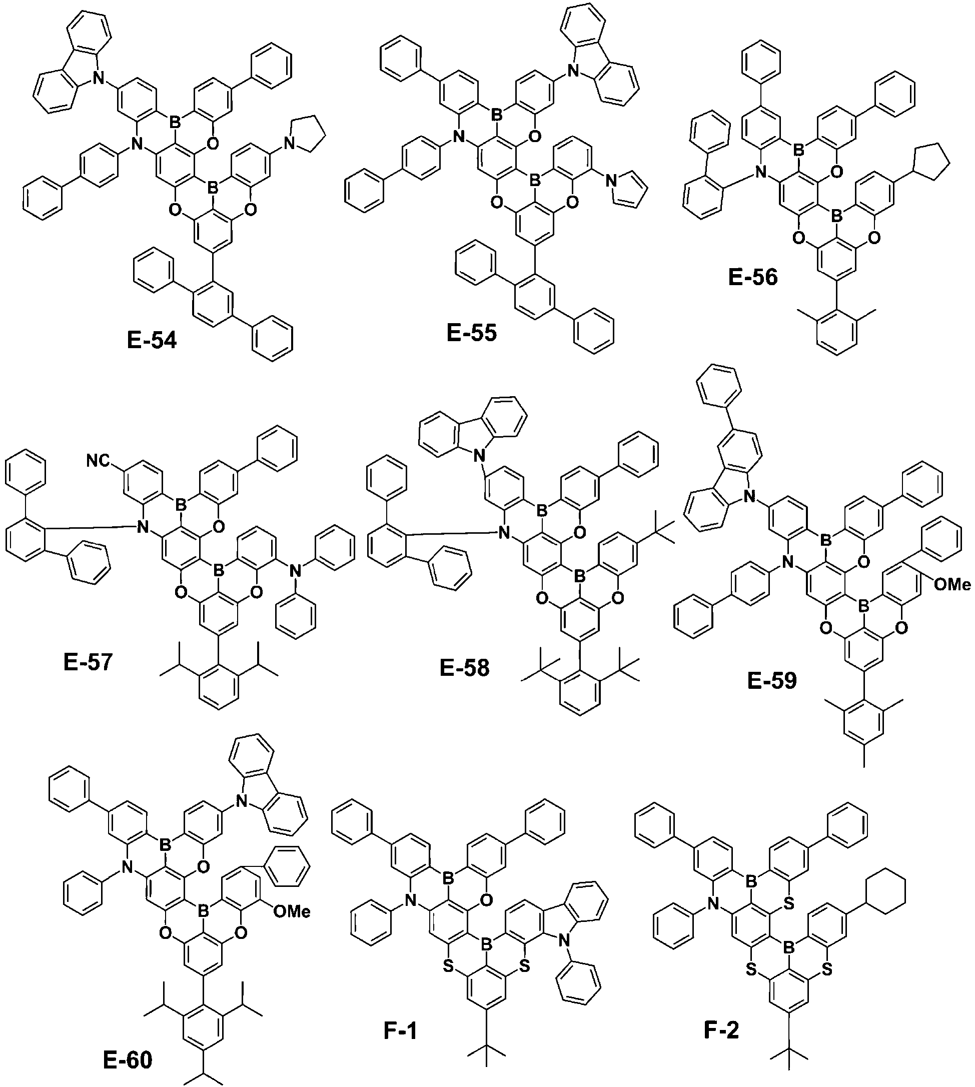

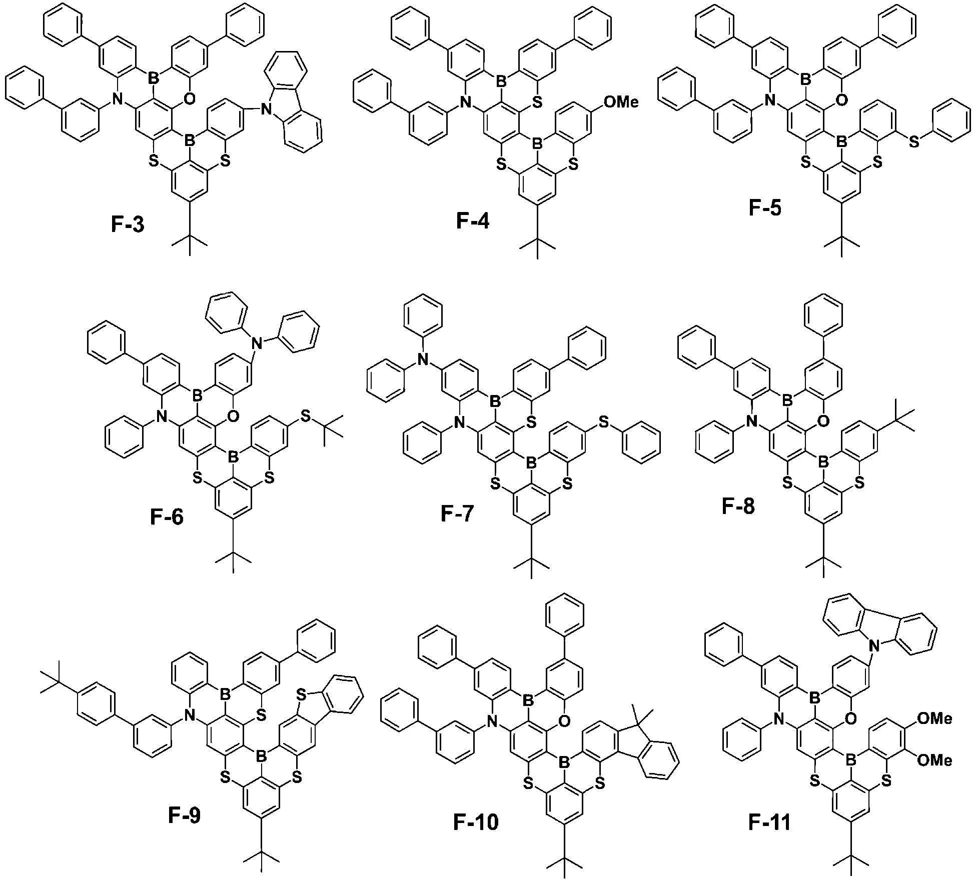

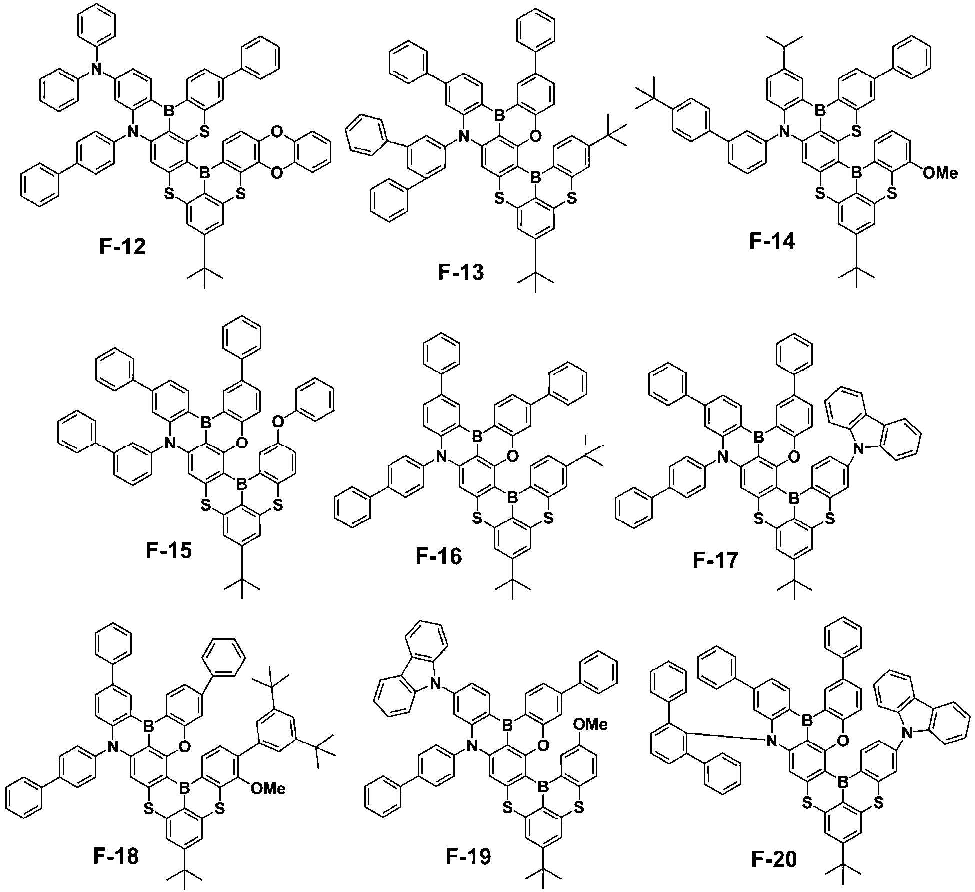

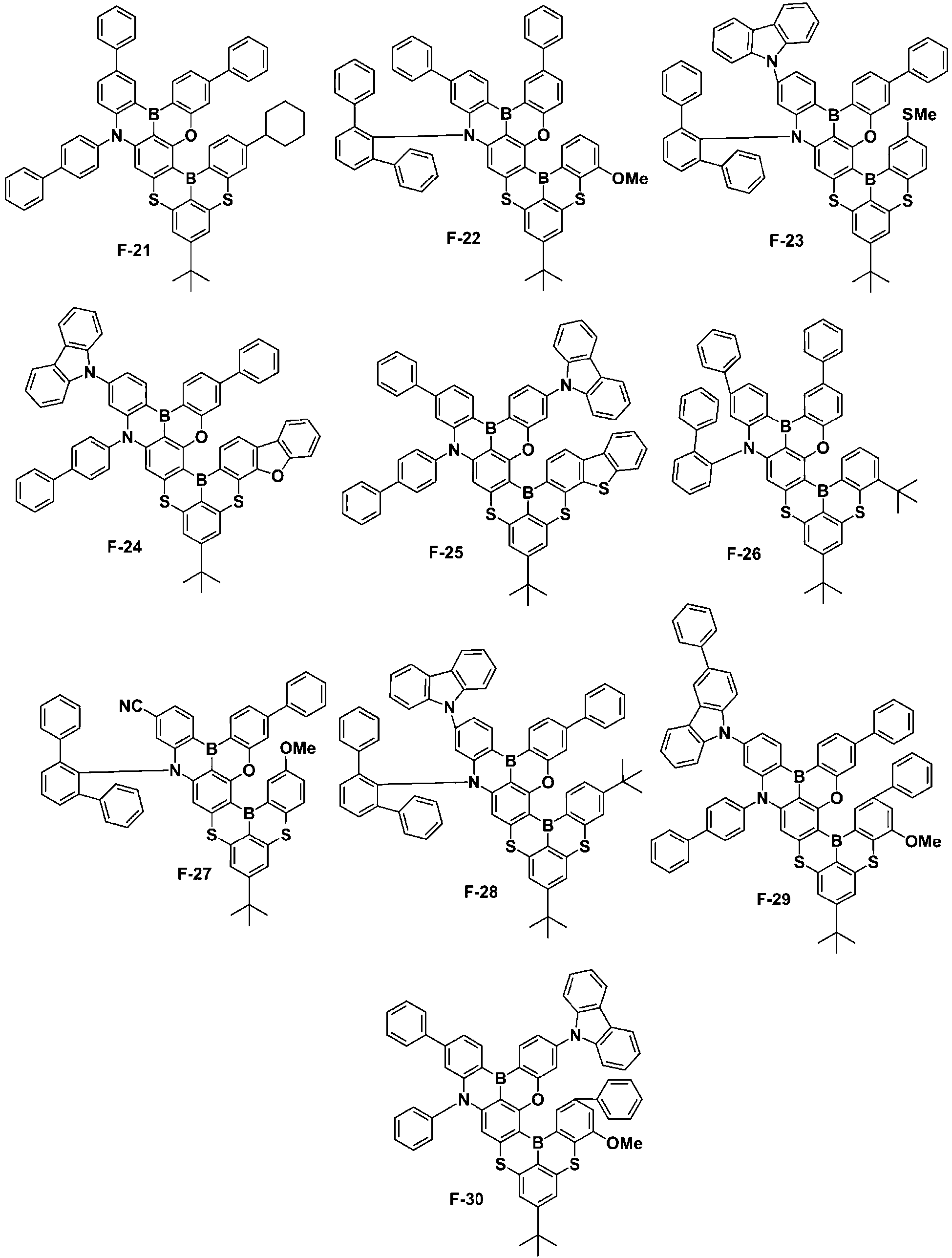

The light-emitting element ED including the fused polycyclic compound according to at least one example embodiment may have a peak emission wavelength in a wavelength region of about 430 nm to about 470 nm. The peak emission wavelength may mean a wavelength at which an emission intensity is maximum in the emission spectrum. The light-emitting element ED including the fused polycyclic compound according to at least one example embodiment may emit blue light. A third light-emitting element ED-3 (FIG. 2) emitting blue light may include the fused polycyclic compound according to at least one example embodiment.

The emission layer EML may include the fused polycyclic compound according to at least one example embodiment as a dopant. The fused polycyclic compound according to at least one example embodiment may be a delayed fluorescence material. The fused polycyclic compound according to at least one example embodiment may be a thermally activated delayed fluorescence (TADF) material. In the fused polycyclic compound according to at least one example embodiment, triplet excitons may be converted into singlet excitons due to a reverse inter system crossing (RISC) mechanism, thereby emitting light.

The fused polycyclic compound according to at least one example embodiment may include, as a core structure, a nine-ring fused ring system including four hetero atoms and two boron atoms as ring-forming atoms. In addition, the fused polycyclic compound according to at least one example embodiment may include a first substituent and a second substituent, each bonded to the core structure. The first substituent is a substituted or unsubstituted aryl group having 6 to 60 ring-forming carbon atoms, is one group among R^{a1} and R^{a2} described previously, and may be bonded at a para position with respect to a boron atom of the core structure. The second substituent may be a substituted or unsubstituted alkyl group having 1 to 20 carbon atoms, or an electron-donating group, and may be at least one group among R^{b1} to R^{b4} described previously. The second substituent may be a group having high electron-donating properties.

The fused polycyclic compound according to at least one example embodiment that includes the nine-ring fused ring system including four hetero atoms and two boron atoms as ring-forming atoms may contribute to improvements in emission efficiency and lifespan of the light-emitting element ED due to high absorbance, a narrow full width at half maximum, and rapid reverse inter system crossing.

A typical compound including a nine-ring fused ring system has high planarity to cause unnecessary (e.g., undesired) intermolecular energy transfer to occur, and is thus likely that the lifespan deteriorates at a high concentration. The fused polycyclic compound according to at least one example embodiment has a sterically increased bulk while maintaining the nine-ring fused ring system and employs a substituent having high electron-donating properties, and thus Dexter energy transfer (DET) may be protected against and charge transfer (CT) characteristics may increase. Dexter energy transfer (DET) may be an unnecessary intermolecular energy transfer. In addition, an aryl group (that is, the first substituent) is introduced at a para position with respect to the boron atom, which is a ring-forming atom in the nine-ring fused ring system of the fused polycyclic compound according to at least one example embodiment, and thus molecular resonance stability may be improved. Therefore, in the fused polycyclic compound according to at least one example embodiment, a decrease in lifespan at a high concentration may be suppressed, improved lifespan may be exhibited at a low concentration, and RISC may be accelerated. Therefore, the fused polycyclic compound according to at least one example embodiment may contribute to improvements in emission efficiency and lifespan of the light-emitting element ED.

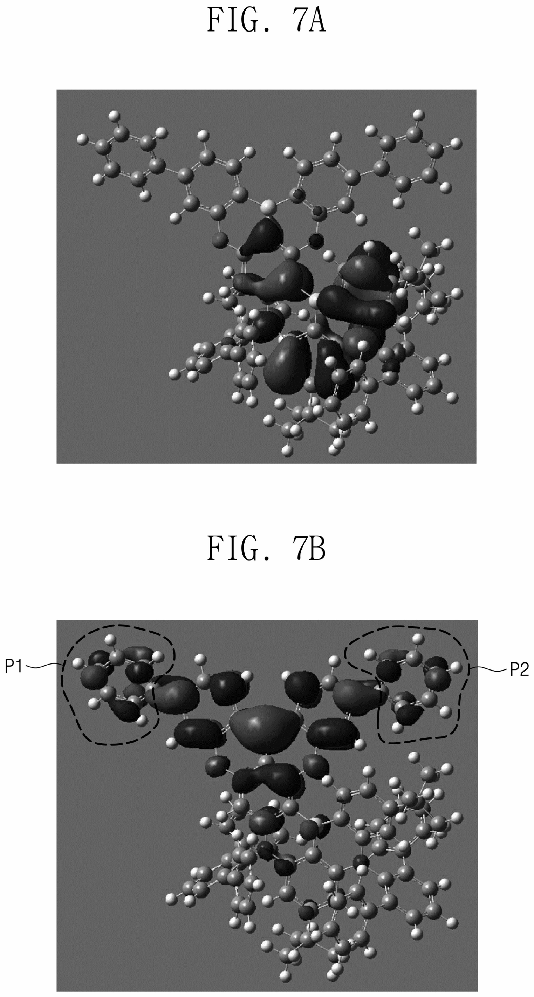

FIG. 7A is an image showing a distribution of a highest occupied molecular orbital (HOMO) of Compound C-18. FIG. 7B is an image showing a distribution of a lowest unoccupied molecular orbital (LUMO) of Compound C-18. Compound C-18 is the fused polycyclic compound according to at least one example embodiment. 'P1' and 'P2' in Compound C-18 and FIG. 7B are designated for convenience of explanation, and P1 and P2 in Compound C-18 correspond to P1 and P2 in FIG. 7B, respectively.

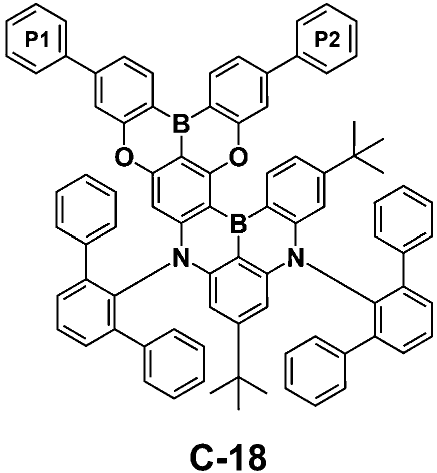

In Compound C-18, R^{b3} in Formula 1 is an unsubstituted t-butyl group, and the unsubstituted t-butyl group is an electron-donating substituent (that is, the second substituent). Referring to FIG. 7A, Compound C-18 exhibits a relatively large HOMO, which is due to introduction of the t-butyl group. Compound C-18 showing a relatively large HOMO has significantly enhanced charge transfer characteristics. The t-butyl group is a sterically bulky substituent and Dexter energy transfer of the compound may be suppressed by preventing intermolecular interactions. Therefore, it can be seen that the fused polycyclic compound according to at least one example embodiment including an electron-donating substituent such as a t-butyl group will have suppressed Dexter energy transfer and will exhibit excellent charge transfer characteristics.

In the compound C-18, R^{a1} and R^{a2} in Formula 1 are each an unsubstituted phenyl group, and the unsubstituted phenyl group corresponds to a cyclic group designated as P1 or P2. The unsubstituted phenyl group may correspond to the above-described first substituent. Referring to FIG. 7B, it can be seen that the LUMO extends to the cyclic group designated as P1 or P2, which is due to introduction of a phenyl group at a para position with respect to the boron atom.

As ΔE_{ST} of Compound C-18 in which the first substituent and the second substituent are introduced becomes lower, RISC is further accelerated, and thus Compound C-18 may contribute to high emission efficiency and roll-off suppression of the light-emitting element ED. The roll-off refers to a phenomenon of a sharp decrease in emission efficiency at a high current density. If RISC is promoted, triplet excitons having long lifespan may be rapidly converted into singlet excitons. ΔE_{ST} refers to an absolute value between energy levels of triplet state and singlet state.

In Compound C-18, the first substituent and the second substituent may effectively protect the boron atom of the core structure and thus may prevent materials from deteriorating due to reaction of water molecules and oxygen molecules during synthesis and/or deposition of the compound. Therefore, the fused polycyclic compound according to at least one example embodiment including the first substituent and the second substituent may exhibit excellent material stability. The fused polycyclic compound according to at least one example embodiment having improved material stability may contribute to improvements in emission efficiency and lifespan of the light-emitting element ED.

In at least one example embodiment, the emission layer EML includes the fused polycyclic compound according to at least one example embodiment, and may further include at least one among second to fourth compounds. In at least one example embodiment, the emission layer EML may include a second compound represented by Formula HT-1 below. For example, the second compound may be used as a hole transporting host material in the emission layer EML.

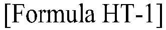

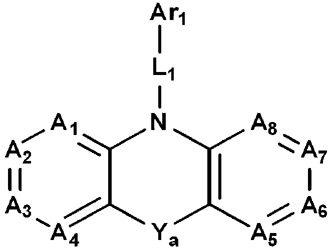

In Formula HT-1, A₁ to A₈ may be each independently N or CR₅₁. For example, all of A₁ to A₈ may be CR₅₁. Alternatively, at least one of A₁ to A₈ may be N, and the rest may be CR₅₁.

In Formula HT-1, L₁ may be a direct linkage, a substituted or unsubstituted arylene group having 6 to 30 ring-forming carbon atoms, or a substituted or unsubstituted heteroarylene group having 2 to 30 ring-forming carbon atoms. For example, L₁ may be a direct linkage, a substituted or unsubstituted phenylene group, a substituted or unsubstituted divalent biphenyl group, a substituted or unsubstituted divalent carbazole group, etc., but the embodiment of the inventive concepts is not limited thereto.

In Formula HT-1, Yₐ may be a direct linkage, CR₅₂R₅₃, or SiR₅₄R₅₅. That is, it may mean that the two benzene rings linked to the nitrogen atom in Formula HT-1 are linked via a direct linkage, 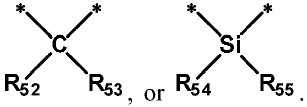 In Formula HT-1, when Yₐ is a direct linkage, the second compound represented by Formula HT-1 may include a carbazole moiety.

In Formula HT-1, Ar₁ may be a substituted or unsubstituted aryl group having 6 to 30 ring-forming carbon atoms, or a substituted or unsubstituted heteroaryl group having 2 to 30 ring-forming carbon atoms. For example, Ar₁ may be a substituted or unsubstituted carbazole group, a substituted or unsubstituted dibenzofuran group, a substituted or unsubstituted dibenzothiophene group, a substituted or unsubstituted biphenyl group, *etc.,* but the embodiment of the inventive concepts is not limited thereto.

In Formula HT-1, R₅₁ to R₅₅ may be each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. Alternatively, each of R₅₁ to R₅₅ may be bonded to an adjacent group to form a ring. For example, R₅₁ to R₅₅ may be each independently a hydrogen atom or a deuterium atom. R₅₁ to R₅₅ may be each independently an unsubstituted methyl group or an unsubstituted phenyl group.

In at least one example embodiment, the second compound represented by Formula HT-1 may be represented by at least one of the compounds represented by Compound Group 2 below. The emission layer EML may include at least one of the compounds represented by Compound Group 2 as a hole transporting host material.

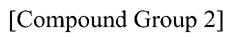

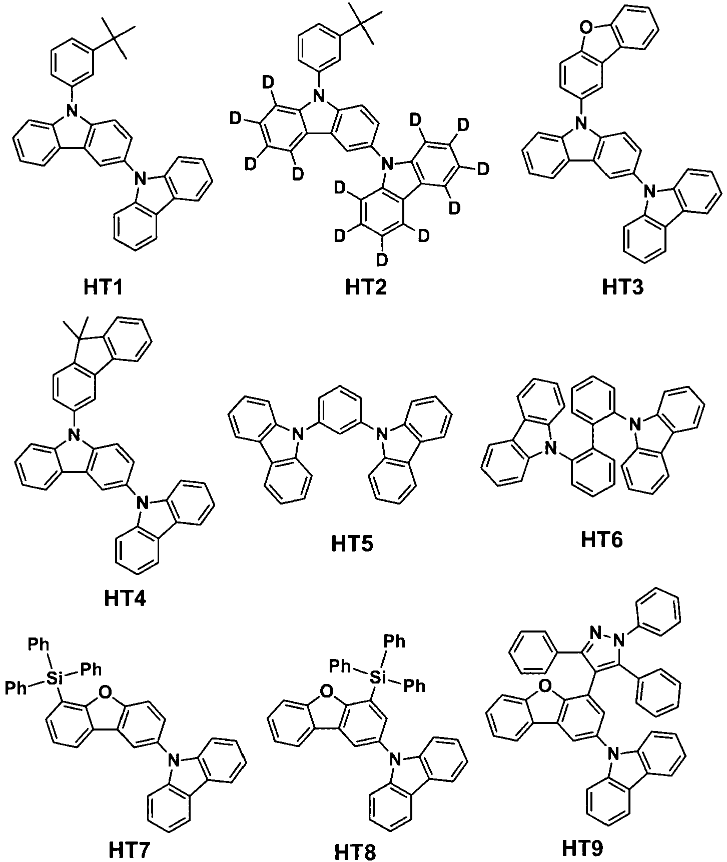

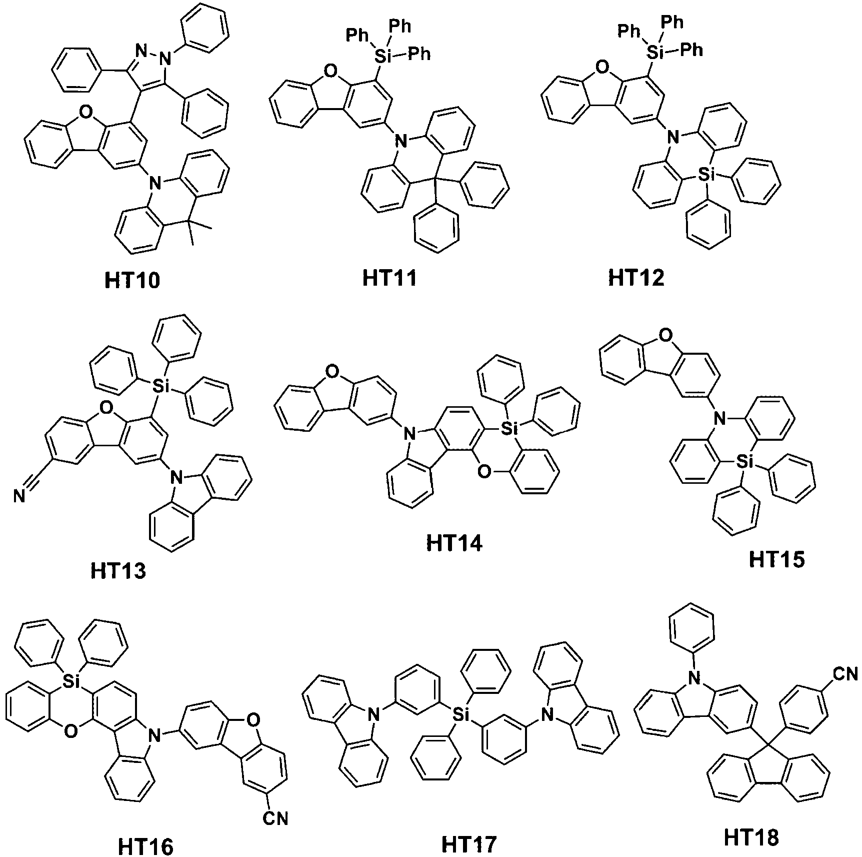

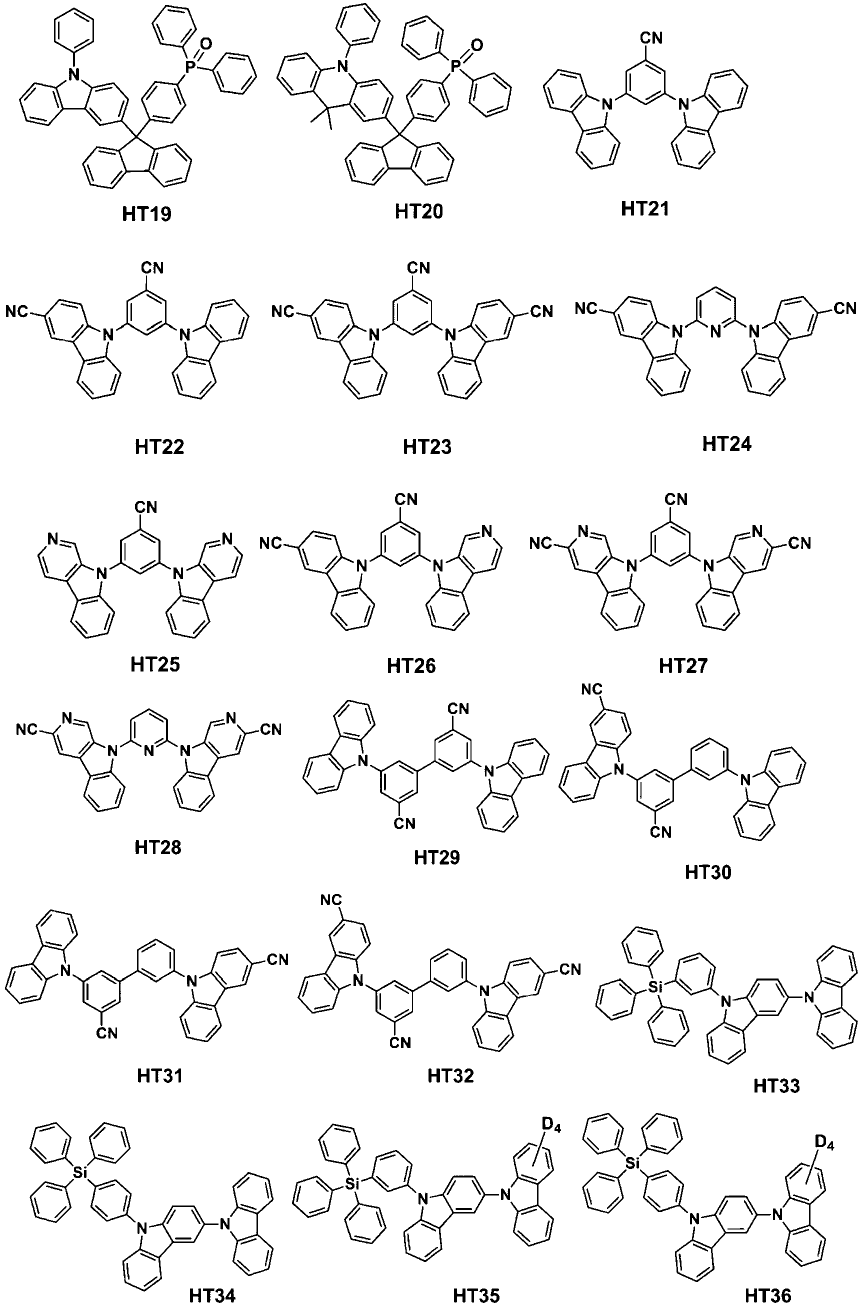

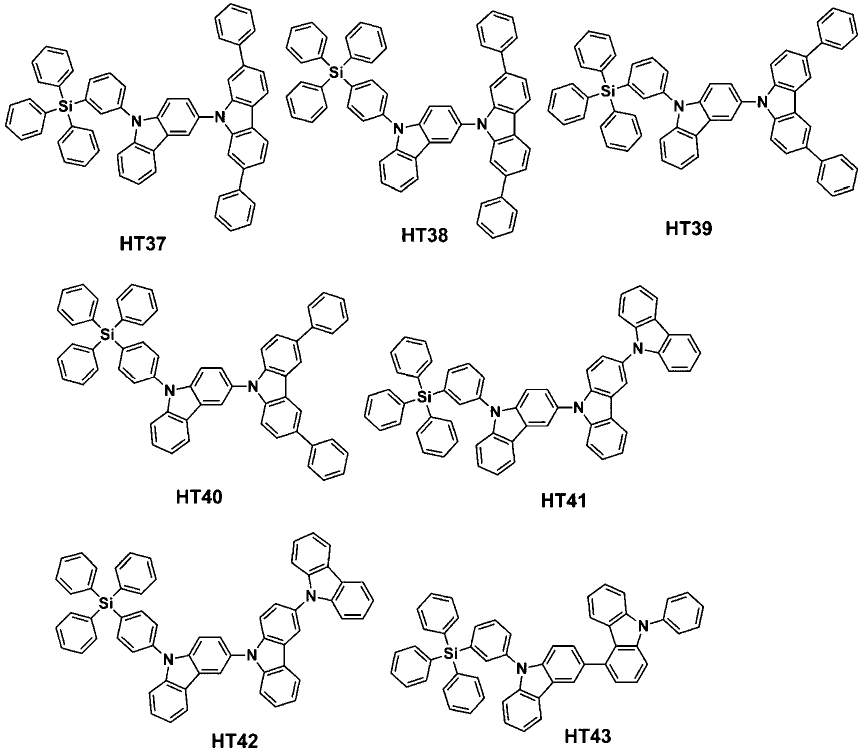

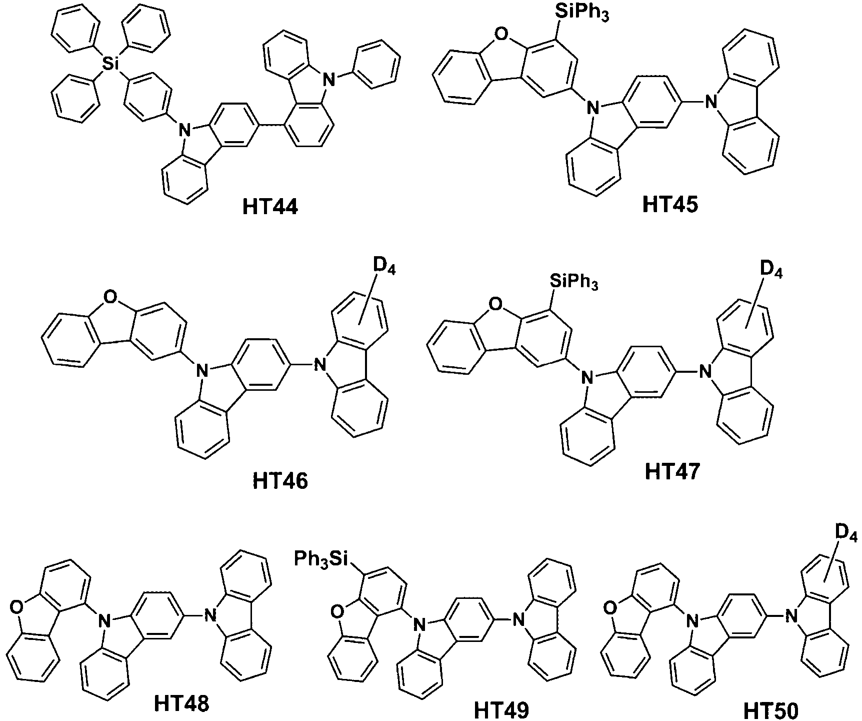

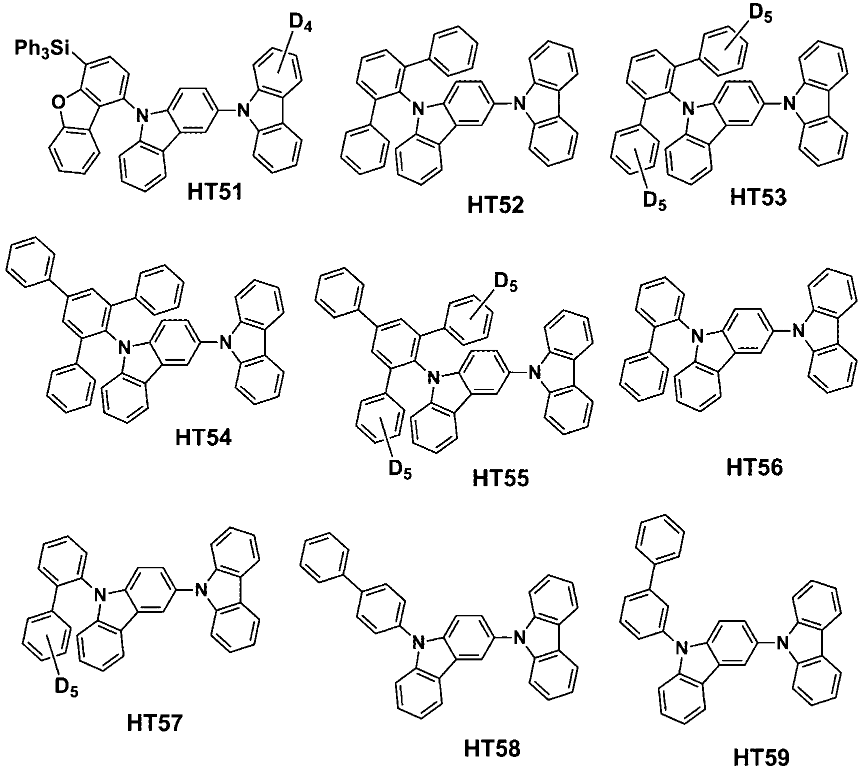

In the compounds presented in Compound Group 2, "D" may mean a deuterium atom, and "Ph" may mean a substituted or unsubstituted phenyl group. For example, in embodiment compounds presented in Compound Group 2, "Ph" may mean an unsubstituted phenyl group.

In at least one example embodiment, the emission layer EML may include the third compound represented by Formula ET-1 below. For example, the third compound may be used as an electron transport host material for the emission layer EML.

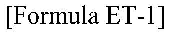

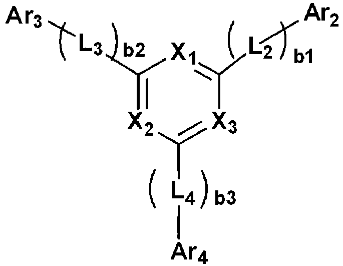

In Formula ET-1, at least one among X₁ to X₃ is N, and the rest are CR₅₆. For example, at least one of X₁ to X₃ may be N, and the rest may be each independently CR₅₆. In this case, the third compound represented by Formula ET-1 may include a pyridine moiety. Alternatively, two among X₁ to X₃ may be N, and the rest may be CR₅₆. In this case, the third compound represented by Formula ET-1 may include a pyrimidine moiety. Alternatively, X₁ to X₃ may all be N. In this case, the third compound represented by Formula ET-1 may include a triazine moiety.

In Formula ET-1, R₅₆ may be a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, b1 to b3 may be each independently an integer of 0 to 10.

In Formula ET-1, Ar₂ to Ar₄ may be each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Ar₂ to Ar₄ may be each independently a substituted or unsubstituted phenyl group, or a substituted or unsubstituted carbazole group.

In Formula ET-1, L₂ to L₄ may be each independently a direct linkage, a substituted or unsubstituted arylene group having 6 to 30 ring-forming carbon atoms, or a substituted or unsubstituted heteroarylene group having 2 to 30 ring-forming carbon atoms. When b1 to b3 are integers of 2 or greater, L₂ to L₄ may be each independently a substituted or unsubstituted arylene group having 6 to 30 ring-forming carbon atoms, or a substituted or unsubstituted heteroarylene group having 2 to 30 ring-forming carbon atoms.

In at least one example embodiment, the third compound may be represented by at least one of compounds in Compound Group 3 below. The light-emitting element ED of at least one example embodiment may include at least one of the compounds in Compound Group 3 below.

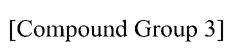

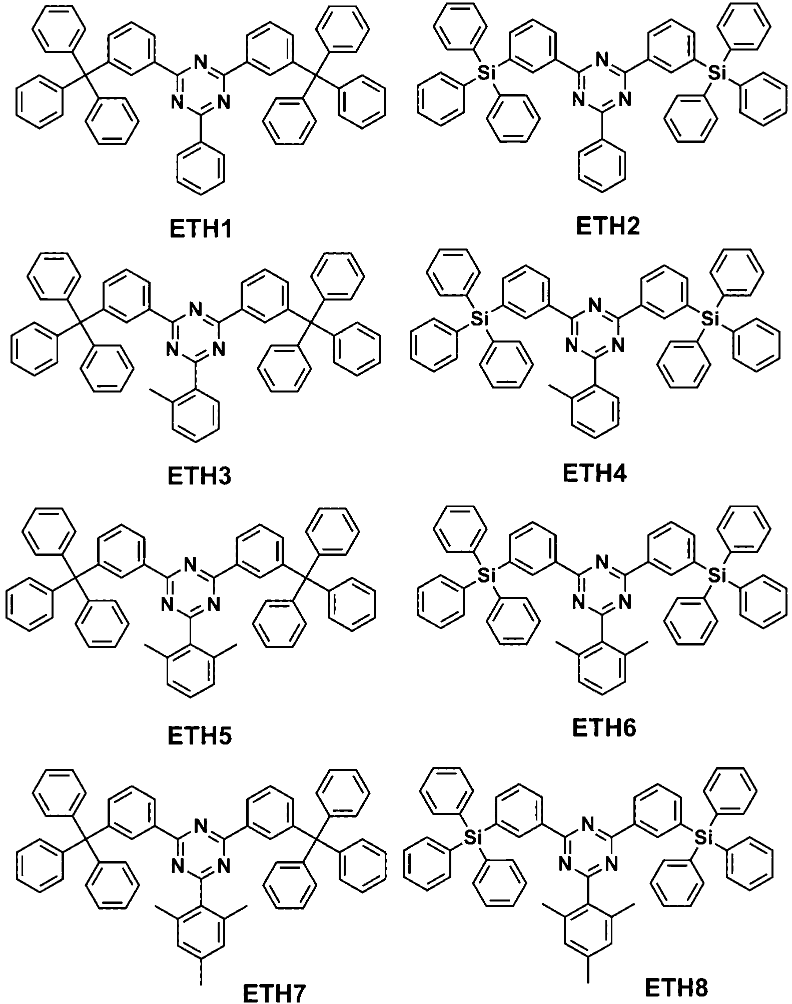

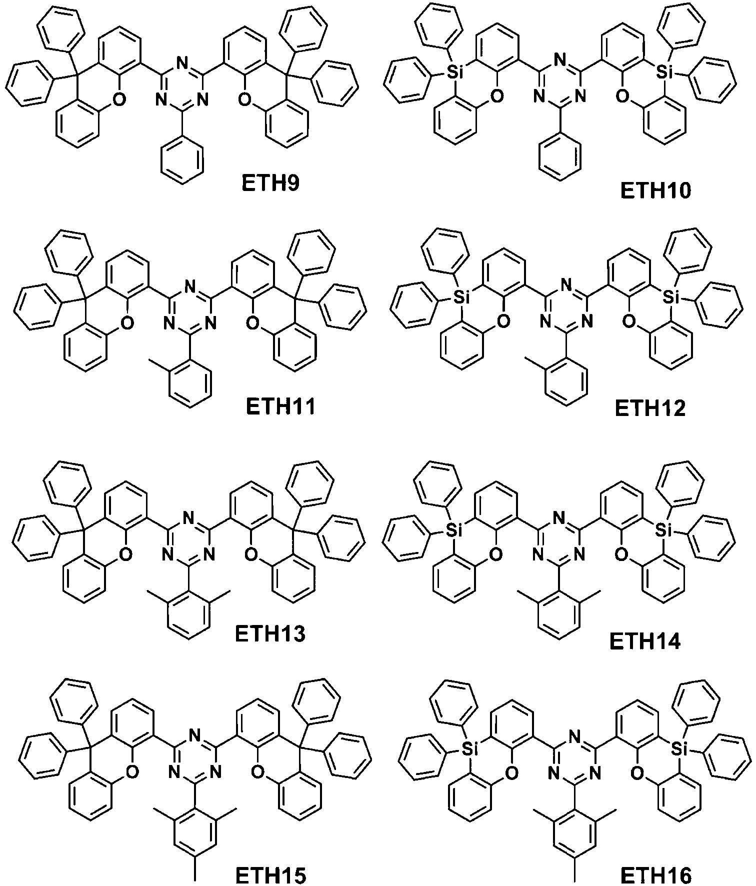

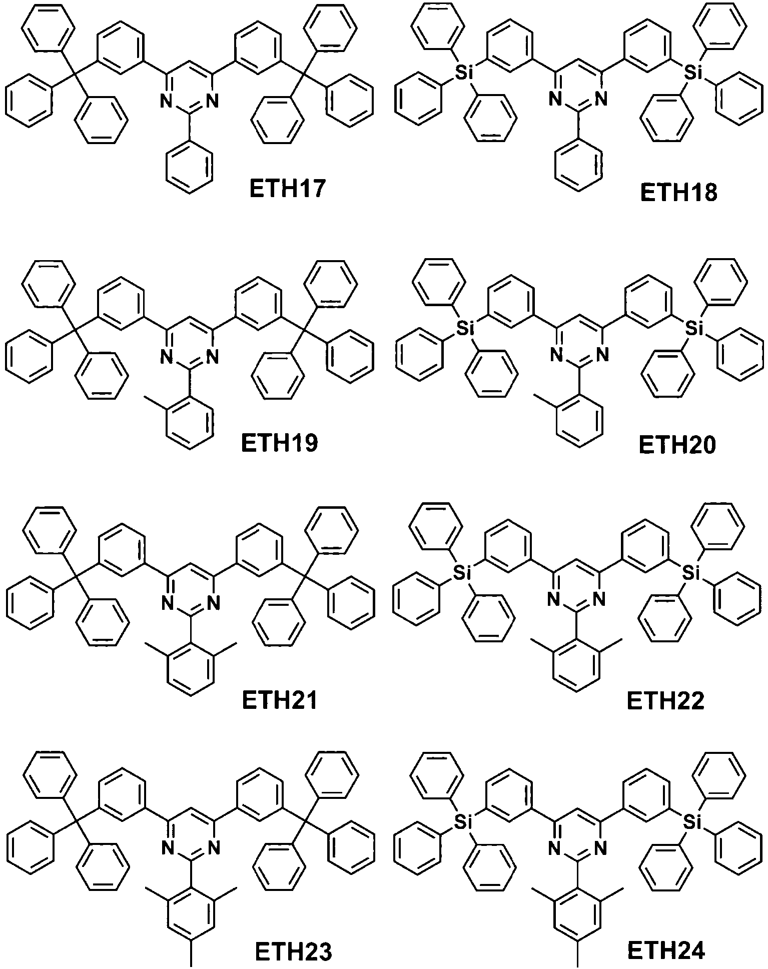

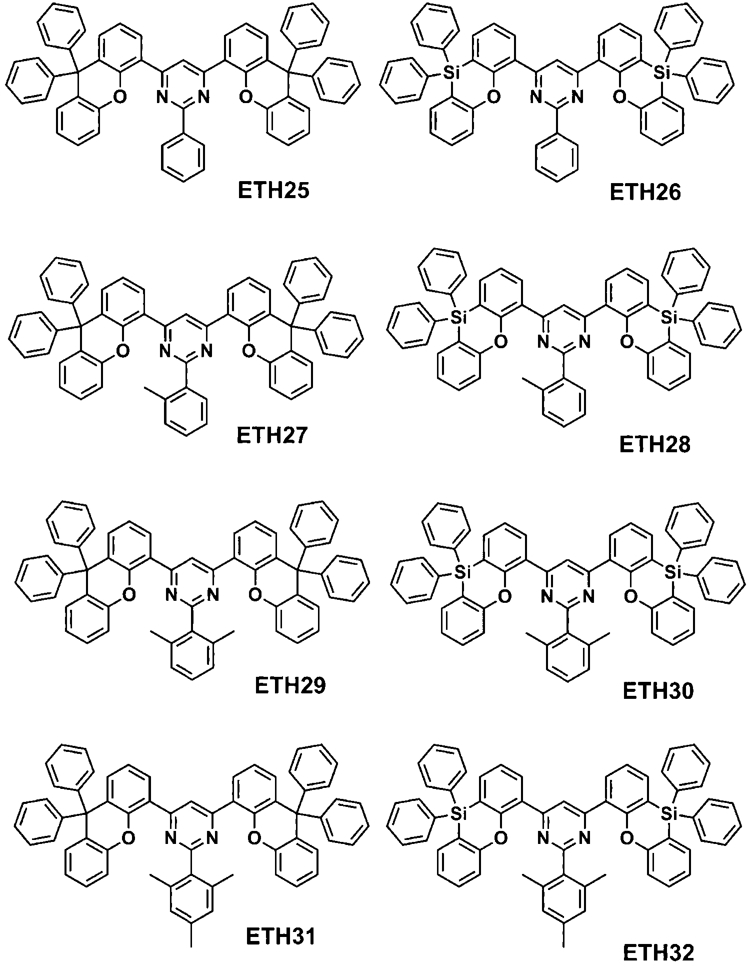

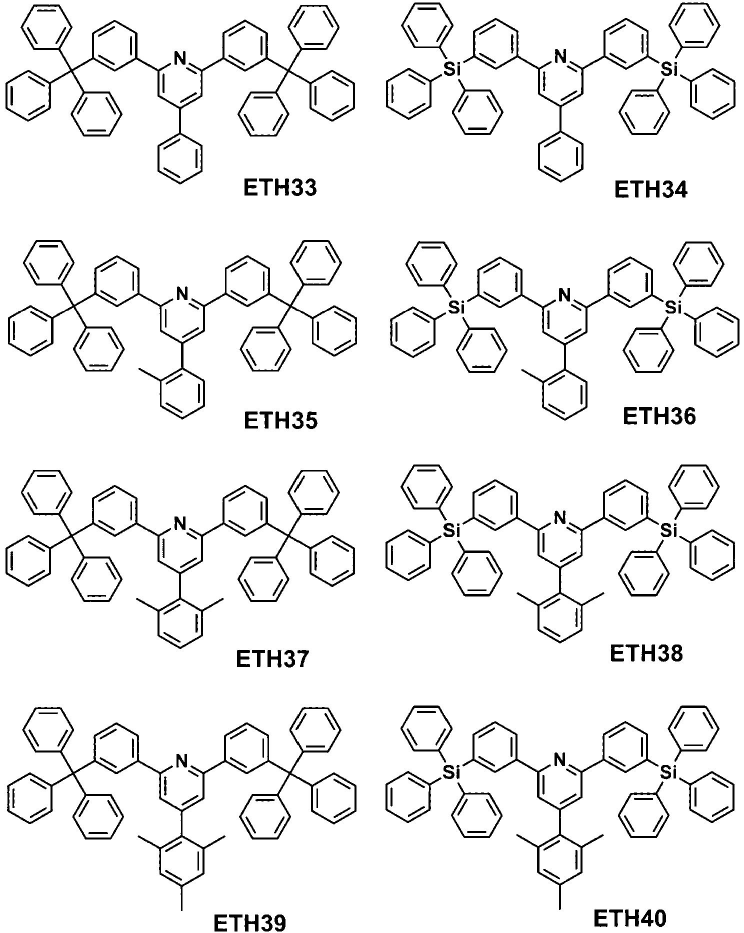

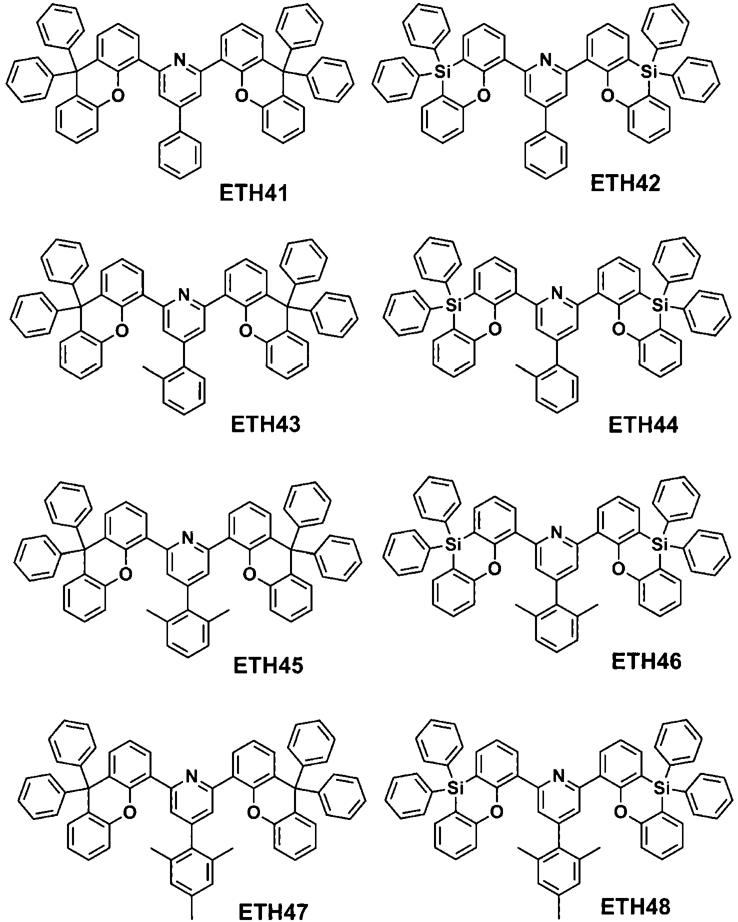

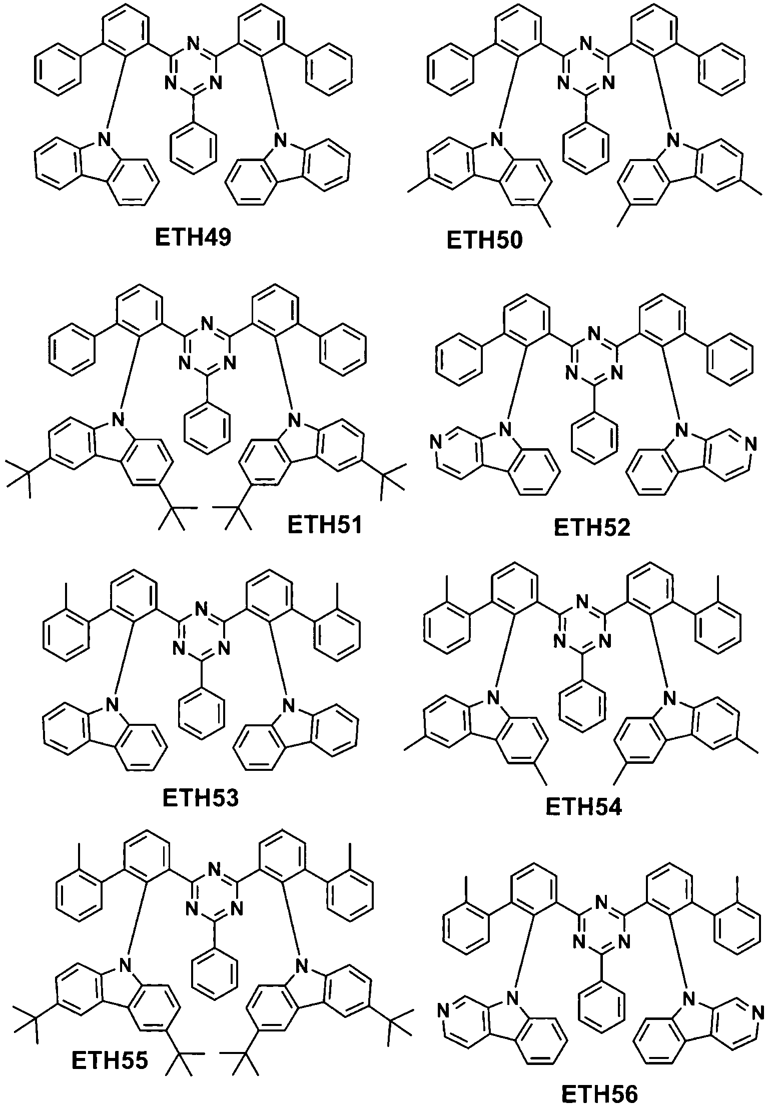

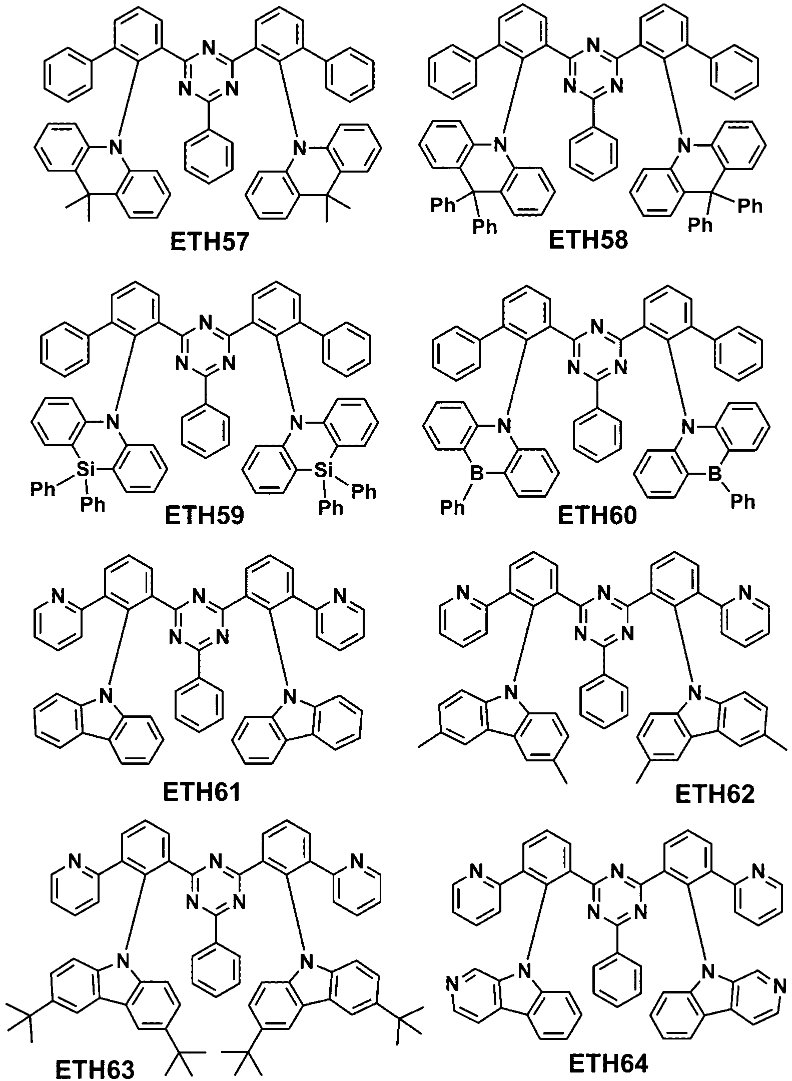

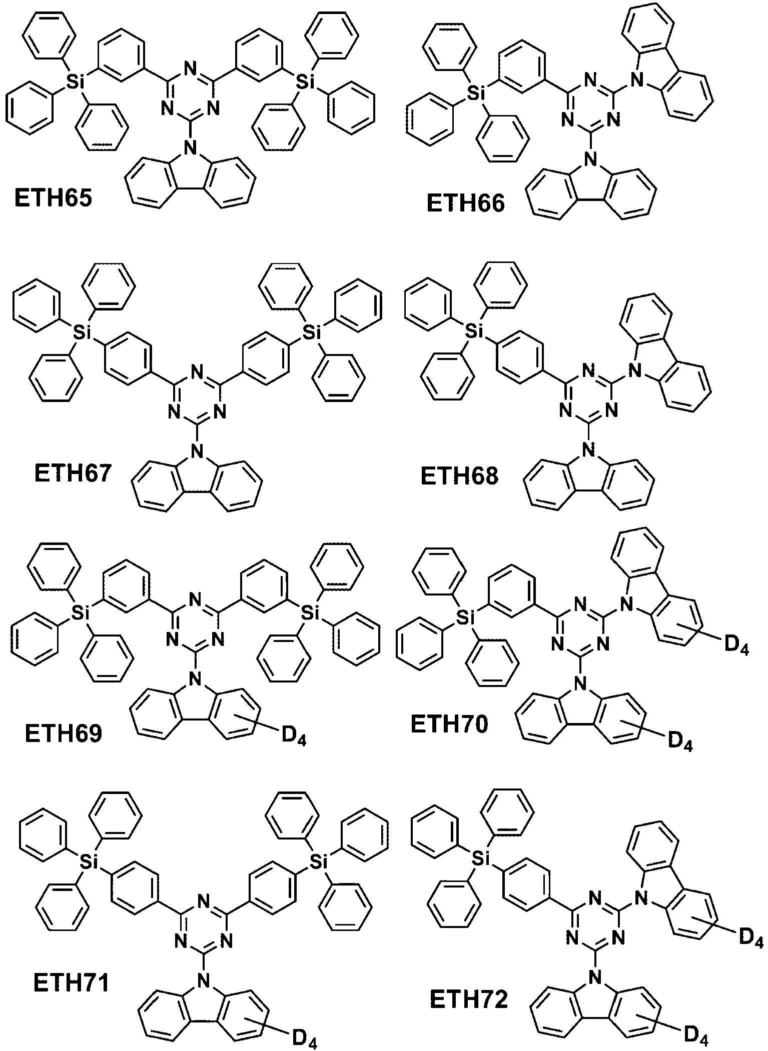

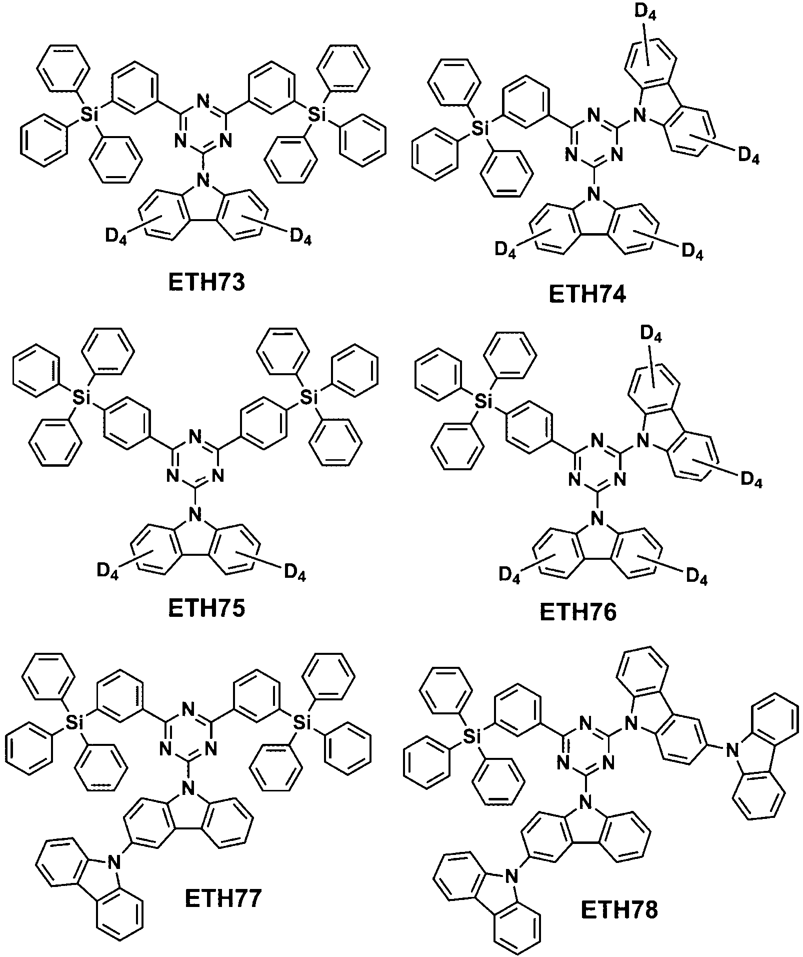

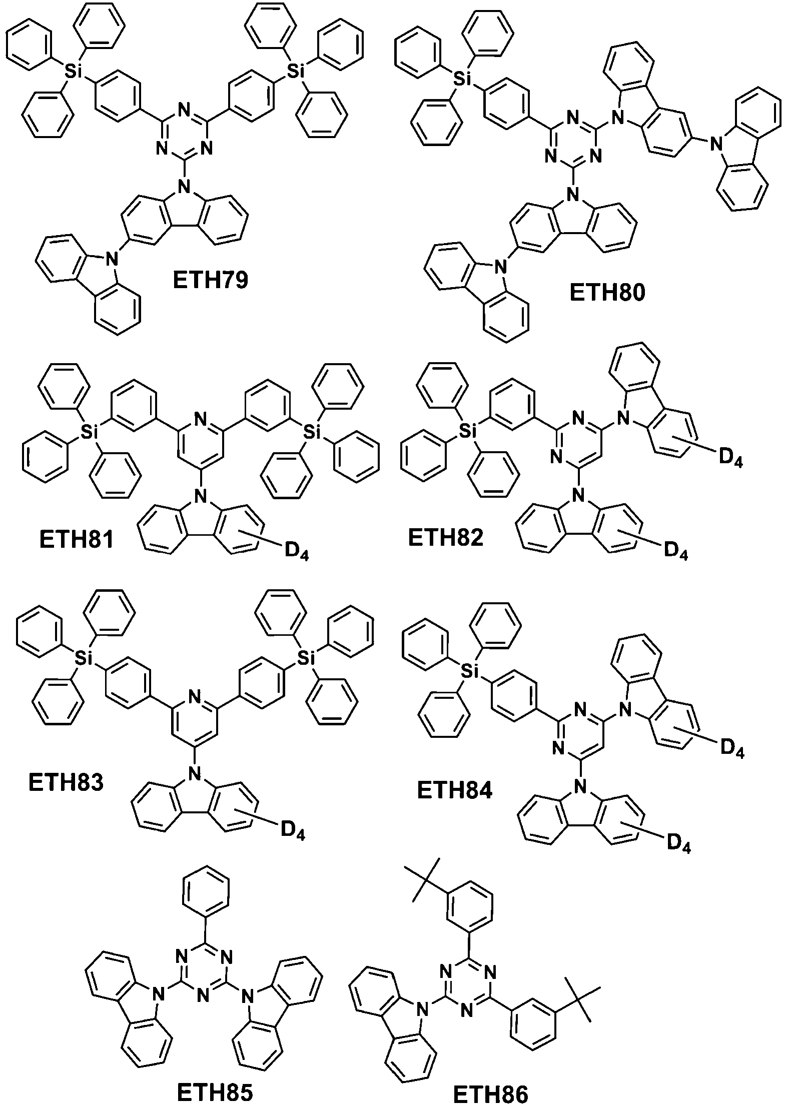

In the examples presented in Compound Group 3, "D" refers to a deuterium atom and "Ph" refers to an unsubstituted phenyl group.

The emission layer EML may include the second compound and the third compound, and the second compound and the third compound may form an exciplex. In the emission layer EML, an exciplex may be formed by the hole transport host and the electron transport host. In this case, a triplet energy of the exciplex formed by the hole transporting host and the electron transporting host may correspond to the difference between a lowest unoccupied molecular orbital (LUMO) energy level of the electron transporting host and a highest occupied molecular orbital (HOMO) energy level of the hole transporting host.

For example, the absolute value of the triplet energy (T1) of the exciplex formed by the hole transporting host and the electron transporting host may be about 2.4 eV to about 3.0 eV. In addition, the triplet energy of the exciplex may be a value smaller than an energy gap of each host material. The exciplex may have a triplet energy of about 3.0 eV or less (e.g., as an energy gap between the hole transporting host and the electron transporting host).

In at least one example embodiment, the emission layer EML may include a fourth compound in addition to the first compound to the third compound as described above. The fourth compound may be used as a phosphorescent sensitizer of the emission layer EML. The energy may be transferred from the fourth compound to the first compound, thereby emitting light.

For example, the emission layer EML may include, as the fourth compound, an organometallic complex containing platinum (Pt) as a central metal atom and ligands linked to the central metal atom. The emission layer EML in the light-emitting element ED of at least one example embodiment may include, as the fourth compound, a compound represented by Formula D-1 below.

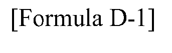

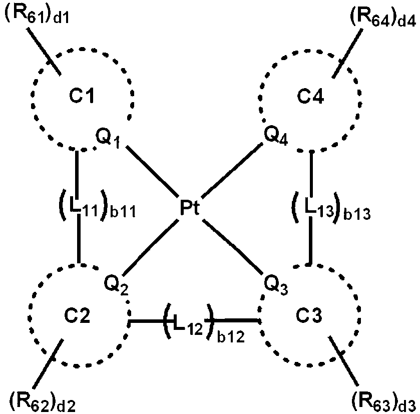

In Formula D-1, Q₁ to Q₄ may be each independently C or N.

In Formula D-1, C1 to C4 may be each independently a substituted or unsubstituted hydrocarbon ring having 5 to 30 ring-forming carbon atoms, a substituted or unsubstituted aryl group having 6 to 30 ring-forming carbon atoms, or a substituted or unsubstituted heterocycle having 2 to 30 ring-forming carbon atoms.

In Formula D-1, L₁₁ to L₁₃ may be each independently a direct linkage, 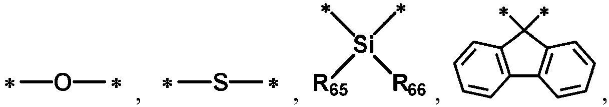 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, "-*" means a part linked to C1 to C4.

In Formula D-1, b11 to b13 may be each independently 0 or 1. If b11 is 0, C1 and C2 may not be linked to each other. If b12 is 0, C2 and C3 may not be linked to each other. If b13 is 0, C3 and C4 may not be linked to each other.

In Formula D-1, R₆₁ to R₆₆ may be each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. Alternatively, each of R₆₁ to R₆₆ may be bonded to an adjacent group to form a ring. R₆₁ to R₆₆ may be each independently a substituted or unsubstituted methyl group, or a substituted or unsubstituted t-butyl group.

In Formula D-1, d1 to d4 are each independently an integer of 0 to 4. In Formula D-1, if each of d1 to d4 is 0, the fourth compound may not be substituted with each of R₆₁ to R₆₄. The case where each of d1 to d4 is 4 and R₆₁'s to R₆₄' are each hydrogen atoms may be the same as the case where each of d1 to d4 is 0. When each of d1 to d4 is an integer of 2 or more, a plurality of R₆₁'s to R₆₄'s may each be the same or at least one among the plurality of R₆₁'s to R₆₄'s may be different from the others.

In Formula D-1, C1 to C4 may be each independently a substituted or unsubstituted hydrocarbon ring or a substituted or unsubstituted heterocycle represented by at least one of C-1 to C-4 below:

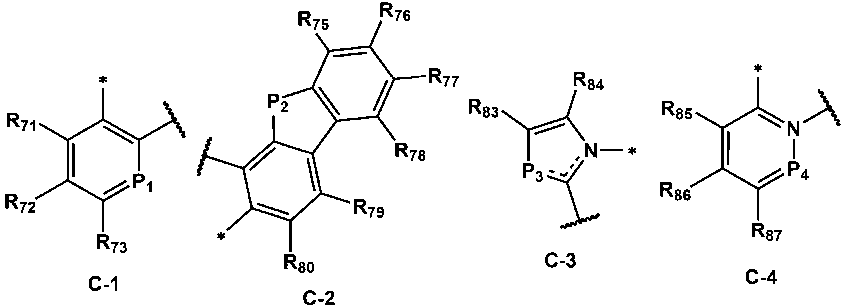

In C-1 to C-4, P₁ may be C-* or CR₇₄, P₂ may be N-* or NR₈₁, P₃ may be N-* or NR₈₂, and P₄ may be C-* or CR₈₈. R₇₁ to R₈₈ may be each independently a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring.

In addition, in C-1 to C-4, 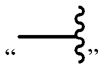 corresponds to a part linked to Pt that is a central metal atom, and "-*" corresponds to a part linked to a neighboring cyclic group (C1 to C4) or a linker (L₁₁ to L₁₃).

The emission layer EML of at least one example embodiment includes the first compound, which is a fused polycyclic compound, and may include at least one of the second to fourth compounds. For example, the emission layer EML may include the first compound, the second compound, and the third compound. In the emission layer EML, the second compound and the third compound may form an exciplex, and the energy may be transferred from the exciplex to the first compound, thereby emitting light.

In addition, the emission layer EML may include the first compound, the second compound, the third compound, and the fourth compound. In the emission layer EML, the second compound and the third compound may form an exciplex, and the energy may be transferred from the exciplex to the fourth compound and the first compound, thereby emitting light. In at least one example embodiment, the fourth compound may be a sensitizer. The fourth compound included in the emission layer EML in the light-emitting element ED of at least one example embodiment may serve as a sensitizer to deliver energy from the host to the first compound that is a light emitting dopant. That is, the fourth compound serving as an auxiliary dopant accelerates energy delivery to the first compound that is a light emitting dopant, thereby increasing the emission ratio of the first compound. Therefore, the emission layer EML of at least one example embodiment may improve emission efficiency. In addition, when the energy delivery to the first compound is increased, an exciton formed in the emission layer EML is not accumulated inside the emission layer EML and emits light rapidly, and thus deterioration of the device may be reduced. Therefore, the lifespan of the light-emitting element ED of at least one example embodiment may increase.

The light-emitting element ED of at least one example embodiment may include all of the first compound, the second compound, the third compound, and the fourth compound, and the emission layer EML may include the combination of two host materials and two dopant materials. In the light-emitting element ED of at least one example embodiment, the emission layer EML may simultaneously include the second compound and the third compound, which are two different hosts, the first compound that emits a delayed fluorescence, and the fourth compound including an organometallic complex, thereby exhibiting excellent emission efficiency characteristics.

In at least one example embodiment, the fourth compound represented by Formula D-1 may represent at least one among the compounds represented by Compound Group 4 below. The emission layer EML may include at least one among the compounds represented by Compound Group 4 as a sensitizer material.

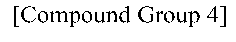

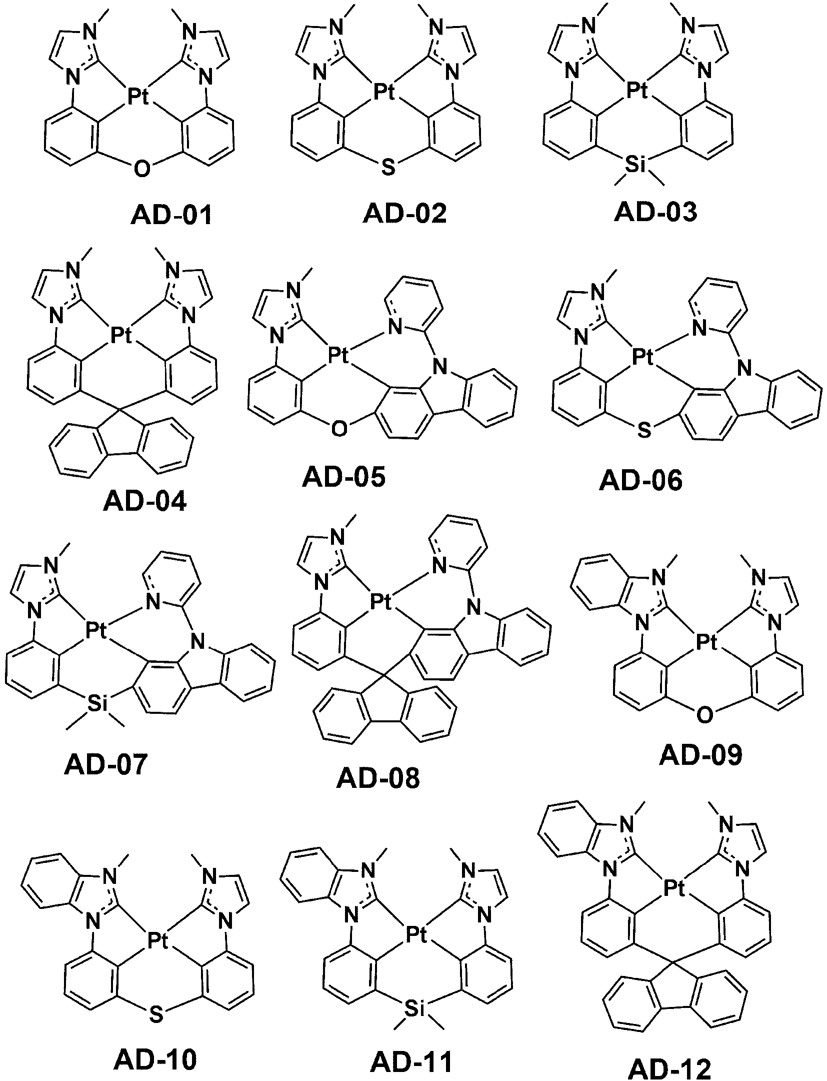

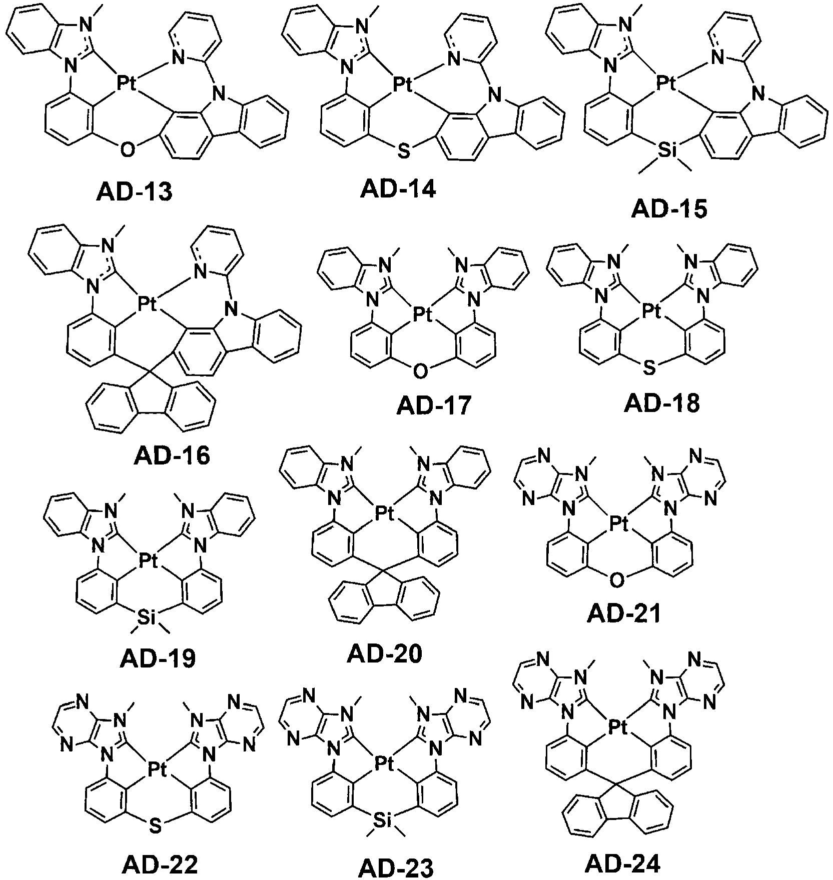

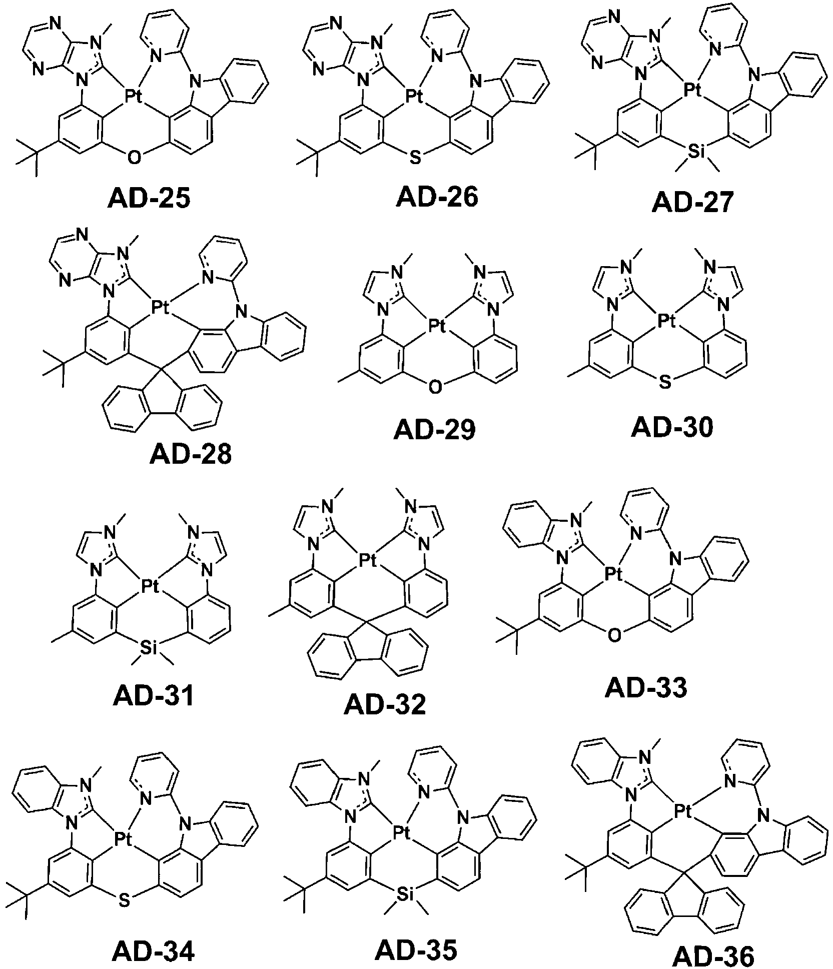

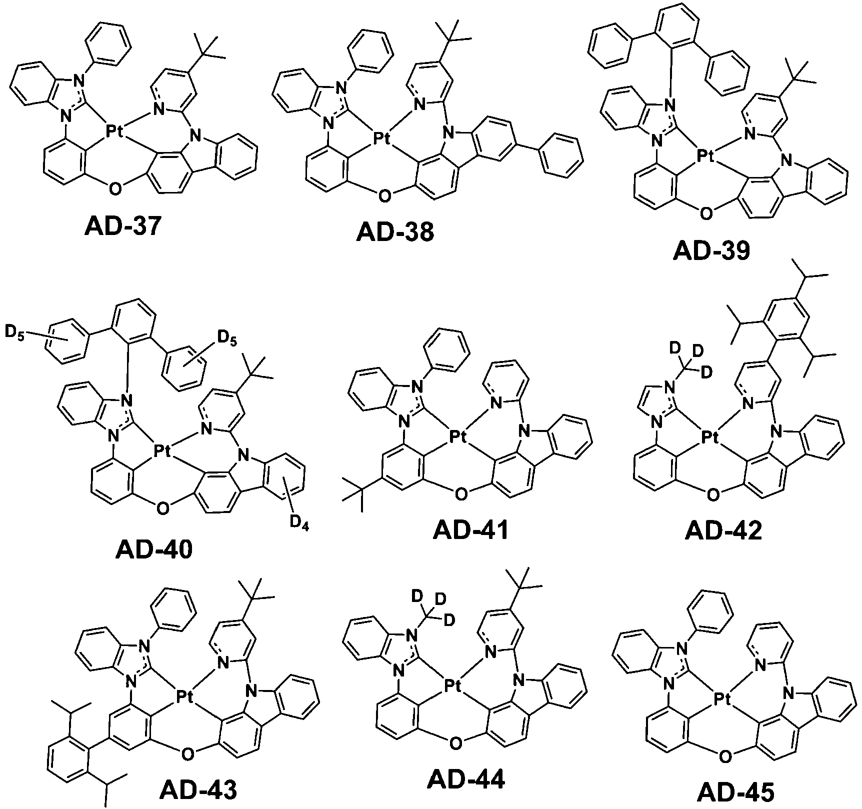

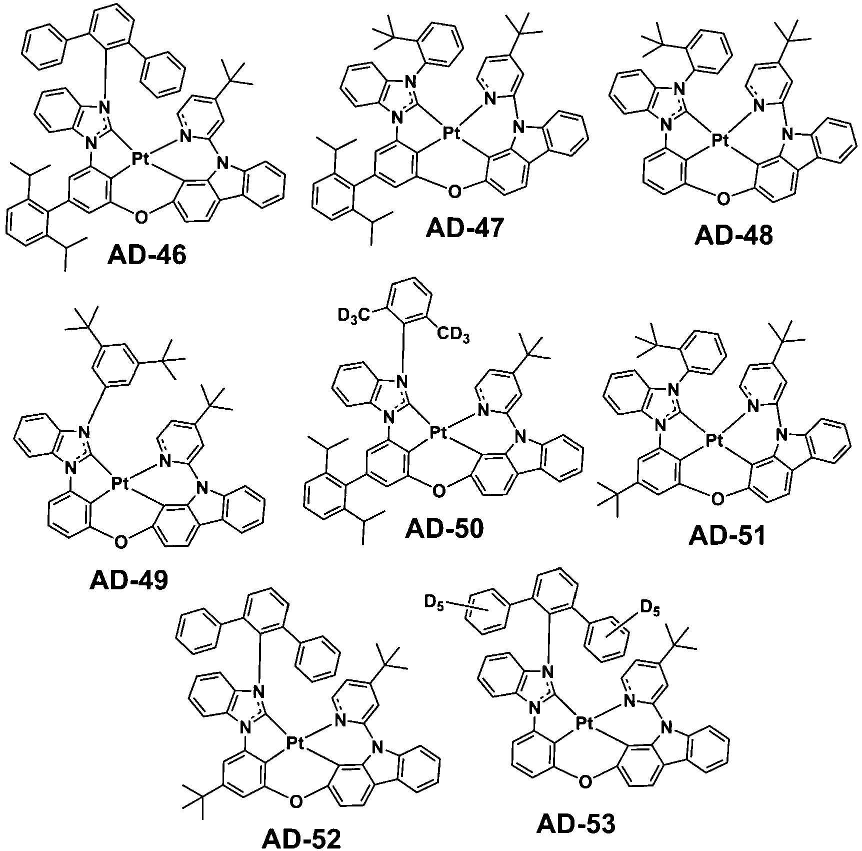

In the example compounds presented in Compound Group 4, "D" means a deuterium atom.

When the emission layer EML in the light-emitting element ED of at least one example embodiment includes all of the first compound, the second compound, and the third compound, with respect to the total weight of the first compound, the second compound, and the third compound, the content of the first compound may be about 0.1 wt% to about 5 wt%. However, the embodiment of the inventive concepts is not limited thereto. When the content of the first compound satisfies the above-described proportion, the energy transfer from the second compound and the third compound to the first compound may increase, and thus the emission efficiency and element service life may increase.

The contents of the second compound and the third compound in the emission layer EML may be the rest excluding the weight of the first compound. For example, the contents of the second compound and the third compound in the emission layer EML may be about 65 wt% to about 95 wt% with respect to the total weight of the first compound, the second compound, and the third compound.

In the total weight of the second compound and the third compound, the weight ratio of the second compound and the third compound may be about 3:7 to about 7:3.

When the contents of the second compound and the third compound satisfy the above-described ratio, a charge balance characteristic in the emission layer EML is improved, and thus the emission efficiency and element service life may increase. When the contents of the second compound and the third compound deviate from the above-described ratio range, a charge balance in the emission layer EML is broken, and thus the emission efficiency may be reduced and the device may be easily deteriorated.

When the emission layer EML includes the fourth compound, the content of the fourth compound in the emission layer EML may be about 10 wt% to about 30 wt% with respect to the total weight of the first compound, the second compound, the third compound, and the fourth compound. However, the examples embodiment are not limited thereto. When the content of the fourth compound satisfies the above-described content, the energy delivery from the host to the first compound, which is a light emitting dopant, may be increased, thereby a luminous ratio may be improved, and thus the emission efficiency of the emission layer EML may be improved. When the first compound, the second compound, the third compound, and the fourth compound included in the emission layer EML satisfy the above-described content ratio range, excellent emission efficiency and long service life may be achieved.

The emission layer EML is provided on the hole transport region HTR. The emission layer EML may have a thickness of, for example, about 100 Å to about 1,000 Å or about 100 Å to about 300 Å. The emission layer EML may have a single layer formed of a single material, a single layer formed of a plurality of different materials, or a multilayer structure having a plurality of layers formed of a plurality of different materials.

The emission layer EML may further include a compound described below in addition to the fused polycyclic compound of at least one example embodiment.

In the light-emitting element ED of at least one example embodiment, the emission layer EML may include an anthracene derivative, a pyrene derivative, a fluoranthene derivative, a chrysene derivative, a dehydrobenzanthracene derivative, or a triphenylene derivative. Specifically, the emission layer EML may include the anthracene derivative or the pyrene derivative.

In each light-emitting element ED illustrated in FIGS. 3 to 6, the emission layer EML may further include a host and dopant besides the above-described host and dopant, and for example the emission layer EML may include a compound represented by Formula E-1 below. The compound represented by Formula E-1 below may be used as a fluorescent host material.

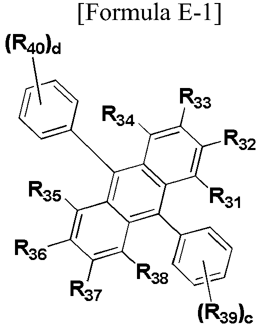

In Formula E-1, R₃₁ to R₄₀ may be each independently a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. R₃₁ to R₄₀ may be bonded to an adjacent group to form a saturated hydrocarbon ring or an unsaturated hydrocarbon ring, a saturated heterocycle, or an unsaturated heterocycle.

In Formula E-1, c and d may be each independently an integer of 0 to 5.

Formula E-1 may be represented by at least one of Compound El to Compound E21 below.

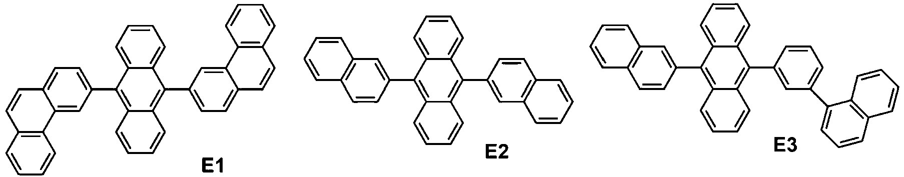

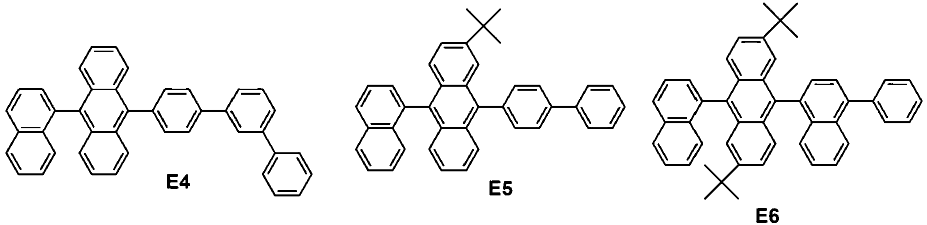

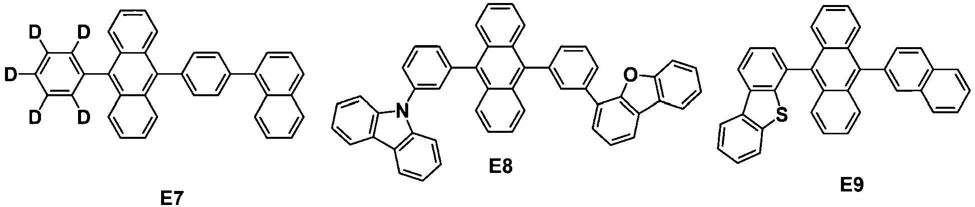

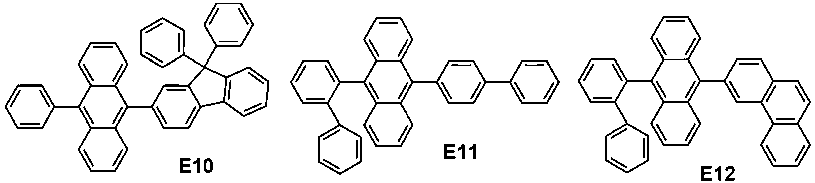

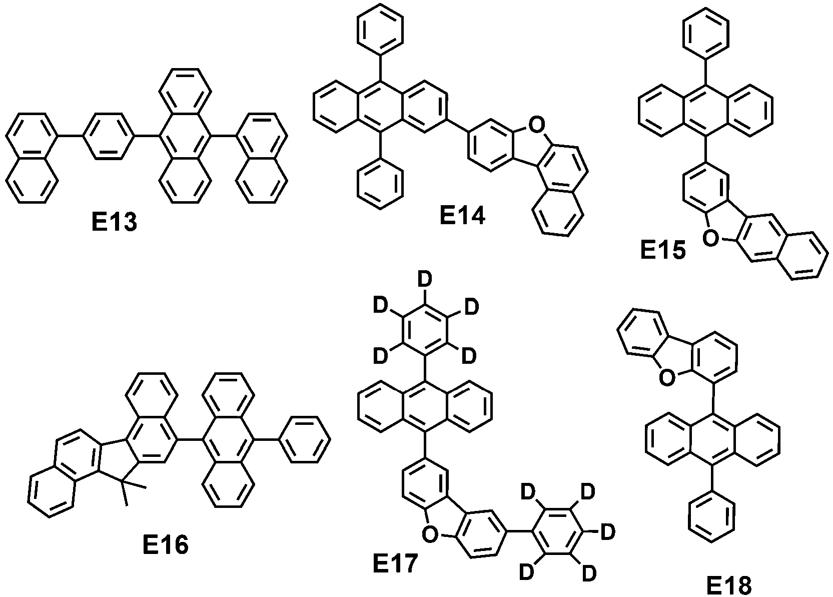

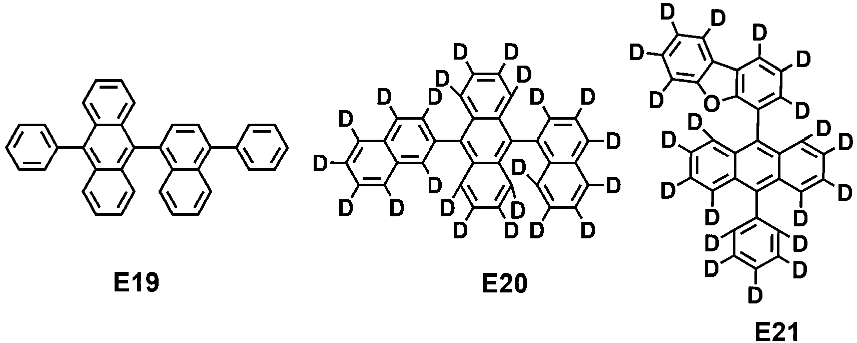

In at least one example embodiment, the emission layer EML may include a compound represented by Formula E-2a or Formula E-2b below. The compound represented by Formula E-2a or Formula E-2b below may be used as a host material of the phosphorescent emission layer.

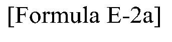

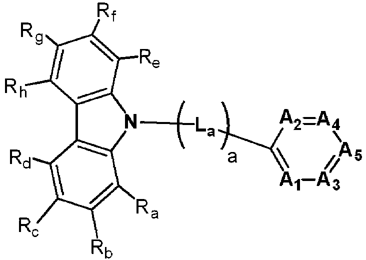

In Formula E-2a, a may be an integer of 0 to 10, and Lₐ may be a direct linkage, a substituted or unsubstituted arylene group having 6 to 30 ring-forming carbon atoms, or a substituted or unsubstituted heteroarylene group having 2 to 30 ring-forming carbon atoms. When a is an integer of 2 or greater, a plurality of Lₐ's may be each independently a substituted or unsubstituted arylene group having 6 to 30 ring-forming carbon atoms, or a substituted or unsubstituted heteroarylene group having 2 to 30 ring-forming carbon atoms.

In addition, in Formula E-2a, A₁ to A₅ may be each independently N or CRᵢ. Rₐ to Rᵢ may be each independently a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. Rₐ to Rᵢ may be bonded to an adjacent group to form a hydrocarbon ring or a heterocycle containing N, O, *S, etc.,* as a ring-forming atom.

In Formula E-2a, two or three selected from among A₁ to A₅ may be N, and the rest may be CRᵢ.

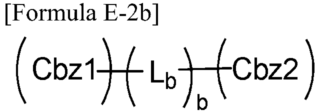

In Formula E-2b, Cbz1 and Cbz2 may be each independently an unsubstituted carbazole group, or a carbazole group substituted with an aryl group having 6 to 30 ring-forming carbon atoms. L_{b} is a direct linkage, a substituted or unsubstituted arylene group having 6 to 30 ring-forming carbon atoms, or a substituted or unsubstituted heteroarylene group having 2 to 30 ring-forming carbon atoms. b is an integer of 0 to 10, and when b is an integer of 2 or more, a plurality of L_{b}'s may be each independently a substituted or unsubstituted arylene group having 6 to 30 ring-forming carbon atoms, or a substituted or unsubstituted heteroarylene group having 2 to 30 ring-forming carbon atoms.

In at least some example embodiments, the compound represented by Formula E-2a or Formula E-2b may be represented by at least one of the compounds of Compound Group E-2 below.

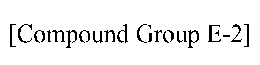

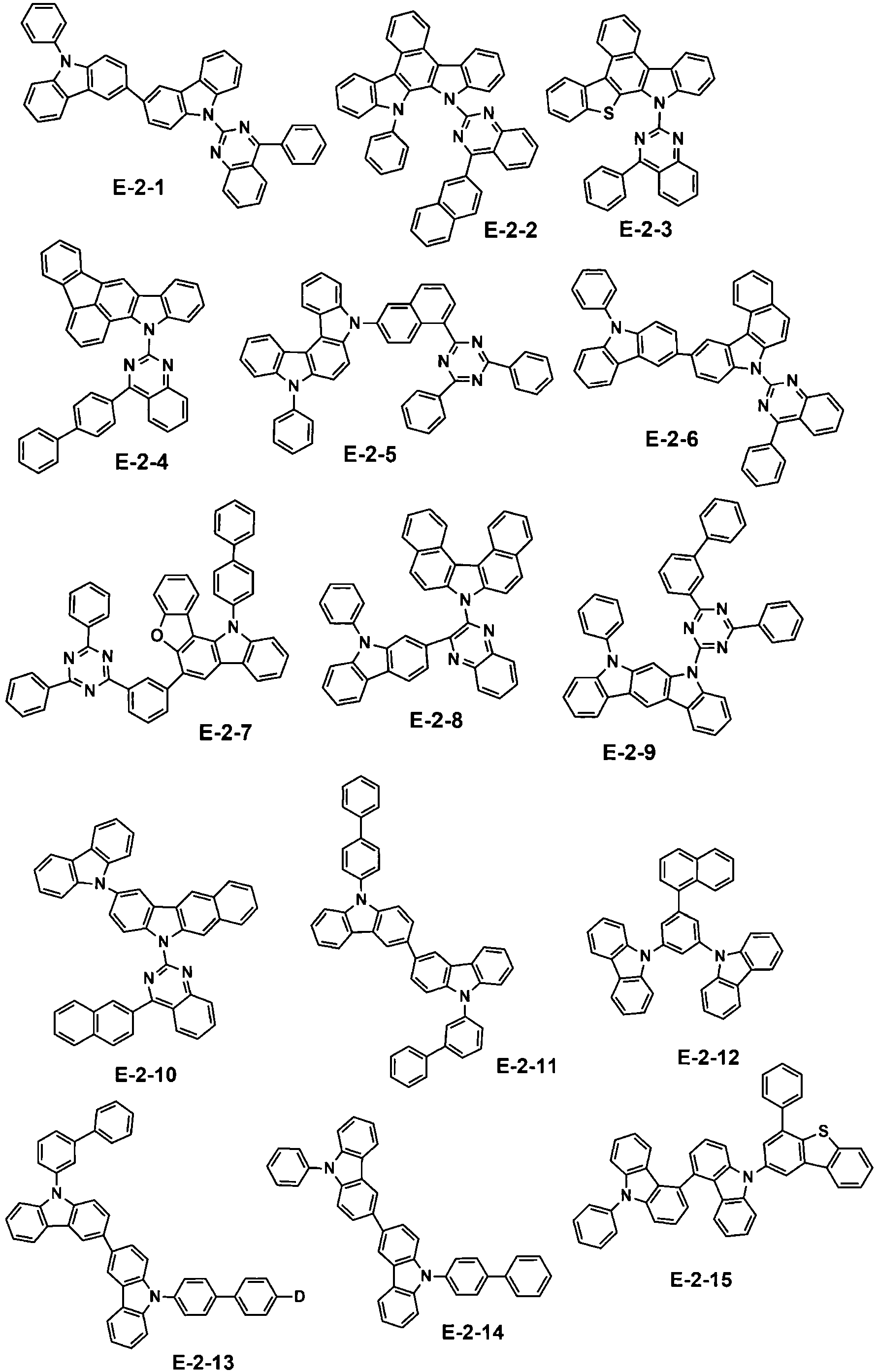

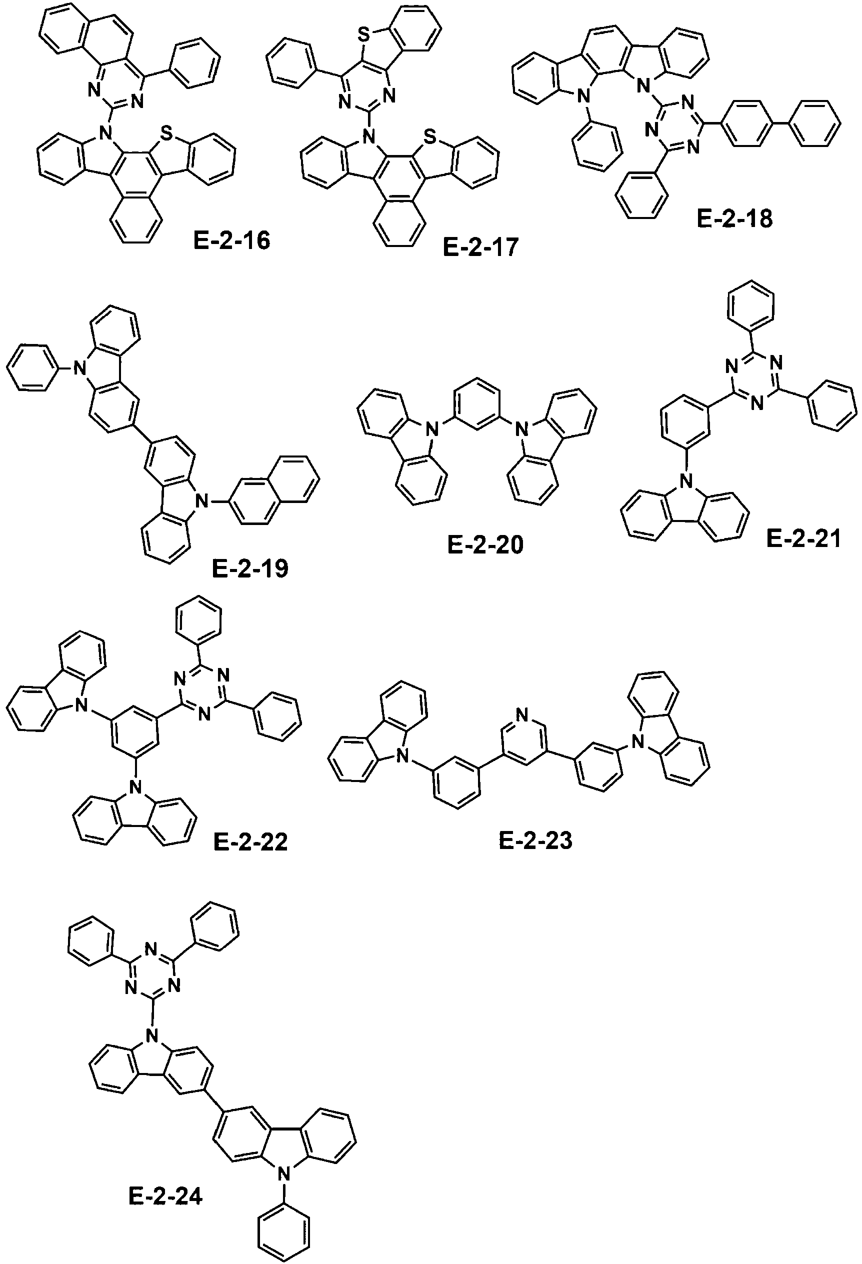

The emission layer EML may further include a general material in the art as a host material. For example, the emission layer EML may include, as a host material, at least one of bis(4-(9H-carbazol-9-yl)phenyl)diphenylsilane (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), and 1,3,5-tris(1-phenyl-1H-benzo[d]imidazole-2-yl)benzene (TPBi). However, the embodiment of the inventive concepts is not limited thereto, for example, tris(8-hydroxyquinolino)aluminium (Alq₃), 9,10-di(naphthalen-2-yl)anthracene (ADN), *2-tert-butyl-9,10-di(naphth-2-yl)anthracene* (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO₃), octaphenylcyclotetrasiloxane (DPSiO₄), *etc.* may be used as a host material.

The emission layer EML may include the compound represented by Formula M-a below. The compound represented by Formula M-a below may be used as a phosphorescent dopant material.

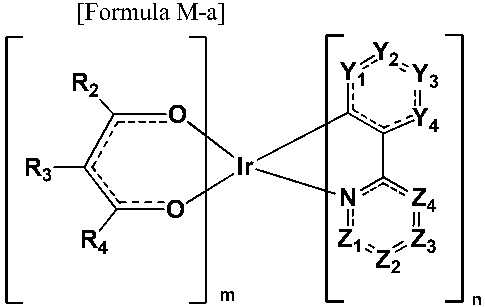

In Formula M-a above, Y₁ to Y₄ and Z₁ to Z₄ may be each independently CR₁ or N, R₁ to R₄ may be each independently a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. In Formula M-a, m is 0 or 1, and n is 2 or 3. In Formula Ma, when m is 0, n is 3, and when m is 1, n is 2.

The compound represented by Formula M-a may be used as a phosphorescent dopant.

In at least some example embodiments, the compound represented by Formula M-a may be represented by at least one of Compound M-a1 to Compound M-a25 below.

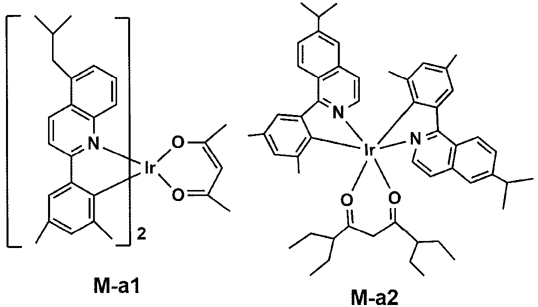

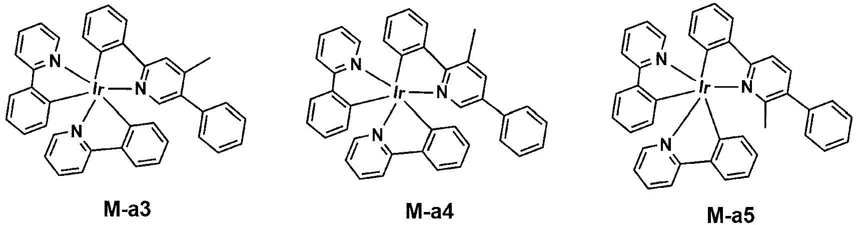

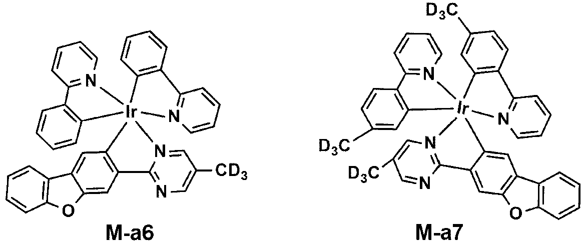

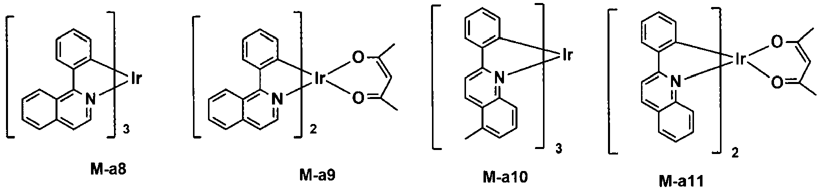

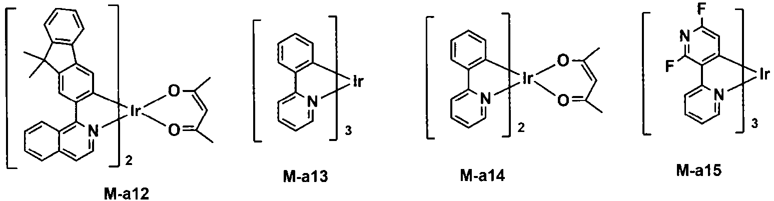

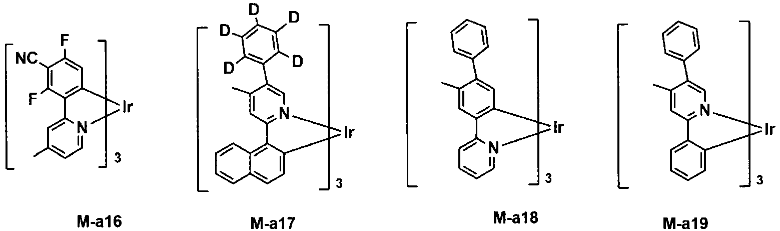

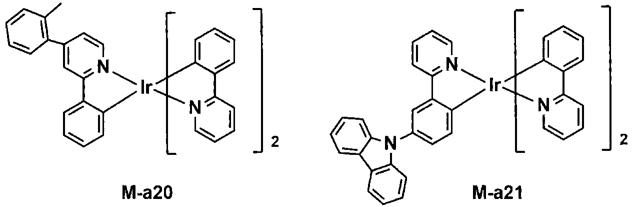

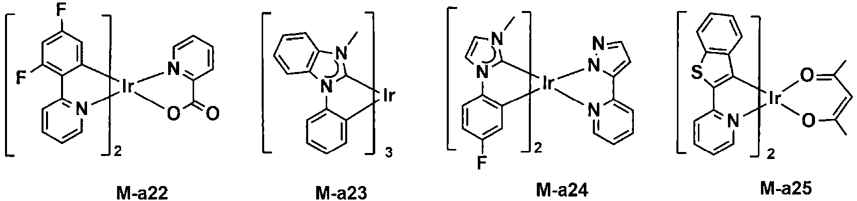

The emission layer EML may include a compound represented by at least one of Formula F-a to Formula F-c below. The compound represented by Formula F-a to Formula F-c below may be used as a fluorescence dopant material.

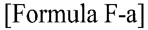

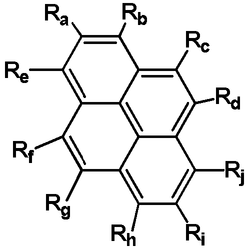

In Formula F-a above, two selected from among Rₐ to Rⱼ may each independently be substituted with *-NAr₁Ar₂. The others, which are not substituted with *-NAr₁Ar₂, among Rₐ to Rⱼ may be each independently a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In *-NAr₁Ar₂, Ar₁ and Ar₂ may be each independently a substituted or unsubstituted aryl group having 6 to 30 ring-forming carbon atoms, or a substituted or unsubstituted heteroaryl group having 2 to 30 ring-forming carbon atoms. For example, at least one of Ar₁ or Ar₂ may be a heteroaryl group containing O or S as a ring-forming atom.

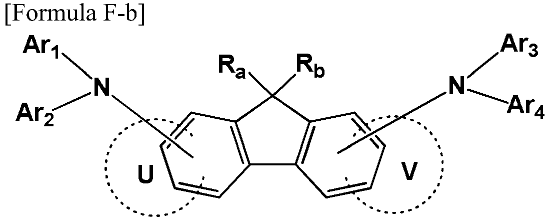

In Formula F-b above, Rₐ and R_{b} may be each independently a hydrogen atom, a deuterium atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. Ar₁ to Ar₄ may be each independently a substituted or unsubstituted aryl group having 6 to 30 ring-forming carbon atoms, or a substituted or unsubstituted heteroaryl group having 2 to 30 ring-forming carbon atoms.

In Formula F-b, U and V may be each independently a substituted or unsubstituted hydrocarbon ring having 5 to 30 ring-forming carbon atoms, or a substituted or unsubstituted heterocycle having 2 to 30 ring-forming carbon atoms. At least one among Ar₁ to Ar₄ may be a heteroaryl group containing O or S as a ring-forming atom.

In Formula F-b, the number of rings represented by U and V may be each independently 0 or 1. For example, in Formula F-b, it means that when the number of U or V is 1, one ring constitutes a fused ring at a portion indicated by U or V, and when the number of U or V is 0, a ring indicated by U or V does not exist. Specifically, when the number of U is 0 and the number of V is 1, or when the number of U is 1 and the number of V is 0, the fused ring having a fluorene core in Formula F-b may be a cyclic compound having four rings. In addition, when each number of U and V is 0, the fused ring in Formula F-b may be a cyclic compound having three rings. In addition, when each number of U and V is 1, the fused ring having a fluorene core in Formula F-b may be a cyclic compound having five rings.

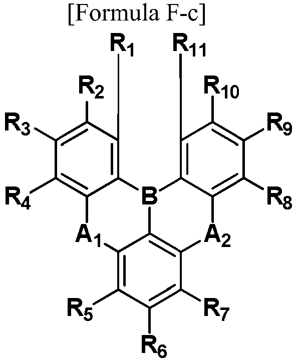

In Formula F-c, A₁ and A₂ may be each independently O, S, Se, or NRₘ, and Rₘ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. R₁ to R₁₁ are each independently a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or are bonded to an adjacent group to form a ring.

In Formula F-c, A₁ and A₂ may each independently be bonded to substituents of an adjacent ring to form a fused ring. For example, when A₁ and A₂ are each independently NRₘ, A₁ may be bonded to R₄ or R₅ to form a ring. In addition, A₂ may be bonded to R₇ or R₈ to form a ring.

In at least one example embodiment, the emission layer EML may further include, as a dopant material, a styryl derivative *(e.g.,* 1,4-bis[2-(3-N-ethylcarbazolyl)vinyl]benzene (BCzVB), 4-(di-p-tolylamino)-4'-[(di-p-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi), perylene and a derivative thereof *(e.g.,* 2,5,8,11-tetra-t-butylperylene (TBP)), pyrene and a derivative thereof *(e.g.,* 1,1-dipyrene, 1,4-dipyrenylbenzene, 1,4-bis(N,N-diphenylamino)pyrene), *etc.*

The emission layer EML may further include a phosphorescence dopant material. For example, a metal complex containing iridium (Ir), platinum (Pt), osmium (Os), gold (Au), titanium (Ti), zirconium (Zr), hafnium (Hf), europium (Eu), terbium (Tb), and/or thulium (Tm) may be used as a phosphorescent dopant. Specifically, iridium(III) bis(4,6-difluorophenylpyridinato-N,C2')picolinate) (FIrpic), bis(2,4-difluorophenylpyridinato)-tetrakis(1-pyrazolyl)borate iridium(III) (Fir6), and platinum octaethyl porphyrin (PtOEP) may be used as a phosphorescent dopant. However, the embodiment of the inventive concepts is not limited thereto.

The emission layer EML may include a quantum dot material. A core of the quantum dot may be selected from a group II-VI compound, a group I-II-VI compound, a group II-IV-VI compound, a group I-II-IV-VI compound, a group II-IV-V compound, a group III-VI compound, a group I-III-VI compound, a group III-V compound, a group III-II-V compound, a group IV-VI compound, a group IV element, a group IV compound, and a combination thereof.

The group II-VI compound may be at least one of: a binary compound (e.g., at least one of CdSe, CdTe, CdS, ZnS, ZnSe, ZnTe, ZnO, HgS, HgSe, HgTe, MgSe, MgS and a mixture thereof); a ternary compound (e.g., at least one of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof); and a quaternary compound (e.g., at least one of HgZnTeS, CdZnSeS, CdZnSeTe, CdZnSTe, CdHgSeS, CdHgSeTe, CdHgSTe, HgZnSeS, HgZnSeTe, and a mixture thereof).

The group II-VI compound may further include a group I metal and/or a group IV element. The group I-II-VI compound may be at least one of CuSnS or CuZnS, and ZnSnS or the like may be selected as the group II-IV-VI compound. The group I-II-IV-VI compound may be selected from a quaternary compound including at least one of Cu₂ZnSnS₂, Cu₂ZnSnS₄, Cu₂ZnSnSe₄, Ag₂ZnSnS₂", and a mixture thereof.

The group II-IV-V compound may be at least one of a ternary compound selected from, e.g., ZnSnP, ZnSnP₂, ZnSnAs₂, ZnGeP₂, ZnGeAs₂, CdSnP₂, CdGeP₂, and a mixture thereof.

The group III-VI compound may include a binary compound such as GaS, Ga₂S₃, GaSe, Ga₂Se₃, GaTe, InTe, InS, InSe, In₂S₃, and In₂Se₃, a ternary compound such as InGaS₃, and InGaSe₃, or any combination thereof.

The group I-III-VI compound may be selected from: a ternary compound including at least one of AgInS, AgInS₂, CuInS, CuInS₂, AgGaS₂, CuGaS₂ CuGaO₂, AgGaO₂, AgAlO₂, or a mixture thereof; and quaternary compounds such as AgInGaS₂, and CuInGaS₂.

The group III-V compound may include at least one of a binary compound (including, e.g., at least one of GaN, GaP, GaAs, GaSb, AlN, AlP, AlAs, AlSb, InN, InP, InAs, InSb, and a mixture thereof); a ternary compound (including, e.g., at least one of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a mixture thereof); and a quaternary (including, e.g., at least one of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof). The group III-V compound may further include a group II metal. For example, InZnP, and the like may be selected as the group III-II-V compound.

The group IV-VI compound may include at least one of: a binary compound (including, e.g., at least one of SnS, SnSe, SnTe, PbS, PbSe, PbTe, and a mixture thereof); a ternary compound (including, e.g., at least one of SnSeS, SnSeTe, SnSTe, PbSeS, PbSeTe, PbSTe, SnPbS, SnPbSe, SnPbTe, and a mixture thereof); and a quaternary compound (including, e.g., at least one of SnPbSSe, SnPbSeTe, SnPbSTe, and a mixture thereof). The group IV element may be, for example, Si, Ge, and a mixture thereof. The group IV compound may be a binary compound such as SiC, SiGe, and a mixture thereof.

Each element contained in a multi-component compound such as the binary compound, the ternary compound, and the quaternary compound may be present in a particle at a uniform concentration or non-uniform concentration. That is, the Formulas above may show types of elements included in the compound, and element ratios in the compound may vary. For example, AgInGaS₂ may indicate AgInₓGa₁₋ₓS₂ (where x is a real number between 0 to 1).

The quantum dot may have a core-shell dual structure or a single structure in which a concentration of each element included in the corresponding quantum dot is uniform. For example, a material included in the core may be different from a material included in the shell.

The shell of the quantum dot may serve as a protection layer for preventing the core from being chemically modified to maintain semiconductor properties and/or as a charging layer for imparting electrophoretic properties to the quantum dot. The shell may have a single layer or multilayer. An interface between the core and the shell may have a concentration gradient in which a concentration of an element presents in the shell decreases toward the core.

In some example embodiments, the quantum dot may have a core-shell structure that includes a core including the above-described nanoparticle, and a shell surrounding the core. Examples of the shell of quantum dot may include an oxide of metal or non-metal, a semiconductor compound, or a combination thereof.

For example, the oxide of metal or non-metal may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and NiO, or a ternary compound such as MgAl₂O₄, CoFe₂O₄, NiFe₂O₄, and CoMn₂O₄, but the inventive concepts are not limited thereto.

In addition, examples of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, etc., but the inventive concepts are not limited thereto.

Each element contained in a multi-component compound such as the binary compound and the ternary compound may be present in a particle at a uniform concentration or non-uniform concentration. That is, the Formulas above may refer to types of elements included in the compound, and element ratios in the compound may vary.

The quantum dot may have a full width of half maximum (FWHM) of about 45 nm or less, specifically about 40 nm or less, or more specifically about 30 nm or less in a light-emitting wavelength spectrum, and color purity and color reproduction may be improved in this range. In addition, light emitted through the quantum dot is emitted in all directions, and thus an optical viewing angle may be improved.

In addition, the type (e.g., shape) of the quantum dot is not particularly limited. For example, the quantum dot may be spherical, pyramidal, multi-arm-shaped, a cubic nanoparticle, a nanotube, a nanowire, a nanofiber, a nanoplate particle, etc.

An energy band gap may be controlled by controlling the size of the quantum dot or by controlling the element ratio in the quantum dot compound, and thus light with various wavelength bands may be emitted from the quantum dot emission layer. Therefore, it is possible to achieve the light-emitting elements emitting light with various wavelengths by using such a quantum dot (in which quantum dots having different sizes are used or element ratios in a quantum dot compound are made different). Specifically, the size of the quantum dot and the element ratio in the quantum dot compound may be selected such that red, green, or blue light is emitted. In addition, the quantum dots may be configured to emit white light by combining various colors of light.

In each of the light-emitting elements ED of embodiments illustrated in FIGS. 3 to 6, the electron transport region ETR is provided on the emission layer EML. The electron transport region ETR may include at least one of the hole blocking layer HBL, the electron transport layer ETL, and the electron injection layer EIL, but the embodiment of the inventive concepts is not limited thereto.

The electron transport region ETR may have a single layer formed of a single material, a single layer formed of a plurality of different materials, or a multilayer structure including a plurality of layers formed of a plurality of different materials.

For example, the electron transport region ETR may have a single layer structure of the electron injection layer EIL or the electron transport layer ETL, or may have a single layer structure formed of an electron injection material and an electron transport material. In addition, the electron transport region ETR may have a single layer structure formed of a plurality of different materials, or may have a structure in which an electron transport layer ETL/electron injection layer EIL, a hole blocking layer HBL/electron transport layer ETL/electron injection layer EIL are stacked in order from the emission layer EML, but the embodiment of the inventive concepts is not limited thereto. The electron transport region ETR may have a thickness, for example, from about 1,000 Å to about 1,500 Å.

The electron transport region ETR may be formed using various methods such as a vacuum deposition method, a spin coating method, a cast method, a Langmuir-Blodgett (LB) method, an inkjet printing method, a laser printing method, and a laser induced thermal imaging (LITI) method.

The electron transport region ETR may include a compound represented by Formula ET-2 below:

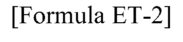

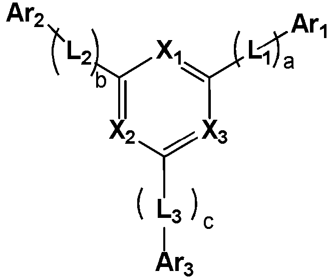

In Formula ET-2, at least one among X₁ to X₃ is N, and the rest are CRₐ. Rₐ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. Ar₁ to Ar₃ may be each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may be each independently an integer of 0 to 10. In Formula ET-2, Li to L₃ may be each independently a direct linkage, a substituted or unsubstituted arylene group having 6 to 30 ring-forming carbon atoms, or a substituted or unsubstituted heteroarylene group having 2 to 30 ring-forming carbon atoms. When a to c are each independently an integer of 2 or more, L₁ to L₃ may be each independently a substituted or unsubstituted arylene group having 6 to 30 ring-forming carbon atoms, or a substituted or unsubstituted heteroarylene group having 2 to 30 ring-forming carbon atoms.

The electron transport region ETR may include an anthracene-based compound. However, the embodiment of the inventive concepts is not limited thereto, and the electron transport region ETR may include, for example, tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminum (BAlq), beryllium bis(benzoquinolin-10-olate) (Bebq₂), 9,10-di(naphthalen-2-yl)anthracene (ADN), 1,3-bis[3,5-di(pyridin-3-yl)phenyl]benzene (BmPyPhB), or a mixture thereof.

The electron transport region ETR may include at least one among Compound ET1 to Compound ET36 below.

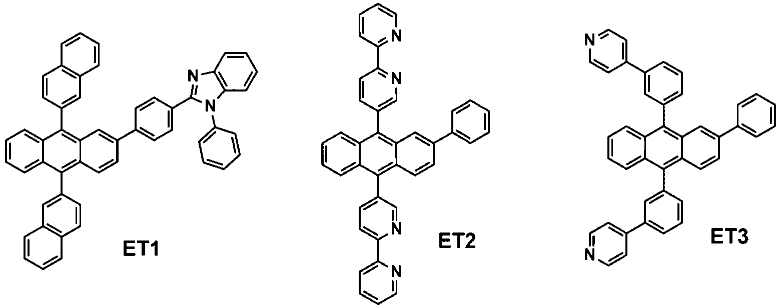

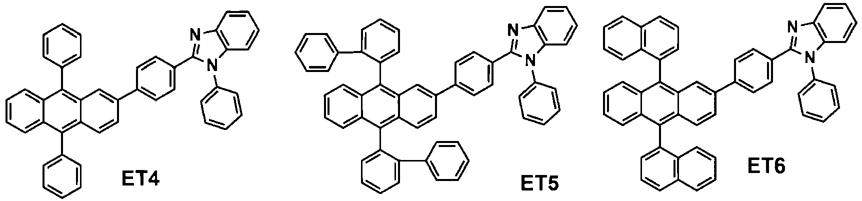

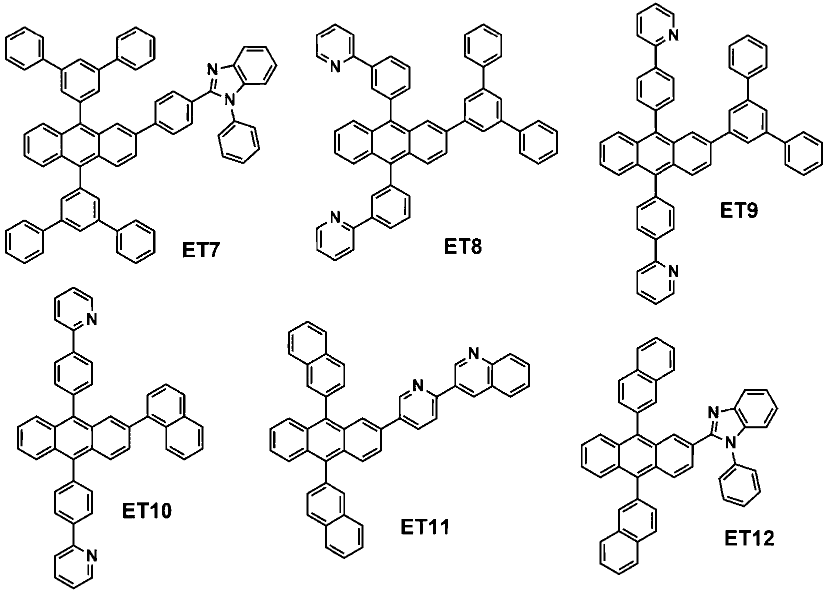

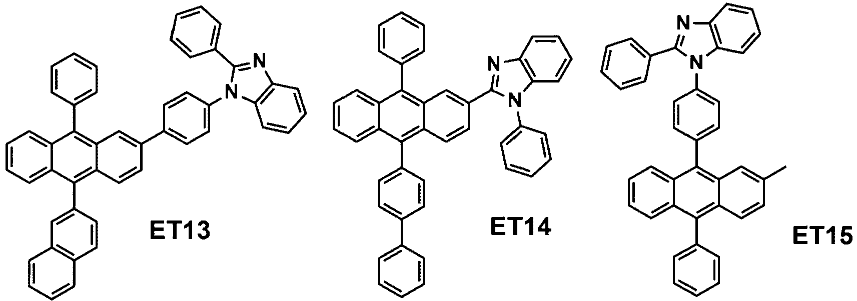

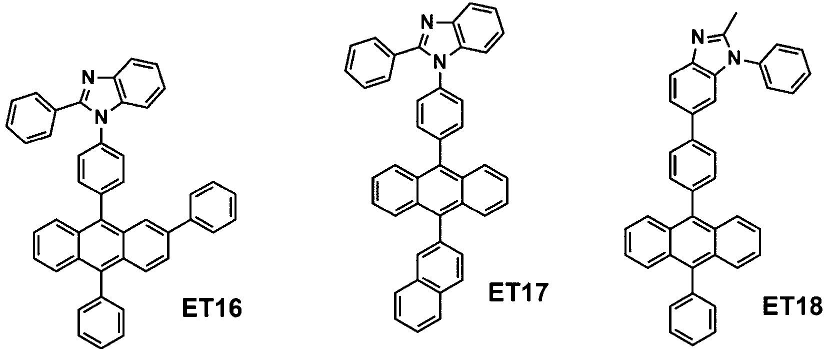

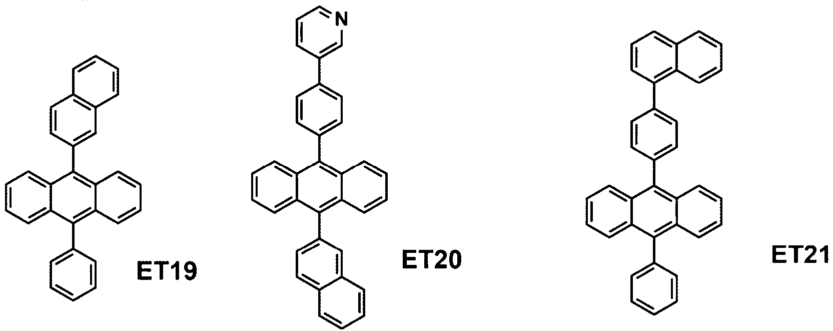

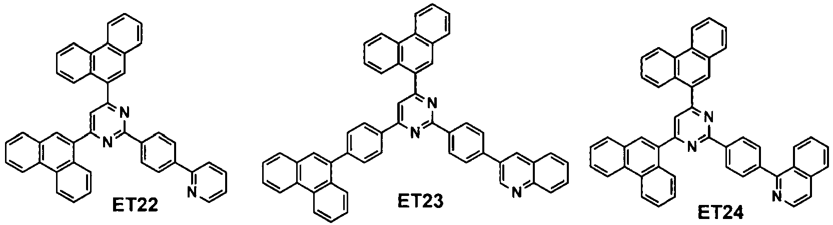

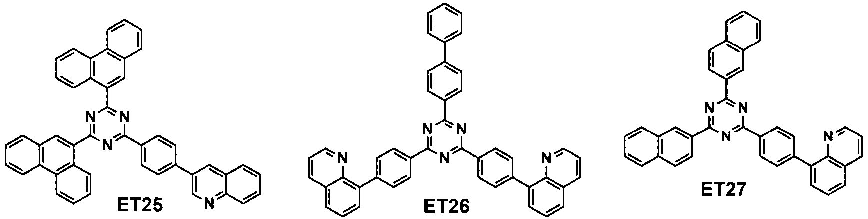

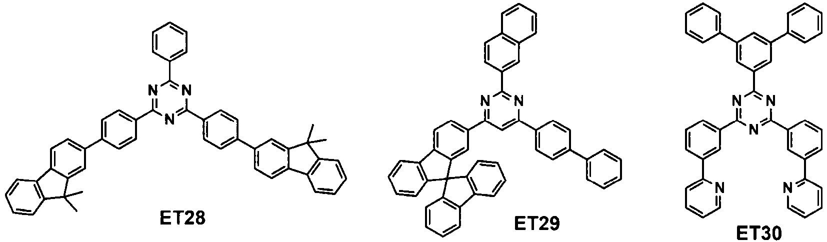

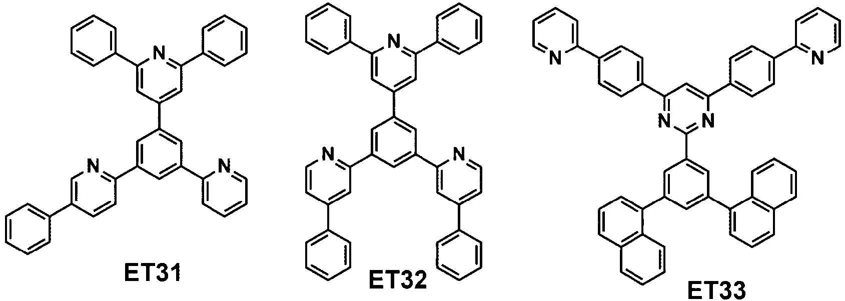

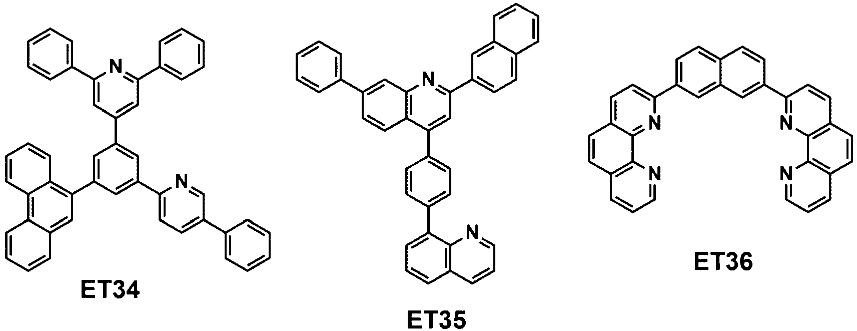

In addition, the electron transport region ETR may include a metal halide such as LiF, NaCl, CsF, RbCl, RbI, CuI, and KI, a lanthanide metal such as Yb, or a co-deposited material of the metal halide and the lanthanide metal. For example, the electron transport region ETR may include KI:Yb, RbI:Yb, LiF:Yb, *etc.,* as a co-deposited material. The electron transport region ETR may be formed using a metal oxide such as Li₂O or BaO, and 8-hydroxyl-lithium quinolate (Liq), *etc.,* but the embodiment of the inventive concepts is not limited thereto. The electron transport region ETR may also be formed of a mixture material of an electron transport material and an insulating organometallic salt. The organometallic salt may be a material having an energy band gap of about 4 eV or more. Specifically, the organometallic salt may include, for example, a metal acetate, a metal benzoate, a metal acetoacetate, a metal acetylacetonate, or a metal stearate.

The electron transport region ETR may further include at least one of 2,9-dimethyl-4,7-diphenyl-1,10-phenanthroline (BCP), diphenyl(4-(triphenylsilyl)phenyl)phosphine oxide (TSPO1), and 4,7-diphenyl-1,10-phenanthroline (Bphen) in addition to the above-described materials, but the embodiment of the inventive concepts is not limited thereto.

The electron transport region ETR may include the above-described compounds of the hole transport region in at least one of the electron injection layer EIL, the electron transport layer ETL, and the hole blocking layer HBL.

When the electron transport region ETR includes the electron transport layer ETL, the electron transport layer ETL may have a thickness of about 100 Å to about 1,000 Å, for example, about 150 Å to about 500 Å. If the thickness of the electron transport layer ETL satisfies the aforementioned range, satisfactory electron transport characteristics may be obtained without a substantial increase in driving voltage. When the electron transport region ETR includes the electron injection layer EIL, the electron injection layer EIL may have a thickness of about 1 Å to about 100 Å, for example, about 3 Å to about 90 Å. If the thickness of the electron injection layer EIL satisfies the above-described range, satisfactory electron injection characteristics may be obtained without a substantial increase in driving voltage.

The second electrode EL2 is provided on the electron transport region ETR. The second electrode EL2 may be a common electrode. The second electrode EL2 may be a cathode or an anode, but the embodiment of the inventive concepts is not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is the transmissive electrode, the second electrode EL2 may be formed of a transparent metal oxide, for example, indium tin oxide (ITO), indium zinc oxide (IZO), zinc oxide (ZnO), indium tin zinc oxide (ITZO), *etc.*

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, Na or a compound or mixture thereof (e.g., AgMg, AgYb, MgYb, AgLi, or AgNa). Alternatively, the second electrode EL2 may have a multilayer structure including a reflective film or a transflective film formed of the above-described materials, or a transparent conductive film formed of ITO, IZO, ZnO, ITZO, *etc.* For example, the second electrode EL2 may include the above-described metal materials, combinations of at least two metal materials of the above-described metal materials, oxides of the above-described metal materials, and the like.

Although not shown, the second electrode EL2 may be connected with an auxiliary electrode. If the second electrode EL2 is connected with the auxiliary electrode, the resistance of the second electrode EL2 may be decreased.

A capping layer CPL may further be disposed on the second electrode EL2 of the light-emitting element ED of at least one example embodiment. The capping layer CPL may include a multilayer or a single layer.

In at least one example embodiment, the capping layer CPL may be or include an organic layer and/or an inorganic layer. For example, when the capping layer CPL contains an inorganic material, the inorganic material may include an alkaline metal compound (e.g., LiF), an alkaline earth metal compound *(e.g.,* MgF₂), SiON, SiNₓ, SiO_{y}, *etc.*

For example, when the capping layer CPL includes an organic material, the organic material may include α-NPD, NPB, TPD, m-MTDATA, Alq₃, CuPc, N4,N4,N4',N4'-tetra(biphenyl-4-yl)biphenyl-4,4'-diamine (TPD15), 4,4',4"-tris(carbazol-9-yl)triphenylamine (TCTA), etc., or an epoxy resin, or acrylate such as methacrylate. However, the example embodiments are not limited thereto, and the capping layer CPL may include at least one of Compounds P1 to P5 below.

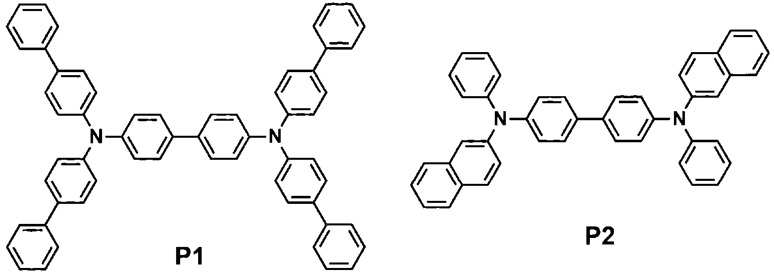

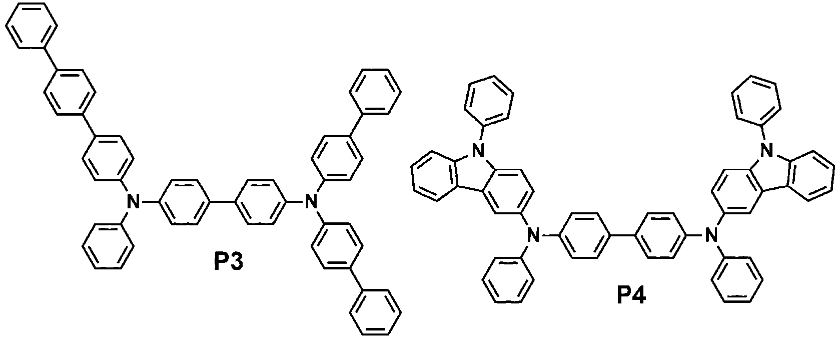

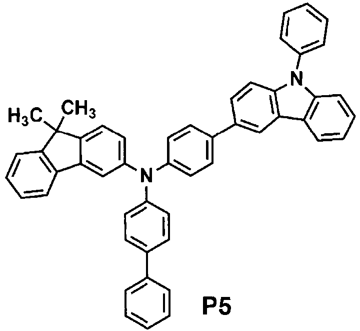

The refractive index of the capping layer CPL may be about 1.6 or more. Specifically, the refractive index of the capping layer CPL may be about 1.6 or more with respect to light in a wavelength range of about 550 nm to about 660 nm.

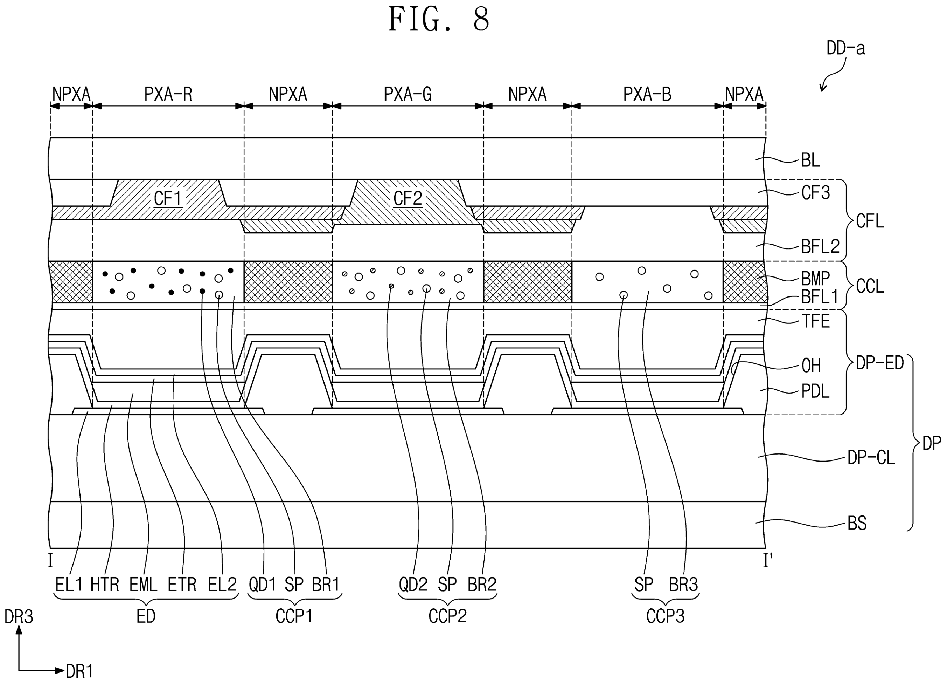

FIG. 8 to FIG. 11 are cross-sectional views of display devices according to embodiments. Hereinafter, in the explanation on the display devices according to embodiments, referring to FIG. 8 to FIG. 11, the overlapping contents with those explained in FIG. 1 to FIG. 7B will not be explained again, and different points will be explained mainly.

Referring to FIG. 8, a display device DD-a according to at least one example embodiment may include a display panel DP including a display element layer DP-ED, a light control layer CCL disposed on the display panel DP and a color filter layer CFL. In at least one example embodiment shown in FIG. 8, the display panel DP may include a base layer BS, a circuit layer DP-CL provided on the base layer BS and a display element layer DP-ED, and the display element layer DP-ED may include a light-emitting element ED.

The light-emitting element ED may include a first electrode EL1, a hole transport region HTR disposed on the first electrode EL1, an emission layer EML disposed on the hole transport region HTR, an electron transport region ETR disposed on the emission layer EML, and a second electrode EL2 disposed on the electron transport region ETR. The same structure as the light-emitting elements ED of FIG. 3 to FIG. 6 may be applied to the structure of the light-emitting element ED, shown in FIG. 8. The light-emitting element ED shown in FIG. 8 includes the fused polycyclic compound of at least one example embodiment. The light-emitting element ED including the fused polycyclic compound of at least one example embodiment may exhibit high emission efficiency and long lifespan.

Referring to FIG. 8, the emission layer EML may be disposed in an opening OH defined in a pixel defining film PDL. For example, the emission layer EML which is divided by the pixel defining film PDL and provided corresponding to each light emitting region PXA-R, PXA-G, and PXA-B may emit light in the same wavelength range. In the display device DD-a of at least one example embodiment, the emission layer EML may emit blue light. Unlike the configuration illustrated, in at least one example embodiment, the emission layer EML may be provided as a common layer in the entire light emitting regions PXA-R, PXA-G, and PXA-B.

The light control layer CCL may be disposed on the display panel DP. The light control layer CCL may include a light conversion body. The light conversion body may emit provided light by converting the wavelength thereof. The light conversion body may be a quantum dot, a phosphor, and the like. That is, the light control layer CCL may be a layer containing the quantum dot or a layer containing the phosphor.

The light control layer CCL may include a plurality of light control parts CCP1, CCP2 and CCP3. The light control parts CCP1, CCP2, and CCP3 may be spaced apart from each other.

Referring to FIG. 8, divided patterns BMP may be disposed between the light control parts CCP1, CCP2 and CCP3 which are spaced apart from each other, but the embodiment of the inventive concepts is not limited thereto. FIG. 8 illustrates that the divided patterns BMP do not overlap the light control parts CCP1, CCP2 and CCP3, but at least a portion of the edges of the light control parts CCP1, CCP2 and CCP3 may overlap the divided patterns BMP.

The light-emitting element ED may emit first color light. The light control layer CCL may include a first light control part CCP1 containing a first quantum dot QD1 which converts first color light provided from the light-emitting element ED into second color light, a second light control part CCP2 containing a second quantum dot QD2 which converts the first color light into third color light, and a third light control part CCP3 which transmits the first color light.

In at least one example embodiment, the first light control part CCP1 may provide red light that is the second color light, and the second light control part CCP2 may provide green light that is the third color light. The third light control part CCP3 may provide blue light by transmitting the blue light that is the first color light provided from the light-emitting element ED. For example, the first quantum dot QD1 may be a red quantum dot, and the second quantum dot QD2 may be a green quantum dot. The same as described above may be applied with respect to the quantum dots QD1 and QD2.

In addition, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include any quantum dot but include the scatterer SP. The scatterer SP may be configured to diffuse the light produced in the light-emitting element ED.

The scatterer SP may be inorganic particles. For example, the scatterer SP may include at least one of TiO₂, ZnO, Al₂O₃, SiO₂, and hollow sphere silica. The scatterer SP may include at least one of TiO₂, ZnO, Al₂O₃, SiO₂, and hollow sphere silica, or may be a mixture of at least two materials selected from among TiO₂, ZnO, Al₂O₃, SiO₂, and hollow sphere silica.

The first light control part CCP1, the second light control part CCP2, and the third light control part CCP3 each may include base resins BR1, BR2, and BR3 in which the quantum dots QD1 and QD2 and the scatterer SP are dispersed. In at least one example embodiment, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 are media in which the quantum dots QD1 and QD2 and the scatterer SP are dispersed, and may be formed of various resin compositions, which may be generally referred to as a binder. For example, the base resins BR1, BR2, and BR3 may be acrylic-based resins, urethane-based resins, silicone-based resins, epoxy-based resins, *etc.* The base resins BR1, BR2, and BR3 may be transparent resins. In at least one example embodiment, the first base resin BR1, the second base resin BR2, and the third base resin BR3 may be the same as or different from each other.

The light control layer CCL may include a barrier layer BFL1. The barrier layer BFL1 may serve to protected against the penetration of moisture and/or oxygen (hereinafter, referred to as 'moisture/oxygen'). The barrier layer BFL1 may block the light control parts CCP1, CCP2 and CCP3 from being exposed to moisture/oxygen. The barrier layer BFL1 may cover the light control parts CCP1, CCP2, and CCP3. In addition, the barrier layer BFL2 may be provided between the light control parts CCP1, CCP2, and CCP3 and the color filter layer CFL.

The barrier layers BFL1 and BFL2 may include at least one inorganic layer. That is, the barrier layers BFL1 and BFL2 may include an inorganic material. For example, the barrier layers BFL1 and BFL2 may include a silicon nitride, an aluminium nitride, a zirconium nitride, a titanium nitride, a hafnium nitride, a tantalum nitride, a silicon oxide, an aluminium oxide, a titanium oxide, a tin oxide, a cerium oxide, a silicon oxynitride, a metal thin film which secures a transmittance, *etc.* The barrier layers BFL1 and BFL2 may further include an organic film. The barrier layers BFL1 and BFL2 may be formed of a single layer or a plurality of layers.

In the display device DD-a of at least one example embodiment, the color filter layer CFL may be disposed on the light control layer CCL. For example, the color filter layer CFL may be directly disposed on the light control layer CCL. In this case, the barrier layer BFL2 may be omitted.

The color filter layer CFL may include filters CF1, CF2, and CF3. The color filter layer CFL may include a first filter CF1 configured to transmit the second color light, a second filter CF2 configured to transmit the third color light, and a third filter CF3 configured to transmit the first color light. For example, the first filter CF1 may be a red filter, the second filter CF2 may be a green filter, and the third filter CF3 may be a blue filter. The filters CF1, CF2, and CF3 each may include a polymeric photosensitive resin and a pigment or dye. The first filter CF1 may include a red pigment or dye, the second filter CF2 may include a green pigment or dye, and the third filter CF3 may include a blue pigment or dye.

The example embodiments of the inventive concepts are not limited thereto, and the third filter CF3 may not include a pigment or dye. The third filter CF3 may include a polymeric photosensitive resin and may not include a pigment or dye. The third filter CF3 may be transparent. The third filter CF3 may be formed of a transparent photosensitive resin.

Furthermore, in at least one example embodiment, the first filter CF1 and the second filter CF2 may be a yellow filter. The first filter CF1 and the second filter CF2 may not be separated but be provided as one filter.

Although not illustrated, the color filter layer CFL may further include a light shielding part (not shown). The light shielding part may be a black matrix. The light shielding part may include an organic light shielding material or an inorganic light shielding material containing a black pigment or dye. The light shielding part may prevent light leakage, and/or may separate boundaries between the adjacent filters CF1, CF2, and CF3. In at least one example embodiment, the light shielding part may be formed of a blue filter.

The first to third filters CF1, CF2, and CF3 may be disposed corresponding to the red light emitting region PXA-R, the green light emitting region PXA-G, and the blue light emitting region PXA-B, respectively.

A base substrate BL may be disposed on the color filter layer CFL. The base substrate BL may be a member which provides a base surface in which the color filter layer CFL, the light control layer CCL, and the like are disposed. The base substrate BL may be a glass substrate, a metal substrate, a plastic substrate, *etc.* However, the example embodiments are not limited thereto, and the base substrate BL may be an inorganic layer, an organic layer, or a composite material layer. In addition, unlike the configuration illustrated, in at least one example embodiment, the base substrate BL may be omitted.

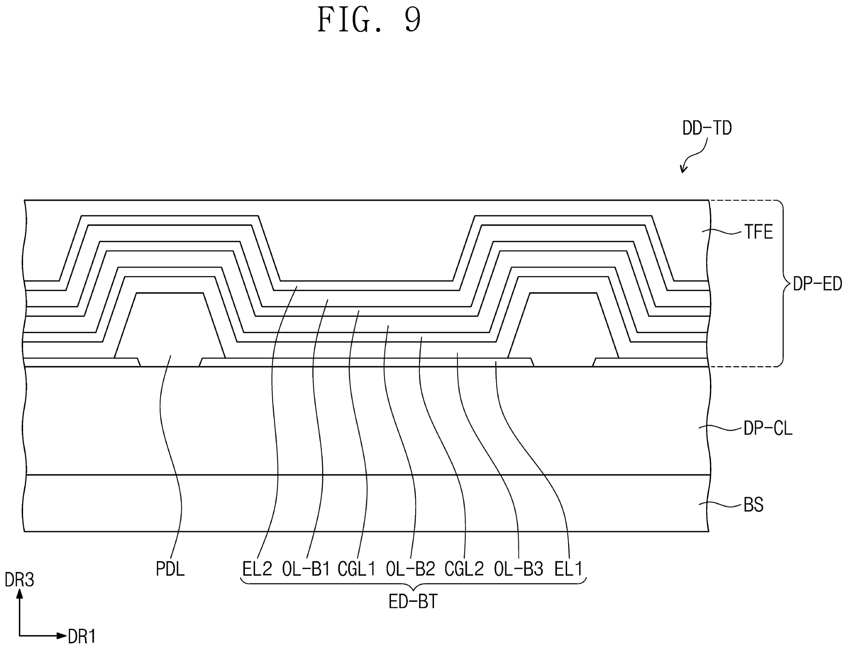

FIG. 9 is a cross-sectional view showing a portion of a display device according to at least one example embodiment. In the display device DD-TD of at least one example embodiment, a light-emitting element ED-BT may include multiple light emitting structures OL-B1, OL-B2 and OL-B3. The light-emitting element ED-BT may include oppositely disposed first electrode EL1 and second electrode EL2, and multiple light emitting structures OL-B1, OL-B2 and OL-B3, which are stacked in order in a thickness direction and provided between the first electrode EL1 and the second electrode EL2. Each of the light emitting structures OL-B1, OL-B2 and OL-B3 may include an emission layer EML (FIG. 8), and a hole transport region HTR and an electron transport region ETR, disposed with the emission layer EML (FIG. 8) therebetween. That is, the light-emitting element ED-BT included in the display device DD-TD of at least one example embodiment may be a light-emitting element with a tandem structure, including multiple emission layers.

At least one among the light emitting structures OL-B1, OL-B2 and OL-B3 includes the fused polycyclic compound of at least one example embodiment. The light-emitting element ED-BT including the fused polycyclic compound of at least one example embodiment may exhibit high emission efficiency and long lifespan.

In at least one example embodiment illustrated in FIG. 9, all light beams respectively emitted from the light emitting structures OL-B1, OL-B2, and OL-B3 may be blue light. However, the example embodiments are not limited thereto, and the light beams respectively emitted from the light emitting structures OL-B1, OL-B2, and OL-B3 may have wavelength ranges different from each other. For example, the light-emitting element ED-BT including the plurality of light emitting structures OL-B1, OL-B2, and OL-B3 which emit light beams having wavelength ranges different from each other may emit white light.

Charge generation layers CGL1 and CGL2 may be respectively disposed between two of the neighboring light emitting structures OL-B1, OL-B2, and OL-B3. The charge generation layers CGL1 and CGL2 may include a p-type charge generation layer and an n-type charge generation layer.

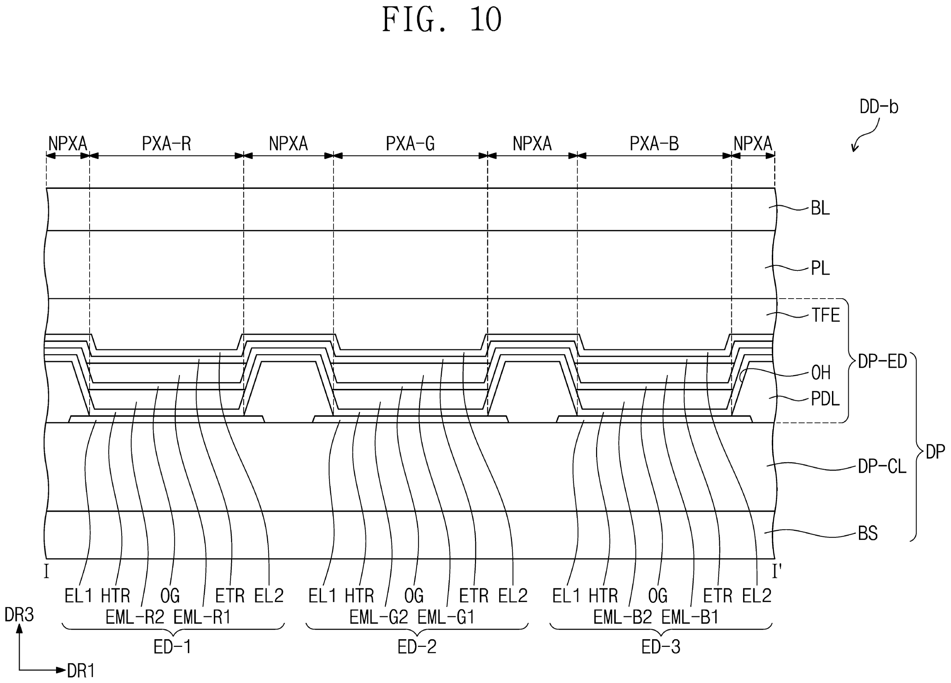

Referring to FIG. 10, a display device DD-b according to at least one example embodiment may include light-emitting elements ED-1, ED-2 and ED-3, in which two emission layers are stacked. Compared to the display device DD of at least one example embodiment (e.g., shown in FIG. 2), the example shown in FIG. 10 differs in that each of the first to third light-emitting elements ED-1, ED-2 and ED-3 includes two emission layers stacked in a thickness direction. Two emission layers in each of the first to third light-emitting elements ED-1, ED-2 and ED-3 may emit light having the same wavelength range.

At least one among the light-emitting elements ED-1, ED-2 and ED-3 includes the fused polycyclic compound of at least one example embodiment. At least one among the light-emitting elements ED-1, ED-2 and ED-3, including the fused polycyclic compound of at least one example embodiment may exhibit high emission efficiency and long lifespan.

The first light-emitting element ED-1 may include a first red emission layer EML-R1 and a second red emission layer EML-R2. The second light-emitting element ED-2 may include a first green emission layer EML-G1 and a second green emission layer EML-G2. In addition, the third light-emitting element ED-3 may include a first blue emission layer EML-B1 and a second blue emission layer EML-B2. An emission auxiliary part OG may be disposed between the first red emission layer EML-R1 and the second red emission layer EML-R2, between the first green emission layer EML-G1 and the second green emission layer EML-G2, and between the first blue emission layer EML-B1 and the second blue emission layer EML-B2.

The emission auxiliary part OG may include a single layer or a multilayer. The emission auxiliary part OG may include a charge generation layer. More specifically, the emission auxiliary part OG may include an electron transport region, a charge generation layer, and a hole transport region that are sequentially stacked. The emission auxiliary part OG may be provided as a common layer in the whole of the first to third light-emitting elements ED-1, ED-2, and ED-3. However, the embodiment of the inventive concepts is not limited thereto, and the emission auxiliary part OG may be provided by being patterned within the openings OH defined in the pixel defining film PDL.

The first red emission layer EML-R1, the first green emission layer EML-G1, and the first blue emission layer EML-B1 may be disposed between the emission auxiliary part OG and the electron transport region ETR. The second red emission layer EML-R2, the second green emission layer EML-G2, and the second blue emission layer EML-B2 may be disposed between the hole transport region HTR and the emission auxiliary part OG.

That is, the first light-emitting element ED-1 may include the first electrode EL1, the hole transport region HTR, the second red emission layer EML-R2, the emission auxiliary part OG, the first red emission layer EML-R1, the electron transport region ETR, and the second electrode EL2 that are sequentially stacked. The second light-emitting element ED-2 may include the first electrode EL1, the hole transport region HTR, the second green emission layer EML-G2, the emission auxiliary part OG, the first green emission layer EML-G1, the electron transport region ETR, and the second electrode EL2 that are sequentially stacked. The third light-emitting element ED-3 may include the first electrode EL1, the hole transport region HTR, the second blue emission layer EML-B2, the emission auxiliary part OG, the first blue emission layer EML-B1, the electron transport region ETR, and the second electrode EL2 that are sequentially stacked.

An optical auxiliary layer PL may be disposed on the display element layer DP-ED. The optical auxiliary layer PL may include a polarizing layer. The optical auxiliary layer PL may be disposed on the display panel DP and control reflected light in the display panel DP due to external light. Unlike the configuration illustrated, the optical auxiliary layer PL in the display device according to at least one example embodiment may be omitted.

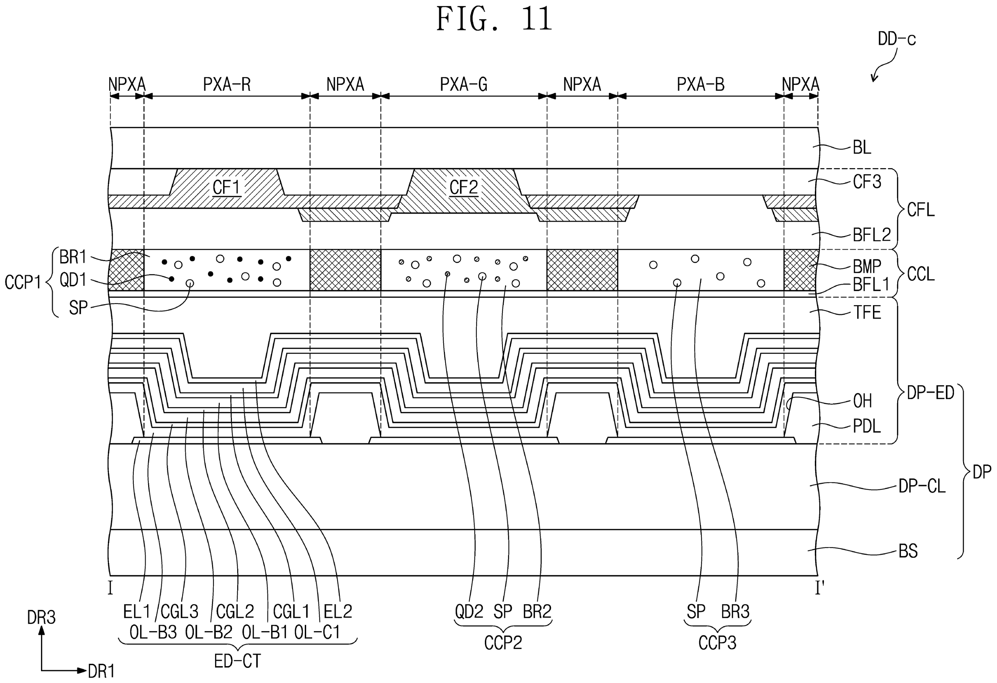

Different from FIG. 9 and FIG. 10, a display device DD-c in FIG. 11 is shown to include four light emitting structures OL-B1, OL-B2, OL-B3 and OL-C1. A light-emitting element ED-CT may include oppositely disposed first electrode EL1 and second electrode EL2, and first to fourth light emitting structures OL-B1, OL-B2, OL-B3 and OL-C1 stacked in order in a thickness direction between the first electrode EL1 and the second electrode EL2. At least one among the first to fourth light emitting structures OL-B1, OL-B2, OL-B3 and OL-C1 includes the fused polycyclic compound of at least one example embodiment. The light-emitting element ED-CT including the fused polycyclic compound of at least one example embodiment may exhibit high emission efficiency and long lifespan.

Charge generation layers CGL1, CGL2, and CGL3 may be disposed between the first to fourth light emitting structures OL-B1, OL-B2, OL-B3, and OL-C1. Among the four light emitting structures, the first to third light emitting structures OL-B1, OL-B2, and OL-B3 may emit blue light, and the fourth light emitting structure OL-C1 may emit green light. However, the embodiment of the inventive concepts is not limited thereto, and the first to fourth light emitting structures OL-B1, OL-B2, OL-B3, and OL-C1 may emit light beams in different wavelength regions.

The charge generation layers CGL1, CGL2, and CGL3 disposed between adjacent light emitting structures OL-B1, OL-B2, OL-B3, and OL-C1 may include a p-type charge generation layer and an n-type charge generation layer.

In at least one example embodiment, an electronic device may include a display device including multiple light-emitting elements and a control part controlling the display device. The electronic device of at least one example embodiment may be a device activated according to electrical signals. The electronic device may include display devices of various embodiments. For example, the electronic devices may include large-size display devices such as televisions, monitors, and/or outside billboards, and/or medium- and small-size display devices such as personal computers, laptop computers, personal digital terminals, display apparatuses for automobiles, game consoles, portable electronic devices, and/or cameras.

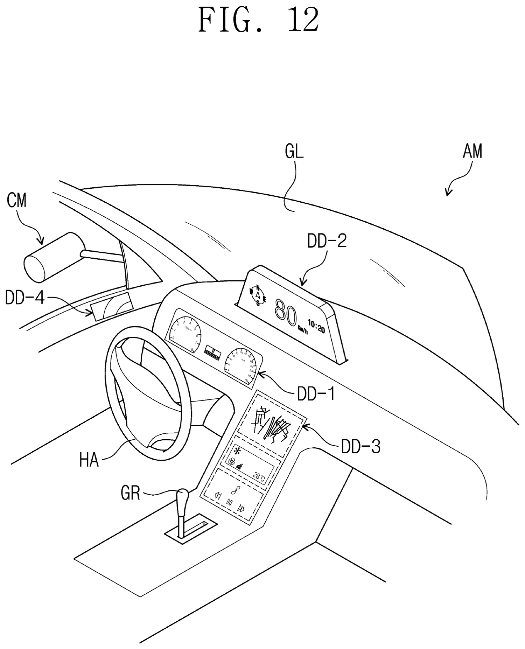

FIG. 12 is a diagram showing an automobile AM in which first to fourth display devices DD-1, DD-2, DD-3 and DD-4 are disposed. At least one among the first to fourth display devices DD-1, DD-2, DD-3 and DD-4 may include the same configurations as those of the display devices DD, DD-TD, DD-a, DD-b and DD-c of embodiments, explained referring to FIGS. 1, 2, and 8 to 11.

In FIG. 12, a vehicle is shown as an automobile AM, but this is an illustration, and the first to fourth display devices DD-1, DD-2, DD-3 and DD-4 may be disposed on other transport means such as bicycles, motorcycles, trains, ships and airplanes. In addition, at least one among the first to fourth display devices DD-1, DD-2, DD-3 and DD-4 including the same configurations as those of the display devices DD, DD-TD, DD-a, DD-b and DD-c may be introduced in personal computers, laptop computers, personal digital terminals, game consoles, portable electronic devices, televisions, monitors, external billboards, and the like. In addition, these are suggested as examples, and the display device may be introduced in other electronic devices as long as not deviated from the inventive concepts.

At least one among the first to fourth display devices DD-1, DD-2, DD-3 and DD-4 may include the light-emitting element ED, explained referring to FIG. 3 to FIG. 6. At least one among the first to fourth display devices DD-1, DD-2, DD-3 and DD-4 includes the fused polycyclic compound of at least one example embodiment. A display device including the fused polycyclic compound of at least one example embodiment (at least one among the first to fourth display devices DD-1, DD-2, DD-3 and DD-4) may show excellent display quality.

Referring to FIG. 12, the vehicle AM may include a steering wheel HA and a gear GR for driving the vehicle AM. In addition, the vehicle AM may include a front window GL disposed so as to face the driver.

The first display device DD-1 may be disposed in a first region overlapping the steering wheel HA. For example, the first display device DD-1 may be a digital cluster which displays first information of the vehicle AM. The first information may include a first scale which indicates a driving speed of the vehicle AM, a second scale which indicates an engine speed (that is, revolutions per minute (RPM)), an image which indicates a fuel state, *etc. A* first scale and a second scale may be indicated as a digital image.

The second display device DD-2 may be disposed in a second region facing the driver's seat and overlapping the front window GL. The driver's seat may be a seat in which the steering wheel HA is disposed. For example, the second display device DD-2 may be a head up display (HUD) which displays second information of the vehicle AM. The second display device DD-2 may be optically transparent. The second information may include digital numbers which indicate a driving speed, and/or may further include information such as the current time. Unlike the configuration illustrated, the second information of the second display device DD-2 may be projected to the front window GL to be displayed.

The third display device DD-3 may be disposed in a third region adjacent to the gear GR. For example, the third display device DD-3 may be disposed between the driver's seat and the passenger seat and may be a center information display (CID) for a vehicle for displaying third information. The passenger seat may be a seat spaced apart from the driver's seat with the gear GR disposed therebetween. The third information may include information about traffic (*e.g.,* navigation information), playing music or radio or a video (or an image), temperatures inside the vehicle AM, *etc.*

The fourth display device DD-4 may be spaced apart from the steering wheel HA and the gear GR, and may be disposed in a fourth region adjacent to the side of the vehicle AM. For example, the fourth display device DD-4 may be a digital side-view mirror which displays fourth information. The fourth display device DD-4 may display an image outside the vehicle AM taken by a camera module CM disposed outside the vehicle AM. The fourth information may include an image outside the vehicle AM.

The above-described first to fourth information may be examples, and the first to fourth display devices DD-1, DD-2, DD-3, and DD-4 may further display information about the inside and outside of the vehicle AM. The first to fourth information may include different information. However, the embodiment of the inventive concepts is not limited thereto, and a part of the first to fourth information may include the same information as one another.

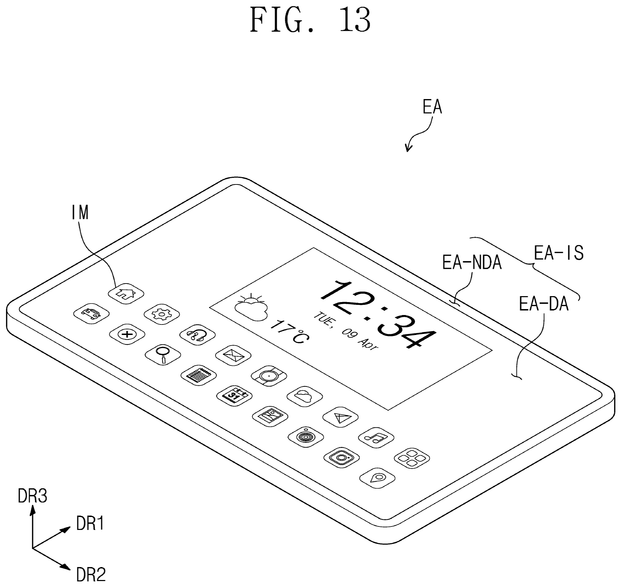

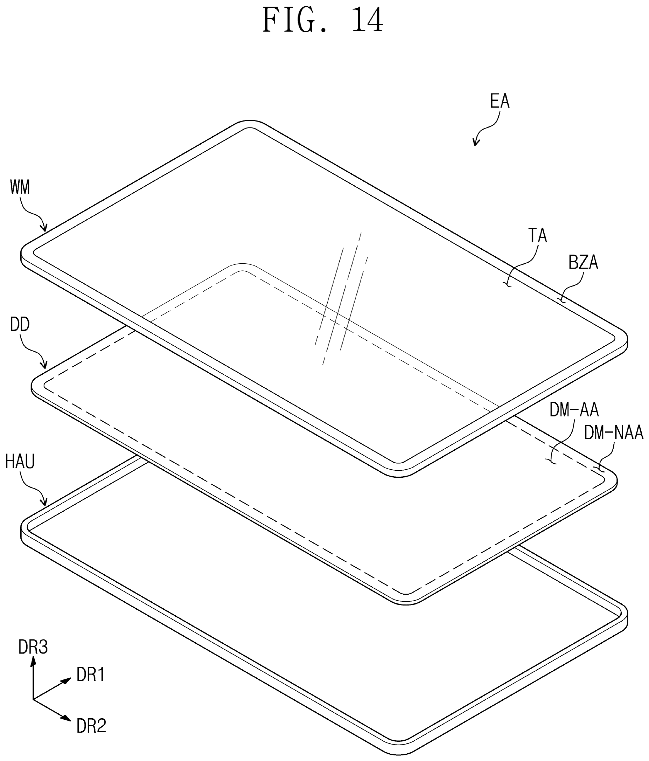

FIG. 13 is a perspective view illustrating an electronic apparatus according to at least one example embodiment. FIG. 14 is an exploded perspective view illustrating an electronic apparatus according to at least one example embodiment.

FIG. 13 illustrates a portable electronic apparatus as an example of an electronic apparatus EA. The electronic apparatus EA may display an image IM through a display surface EA-IS. The image IM may include a still image as well as a dynamic image. The display surface EA-IS may be parallel to a plane defined by a first direction axis DR1 and a second direction axis DR2. FIG. 13 illustrates an electronic apparatus EA including a flat display surface EA-IS, but the example embodiments are not limited thereto. For example, the electronic apparatus EA may also include a curved display surface or a three-dimensional display surface. The three-dimensional display surface may also include a plurality of display regions indicating different directions from each other.

The display surface EA-IS may include a display region EA-DA and a non-display region EA-NDA. The electronic apparatus EA may display an image IM through the display region EA-DA.

The non-display region EA-NDA may not be optically transparent and may have a color. The non-display region EA-NDA may be adjacent to the display region EA-DA. The non-display region EA-NDA may surround the display region EA-DA. Therefore, a shape of the display region EA-DA may be substantially defined by the non-display region EA-NDA. However, what is illustrated in FIG. 13 is an example, and the non-display region EA-NDA may be disposed adjacent to only one side of the display region EA-DA, or may also be omitted.

Referring to FIG. 14, the electronic apparatus EA may include a display device DD. In addition, the electronic apparatus EA may further include a window member WM and a housing HAU.

The window member WM may cover the entire exterior of the electronic apparatus EA. The window member WM may include a transmissive region TA and a bezel region BZA. A front surface of the window member WM including the transmissive region TA and the bezel region BZA may correspond to a front surface of the electronic apparatus EA. The transmissive region TA may correspond to the display region EA-DA of the electronic apparatus EA illustrated in FIG. 13, and the bezel region BZA may correspond to the non-display region EA-NDA of the electronic apparatus EA illustrated in FIG. 13.

The transmissive region TA may be an optically transparent region. The bezel region BZA may be a region having relatively lower light transmittance than the transmissive region TA. The bezel region BZA may not be optically transparent and may have a color. The bezel region BZA may be adjacent to the transmissive region TA and may surround the transmissive region TA. The bezel region BZA may define a shape of the transmissive region TA. However, at least one example embodiment is not limited to what is illustrated, and the bezel region BZA may be disposed adjacent to only one side of the transmissive region TA, and a portion thereof may also be omitted.

The housing HAU may include a material having relatively high rigidity. For example, the housing HAU may include a frame and/or plate composed of glass, plastic, and/or metal. The frame and/or plate may be provided in plurality. The housing HAU may provide an accommodation space. The display device DD may be accommodated in the accommodation space and protected from an external impact.

The display device DD may include the same structure as at least one of the display devices DD, DD-TD, DD-a, DD-b, and DD-c, according to embodiments, described with reference to FIGS. 1, 2, and 8 to 11. The display device DD may include the light-emitting element ED described with reference to FIG. 3 to FIG. 6. Therefore, the electronic apparatus EA including the display device DD according to at least one example embodiment, may exhibit excellent reliability.

The display device DD may be activated in response to an electrical signal and provide an image IM (FIG. 13). The display device DD may be activated to display an image IM (FIG. 13) in the display region EA-DA (FIG. 13) of the electronic apparatus EA. An active region DM-AA and a peripheral region DM-NAA may be defined in the display device DD. The active region DM-AA may overlap the display region EA-DA illustrated in FIG. 13, and the peripheral region DM-NAA may overlap the non-display region EA-NDA illustrated in FIG. 13.

The active region DM-AA may be a region activated in response to an electrical signal. The peripheral region DM-NAA may be a region disposed adjacent to at least one side of the active region DM-AA. The active region DM-AA may include a non-emission region NPXA and emission regions PXA-R, PXA-G, and PXA-B. The peripheral region DM-NAA may be disposed to cover the active region DM-AA. However, the example embodiments are not limited thereto, and unlike what is illustrated, a portion of the peripheral region DM-NAA may be omitted. In the peripheral region DM-NAA, the driving circuit, driving wire, and the like for driving the active region DM-AA may be disposed.

The display devices DD, DD-TD, DD-a, DD-b, and DD-c according to at least one example embodiment (FIGS. 1, 2, and FIGS. 8 to 11) may be applied to various electronic apparatuses. The electronic apparatus EA according to at least one example embodiment may include the above-described display devices DD-TD, DD-a, DD-b, and DD-c (FIGS. 1, 2, and FIGS. 8 to 11), and may further include a module or device having another additional function in addition to the display devices DD-TD, DD-a, DD-b, and DD-c (FIGS. 1, 2, and FIGS. 8 to 11).

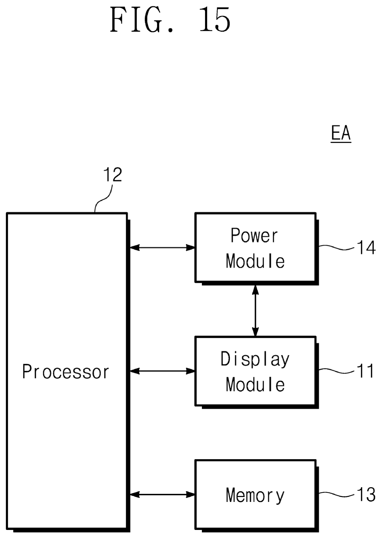

FIG. 15 is a block diagram of an electronic apparatus according to at least one example embodiment. Referring to FIG. 15, the electronic apparatus EA may include a display module 11, a processor 12, a memory 13, and a power module 14.

The processor 12 may include at least one among a central processing unit (CPU), an application processor (AP), a graphic processing unit (GPU), a communication processor (CP), an image signal processor (ISP), and a controller.

The memory 13 may store data information needed for the operations of the processor 12 or the display module 11. When the processor 12 executes an application stored in the memory 13, an image data signal and/or an input control signal are transmitted to the display module 11, and the display module 11 may process the received signal and output image information through a display screen.

The power module 14 may include a power supply module such as a power adaptor or a battery device, and a power conversion module that converts power supplied by the power supply module to generate power needed for the operation of the electronic apparatus EA.

At least one among the components of the electronic apparatus EA may be included in the display device according to some example embodiments. In addition, some of individual modules functionally included in one module among the components of the electronic apparatus EA may be included in the display device, and some others may be provided separately from the display device. For example, the display device may include a display module 11, and the processor 12, the memory 13 and the power module 14 may be provided in the form of other devices within the electronic apparatus EA, not the display device.

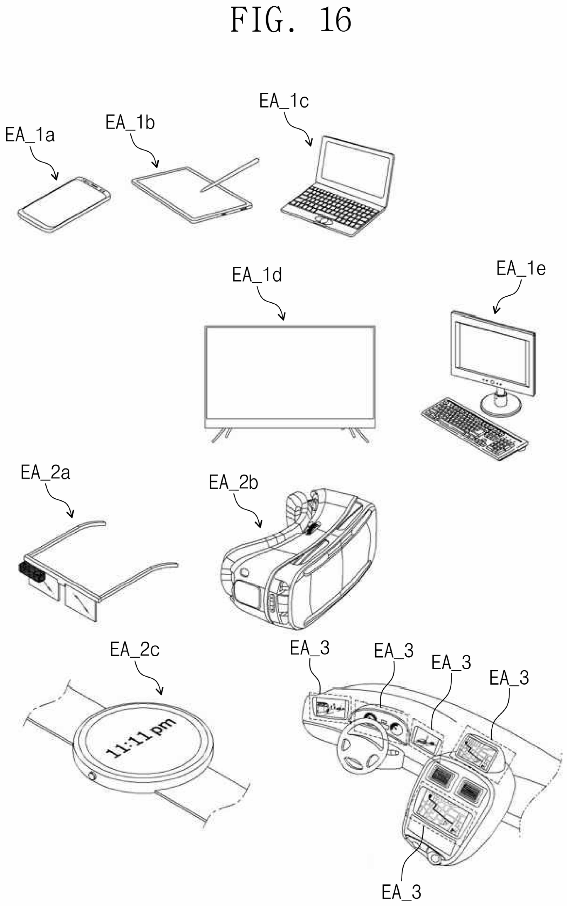

FIG. 16 illustrates schematic views of electronic apparatuses according to various embodiments Referring to FIG. 16, various electronic apparatuses to which the display devices according to embodiments are applied may not include only an image-displaying electronic apparatus such as a smart phone EA_1a, a tablet EA_1b, a laptop computer EA_1c, a TV EA_1d, and a desktop monitor EA_1e, but also include a wearable electronic apparatus such as smart glasses EA_2a, a head mounted display EA_2b, and a smart watch EA_2c, and a vehicular electronic apparatus EA_3 including a display module, such as a car dashboard, a center fascia, a center information display (CID) disposed in a dashboard, and a room mirror display, etc.

Hereinafter, with reference to Examples and Comparative Examples, the fused polycyclic compound according to at least one example embodiment of the inventive concepts and the light-emitting element according to at least one example embodiment will be described in detail. In addition, Examples shown below are exemplified only for helping the understanding of the inventive concepts, and the scope of the inventive concepts is not limited thereto.

### [Examples]

### 1. Synthesis of fused polycyclic compound according to one embodiment

A synthetic method of the fused polycyclic compounds according to the present embodiments will be explained by exemplifying the synthetic methods of Fused Polycyclic Compounds B-2, B-14, B-17, B-24, B-25, C-2, C-16, C-18, C-20, C-30, D-15 and E-1. In addition, the synthetic methods of the fused polycyclic compounds explained hereinafter are examples, and a synthetic method of the compound according is not limited to the examples below.

### (1) Synthesis of Fused Polycyclic Compound B-2

Fused Polycyclic Compound B-2 according to one example may be synthesized by, for example, the following steps.

### [Synthesis of Compound B-2-10]

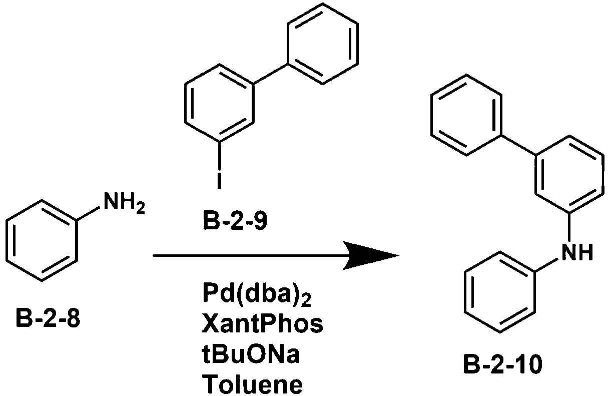

Compound B-2-8 (300 mmol), Compound B-2-9 (300 mmol), tBuONa (450 mmol), Bis(dibenzylideneacetone)palladium(0) ("Pd(dba)₂") (15 mmol), and (9,9-Dimethyl-9*H*-xanthene-4,5-diyl)bis(diphenylphosphane) ("XantPhos") (30 mmol) were added to a three-necked flask, the flask was purged with argon (Ar), then 1000 ml of toluene was added, and the resultant mixture was stirred at about 80 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain 285 mmol of Compound B-2-10 (yield of about 95%). The purified product which was obtained was identified to have a molecular weight of about 245, as measured by fast atom bombardment mass spectrometry (FABMS).

### [Synthesis of Compound B-2-6]

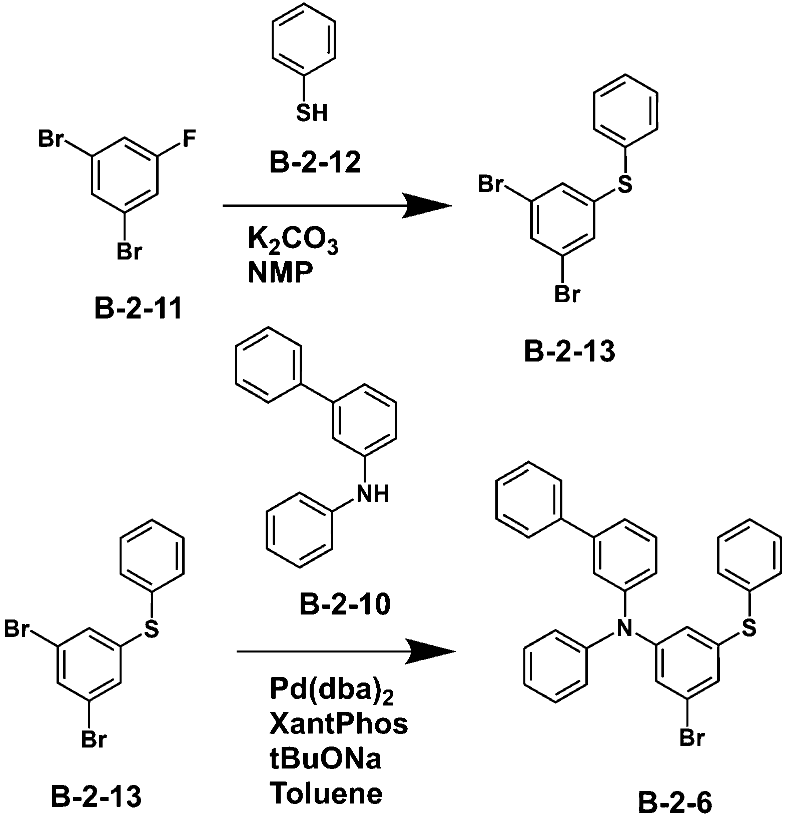

Compound B-2-11 (300 mmol), Compound B-2-12 (300 mmol), and K₂CO₃ (600 mmol) were added to a three-necked flask, the flask was purged with Ar, then 200 ml of N-Methyl-2-pyrrolidone (NMP) was added, and the resultant mixture was stirred at about 150 °C for about 24 hours. Water was added to a reaction system, and an organic layer was extracted using toluene. The obtained organic layer was dried over magnesium sulfate and a solvent was removed by distillation. The obtained crude product was purified through silica gel column chromatography (a mixed solvent of hexane/toluene) to obtain 258 mmol of Compound B-2-13 (yield of about 86 %). The purified product which was obtained was identified to have a molecular weight of about 344, as measured by FABMS.

Compound B-2-13 (258 mmol), Compound B-2-10 (258 mmol), tBuONa (387 mmol), Pd(dba)₂ (13 mmol), and XantPhos (26 mmol) were added to a three-necked flask, the flask was purged with Ar, then 800 ml of toluene was added, and the resultant mixture was stirred at about 80 °C for about 8 hours. Water was added to a reaction system, and an organic layer was extracted using toluene. The obtained organic layer was dried over magnesium sulfate and a solvent was removed by distillation. The obtained crude product was purified through silica gel column chromatography (a mixed solvent of hexane/toluene) to obtain about 227 mmol of Compound B-2-6 (yield of about 88%). The purified product which was obtained was identified to have a molecular weight of about 508, as measured by FABMS.

### [Synthesis of Compound B-2]

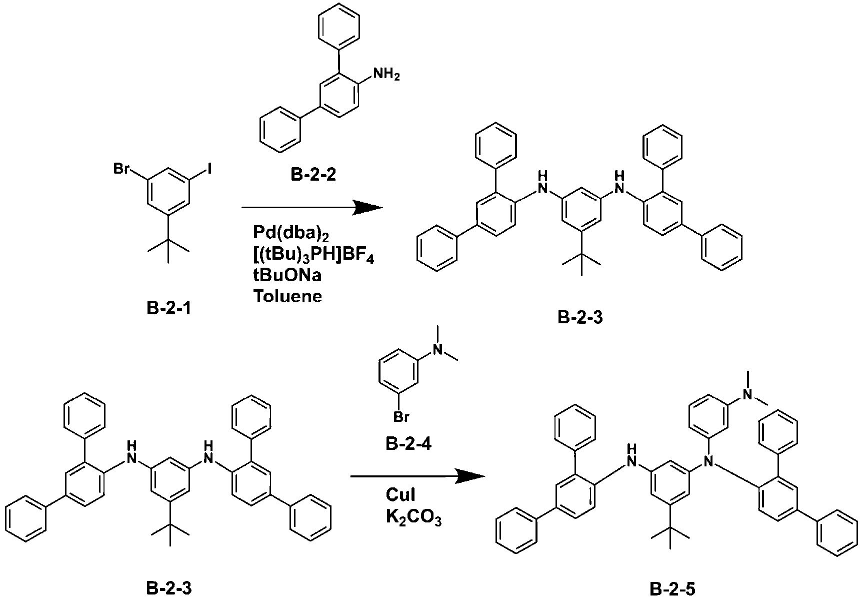

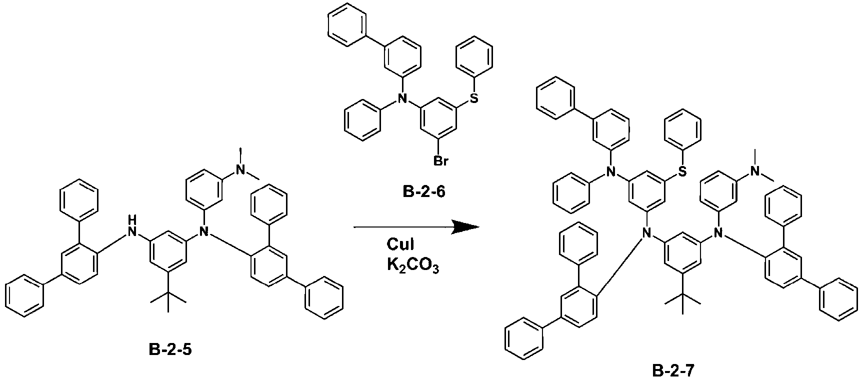

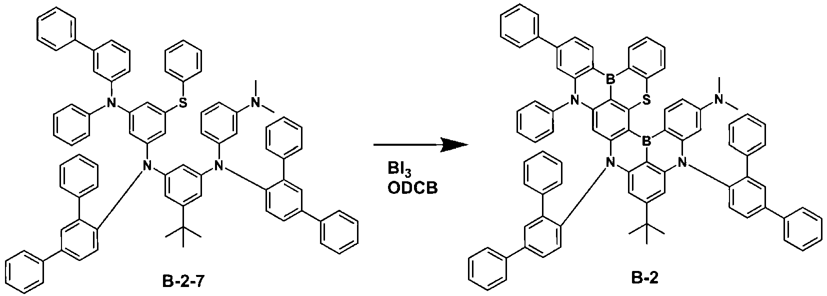

Compound B-2-1 (200 mmol), Compound B-2-2 (410 mmol), tBuONa (600 mmol), Pd(dba)₂ (10 mmol), and Tri-tert-butylphosphine tetrafluoroborate ("[(tBu)₃PH]BF₄") (20 mmol) were added to a three-necked flask, the flask was purged with Ar, then 1000 ml of toluene was added, and the resultant mixture was stirred at about 90 °C for about 7 hours. Water was added to a reaction system, and an organic layer was extracted using toluene. The extracted organic layer was dried over magnesium sulfate and a solvent was removed by distillation. The extracted crude product was purified through silica gel column chromatography (a mixed solvent of hexane/toluene) and recrystallization (a mixed solvent of ethanol/toluene) to obtain about 170 mmol of Compound B-2-3 (yield of about 85%). The purified product which was obtained was identified to have a molecular weight of about 620, as measured by FABMS.

Compound B-2-3 (150 mmol), Compound B-2-4 (750 mmol), K₂CO₃ (900 mmol), and CuI (165 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 62 mmol of Compound B-2-5 (yield of about 41%). The purified product which was obtained was identified to have a molecular weight of about 740, as measured by FABMS.

Compound B-2-5 (62 mmol), Compound B-2-6 (310 mmol), K₂CO₃ (372 mmol), and CuI (68 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 41 mmol of Compound B-2-7 (yield of about 66%). The purified product which was obtained was identified to have a molecular weight of about 1167, as measured by FABMS.

Compound B-2-7 (41 mmol) was added to a three-necked flask, the flask was purged with Ar, then 21 ml of 1,2-Dichlorobenzene ("ODCB") was added and dissolved, then BI₃ (164 mmol) was added, and the resultant was stirred at about 140 °C for about 3 hours. The reaction mixture was dispersed and washed using a large amount of acetonitrile and then filtered to collect the solids. The obtained crude product was purified through silica gel column chromatography (a mixed solvent of hexane/ dichloromethane) and recrystallization (a mixed solvent of ethanol/toluene) to obtain about 20 mmol of Compound B-2 (yield of about 49%). The purified product which was obtained was identified to have a molecular weight of about 1183, as measured by FABMS.

### (2) Synthesis of Compound B-14

Fused Polycyclic Compound B-14 according to at least one example embodiment may be synthesized by, for example, the following steps.

### A. [Synthesis of Compound B-14-11]

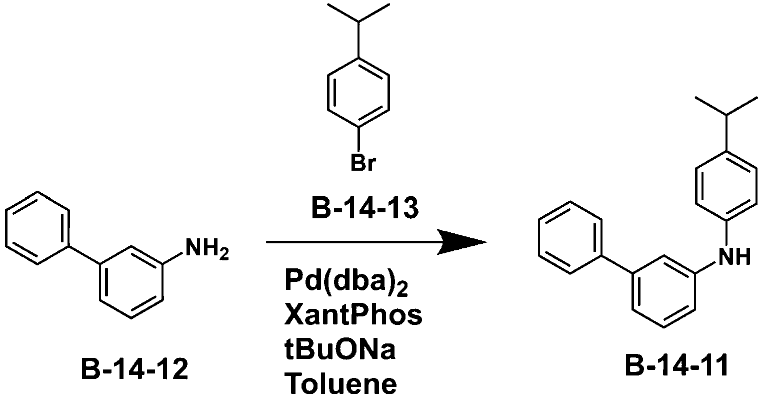

Compound B-14-12 (300 mmol), Compound B-14-13 (300 mmol), tBuONa (450 mmol), Pd(dba)₂ (15 mmol), and XantPhos (30 mmol) were added to a three-necked flask, the flask was purged with Ar, then 1000 ml of toluene was added, and the resultant mixture was stirred at about 80 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 264 mmol of Compound B-14-11 (yield of about 88%). The purified product which was obtained was identified to have a molecular weight of about 287, as measured by FABMS.

### [Synthesis of Compound B-14-6]

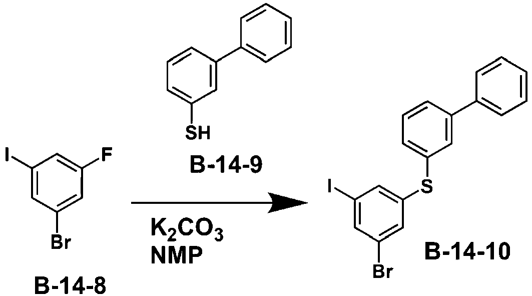

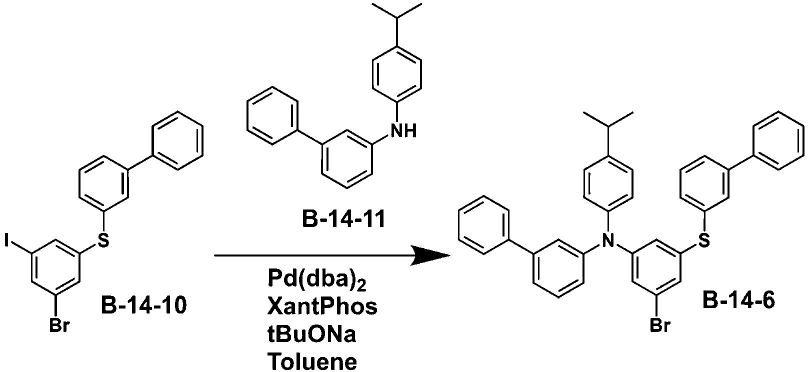

Compound B-14-8 (300 mmol), Compound B-14-9 (300 mmol), and K₂CO₃ (600 mmol) were added to a three-necked flask, the flask was purged with Ar, then 200 ml of NMP was added, and the resultant mixture was stirred at about 150 °C for about 24 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 240 mmol of Compound B-14-10 (yield of about 80%). The purified product which was obtained was identified to have a molecular weight of about 467, as measured by FABMS.

Compound B-14-10 (240 mmol), B-14-11 (240 mmol), tBuONa (360 mmol), Pd(dba)₂ (12 mmol), and XantPhos (24 mmol) were added to a three-necked flask, and the flask was purged with Ar, then 800 ml of toluene was added, and the resultant was stirred at about 80 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 228 mmol of Compound B-14-6 (yield of about 95%). The purified product which was obtained was identified to have a molecular weight of about 626, as measured by FABMS.

### [Synthesis of Compound B-14]

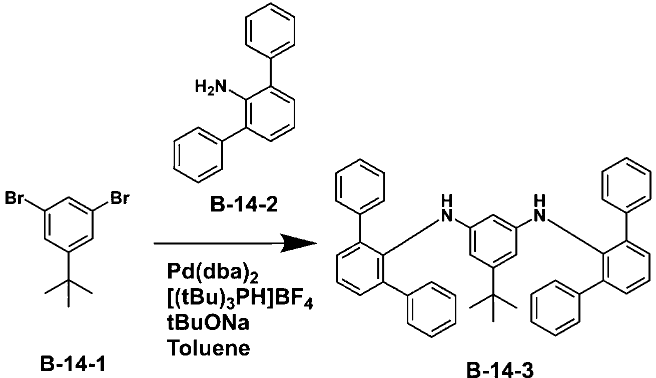

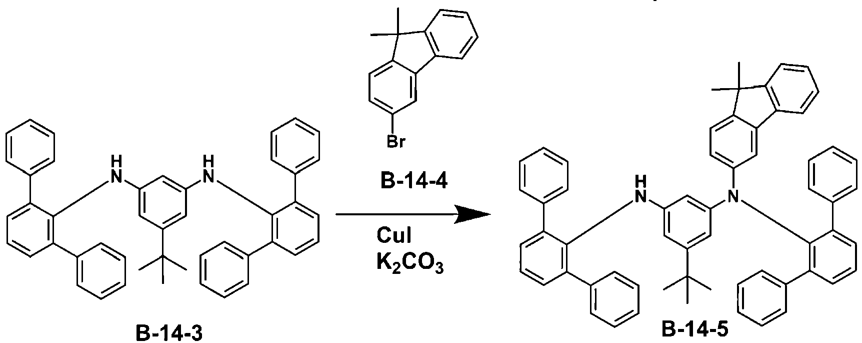

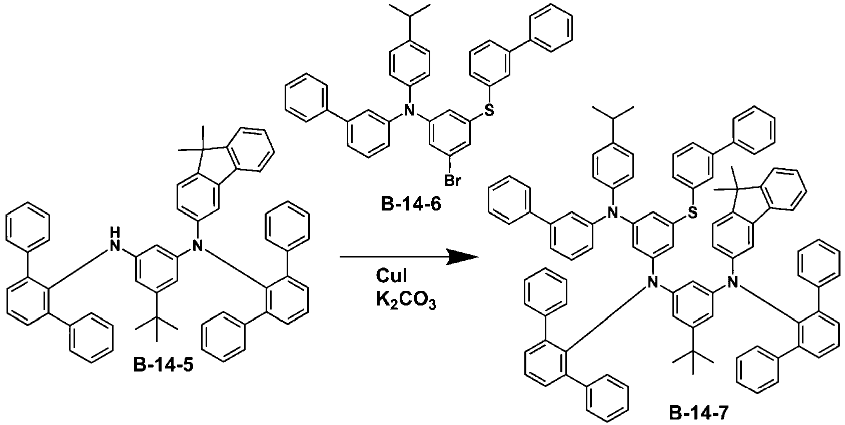

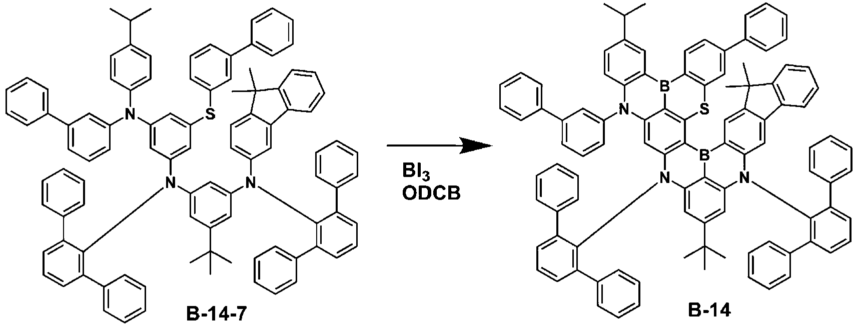

Compound B-14-1 (200 mmol), Compound B-14-2 (410 mmol), tBuONa (600 mmol), Pd(dba)₂ (10 mmol), and [(tBu)₃PH]BF₄ (20 mmol) were added to a three-necked flask, the flask was purged with Ar, then 1000 ml of toluene was added, and the resultant mixture was stirred at about 90 °C for about 5 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 162 mmol of Compound B-14-3 (yield of about 81%). The purified product which was obtained was identified to have a molecular weight of about 620, as measured by FABMS.

Compound B-14-3 (162 mmol), Compound B-14-4 (810 mmol), K₂CO₃ (972 mmol), and CuI (178 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 87 mmol of Compound B-14-5 (yield of about 54%). The purified product which was obtained was identified to have a molecular weight of about 813, as measured by FABMS.

Compound B-14-5 (87 mmol), Compound B-14-6 (228 mmol), K₂CO₃ (522 mmol), and CuI (96 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 44 mmol of Compound B-14-7 (yield of about 51%). The purified product which was obtained was identified to have a molecular weight of about 1358, as measured by FABMS.

Compound B-14-7 (44 mmol) was added to a three-necked flask, the flask was purged with Ar, then 22 ml of ODCB was added and dissolved, then BI₃ (176 mmol) was added, and the resultant mixture was stirred at about 140 °C for about 3 hours. The reaction mixture was dispersed and washed using a large amount of acetonitrile and then filtered to collect the solids. The obtained crude product was purified through silica gel column chromatography (a mixed solvent of hexane/dichloromethane) and recrystallization (a mixed solvent of ethanol/toluene) to obtain about 10 mmol of Compound B-14 (yield of about 23%). The purified product which was obtained was identified to have a molecular weight of about 1374, as measured by FABMS.

### (3) Synthesis of Compound B-17

Fused Polycyclic Compound B-17 according to at least one example embodiment may be synthesized by, for example, the following steps.

### [Synthesis of Compound B-17-9]

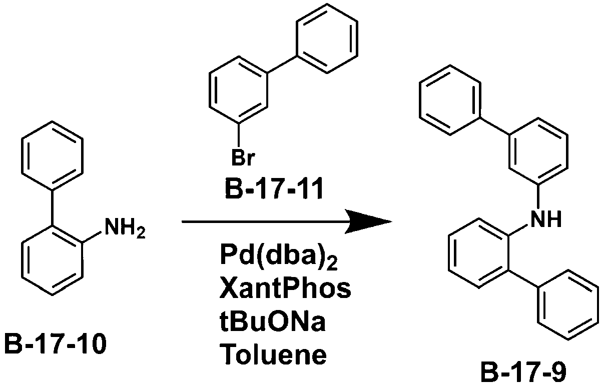

Compound B-17-10 (300 mmol), Compound B-17-11 (300 mmol), tBuONa (450 mmol), Pd(dba)₂ (15 mmol), and XantPhos (30 mmol) were added to a three-necked flask, the flask was purged with Ar, then 1000 ml of toluene was added, and the resultant mixture was stirred at about 80 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 276 mmol of Compound B-17-9 (yield of about 92%). The purified product which was obtained was identified to have a molecular weight of about 321, as measured by FABMS.

### [Synthesis of Compound B-17-3]

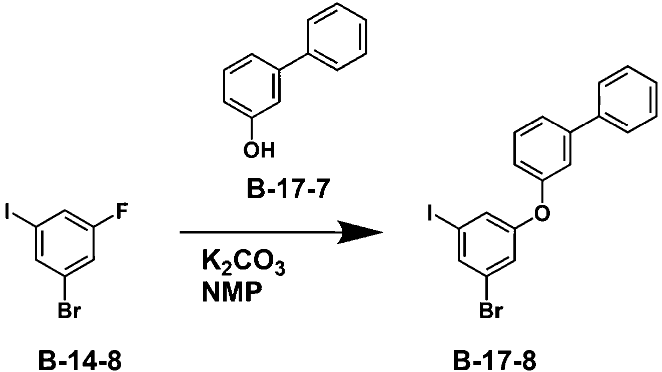

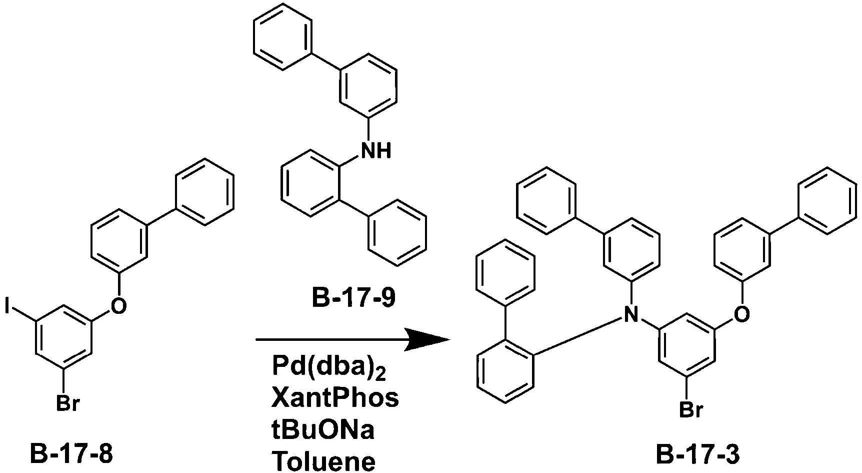

Compound B-14-8 (300 mmol), Compound B-17-7 (300 mmol), and K₂CO₃ (600 mmol) were added to a three-necked flask, the flask was purged with Ar, then 200 ml of NMP was added, and the resultant mixture was stirred at about 150 °C for about 24 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 249 mmol of Compound B-17-8 (yield of about 83%). The purified product which was obtained was identified to have a molecular weight of about 451, as measured by FABMS.

Compound B-17-8 (249 mmol), Compound B-17-9 (249 mmol), tBuONa (373 mmol), Pd(dba)₂ (12 mmol), and XantPhos (24 mmol) were added to a three-necked flask, the flask was purged with Ar, then 800 ml of toluene was added, and the resultant mixture was stirred at about 80 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 224 mmol of Compound B-17-3 (yield of about 90%). The purified product which was obtained was identified to have a molecular weight of about 644, as measured by FABMS.

### [Synthesis of Compound B-17]

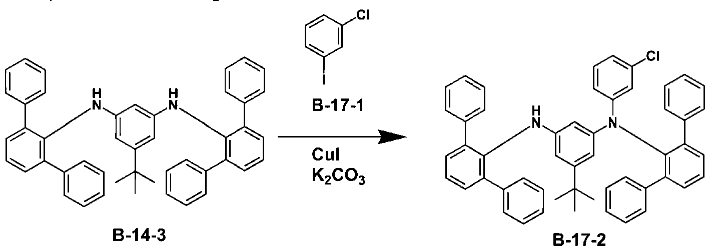

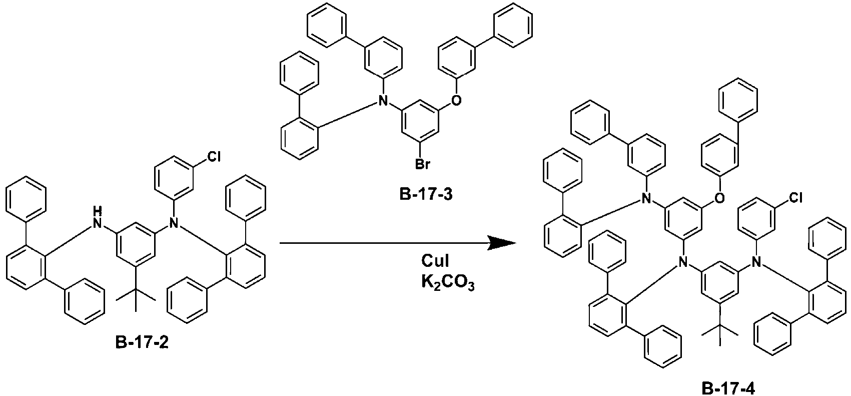

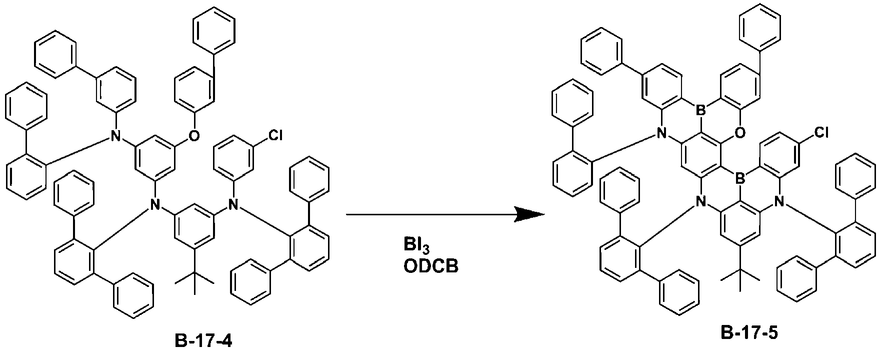

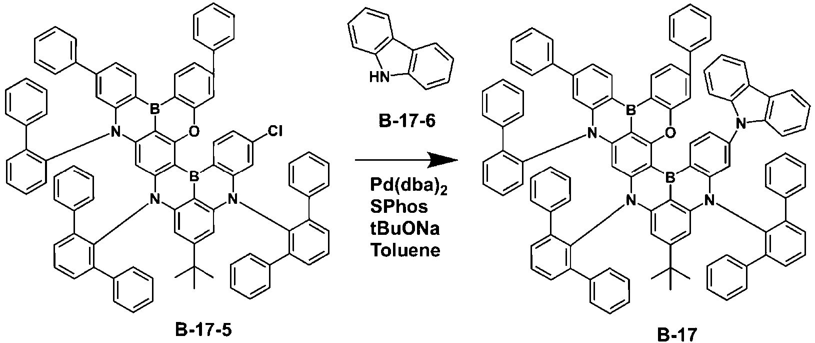

Compound B-14-3 (150 mmol), Compound B-17-1 (750 mmol), K₂CO₃ (900 mmol), and CuI (165 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 68 mmol of Compound B-17-2 (yield of about 45%). The purified product which was obtained was identified to have a molecular weight of about 731, as measured by FABMS.

Compound B-17-2 (68 mmol), B-17-3 (224 mmol), K₂CO₃ (408 mmol), and CuI (75 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 41 mmol of Compound B-17-4 (yield of about 61%). The purified product which was obtained was identified to have a molecular weight of about 1295, as measured by FABMS.

Compound B-17-4 (41 mmol) was added to a three-necked flask, the flask was purged with Ar, then 21 ml of ODCB was added and dissolved, then BI₃ (164 mmol) was added, and the resultant mixture was stirred at about 140 °C for about 3 hours. The reaction mixture was dispersed and washed using a large amount of acetonitrile and then filtered to collect the solids. The obtained crude product was purified through silica gel column chromatography (a mixed solvent of hexane/ dichloromethane) and recrystallization (a mixed solvent of ethanol/toluene) to obtain about 22 mmol of Compound B-17-5 (yield of about 53%). The purified product which was obtained was identified to have a molecular weight of about 1310, as measured by FABMS.

Compound B-17-5 (22 mmol), Compound B-17-6 (44 mmol), Pd(dba)₂ (2 mmol), SPhos (4 mmol), and tBuONa (66 mmol) were added to a three-necked flask, the flask was purged with Ar, then 22 ml of toluene was added, and the resultant mixture was stirred at about 110 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 15 mmol of Compound B-17 (yield of about 70%). The purified product which was obtained was identified to have a molecular weight of about 1441, as measured by FABMS.

### (4) Synthesis of Compound B-24

Fused Polycyclic Compound B-24 according to at least one example embodiment may be synthesized by, for example, the following steps.

### [Synthesis of Compound B-24-3]

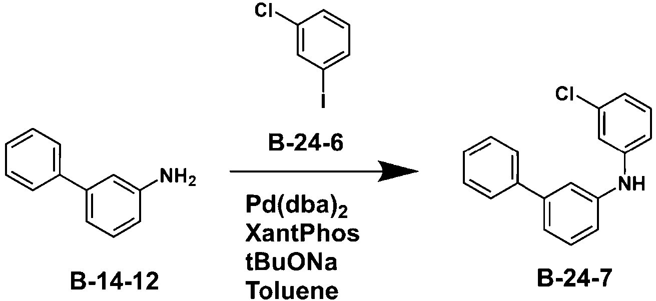

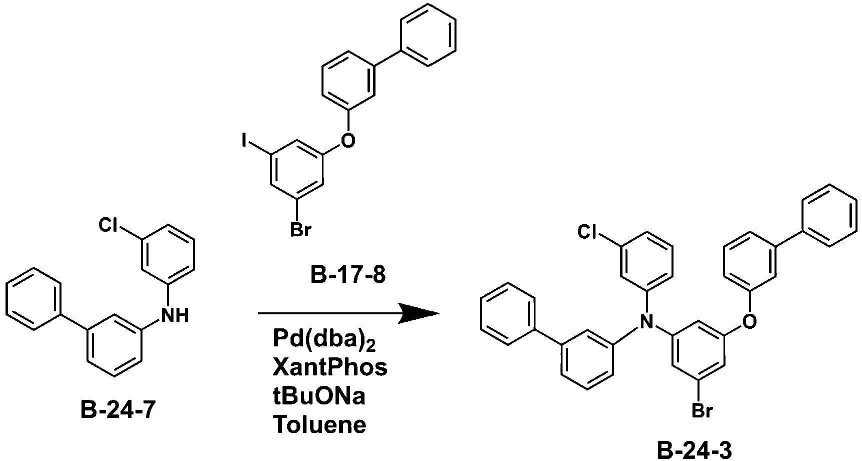

Compound B-14-12 (300 mmol), Compound B-24-6 (300 mmol), tBuONa (450 mmol), Pd(dba)₂ (15 mmol), and XantPhos (30 mmol) were added to a three-necked flask, the flask was purged with Ar, then 1000 ml of toluene was added, and the resultant mixture was stirred at about 80 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 273 mmol of Compound B-24-7 (yield of about 91%). The purified product which was obtained was identified to have a molecular weight of about 279, as measured by FABMS.

Compound B-24-7 (273 mmol), Compound B-17-8 (273 mmol), tBuONa (410 mmol), Pd(dba)₂ (14 mmol), and XantPhos (28 mmol) were added to a three-necked flask, the flask was purged with Ar, then 910 ml of toluene was added, and the resultant mixture was stirred at about 80 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 246 mmol of Compound B-24-3 (yield of about 90%). The purified product which was obtained was identified to have a molecular weight of about 602, as measured by FABMS.

### [Synthesis of Compound B-24]

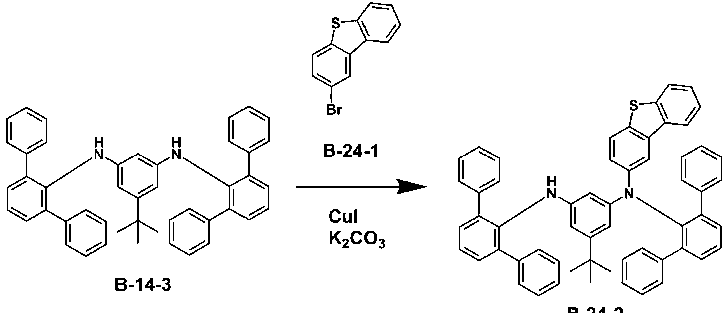

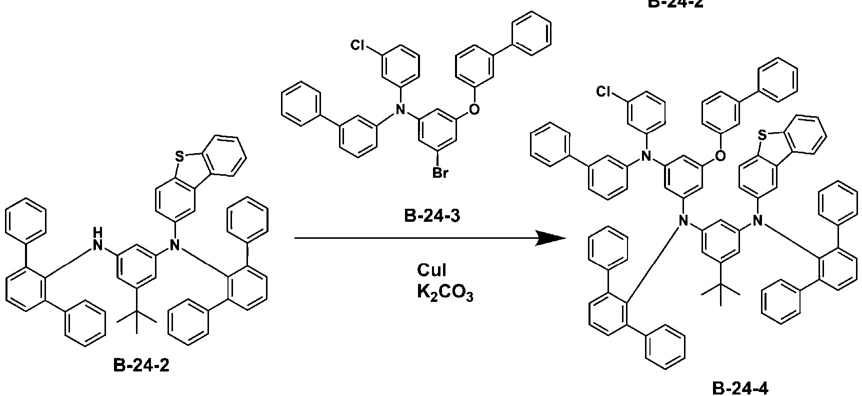

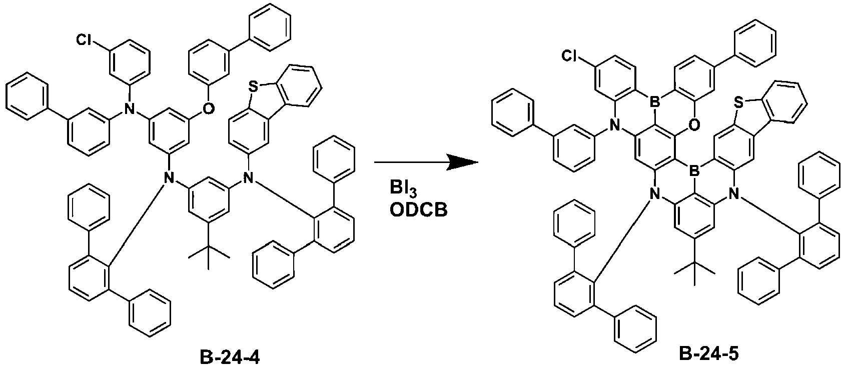

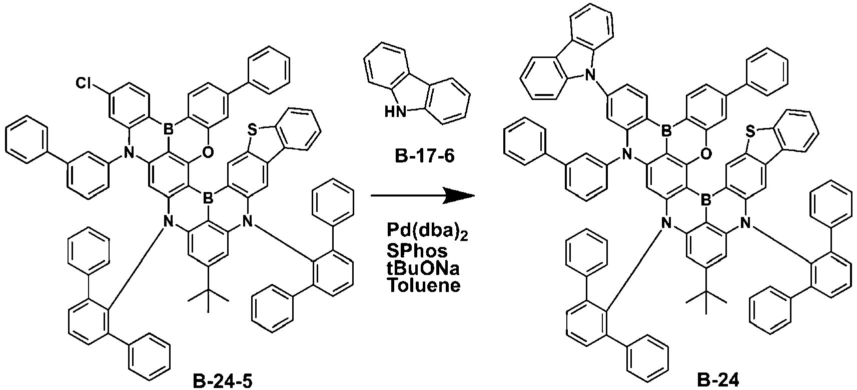

Compound B-14-3 (150 mmol), Compound B-24-1 (750 mmol), K₂CO₃ (900 mmol), and CuI (165 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 78 mmol of Compound B-24-2 (yield of about 52%). The purified product which was obtained was identified to have a molecular weight of about 803, as measured by FABMS.

Compound B-24-2 (78 mmol), Compound B-24-3 (246 mmol), K₂CO₃ (468 mmol), and CuI (86 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 43 mmol of Compound B-24-4 (yield of about 55%). The purified product which was obtained was identified to have a molecular weight of about 1325, as measured by FABMS.

Compound B-24-4 (43 mmol) was added to a three-necked flask, the flask was purged with Ar, then 22 ml of ODCB was added and dissolved, then BI₃ (172 mmol) was added, and the resultant mixture was stirred at about 140 °C for about 3 hours. The reaction mixture was dispersed and washed using a large amount of acetonitrile, and then solids were filtered and collected. The obtained crude product was purified through silica gel column chromatography (a mixed solvent of hexane/ dichloromethane) and recrystallization (a mixed solvent of ethanol/toluene) to obtain about 11 mmol of Compound B-24-5 (yield of about 25%). The purified product which was obtained was identified to have a molecular weight of about 1340, as measured by FABMS.

Compound B-24-5 (11 mmol), Compound B-17-6 (22 mmol), Pd(dba)₂ (1 mmol), SPhos (2 mmol), and tBuONa (33 mmol) were added to a three-necked flask, the flask was purged with Ar, then 11 ml of toluene was added, and the resultant mixture was stirred at about 110 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 8 mmol of Compound B-24 (yield of about 72%). The purified product which was obtained was identified to have a molecular weight of about 1471, as measured by FABMS.

### (5) Synthesis of Compound B-25

Fused Polycyclic Compound B-25 according to at least one example embodiment may be synthesized by, for example, the following steps.

### [Synthesis of Compound B-25-7]

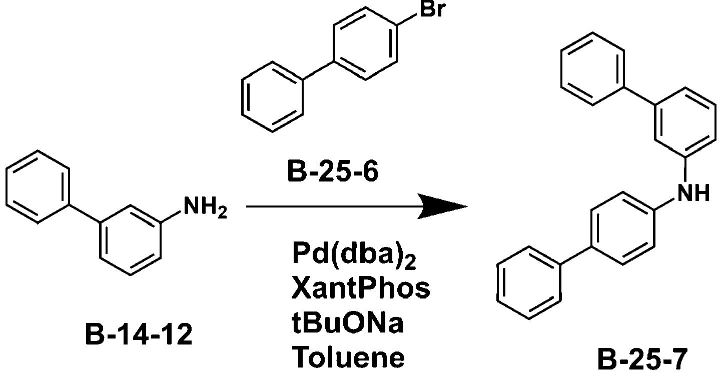

Compound B-14-12 (300 mmol), Compound B-25-6 (300 mmol), tBuONa (450 mmol), Pd(dba)₂ (15 mmol), and XantPhos (30 mmol) were added to a three-necked flask, the flask was purged with Ar, then 1000 ml of toluene was added, and the resultant mixture was stirred at about 80 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 282 mmol of Compound B-25-7 (yield of about 94%). The purified product which was obtained was identified to have a molecular weight of about 321, as measured by FABMS.

### [Synthesis of Compound B-25-3]

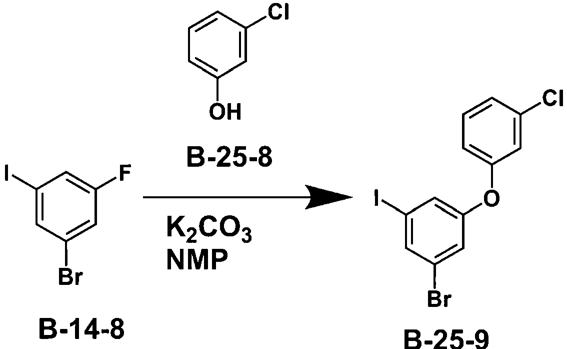

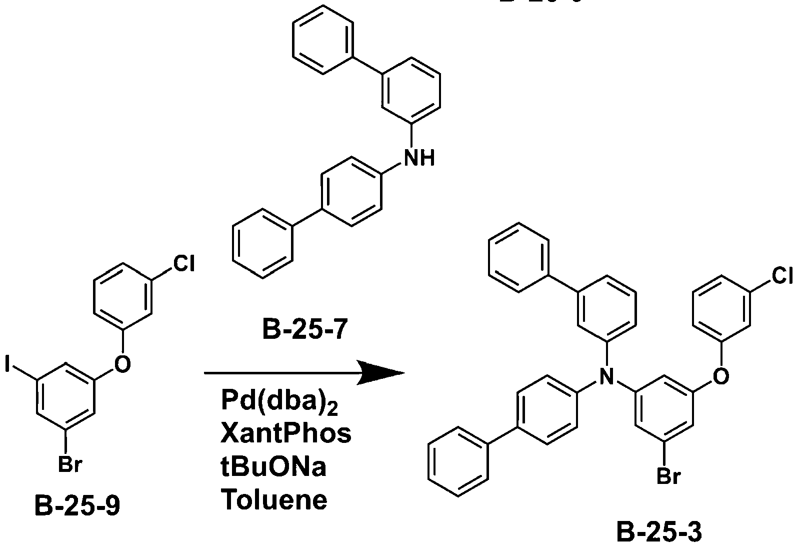

Compound B-14-8 (300 mmol), Compound B-25-8 (300 mmol), and K₂CO₃ (600 mmol) were added to a three-necked flask, the flask was purged with Ar, then 200 ml of NMP was added, and the resultant mixture was stirred at about 150 °C for about 24 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 243 mmol of Compound B-25-9 (yield of about 81%). The purified product which was obtained was identified to have a molecular weight of about 409, as measured by FABMS.

Compound B-25-9 (243 mmol), Compound B-25-7 (243 mmol), tBuONa (364 mmol), Pd(dba)₂ (12 mmol), and XantPhos (24 mmol) were added to a three-necked flask, the flask was purged with Ar, then 800 ml of toluene was added, and the resultant mixture was stirred at about 80 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 221 mmol of Compound B-25-3 (yield of about 91%). The purified product which was obtained was identified to have a molecular weight of about 602, as measured by FABMS.

### [Synthesis of Compound B-25]

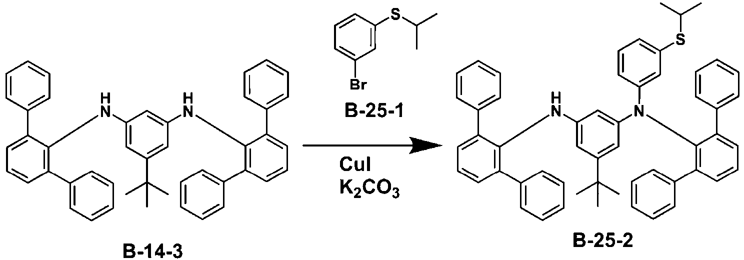

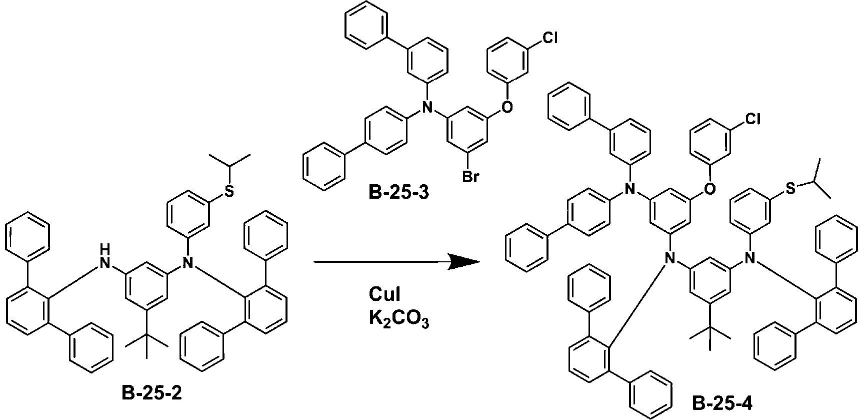

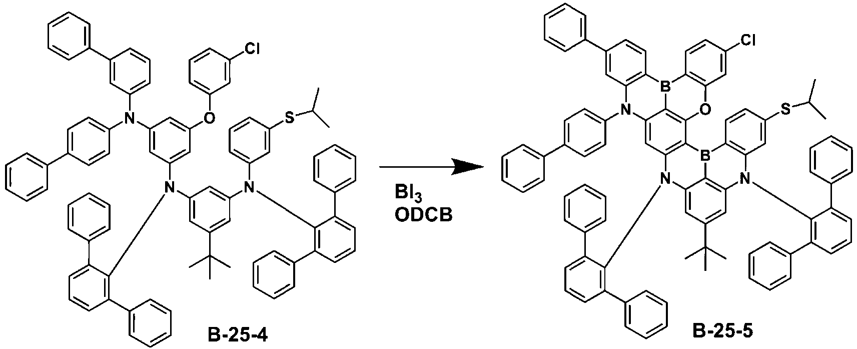

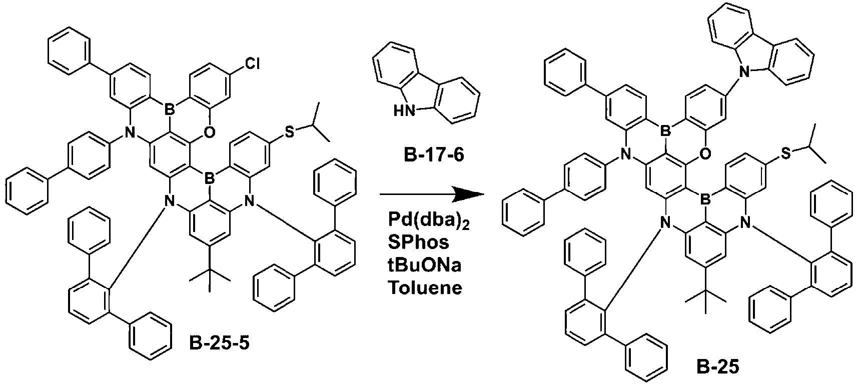

Compound B-14-3 (150 mmol), Compound B-25-1 (750 mmol), K₂CO₃ (900 mmol), and CuI (165 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 69 mmol of Compound B-25-2 (yield of about 46%). The purified product which was obtained was identified to have a molecular weight of about 771, as measured by FABMS.

Compound B-25-2 (69 mmol), Compound B-25-3 (221 mmol), K₂CO₃ (414 mmol), and CuI (76 mmol) were added to a three-necked flask, the flask was purged with Ar, and then the resultant was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 41 mmol of Compound B-25-4 (yield of about 59%). The purified product which was obtained was identified to have a molecular weight of about 1293, as measured by FABMS.

Compound B-25-4 (41 mmol) was added to a three-necked flask, the flask was purged with Ar, then 21 mL of ODCB was added and dissolved, then BI₃ (164 mmol) was added, and the resultant mixture was stirred at about 140 °C for about 3 hours. The reaction mixture was dispersed and washed using a large amount of acetonitrile, and then solids were filtered and collected. The obtained crude product was purified through silica gel column chromatography (a mixed solvent of hexane/dichloromethane) and recrystallization (a mixed solvent of ethanol/toluene) to obtain about 21 mmol of Compound B-25-5 (yield of about 50%). The purified product which was obtained was identified to have a molecular weight of about 1308, as measured by FABMS.

Compound B-25-5 (21 mmol), Compound B-17-6 (42 mmol), Pd(dba)₂ (2 mmol), SPhos (4 mmol), and tBuONa (63 mmol) were added to a three-necked flask, the flask was purged with Ar, then 21 ml of toluene was added, and the resultant mixture was stirred at about 110 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 16 mmol of Compound B-25 (yield of about 77%). The purified product which was obtained was identified to have a molecular weight of about 1439, as measured by FABMS.

### (6) Synthesis of Compound C-2

Fused Polycyclic Compound C-2 according to at least one example embodiment may be synthesized by, for example, the following steps.

### [Synthesis of Compound C-2-4]

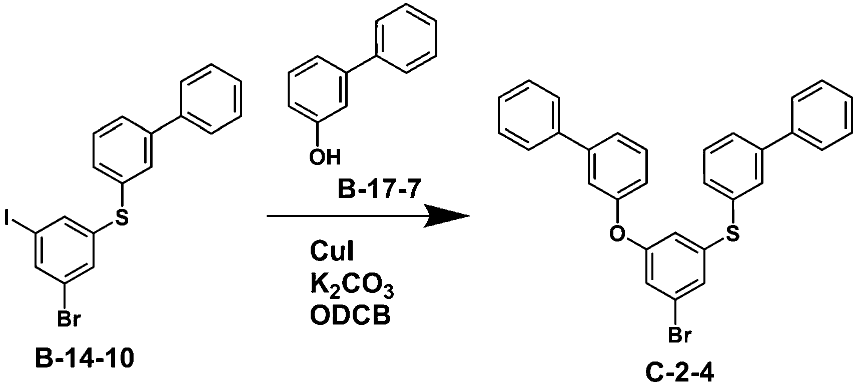

Compound B-14-10 (600 mmol), Compound B-17-7 (300 mmol), K₂CO₃ (1800 mmol), CuI (330 mmol), and 40 mL of ODCB were added to a three-necked flask, the flask was purged with Ar, and then the resultant mixture was stirred at about 170 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 240 mmol of Compound C-2-4 (yield of about 80%). The purified product which was obtained was identified to have a molecular weight of about 509, as measured by FABMS.

### [Synthesis of Compound C-2]

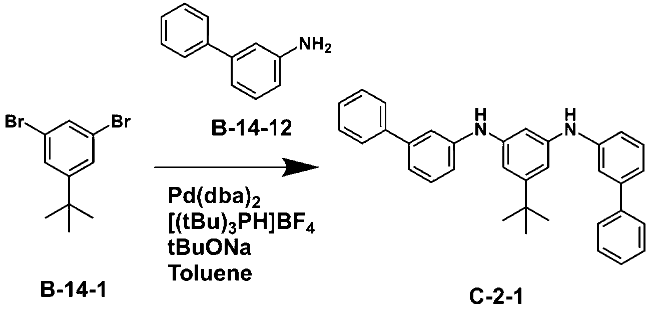

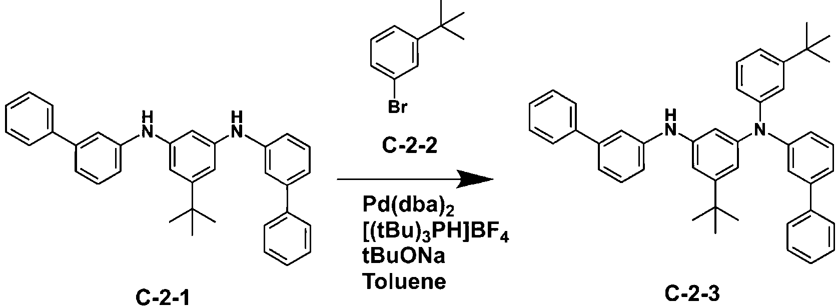

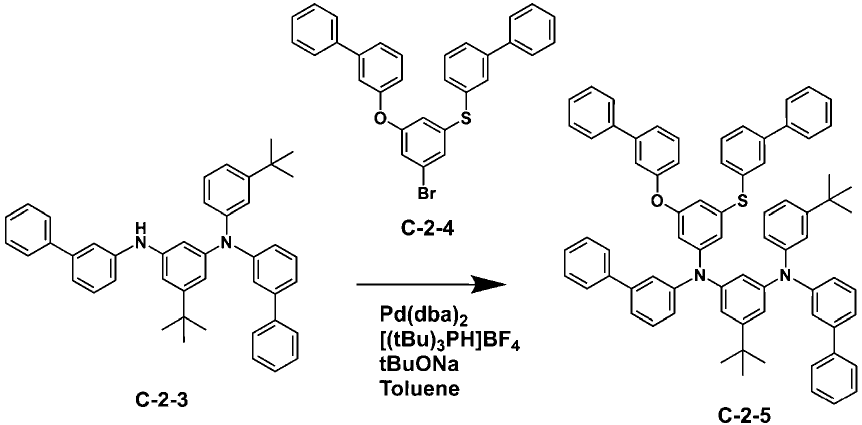

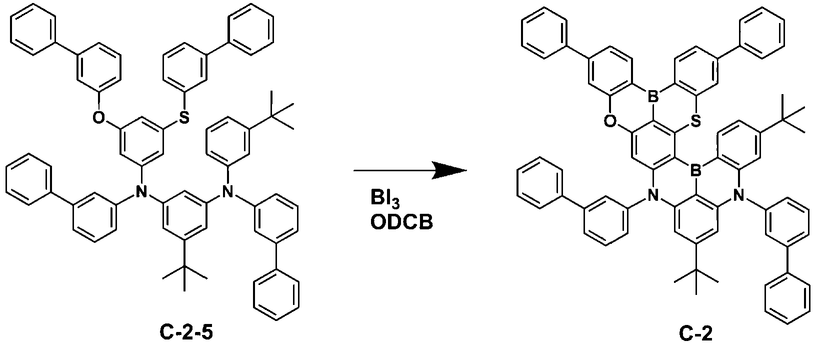

Compound B-14-1 (200 mmol), Compound B-14-12 (410 mmol), tBuONa (600 mmol), Pd(dba)₂ (10 mmol), and [(tBu)₃PH]BF₄ (20 mmol) were added to a three-necked flask, the flask was purged with Ar, then 1000 ml of toluene was added, and the resultant mixture was stirred at about 90 °C for 5 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 186 mmol Compound C-2-1 (yield of about 93%). The purified product which was obtained was identified to have a molecular weight of about 468, as measured by FABMS.

Compound C-2-1 (186 mmol), Compound C-2-2 (169 mmol), tBuONa (186 mmol), Pd(dba)₂ (8 mmol), and [(tBu)₃PH]BF₄ (16 mmol) were added to a three-necked flask, the flask was purged with Ar, then 845 ml of toluene was added, and the resultant mixture was stirred at about 90 °C for about 5 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 130 mmol of Compound C-2-3 (yield of about 77%). The purified product which was obtained was identified to have a molecular weight of about 600, as measured by FABMS.

Compound C-2-3 (130 mmol), Compound C-2-4 (143 mmol), tBuONa (260 mmol), Pd(dba)₂ (6 mmol), and [(tBu)₃PH]BF₄ (12 mmol) were added to a three-necked flask, the flask was purged with Ar, then 650 ml of toluene was added, and the resultant mixture was stirred at about 90 °C for about 7 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 104 mmol of Compound C-2-5 (yield of about 80%). The purified product which was obtained was identified to have a molecular weight of about 1029, as measured by FABMS.

Compound C-2-5 (104 mmol) was added to a three-necked flask, the flask was purged with Ar, then 52 ml of ODCB was added and dissolved, then BI₃ (416 mmol) was added, and the resultant mixture was stirred at about 140 °C for about 3 hours. The reaction mixture was dispersed and washed using a large amount of acetonitrile, and then solids were filtered and collected. The obtained crude product was purified through silica gel column chromatography (a mixed solvent of hexane/ dichloromethane) and recrystallization (a mixed solvent of ethanol/toluene) to obtain about 8 mmol of Compound C-2 (yield of about 8%). The purified product which was obtained was identified to have a molecular weight of about 1044, as measured by FABMS.

### (7) Synthesis of Compound C-16

Fused Polycyclic Compound C-16 according to at least one example embodiment may be synthesized by, for example, the following steps.

### [Synthesis of Compound C-16-1]

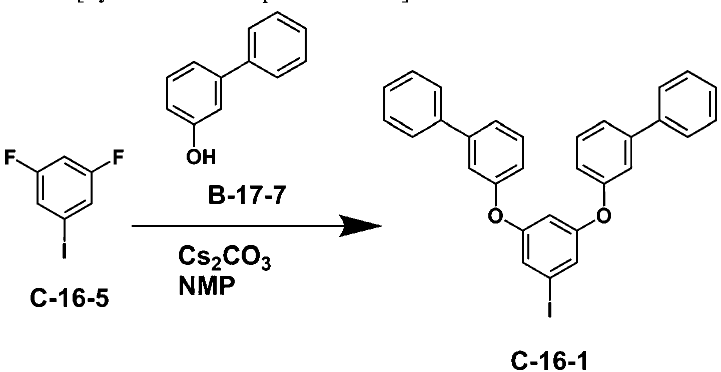

Compound C-16-5 (300 mmol), Compound B-17-7 (630 mmol), and Cs₂CO₃ (900 mmol) were added to a three-necked flask, the flask was purged with Ar, then 500 ml of NMP was added, and the resultant mixture was stirred at about 165 °C for about 3 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 240 mmol of Compound C-16-1 (yield of about 80%). The purified product which was obtained was identified to have a molecular weight of about 540, as measured by FABMS.

### [Synthesis of Compound C-16]

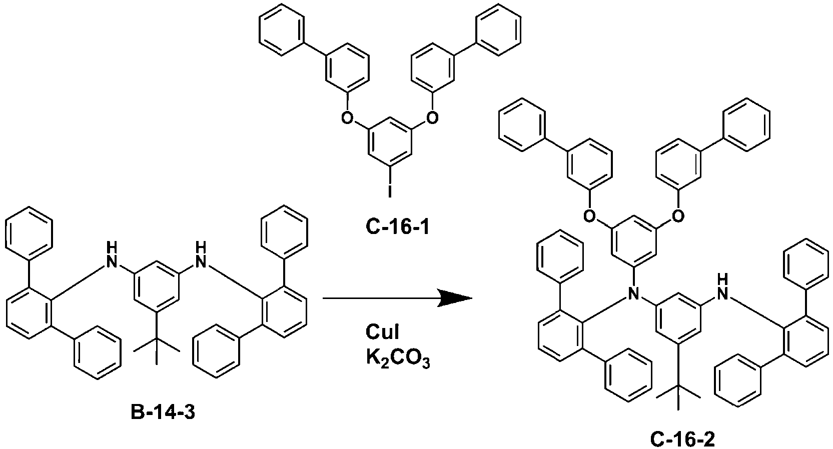

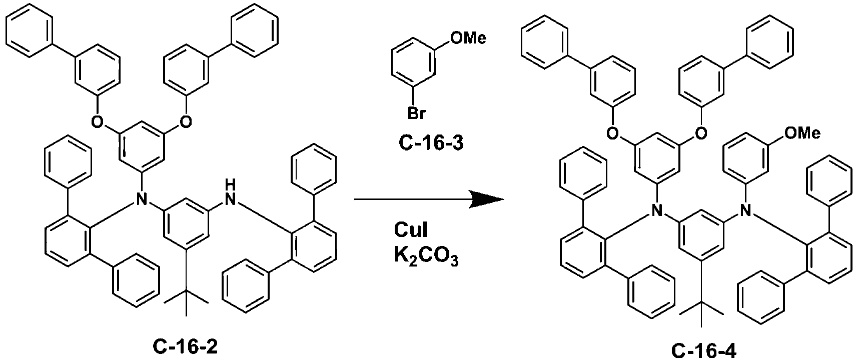

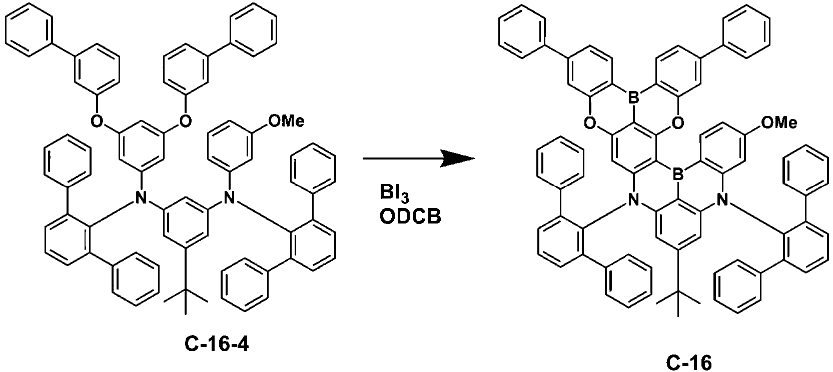

Compound B-14-3 (50 mmol), Compound C-16-1 (240 mmol), K₂CO₃ (300 mmol), and CuI (55 mmol) were added to a three-necked flask, the flask was purged with Ar, and then the resultant was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 28 mmol of Compound C-16-2 (yield of about 55%). The purified product which was obtained was identified to have a molecular weight of about 1033, as measured by FABMS.

Compound C-16-2 (8 mmol), Compound C-16-3 (40 mmol), K₂CO₃ (48 mmol), and CuI (9 mmol) were added to a three-necked flask, the flask was purged with Ar, and then the resultant mixture was stirred at about 210 °C for about 48 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 6 mmol of Compound C-16-4 (yield of about 80%). The purified product which was obtained was identified to have a molecular weight of about 1139, as measured by FABMS.

Compound C-16-4 (6 mmol) was added to a three-necked flask, the flask was purged with Ar, then 57 ml of ODCB was added and dissolved, then BI₃ (27 mmol) was added, and the resultant mixture was stirred at about 140 °C for about 3 hours. The reaction mixture was dispersed and washed using a large amount of acetonitrile, and then solids were filtered and collected. The obtained crude product was purified through silica gel column chromatography (a mixed solvent of hexane/ dichloromethane) and recrystallization (a mixed solvent of ethanol/toluene) to obtain about 3 mmol of Compound C-16 (yield of about 43%). The purified product which was obtained was identified to have a molecular weight of about 1155, as measured by FABMS.

### (8) Synthesis of Compound C-18

Fused Polycyclic Compound C-18 according to at least one example embodiment may be synthesized by, for example, the following steps.

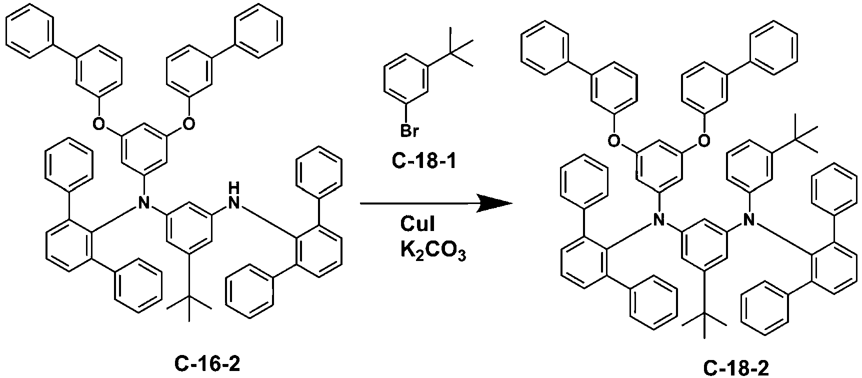

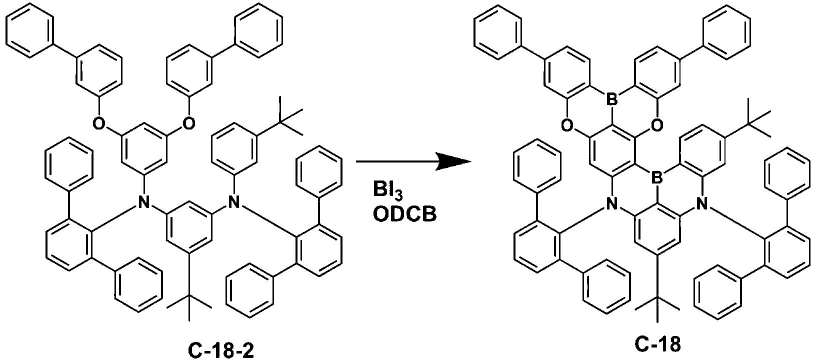

Compound C-16-2 (8 mmol), Compound C-18-1 (54 mmol), K₂CO₃ (46 mmol), and CuI (8 mmol) were added to a three-necked flask, the flask was purged with Ar, and then the resultant mixture was stirred at about 210 °C for about 38 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 7 mmol of Compound C-18-2 (yield of about 88%). The purified product which was obtained was identified to have a molecular weight of about 1165, as measured by FABMS.

Compound C-18-2 (7 mmol) was added to a three-necked flask, the flask was purged with Ar, then 57 ml of ODCB was added and dissolved, then BI₃ (27 mmol) was added, and the resultant mixture was stirred at about 140 °C for about 3 hours. The reaction mixture was dispersed and washed using a large amount of acetonitrile, and then solids were filtered and collected. The obtained crude product was purified through silica gel column chromatography (a mixed solvent of hexane/ dichloromethane) and recrystallization (a mixed solvent of ethanol/toluene) to obtain about 3 mmol of Compound C-18 (yield of about 47%). The purified product which was obtained was identified to have a molecular weight of about 1181, as measured by FABMS.

### (9) Synthesis of Compound C-20

Fused Polycyclic Compound C-20 according to at least one example embodiment may be synthesized by, for example, the following steps.

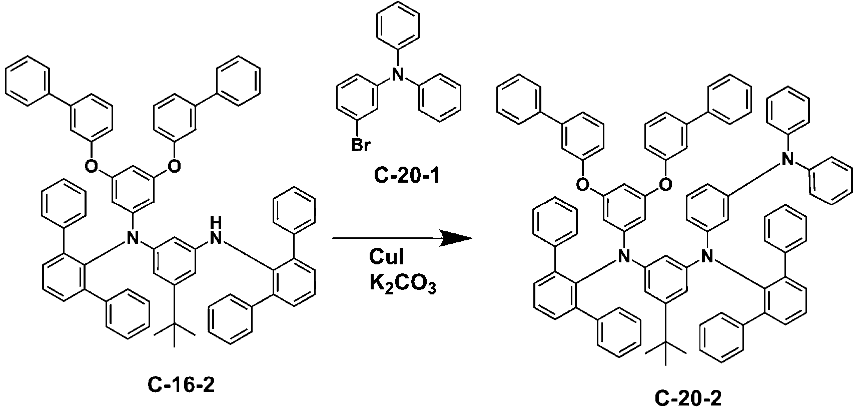

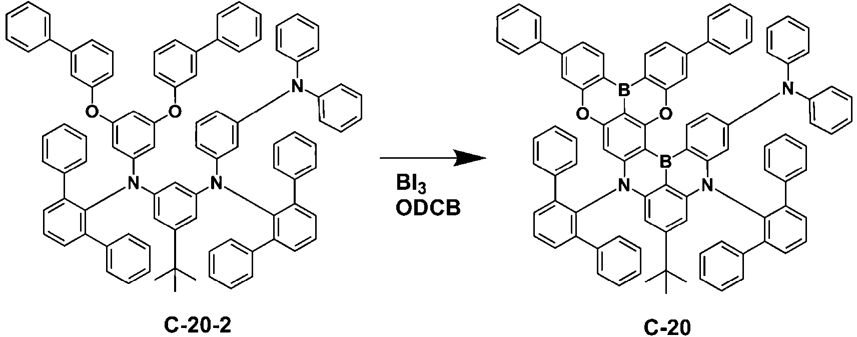

Compound C-16-2 (8 mmol), Compound C-20-1 (40 mmol), K₂CO₃ (48 mmol), and CuI (9 mmol) were added to a three-necked flask, the flask was purged with Ar, and then the resultant mixture was stirred at about 210 °C for about 48 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 7 mmol of Compound C-20-2 (yield of about 89%). The purified product which was obtained was identified to have a molecular weight of about 1276, as measured by FABMS.

Compound C-20-2 (7 mmol) was added to a three-necked flask, the flask was purged with Ar, then 56 ml of ODCB was added and dissolved, then BI₃ (21 mmol) was added, and the resultant mixture was stirred at about 140 °C for about 3 hours. The reaction mixture was dispersed and washed using a large amount of acetonitrile, and then solids were filtered and collected. The obtained crude product was purified through silica gel column chromatography (a mixed solvent of hexane/ dichloromethane) and recrystallization (a mixed solvent of ethanol/toluene) to obtain about 3 mmol of Compound C-20 (yield of about 42%). The purified product which was obtained was identified to have a molecular weight of about 1292, as measured by FABMS.

### (10) Synthesis of Compound C-30

Fused Polycyclic Compound C-30 according to at least one example embodiment may be synthesized by, for example, the following steps.

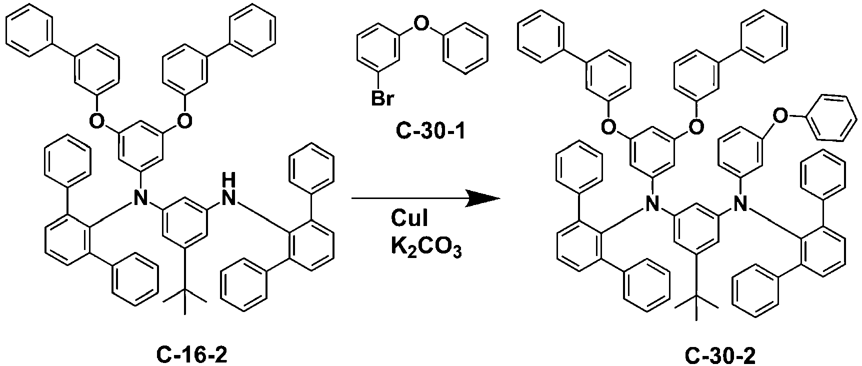

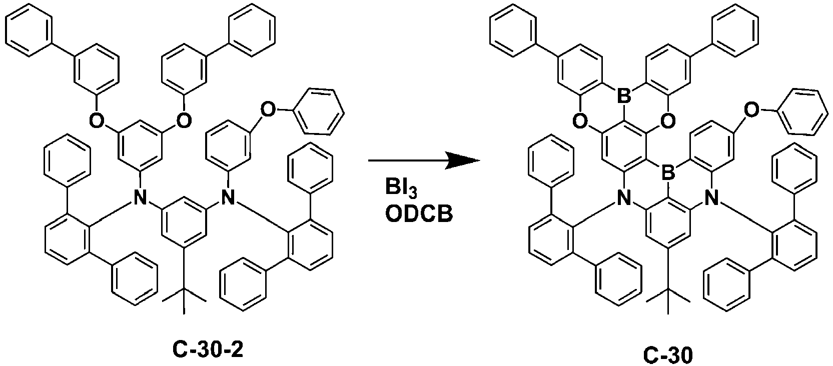

Compound C-16-2 (8 mmol), Compound C-30-1 (40 mmol), K₂CO₃ (48 mmol), and CuI (9 mmol) were added to a three-necked flask, the flask was purged with Ar, and then the resultant mixture was stirred at about 210 °C for about 38 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 7 mmol of Compound C-30-2 (yield of about 87%). The purified product which was obtained was identified to have a molecular weight of about 1201, as measured by FABMS.

Compound C-30-2 (7 mmol) was added to a three-necked flask, the flask was purged with Ar, then 56 ml of ODCB was added and dissolved, then BI₃ (21 mmol) was added, and the resultant mixture was stirred at about 140 °C for about 3 hours. The reaction mixture was dispersed and washed using a large amount of acetonitrile, and then solids were filtered and collected. The obtained crude product was purified through silica gel column chromatography (a mixed solvent of hexane/ dichloromethane) and recrystallization (a mixed solvent of ethanol/toluene) to obtain about 3 mmol of Compound C-30 (yield of about 46%). The purified product which was obtained was identified to have a molecular weight of about 1217, as measured by FABMS.

### (11) Synthesis of Compound D-15

Fused Polycyclic Compound D-15 according to at least one example embodiment may be synthesized by, for example, the following steps.

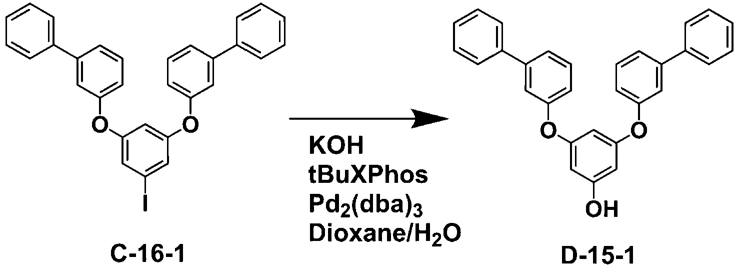

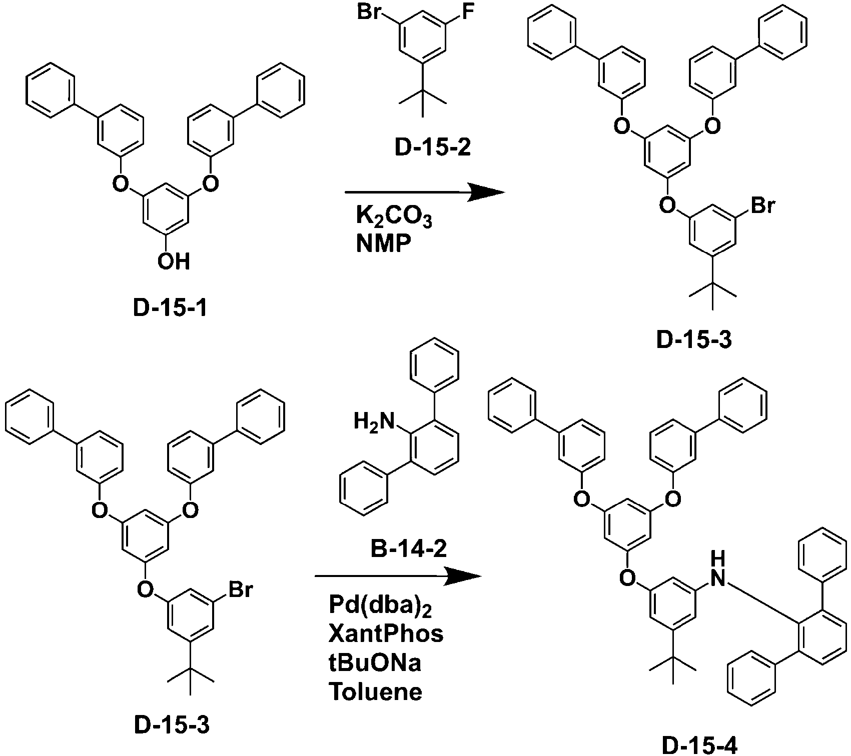

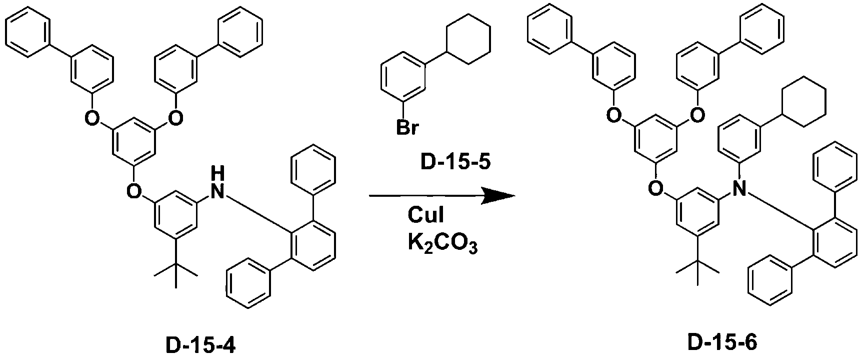

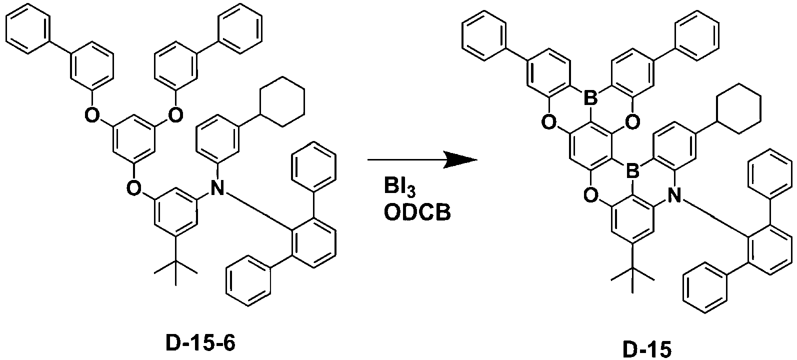

Compound C-16-1 (281 mmol), KOH (843 mmol), Pd(dba)₂ (2 mmol), and tBuXPhos (8 mmol) were added to a three-necked flask, the flask was purged with Ar, then 60 ml of dioxane, and 60 ml of H₂O were added, and the resultant mixture was stirred at about 100 °C for about 6 hours. Hydrochloric acid of 10 vol% was added to a reaction system, and an organic layer was extracted using toluene and dried over magnesium sulfate and a solvent was removed by distillation. The obtained crude product was purified through silica gel column chromatography (a mixed solvent of hexane/toluene) to obtain about 132 mmol of Compound D-15-1 (yield of about 47%). The purified product which was obtained was identified to have a molecular weight of about 430, as measured by FABMS.

Compound D-15-1 (132 mmol), Compound D-15-2 (132 mmol), and K₂CO₃ (396 mmol) were added to a three-necked flask, the flask was purged with Ar, then 400 ml of NMP was added, and the resultant mixture was stirred at about 165 °C for about 5 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 119 mmol of Compound D-15-3 (yield of about 90%). The purified product which was obtained was identified to have a molecular weight of about 641, as measured by FABMS.

Compound D-15-3 (119 mmol), Compound B-14-2 (131 mmol), tBuONa (179 mmol), Pd(dba)₂ (6 mmol), and XantPhos (12 mmol) were added to a three-necked flask, the flask was purged with Ar, then 1000 ml of toluene was added, and the resultant mixture was stirred at about 90 °C for 6 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 108 mmol of Compound D-15-4 (yield of about 91%). The purified product which was obtained was identified to have a molecular weight of about 806, as measured by FABMS.

Compound D-15-4 (108 mmol), Compound D-15-5 (540 mmol), K₂CO₃ (648 mmol), and CuI (119 mmol) were added to a three-necked flask, the flask was purged with Ar, and then the resultant mixture was stirred at about 210 °C for about 72 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) and recrystallization (a mixed solvent of ethanol/toluene) to obtain about 66 mmol of Compound D-15-6 (yield of about 61%). The purified product which was obtained was identified to have a molecular weight of about 964, as measured by FABMS.

Compound D-15-6 (66 mmol) was added to a three-necked flask, the flask was purged with Ar, then 198 ml of ODCB was added and dissolved, then BI₃ (198 mmol) was added, and the resultant mixture was stirred at about 140 °C for about 3 hours. The reaction mixture was dispersed and washed using a large amount of acetonitrile, and then solids were filtered and collected. The obtained crude product was purified through silica gel column chromatography (a mixed solvent of hexane/dichloromethane) and recrystallization (a mixed solvent of ethanol/toluene) to obtain about 9 mmol of Compound D-15 (yield of about 14%). The purified product which was obtained was identified to have a molecular weight of about 979, as measured by FABMS.

### (12) Synthesis of Compound E-1

Fused Polycyclic Compound E-1 according to at least one example embodiment may be synthesized by, for example, the following steps.

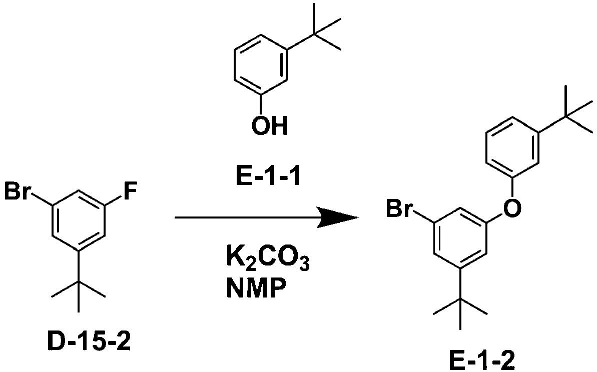

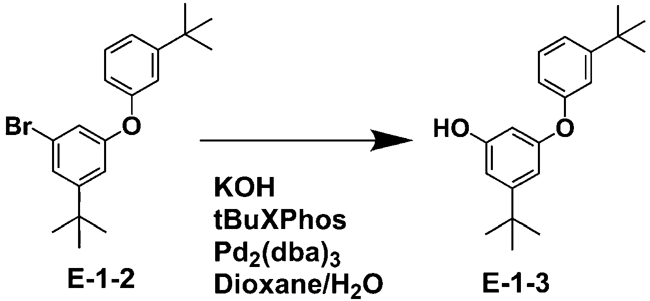

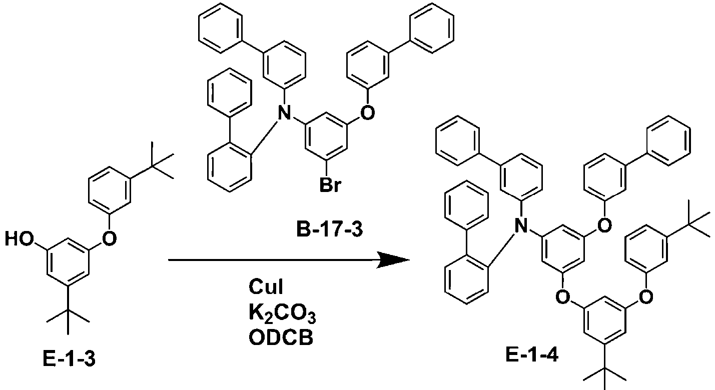

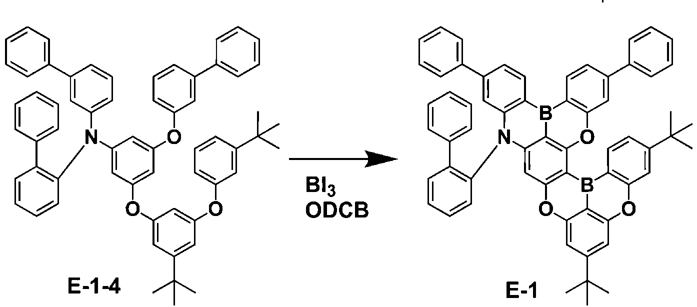

Compound D-15-2 (300 mmol), Compound E-1-1 (300 mmol), and K₂CO₃ (600 mmol) were added to a three-necked flask, the flask was purged with Ar, then 200 ml of NMP was added, and the resultant mixture was stirred at about 150 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 234 mmol of Compound E-1-2 (yield of about 78%). The purified product which was obtained was identified to have a molecular weight of about 361, as measured by FABMS.

Compound E-1-2 (234 mmol), KOH (702 mmol), Pd(dba)₂ (2 mmol), and 2-di-tert-butylphosphino-2',4',6'-triisopropylbiphenyl ("tBuXPhos") (8 mmol) were added to a three-necked flask, the flask was purged with Ar, then 60 ml of dioxane and 60 ml of H₂O were added, and the resultant mixture was stirred at about 100 °C for about 6 hours. 10 vol% of hydrochloric acid was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 105 mmol of Compound E-1-3 (yield of about 45%). The purified product which was obtained was identified to have a molecular weight of about 298, as measured by FABMS.

Compound E-1-3 (105 mmol), Compound B-17-3 (315 mmol), K₂CO₃ (630 mmol), CuI (116 mmol), and 14 ml of ODCB were added to a three-necked flask, the flask was purged with Ar, and then the resultant mixture was stirred at about 170 °C for about 8 hours. Water was added to a reaction system, and an organic layer was extracted using toluene. The extracted organic layer was dried over magnesium sulfate and a solvent was removed by distillation. The obtained crude product was purified through silica gel column chromatography (a mixed solvent of hexane/toluene) to obtain about 51 mmol of Compound E-1-4 (yield of about 49%). The purified product which was obtained was identified to have a molecular weight of about 862, as measured by FABMS.

Compound E-1-4 (51 mmol) was added to a three-necked flask, the flask was purged with Ar, then 26 ml of ODCB was added and dissolved, then BI₃ (204 mmol) was added, and the resultant mixture was stirred at about 140 °C for about 3 hours. The reaction mixture was dispersed and washed using a large amount of acetonitrile, and then solids were filtered and collected. The obtained crude product was purified through silica gel column chromatography (a mixed solvent of hexane/dichloromethane) and recrystallization (a mixed solvent of ethanol/toluene) to obtain about 3 mmol of Compound E-1 (yield of about 6%). The purified product which was obtained was identified to have a molecular weight of about 877, as measured by FABMS.

### 2. Evaluation of compounds

Example Compounds and Comparative Example Compounds were evaluated, and the evaluation results were listed in Table 1 below. Compounds B-2, B-14, B-17, B-24, B-25, C-2, C-16, C-18, C-20, C-30, D-15, and E-1, which are the fused polycyclic compounds according to Examples, were evaluated as Example Compounds. Comparative Example Compounds X1 to X11 were evaluated as Comparative Example Compounds.

### <Example Compounds>

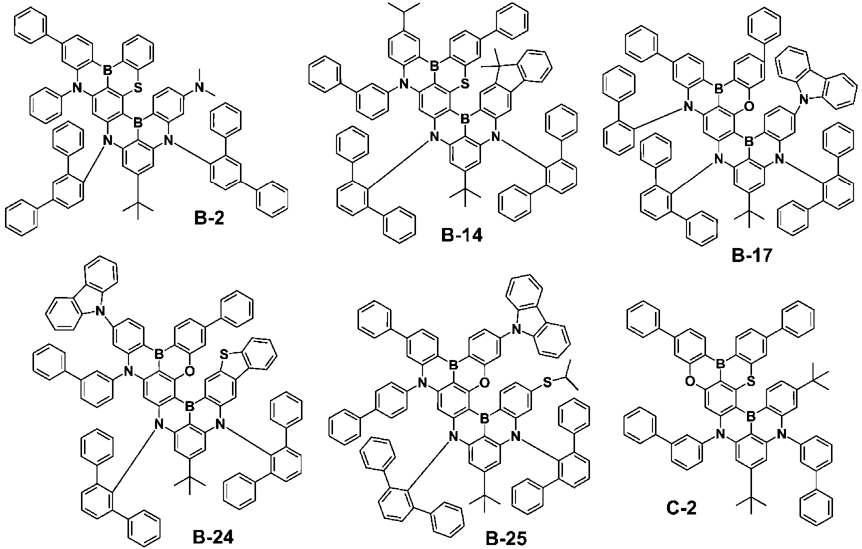

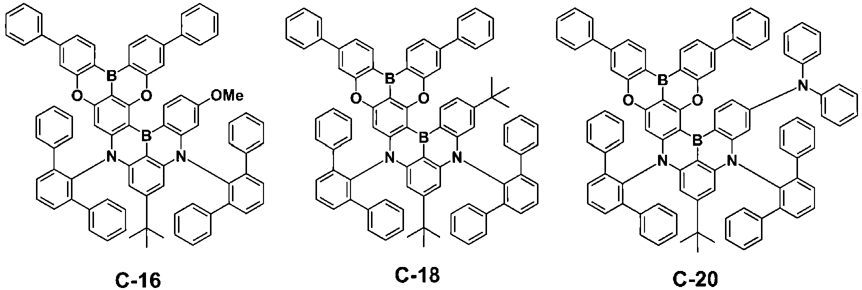

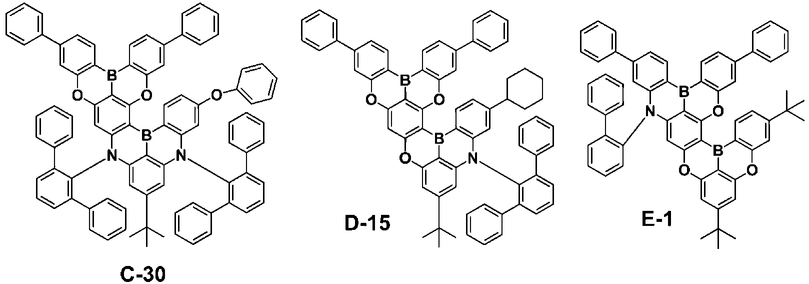

### <Comparative Example Compounds>

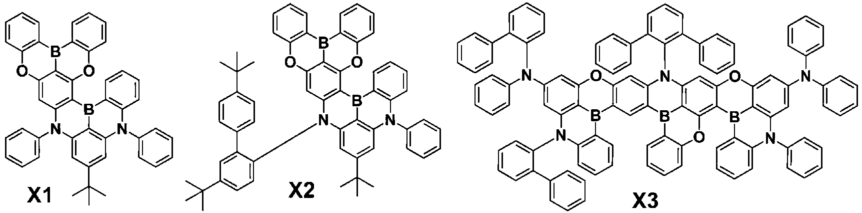

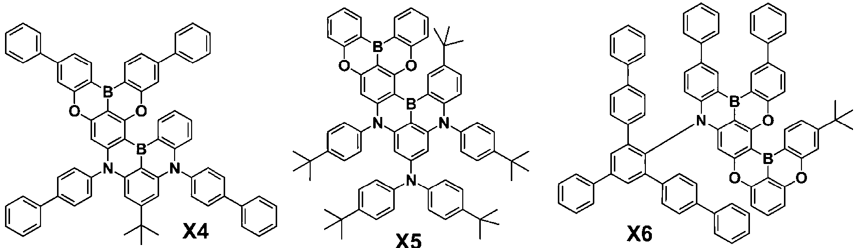

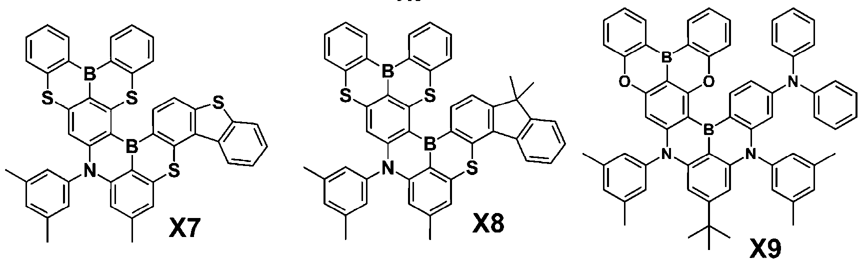

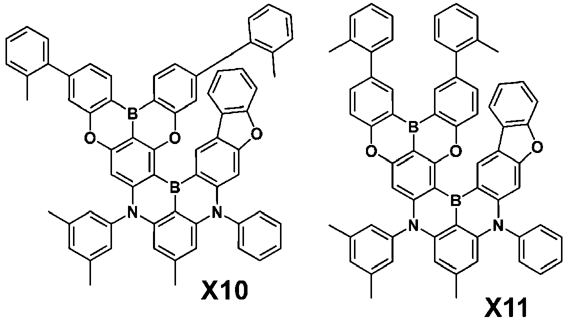

Table 1 shows the evaluation results of light-emitting characteristics. 20 wt% of a dope film was deposited with PPF as a matrix and formed on a quartz glass substrate, a fluorescence emission spectrum thereof was observed using a JASCO V-670 spectrometer, and λₘₐₓ was confirmed from the spectrum. The fluorescence quantum efficiency was measured using a JASCOILF-835 integrating sphere system.

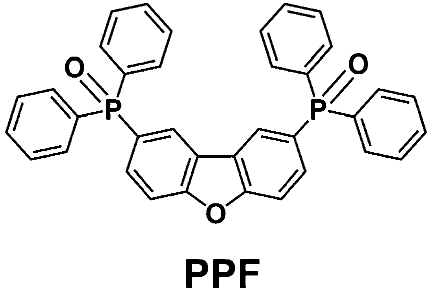

**[Table 1]**

| Compound | λₘₐₓ (nm) | Fluorescence quantum efficiency (%) |
|---|---|---|
| Example Compound B-2 | 467 | 79 |
| Example Compound B-14 | 468 | 82 |
| Example Compound B-17 | 456 | 81 |
| Example Compound B-24 | 460 | 83 |
| Example Compound B-25 | 462 | 80 |
| Example Compound C-2 | 461 | 84 |
| Example Compound C-16 | 462 | 81 |
| Example Compound C-18 | 460 | 84 |
| Example Compound C-20 | 459 | 81 |
| Example Compound C-30 | 461 | 80 |
| Example Compound D-15 | 455 | 79 |
| Example Compound E-1 | 453 | 80 |
| Comparative Example Compound X1 | 455 | 75 |
| Comparative Example Compound X2 | 454 | 78 |
| Comparative Example Compound X3 | 466 | 79 |
| Comparative Example Compound X4 | 462 | 77 |
| Comparative Example Compound X5 | 453 | 76 |
| Comparative Example Compound X6 | 452 | 70 |
| Comparative Example Compound X7 | 462 | 74 |
| Comparative Example Compound X8 | 461 | 72 |
| Comparative Example Compound X9 | 455 | 73 |
| Comparative Example Compound X10 | 457 | 76 |
| Comparative Example Compound X11 | 455 | 72 |

Referring to Table 1, it can be seen that the Example Compounds and Comparative Example Compounds each have λₘₐₓ of about 450 nm to about 470 nm. It can be seen that the Example Compounds exhibit higher fluorescence quantum efficiency than Comparative Example Compounds X1, X2, and X4 to X11. Example Compounds B-2, B-14, B-17, B-24, B-25, C-2, C-16, C-18, C-20, C-30, D-15 and E-1 are the fused polycyclic compound according to Examples and include the first substituent and the second substituent bonded to the nine-ring fused ring system (that is, the core structure). The first substituent corresponds to at least one of R^{a1} and R^{a2} in Formula 1 described previously and is a substituted or unsubstituted aryl group having 6 to 60 ring-forming carbon atoms. The second substituent corresponds to at least one among R^{b1} to R^{b4} in Formula 1 described previously and is an electron-donating substituent. Therefore, it can be seen that the fused polycyclic compound according to at least one example embodiment that includes the first and second substituents bonded to the nine-ring fused ring system will exhibit excellent fluorescence quantum efficiency.

Comparative Example Compounds X1 to X3 each include a nine-ring fused ring system but include no first and second substituents. Comparative Example Compound X4 includes a nine-ring fused ring system and a first substituent and includes no second substituent. Comparative Example Compounds X5 to X9 and X11 each include a nine-ring fused ring system and a second substituent and includes no first substituent. Comparative Example Compound X10 corresponds to a case where R^{b2} and R^{b3} are bonded to each other in Formula 1 described previously to form a moiety represented by Formula RB, but the first substituent is a phenyl group that is substituted with a methyl group. In the fused polycyclic compound according to at least one example embodiment represented by Formula 1, when R^{b2} and R^{b3} are bonded to each other to form a moiety represented by Formula RB, the first substituent is an unsubstituted aryl group. Therefore, Comparative Example Compounds X1, X2, and X4 to X11 each exhibit relatively low fluorescence quantum efficiency.

### 3. Manufacture and evaluation of light-emitting element

### (1) Manufacture of light-emitting element

The light-emitting elements including the fused polycyclic compounds according to the Examples or Comparative Example Compounds in the emission layer, respectively, were manufactured by the following method. The light-emitting elements according to Examples 1 to 12 were manufactured respectively using Compounds B-2, B-14, B-17, B-24, B-25, C-2, C-16, C-18, C-20, C-30, D-15 and E-1, which are the fused polycyclic compound according to the Examples, as a dopant material of the emission layer. The light-emitting elements according to Comparative Examples 1 to 11 were manufactured using the Comparative Example Compounds X1 to X11 as a dopant material of the emission layer.

ITO having a thickness of about 1500 Å was patterned on a glass substrate as the first electrode, and then the glass substrate was cleaned with ultrapure water and subjected to UV ozone treatment for about 10 minutes. Thereafter, a hole injection layer having a thickness of about 100 Å was formed of HAT-CN, and a hole transport layer having a thickness of about 400 Å was formed of α-NPD.

Next, an electron-blocking layer having a thickness of about 50 Å was formed of mCBP, and the Example Compound or the Comparative Example Compound, and mCBP were provided at a weight ratio of about 1:99 to form an emission layer. The emission layer was formed to a thickness of about 200 Å. An electron transport layer having a thickness of about 300 Å was formed of TPBi on the emission layer, and an electron injection layer having a thickness of about 5 Å was formed of LiF. Thereafter, a second electrode having a thickness of about 1000 Å was formed of aluminium (Al). The hole injection layer, the hole transport layer, the electron-blocking layer, the electron transport layer, the electron injection layer, and the second electrode were formed using a vacuum deposition system.

### (2) Evaluation of light-emitting element

The light-emitting elements according to the Examples and Comparative Examples were evaluated and the evaluated results are listed in Table 2 below. A voltage and a current density of the light-emitting element were measured using a sourcemeter (made by Keithley Instrument, 2400 series), and luminance and external quantum efficiency (EQE) were measured using an external quantum efficiency measurement system C9920-12 made by Hamamatsu Photonics. The time taken for luminance to decrease to 50% from 100% of an initial luminance was measured and a relative value with respect to the time measured of the light-emitting element according to Comparative Example 1 as 100% was listed as a lifespan (LT₅₀).

**[Table 2]**

| | Compound | λₘₐₓ (nm) | EQEₘₐₓ(%) | LT₅₀(%) |
|---|---|---|---|---|
| Example 1 | Example Compound B-2 | 469 | 22 | 381 |
| Example 2 | Example Compound B-14 | 469 | 23 | 412 |
| Example 3 | Example Compound B-17 | 460 | 22 | 380 |
| Example 4 | Example Compound B-24 | 462 | 23 | 425 |
| Example 5 | Example Compound B-25 | 464 | 22 | 391 |
| Example 6 | Example Compound C-2 | 463 | 24 | 410 |
| Example 7 | Example Compound C-16 | 463 | 22 | 395 |
| Example 8 | Example Compound C-18 | 461 | 24 | 433 |
| Example 9 | Example Compound C-20 | 461 | 22 | 385 |
| Example 10 | Example Compound C-30 | 463 | 21 | 407 |
| Example 11 | Example Compound D-15 | 458 | 20 | 377 |
| Example 12 | Example Compound E-1 | 456 | 21 | 365 |
| Comparative Example 1 | Comparative Example Compound X1 | 458 | 16 | 100 |
| Comparative Example 2 | Comparative Example Compound X2 | 457 | 19 | 156 |
| Comparative Example 3 | Comparative Example Compound X3 | 468 | 20 | 330 |
| Comparative Example 4 | Comparative Example Compound X4 | 463 | 18 | 172 |
| Comparative Example 5 | Comparative Example Compound X5 | 455 | 17 | 146 |
| Comparative Example 6 | Comparative Example Compound X6 | 454 | 12 | 133 |
| Comparative Example 7 | Comparative Example Compound X7 | 464 | 15 | 143 |
| Comparative Example 8 | Comparative Example Compound X8 | 463 | 14 | 139 |
| Comparative Example 9 | Comparative Example Compound X9 | 457 | 14 | 111 |
| Comparative Example 10 | Comparative Example Compound X10 | 460 | 17 | 164 |
| Comparative Example 11 | Comparative Example Compound X11 | 458 | 15 | 143 |

Referring to Table 2, it can be seen that the light-emitting elements according to Examples 1 to 12 each emit light with a wavelength around about 460 nm. It can be seen that the light-emitting elements according to Examples 1 to 12 each have longer lifespan than the light-emitting elements according to Comparative Examples 1 to 11. It can be seen that the light-emitting elements according to Examples 1 to 12 each exhibit higher external quantum efficiency and longer lifespan than the light-emitting elements according to Comparative Examples 1, 2, and 4 to 11. The light-emitting elements according to Examples 1 to 12 respectively include Example Compounds B-2, B-14, B-17, B-24, B-25, C-2, C-16, C-18, C-20, C-30, D-15, and E-1, and Compounds B-2, B-14, B-17, B-24, B-25, C-2, C-16, C-18, C-20, C-30, D-15, and E-1 are the fused polycyclic compound according to Examples. Compounds B-2, B-14, B-17, B-24, B-25, C-2, C-16, C-18, C-20, C-30, D-15, and E-1 each include the first and second substituents, which are bonded to the nine-ring fused ring system. Therefore, it can be seen that the light-emitting element including the fused polycyclic compound according to at least one example embodiment exhibits high emission efficiency and long lifespan.

Calculating molecular orbitals of Example Compounds B- 14, B- 17, B-24, C-2, C-18, and E-1 using Gaussian demonstrates that Example Compounds B-14, B-17, B-24, C-2, C-18, and E-1 each have a charge transfer type in which HOMO and LUMO distributions are separated. In Comparative Example Compounds X1 and X2, the HOMO distribution and the LUMO distribution are separated, but the first substituent and the second substituent are not contained, and thus charge transfer ("CT") characteristics are weak. In Comparative Example Compound X3, it can be seen that the HOMO distribution and the LUMO distribution are not well separated, and thus Comparative Example Compound X3 has an incomplete CT. Therefore, even when an electron-donating substituent is bonded to Comparative Example Compound X3, HOMO and LUMO slightly overlap, ΔE_{ST} is increased, and thus improvements in efficiency and suppression of roll-off may not be expected. The light-emitting elements according to Comparative Examples 1 to 3 respectively include Comparative Example Compounds X1 to X3. Comparative Example Compounds X1 to X3 each include no first and second substituents at predetermined positions and thus differ from the fused polycyclic compound according to at least one example embodiment. Therefore, the light-emitting elements according to Comparative Examples 1 to 3 each exhibit relatively low external quantum efficiency and short lifespan.

Comparative Example Compound X4 includes no second substituent at a predetermined position, and thus has weaker CT characteristics than the Example Compounds, and is not expected to have DET suppression and boron atom protection, which are steric effects. The light-emitting element according to Comparative Example 4 includes Comparative Example Compound X4. Therefore, the light-emitting element according to Comparative Example 4 exhibits relatively low external quantum efficiency and short lifespan.

The light-emitting elements according to Comparative Examples 5 to 8 respectively include Comparative Example Compounds X5 to X8. Comparative Example Compounds X5 to X8 include no first substituent at a para position with respect to the boron atom and thus differ from the fused polycyclic compounds according to Examples. In Comparative Example Compound X6, an aryl group is bonded at a meta position with respect to the boron atom, LUMO is not spread, and thus Comparative Example Compound X6 has weaker CT characteristics than the Example Compounds. Therefore, the light-emitting elements according to Comparative Examples 5 to 8 each exhibit relatively low external quantum efficiency and short lifespan.

The light-emitting elements according to Comparative Examples 9 and 11 respectively include Comparative Example Compounds X9 and X11. Comparative Example Compounds X9 and X11 each include a nine-ring fused ring system and a second substituent, but includes no first substituent. Therefore, the light-emitting elements according to Comparative Examples 9 and 11 exhibit relatively low external quantum efficiency and short lifespan.

The light-emitting element according to Comparative Example 10 includes Comparative Example Compound X10. Comparative Example Compound X10 corresponds to a case where, in Formula 1 described above, R^{b2} and R^{b3} are bonded to each other to form a moiety represented by Formula RB, but the first substituent is a phenyl group that is substituted with a methyl group. Therefore, the light-emitting element according to Comparative Example 10 exhibits relatively low external quantum efficiency and short lifespan.

According to some example embodiments, an electronic apparatus may include a light-emitting element, and the light-emitting element may include a fused polycyclic compound. The fused polycyclic compound according to at least one example embodiment may include a nine-ring fused ring system, a first substituent, and a second substituent. The nine-ring fused ring system may be a core structure and may include four hetero atoms and two boron atoms as ring-forming atoms. The first substituent is bonded at a para position with respect to the boron atom, which is a ring-forming atom, and may be a substituted or unsubstituted aryl group. The second substituent is bonded, in the nine-ring fused ring system, to another cyclic group, which is not bonded to the first substituent, and may be an electron-donating substituent. Therefore, in the fused polycyclic compound according to at least one example embodiment, RISC is accelerated, and the fused polycyclic compound according to at least one example embodiment may contribute to improvements in emission efficiency and lifespan.

The light-emitting element according to at least one example embodiment and the electronic apparatus including the same include the fused polycyclic compound according to at least one example embodiment and thus may exhibit high emission efficiency and long lifespan characteristics.

The fused polycyclic compound according to at least one example embodiment may contribute to improvements in emission efficiency and long lifespan of the light-emitting element.

Hitherto, although some example embodiments of the inventive concepts have been described with reference to preferable embodiments, and those skilled in the art or having ordinary knowledge of the art will understand that various modifications and changes can be made without departing from the technical idea or features of the inventive concepts as described later in the claims, which will be described hereinafter.

Accordingly, the technical scope of the inventive concepts is not limited to what is set forth in the detailed description of the specification, but should be defined by the claims.

## Claims

1. A fused polycyclic compound represented by Formula 1: 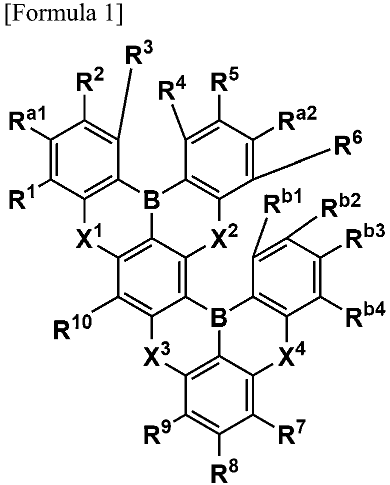 wherein, in Formula 1,
X¹ to X⁴ are each independently O, S, or NR^{y1},
R^{y1} is a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms, or represented by Formula 2,
R¹ to R⁶ and R^{b1} to R^{b4} are each independently a hydrogen atom, a deuterium atom, a halogen atom, a substituted or unsubstituted amine group, a substituted or unsubstituted oxy group, a substituted or unsubstituted thio group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms, wherein R¹ to R⁶ and R^{b1} to R^{b4} are optionally bonded to an adjacent group to form a ring,
R⁷ to R¹⁰, R^{a1}, and R^{a2} are each independently a hydrogen atom, a deuterium atom, a cyano group, a halogen atom, a substituted or unsubstituted amine group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms,
at least one among R^{a1} and R^{a2} is the substituted or unsubstituted aryl group having 6 to 60 ring-forming carbon atoms,
at least one among R^{b1} to R^{b4} is the substituted or unsubstituted alkyl group having 1 to 20 carbon atoms, or an electron-donating group,
the electron-donating group is a substituted or unsubstituted alkoxy group, a substituted or unsubstituted alkylthio group, a substituted or unsubstituted alkylamine group, a substituted or unsubstituted aryloxy group, a substituted or unsubstituted arylthio group, a substituted or unsubstituted arylamine group, or a substituted or unsubstituted carbazole group, 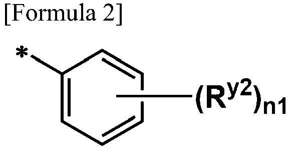
wherein, in Formula 2,
n1 is an integer of 0 to 5,
R^{y2} is a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms,
when R^{b2} and R^{b3} are bonded to each other R^{b2} and R^{b3} form a moiety represented by Formula RB and the at least one among R^{a1} and R^{a2} is the unsubstituted aryl group having 6 to 60 ring-forming carbon atoms, 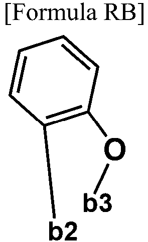
where, in Formula RB, b2 is a position corresponding to R^{b2}, and b3 is a position corresponding to R^{b3}, and
the fused polycyclic compound includes a chemical structure in which a hydrogen atom is optionally substituted with a deuterium atom.

2. The fused polycyclic compound of claim 1, wherein the fused polycyclic compound is represented by at least one of Formula 1-A1 to Formula 1-A6: 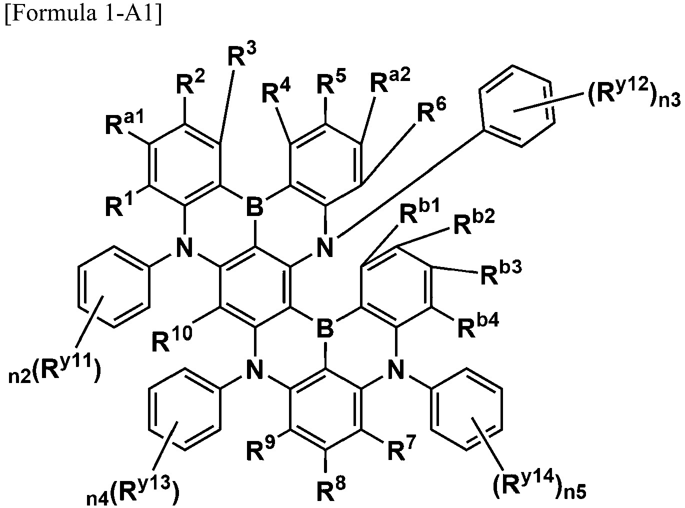 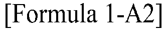 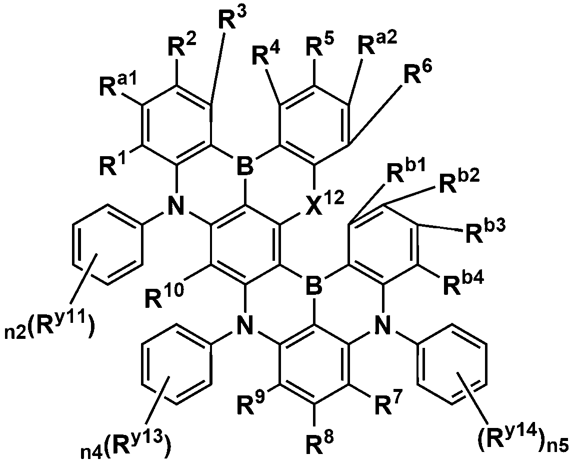 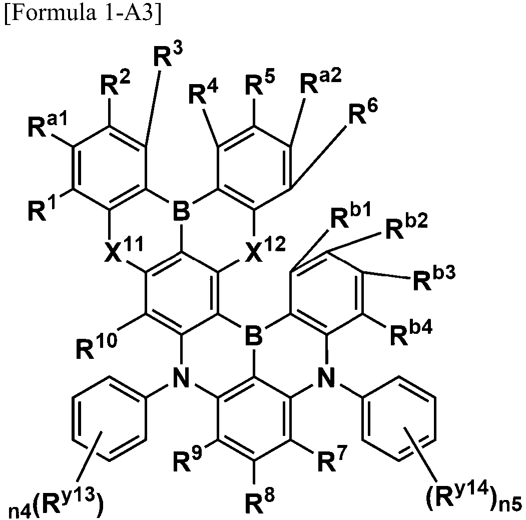 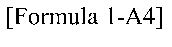 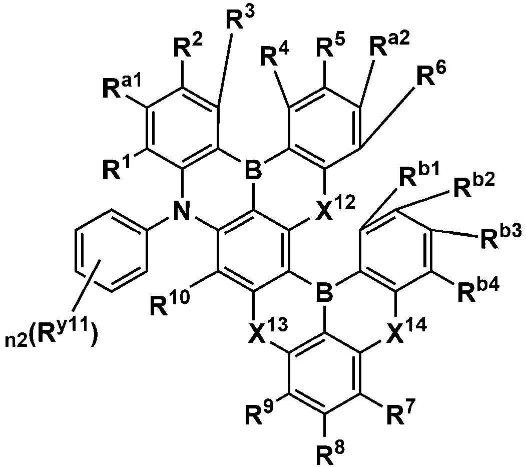 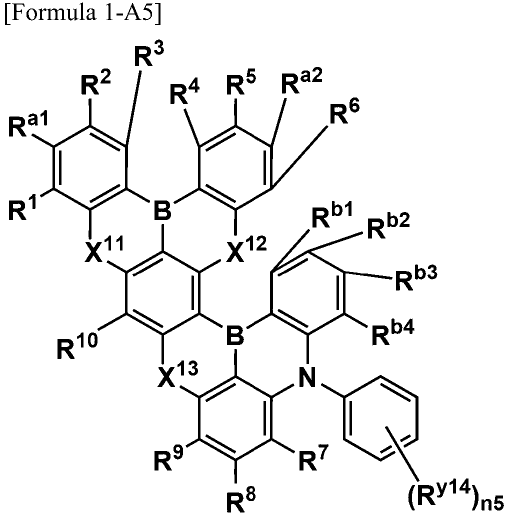 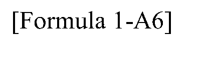 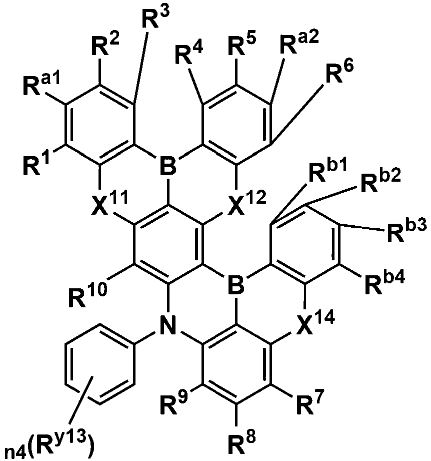 where, in Formula 1-A1 to Formula 1-A6,
X¹¹ to X¹⁴ are each independently O or S,
n2 to n5 are each independently an integer of 0 to 5,
R^{y11} to R^{y14} are each independently a hydrogen atom, a deuterium atom, a halogen atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 30 ring-forming carbon atoms, and
R¹ to R⁶, R^{b1} to R^{b4}, R⁷ to R¹⁰, R^{a1}, and R^{a2} are the same as defined in Formula 1.

3. The fused polycyclic compound of claim 1 or claim 2, wherein, at least one among R^{b1} to R^{b4} includes a substituted or unsubstituted methyl group, a substituted or unsubstituted ethyl group, a substituted or unsubstituted isopropyl group, a substituted or unsubstituted n-butyl group, a substituted or unsubstituted t-butyl group, a substituted or unsubstituted cyclopentyl group, a substituted or unsubstituted cyclohexyl group, a substituted or unsubstituted methoxy group, a substituted or unsubstituted propyloxy group, a substituted or unsubstituted isopropyloxy, a substituted or unsubstituted t-butyloxy group, a substituted or unsubstituted cyclohexyloxy group, a substituted or unsubstituted phenyloxy group, a substituted or unsubstituted dimethylamine group, a substituted or unsubstituted ethylamine group, a substituted or unsubstituted N-methylphenylamine group, a substituted or unsubstituted N-propylphenylamine group, a substituted or unsubstituted diphenylamine group, a substituted or unsubstituted methylthio group, a substituted or unsubstituted isopropylthio group, a substituted or unsubstituted propylthio group, a substituted or unsubstituted t-butylthio group, a substituted or unsubstituted phenylthio group, or a substituted or unsubstituted carbazole group.

4. The fused polycyclic compound of claim 1 or claim 2, wherein, in Formula 1 above, at least one among R^{b1} to R^{b4} is represented by at least one of Rb-1 to Rb-45:

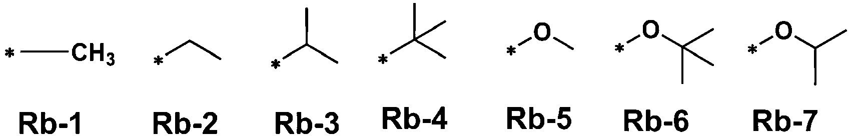

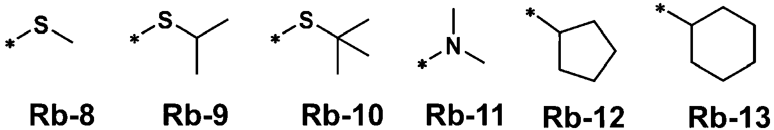

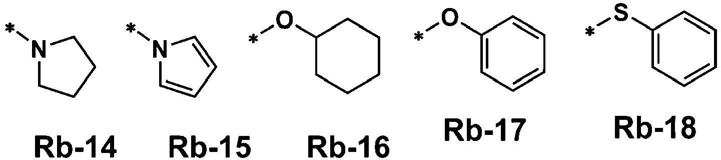

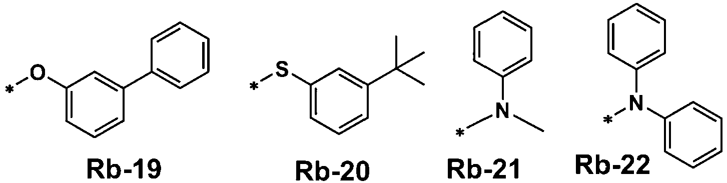

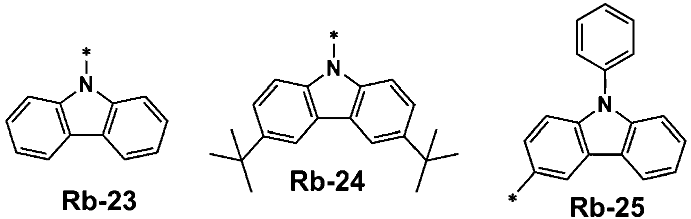

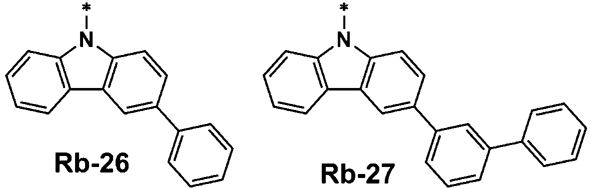

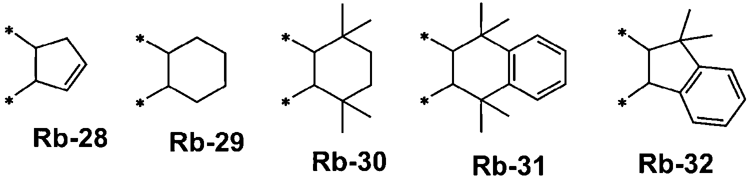

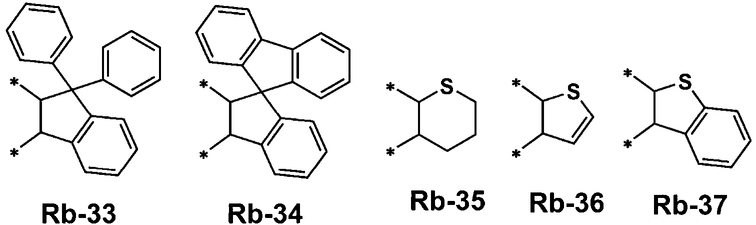

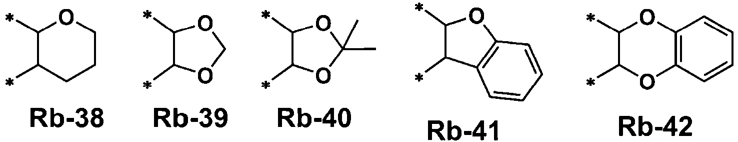

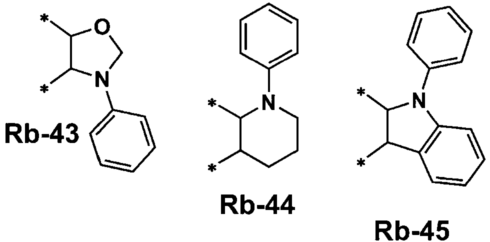

5. The fused polycyclic compound of any one of claims 1 to 4, wherein in Formula 1 above, the one among R^{a1} and R^{a2} is represented by at least one of Ra-1 to Ra-5: 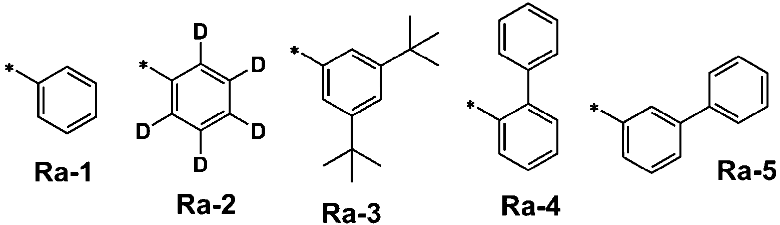 where, in Ra-2, D is a deuterium atom.

6. The fused polycyclic compound of any one of claims 1 to 5, wherein, in Formula 1, a remainder among R^{a1} and R^{a2}, is a hydrogen atom, a deuterium atom, a cyano group, a substituted or unsubstituted diphenylamine group, or a substituted or unsubstituted carbazole group.

7. The fused polycyclic compound of any one of claims 1 to 6, wherein R^{y1} is represented by at least one of Y1-1 to Y1-18:

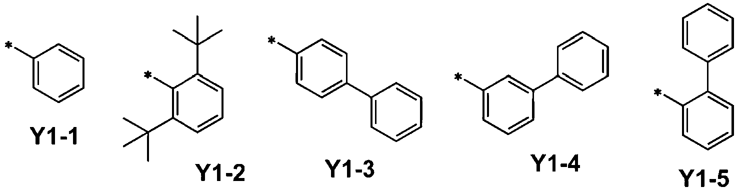

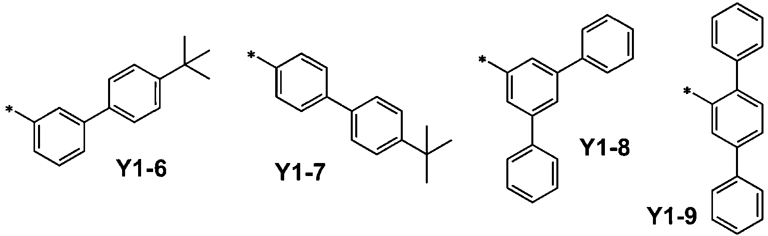

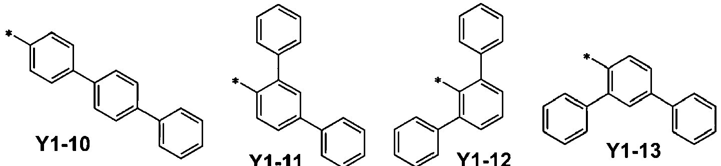

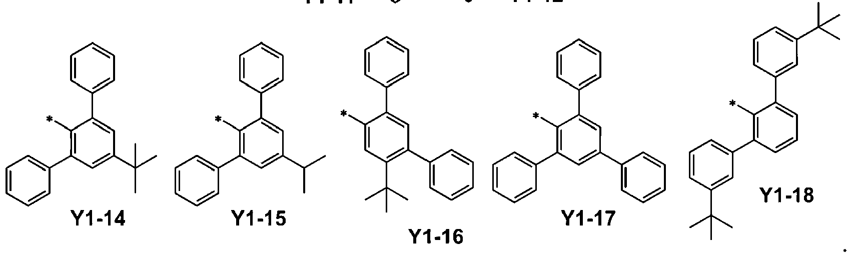

8. The fused polycyclic compound of claim 1, wherein the fused polycyclic compound is represented by at least one of a compound in Compound Group 1: 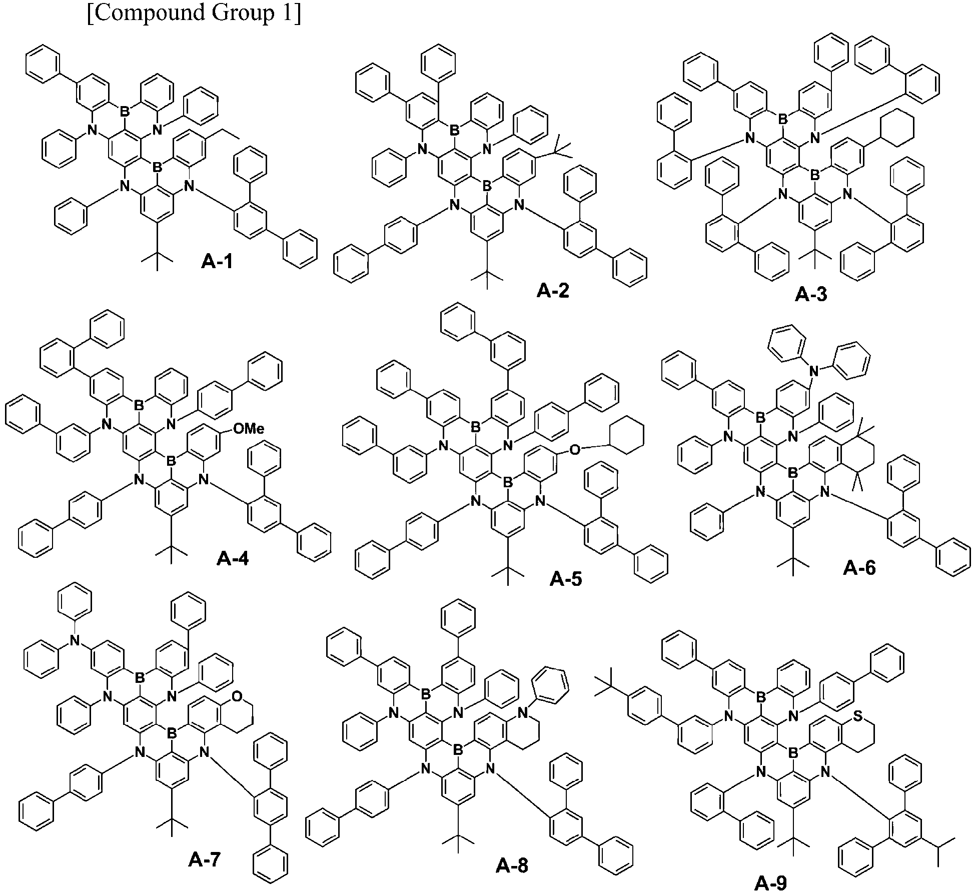 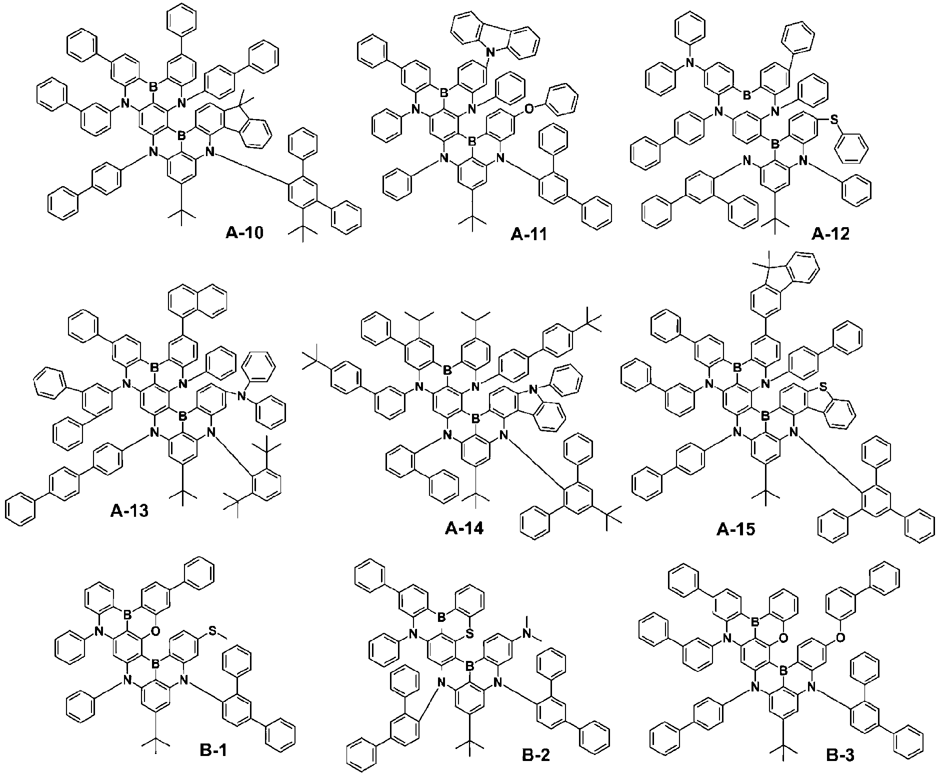 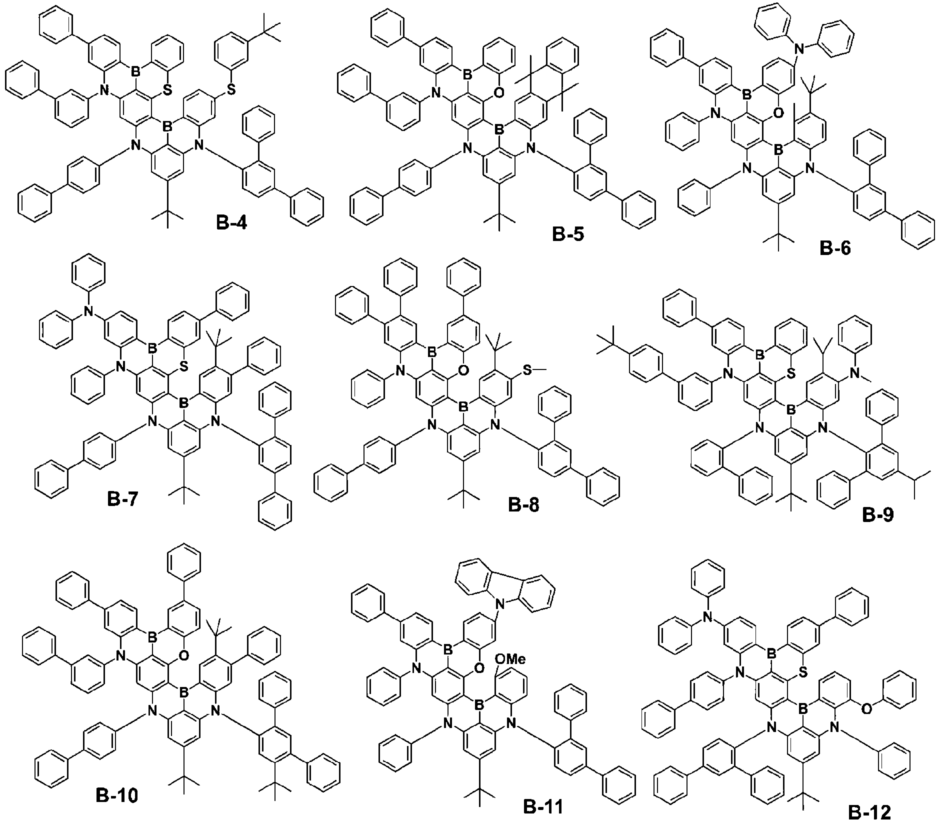 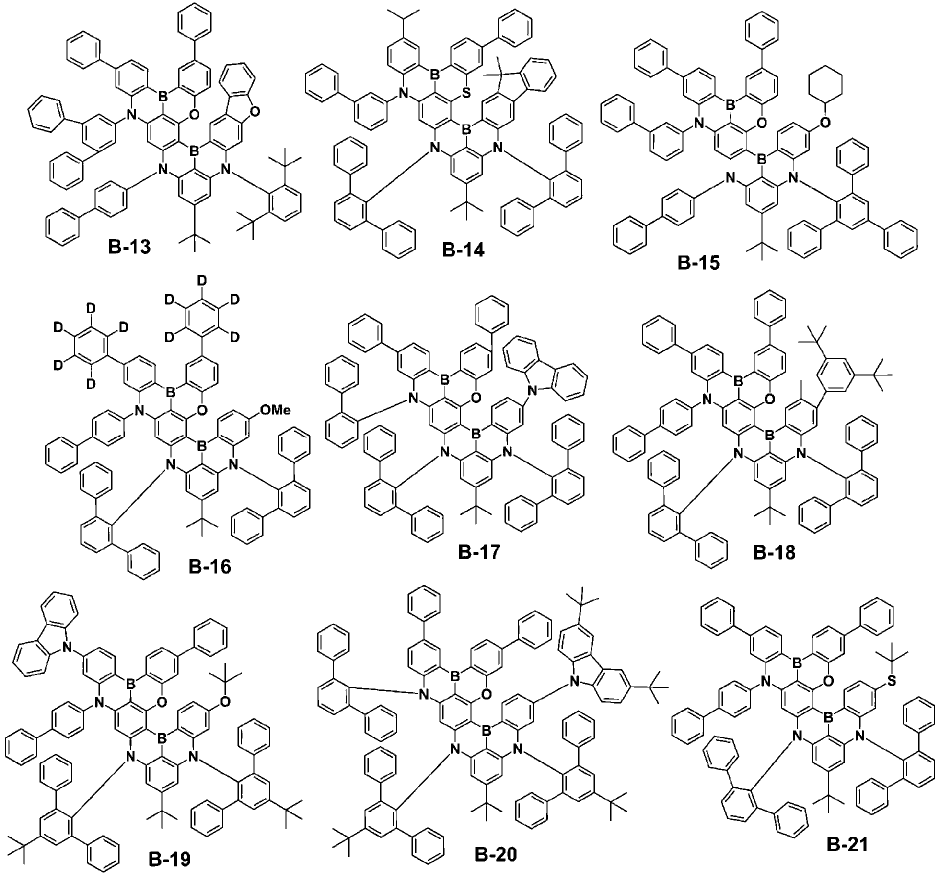 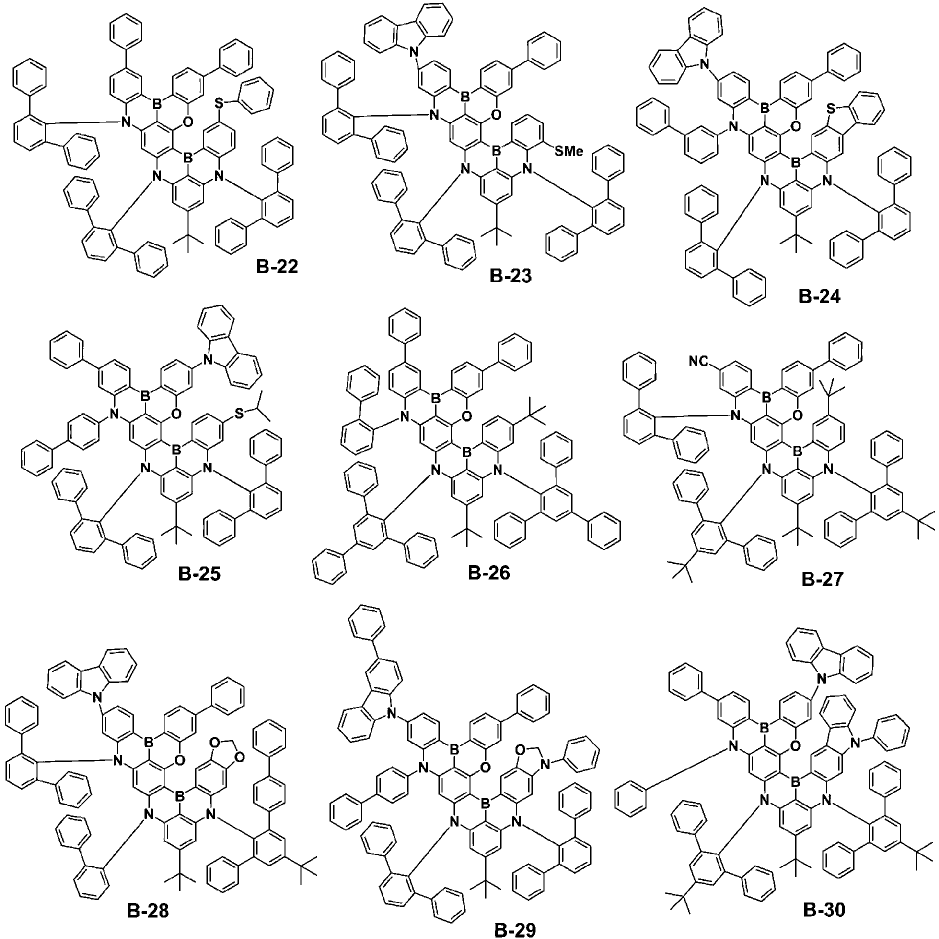 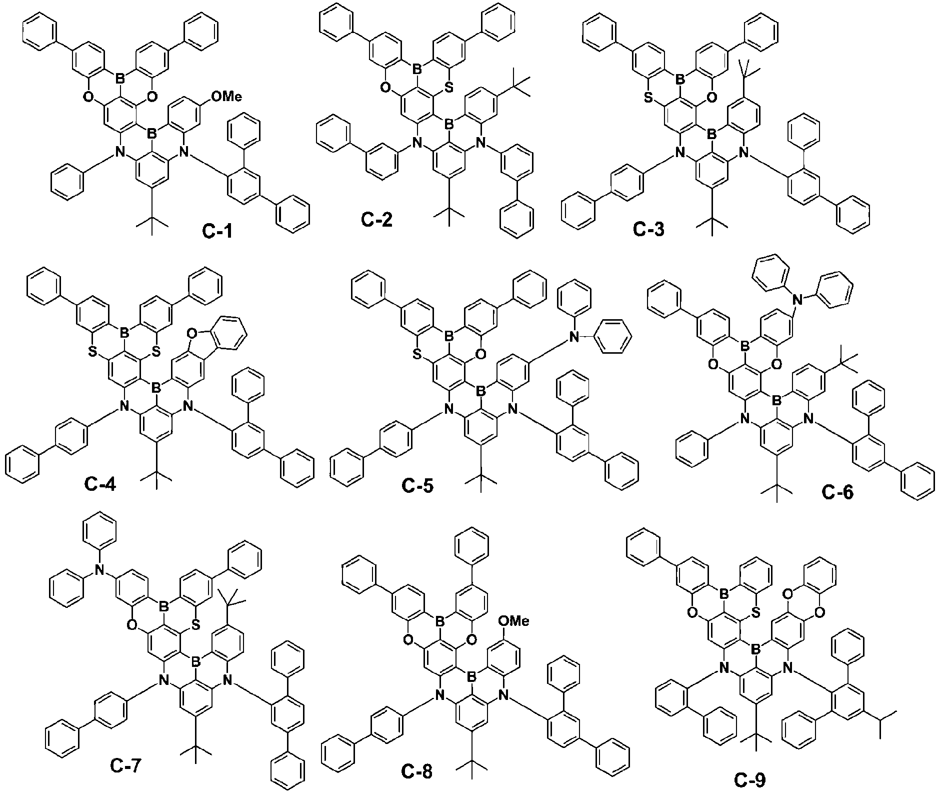 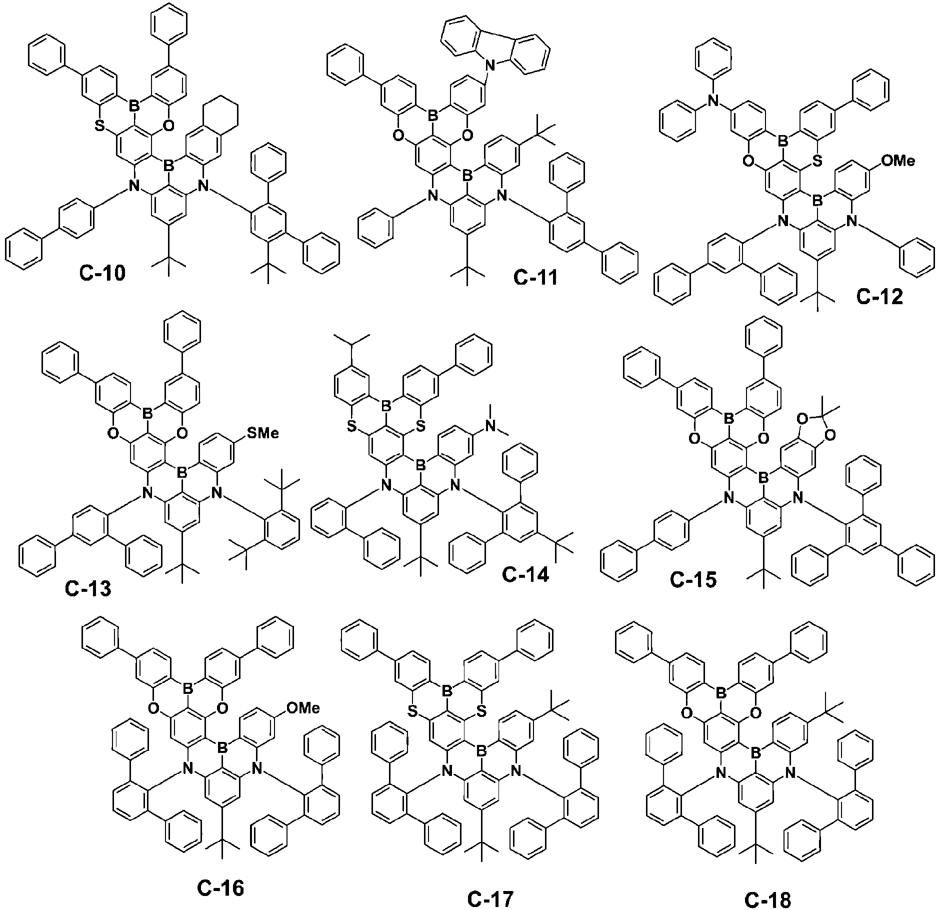 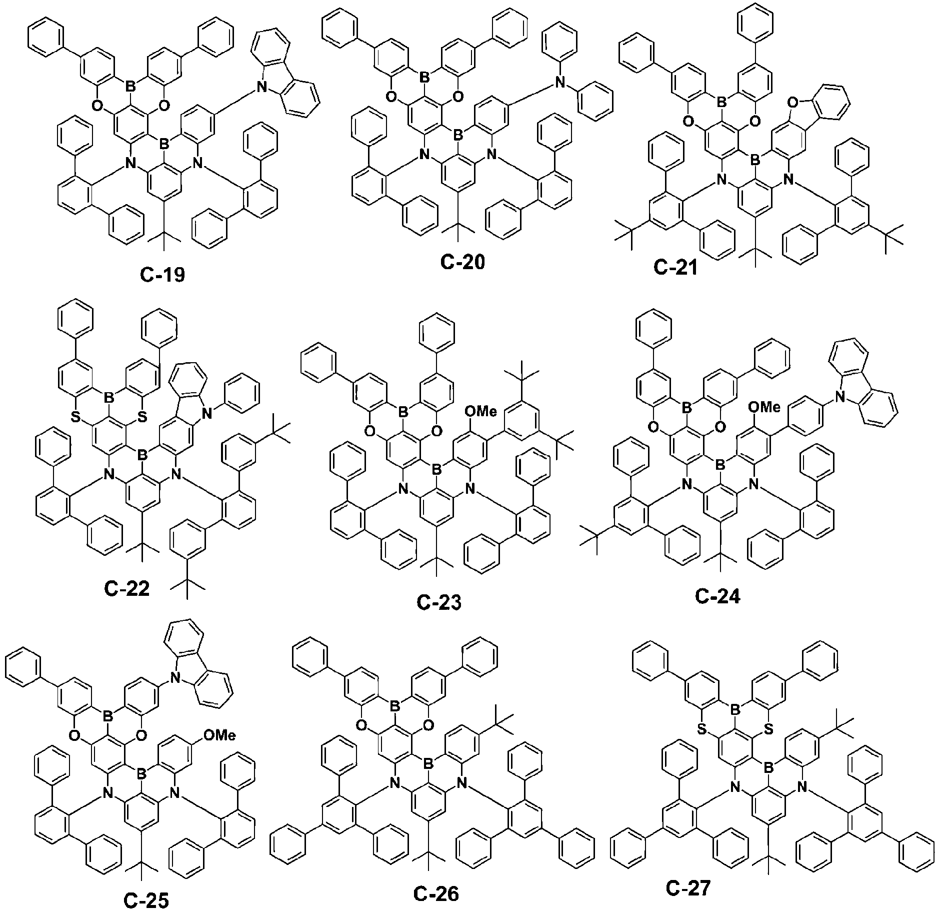 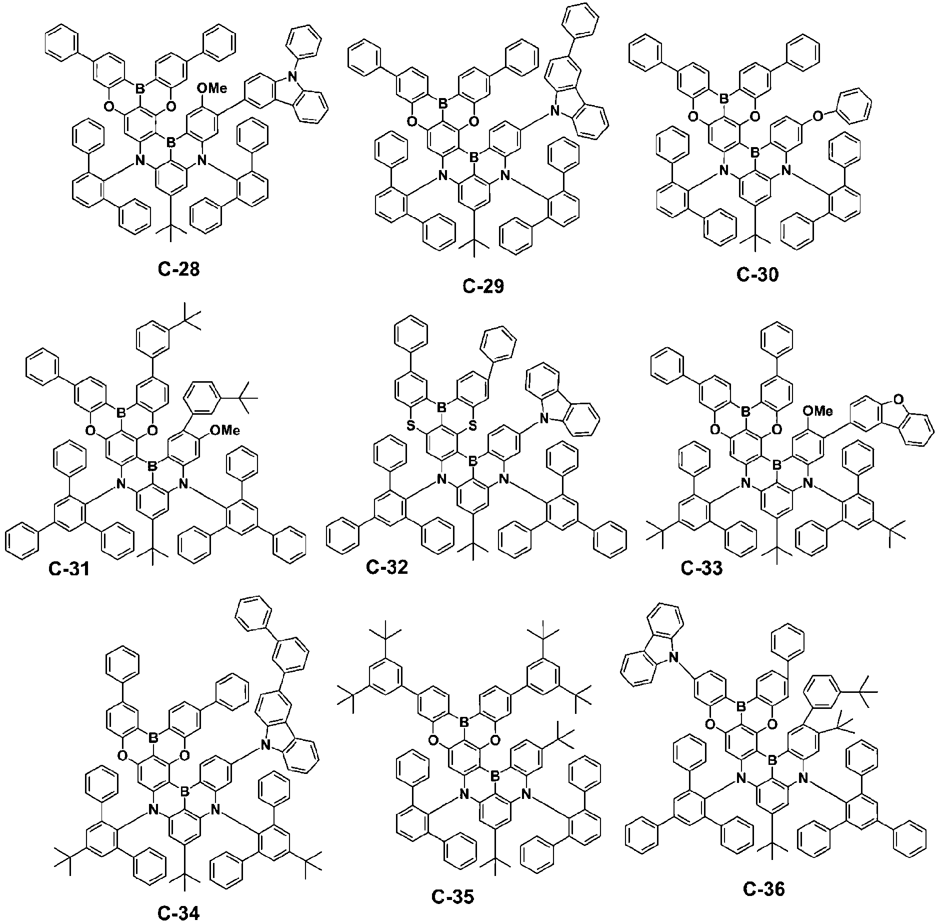 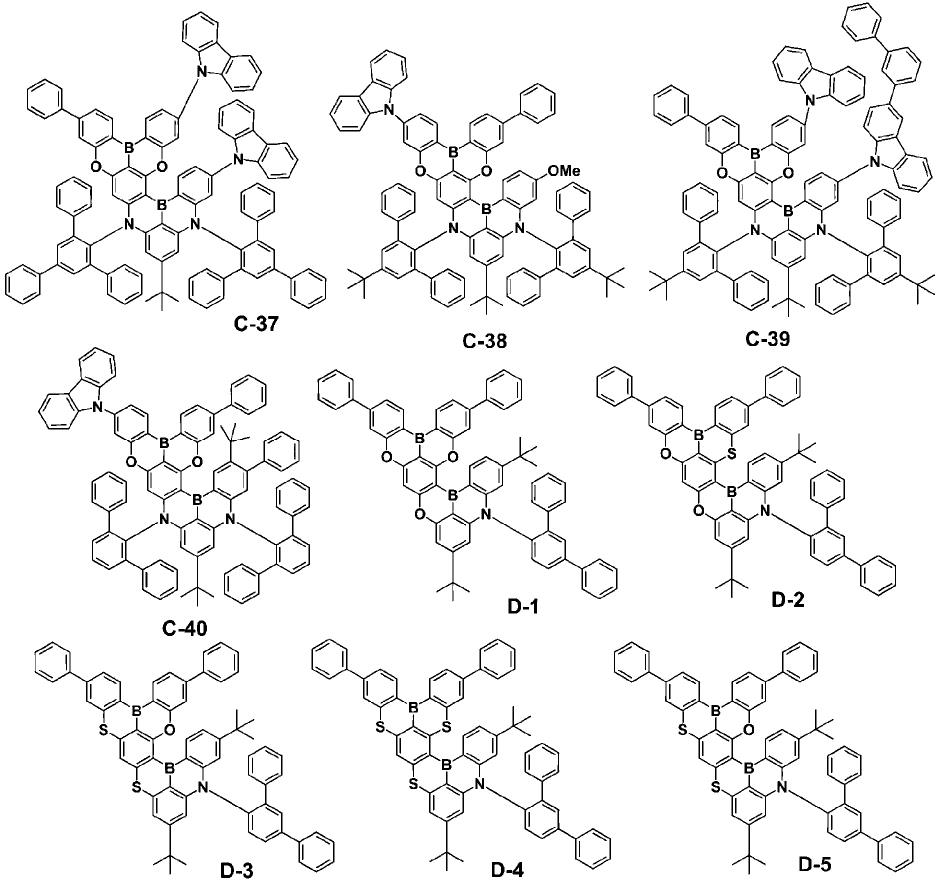 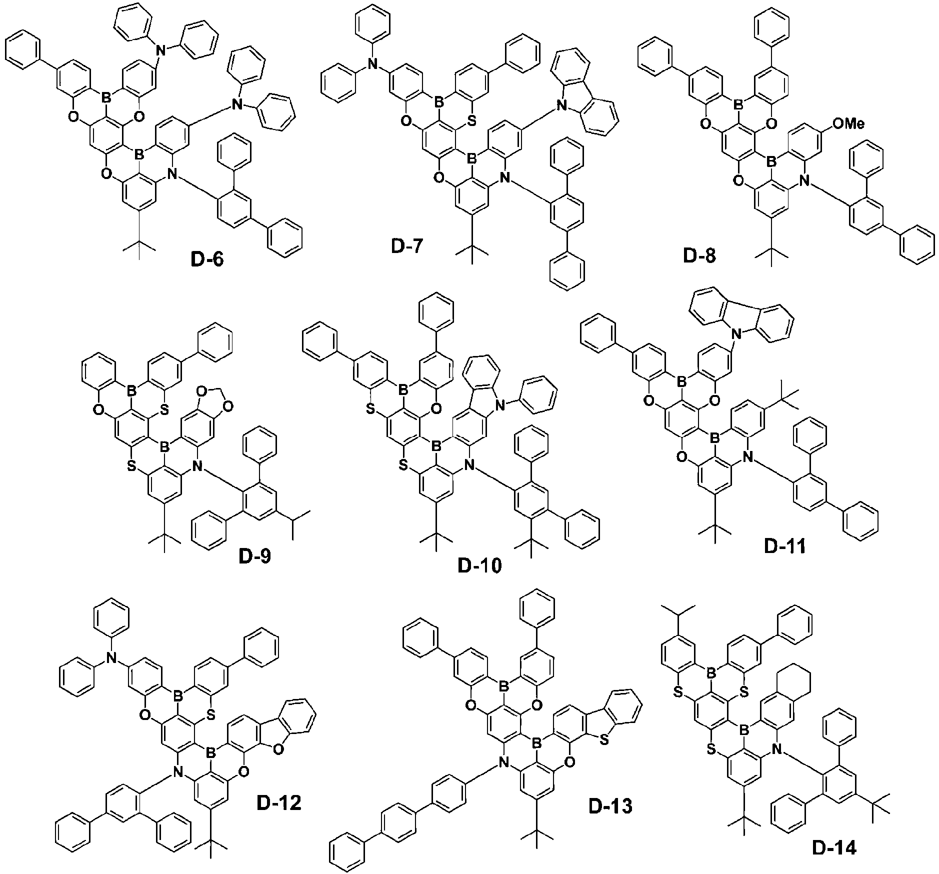 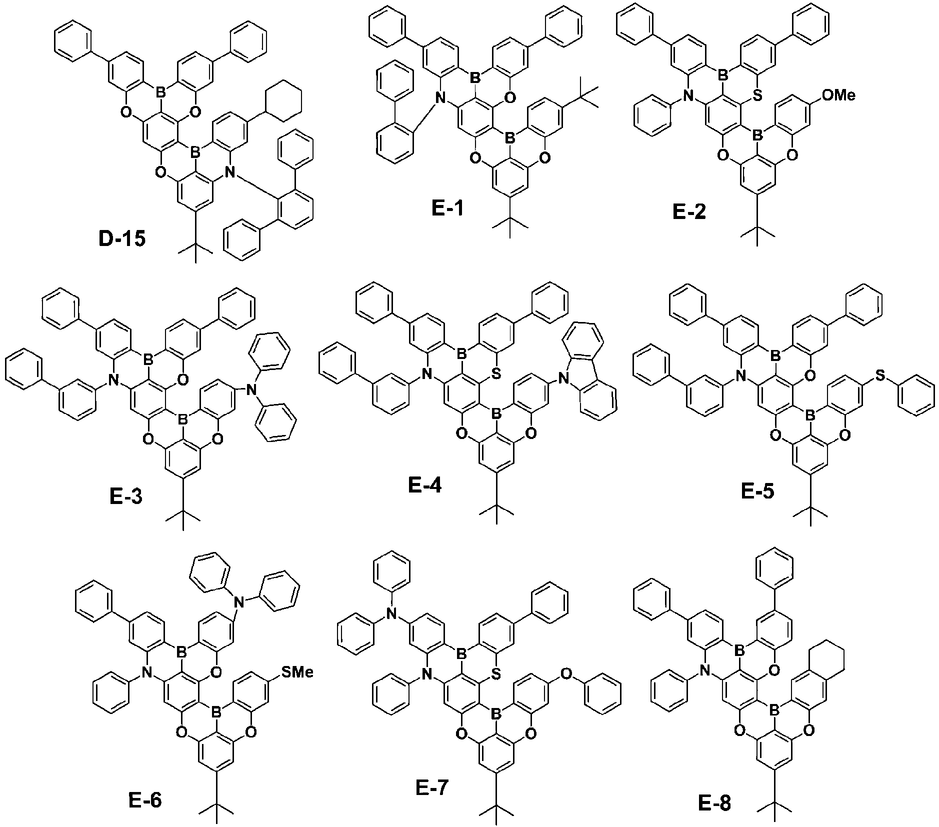 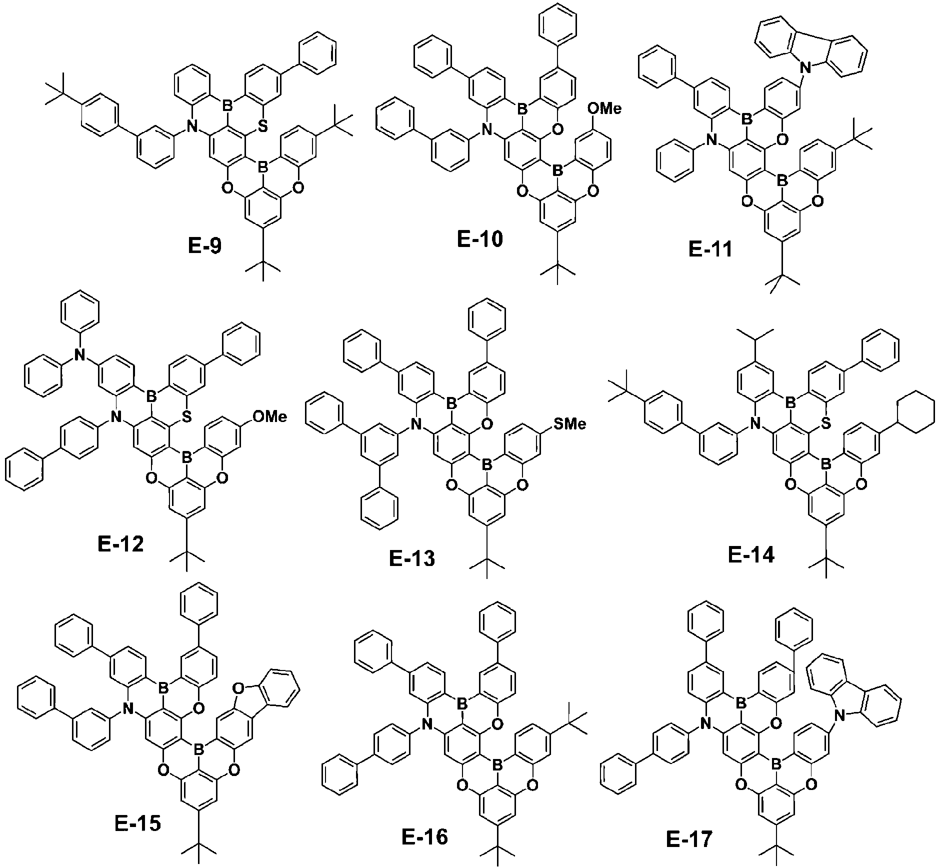 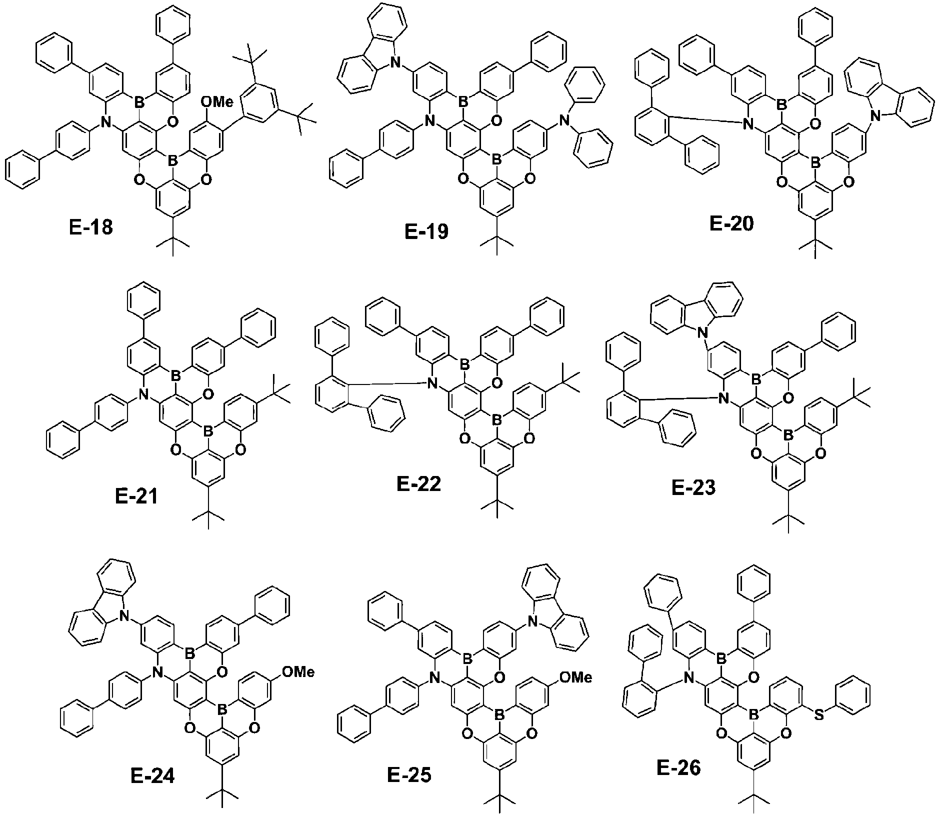 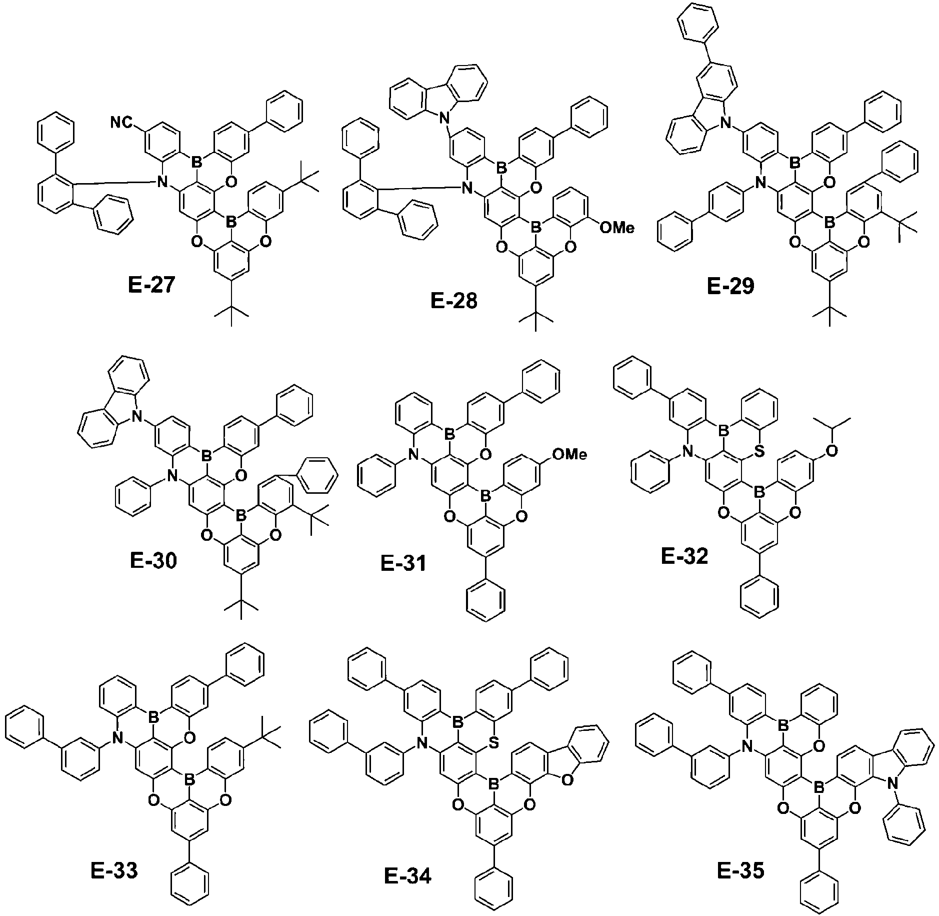 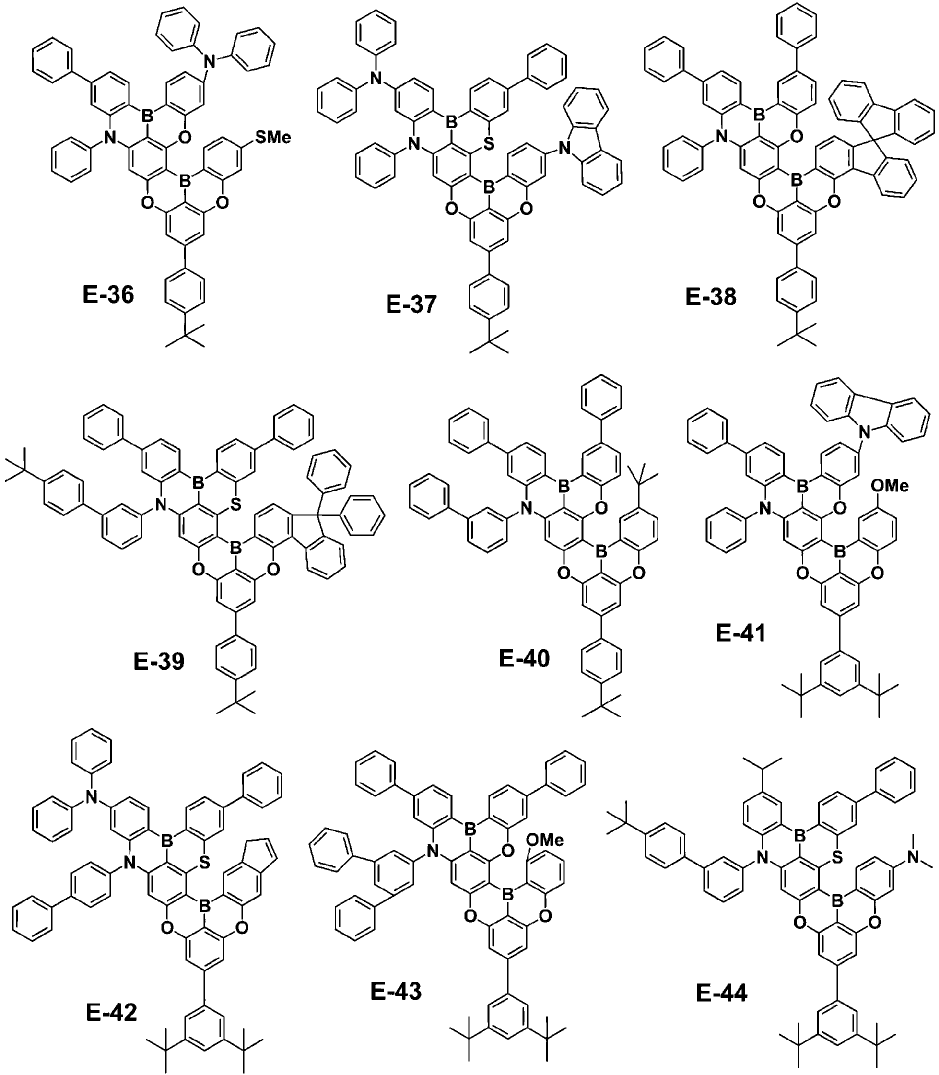 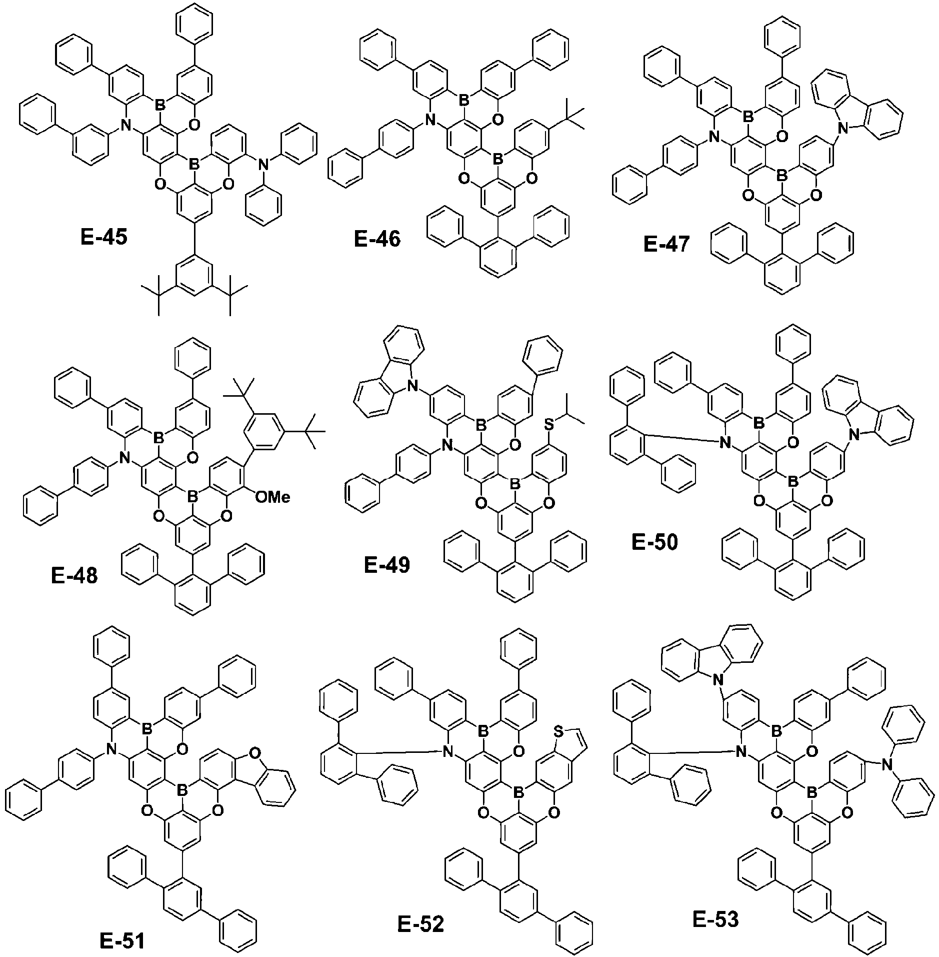 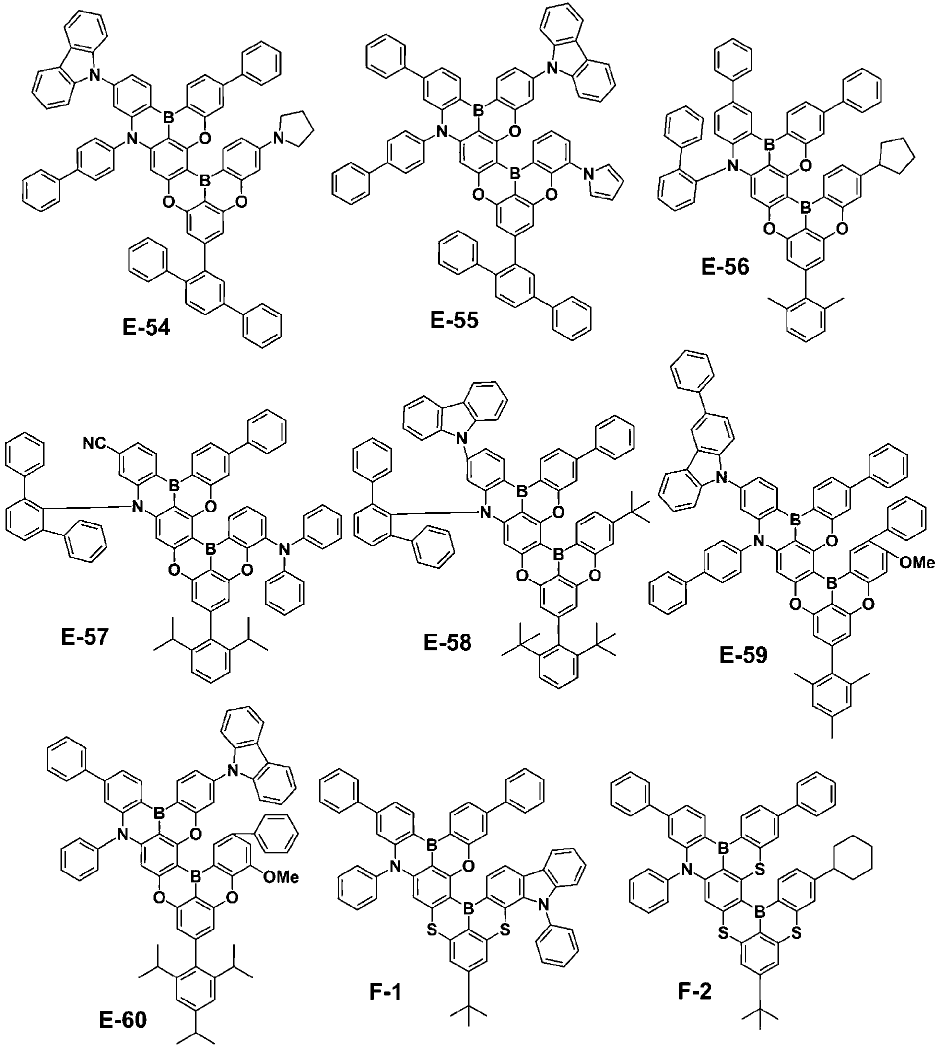 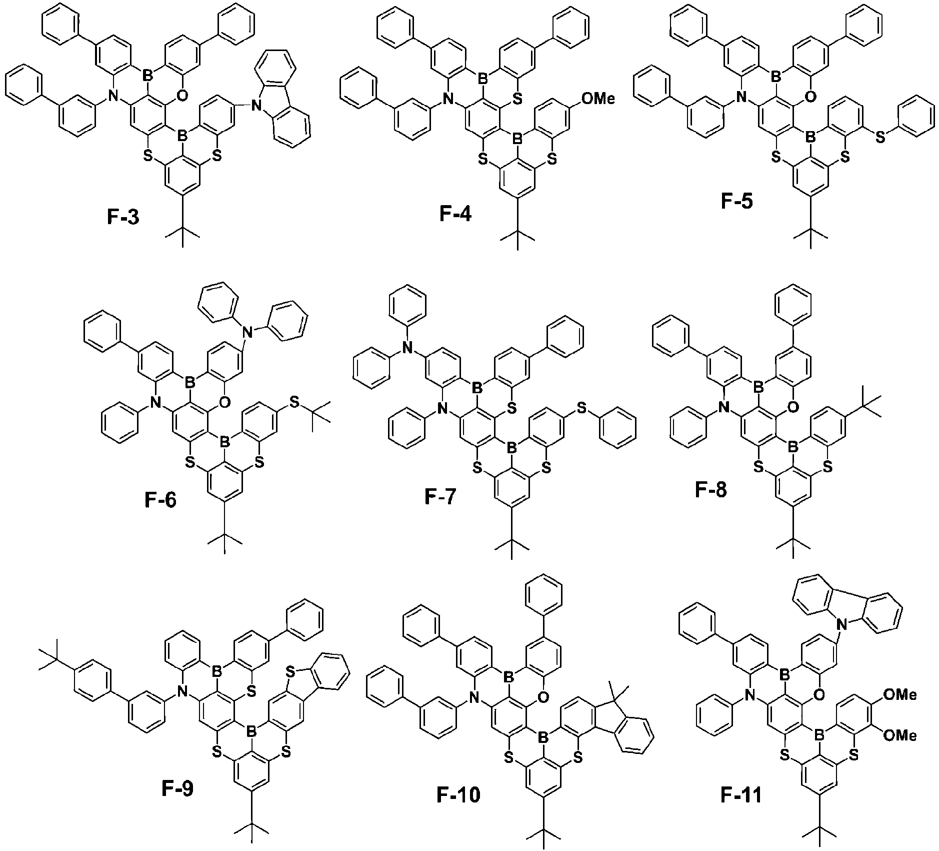 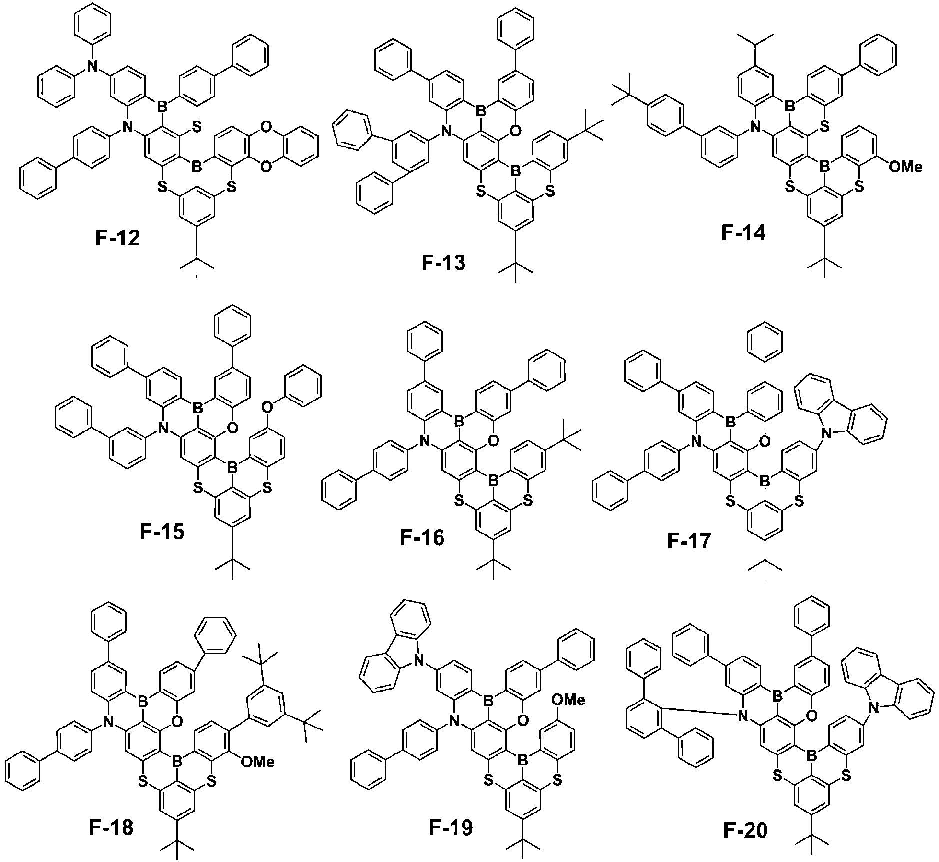 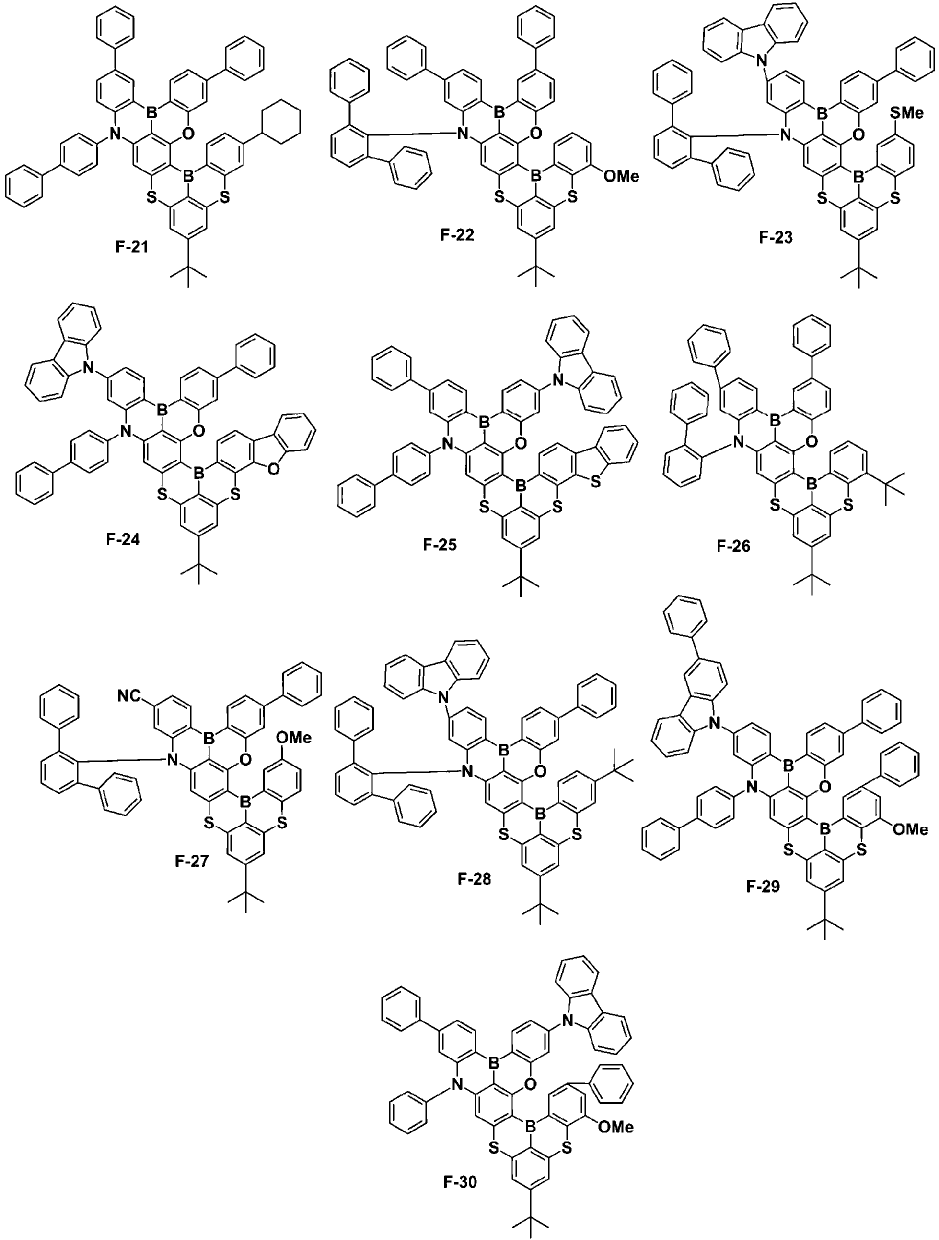 where, in Compound Group 1, D is a deuterium atom.

9. A light-emitting element (ED) comprising:
a first electrode (EL1);
a second electrode (EL2) on the first electrode (EL1); and
an emission layer (EML) between the first electrode (EL1) and the second electrode (EL2), the emission layer (EML) including a first compound, and
wherein the first compound is the fused polycyclic compound according to any one of claims 1 to 8.

10. The light-emitting element (ED) of claim 9, wherein the emission layer (EML) further comprises at least one of a second compound represented by Formula HT-1, a third compound represented by Formula ET-1, and a fourth compound represented by Formula D-1: 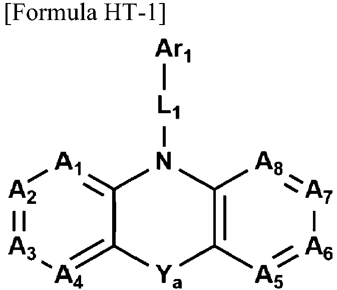 where, in Formula HT-1,
A₁ to A₈ are each independently N or CR₅₁,
L₁ is a direct linkage, a substituted or unsubstituted arylene group having 6 to 30 ring-forming carbon atoms, or a substituted or unsubstituted heteroarylene group having 2 to 30 ring-forming carbon atoms,
Yₐ is a direct linkage, CR₅₂R₅₃, or SiR₅₄R₅₅,
Ar₁ is a substituted or unsubstituted aryl group having 6 to 30 ring-forming carbon atoms, or a substituted or unsubstituted heteroaryl group having 2 to 30 ring-forming carbon atoms,
R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, wherein R₅₁ to R₅₅ are optionally bonded to an adjacent group to form a ring, 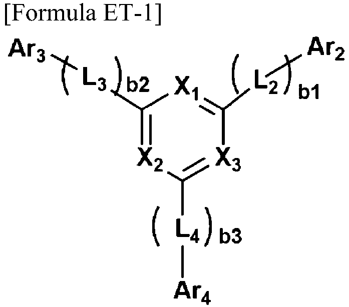
wherein, in Formula ET-1,
at least one among X₁ to X₃ is N, and a remainder of X₁ to X₃ are CR₅₆,
R₅₆ is a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms,
b1 to b3 are each independently an integer of 0 to 10,
Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms,
L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms, 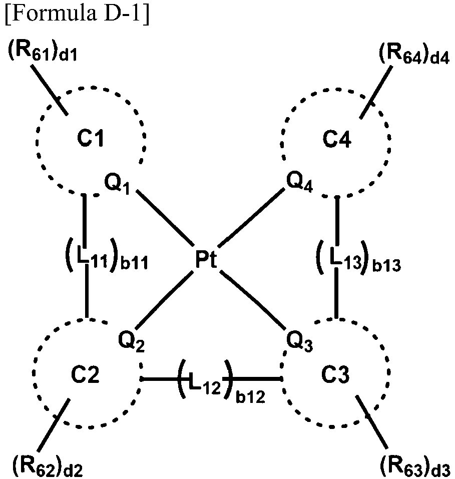
where, in Formula D-1,
Q₁ to Q₄ are each independently C or N,
C1 to C4 are each independently a substituted or unsubstituted hydrocarbon ring having 5 to 30 ring-forming carbon atoms, a substituted or unsubstituted aryl group having 6 to 30 ring-forming carbon atoms, or a substituted or unsubstituted heterocycle having 2 to 30 ring-forming carbon atoms,
L₁₁ to L₁₃ are each independently a direct linkage, 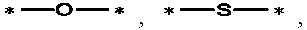 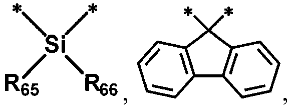
a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms,
b11 to b13 are each independently 0 or 1,
R₆₁ to R₆₆ are each independently hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, and
d1 to d4 are each independently an integer of 0 to 4.

11. An electronic apparatus (EA) comprising a display device (DD) configured to provide an image,
wherein, the display device (DD) includes a base layer (BS), a circuit layer (DP-CL) disposed on the base layer (BS), and a display element layer (DP-ED) disposed on the circuit layer (DP-CL) and including a light-emitting element (ED),
the light-emitting element (ED) includes a first electrode (EL1), a second electrode (EL2) on the first electrode (EL1), and an emission layer (EML) between the first electrode (EL1) and the second electrode (EL2), and
the emission layer (EML) includes the fused polycyclic compound according to any one of claims 1 to 8.

12. The electronic apparatus (EA) of claim 11, further comprising:
at least one of a light control layer (CCL) and a color filter layer (CFL),
wherein the light control layer (CCL) includes quantum dots (QD), and
the color filter layer (CFL) includes at least one of a pigment or dye.

13. The electronic apparatus (EA) of claim 11 or claim 12, further comprising:
at least one of a processor (12), a memory (13), and power module (14).
